# EUROPEAN PATENT SPECIFICATION

(11) **EP 3 476 852 B1**
(45) Date of publication and mention of the grant of the patent: **27.11.2024**
(21) Application number: 18191151.2
(22) Date of filing: 28.08.2018
(51) Int. Cl.: C07F 9/6521, C07F 9/6568, C07F 9/6558, H10K 50/13, H10K 71/16, H10K 71/40, H10K 71/60, H10K 85/60, H10K 101/40

(54) **HETEROCYCLIC COMPOUND AND ORGANIC LIGHT-EMITTING DEVICE INCLUDING THE SAME**
HETEROCYCLISCHE VERBINDUNG UND ORGANISCHE LICHTEMITTIERENDE VORRICHTUNG DAMIT
COMPOSÉ HÉTÉROCYCLIQUE ET DISPOSITIF ÉLECTROLUMINESCENT ORGANIQUE L'INCLUANT

(30) Priority: 31.10.2017 KR 20170144221
(43) Date of publication of application: 01.05.2019
(73) Proprietor: Samsung Display Co., Ltd., Gyeonggi-Do (KR)
(72) Inventor: Lee, Hyoyoung, Gyeonggi-do, (KR); Park, Junha, Gyeonggi-do, (KR); Sim, Munki, Gyeonggi-do, (KR); Kim, Youngkook, Gyeonggi-do, (KR); Hwang, Seokhwan, Gyeonggi-do, (KR)
(74) Representative: Newcombe, Christopher David

(56) References cited:
- EP-A1- 3 406 597
- KR-A- 20160 050 894
- KR-A- 20170 004 432
- KR-A- 20170 032 833
- US-A1- 2017 244 048
- US-B1- 9 640 767
- YU HONGCUI ET AL: "Effect of substituents on properties of diphenylphosphoryl-substituted bis-cyclometalated Ir(III) complexes with a picolinic acid as ancillary ligand", DYES AND PIGMENTS, ELSEVIER APPLIED SCIENCE PUBLISHERS. BARKING, GB, vol. 145, 1 June 2017 (2017-06-01), pages 136 - 143, XP085123197, ISSN: 0143-7208, DOI: 10.1016/J.DYEPIG.2017.05.056
- NALLAN CHAKRAVARTHI ET AL: "Triazine-based Polyelectrolyte as an Efficient Cathode Interfacial Material for Polymer Solar Cells", ACS APPLIED MATERIALS & INTERFACES, vol. 9, no. 29, 26 July 2017 (2017-07-26), US, pages 24753 - 24762, XP055563890, ISSN: 1944-8244, DOI: 10.1021/acsami.7b03187
- LIJUN DENG ET AL: "Diphenylphosphorylpyridine-functionalized iridium complexes for high-efficiency monochromic and white organic light-emitting diodes", JOURNAL OF MATERIALS CHEMISTRY, vol. 22, no. 31, 1 January 2012 (2012-01-01), GB, pages 15910, XP055563887, ISSN: 0959-9428, DOI: 10.1039/c2jm32811a
- PENGBO ZHANG ET AL: "Synthesis of 3-phosphinoylquinolines via a phosphinoylation-cyclization-aromatization process mediated by tert-butyl hydroperoxide", RSC ADVANCES, vol. 6, no. 65, 1 January 2016 (2016-01-01), pages 60922 - 60925, XP055563885, ISSN: 2046-2069, DOI: 10.1039/C6RA11426A
- DATABASE WPI Week 201770, Derwent World Patents Index; AN 2017-587008, XP002789398

## Description

### 1. Field

The present invention relates to a heterocyclic compound and an organic light-emitting device comprising the same.

### 2. Description of the Related Art

Organic light-emitting devices (OLEDs) are self-emission devices that, as compared with other devices, have wide viewing angles, high contrast ratios, short response times, and excellent brightness, driving voltage, and response speed characteristics, and produce full-color images.

OLEDs may include a first electrode disposed on a substrate, and may include a hole transport region, an emission layer, an electron transport region, and a second electrode sequentially disposed on the first electrode. Holes provided from the first electrode may move toward the emission layer through the hole transport region. Electrons provided from the second electrode may move toward the emission layer through the electron transport region. Carriers, such as holes and electrons, may recombine in the emission layer to produce excitons. These excitons transit (or relax) from an excited state to a ground state to thereby generate light.
US 9,640,767 B1 describes a alectronic device including a phosphine oxide functionalized triazine derivative.
US 2017/244048A1 describes a material for use in an electron transport region of an organic light-emitting device.
KR 2017 0032833A describes an organic light emitting device comprising a first electrode, a second electrode, and at least one organic layer disposed between the first electrode and the second electrode, and a compound represented by the formula (1). KR 2017 0004432A describes heterocyclic compounds and an organic light-emitting device using the same.
KR 2016 0050894A describes a triazine derivative bonded to a phosphoryl group and an organic electroluminescent device including the same.

### SUMMARY

The present invention provides a heterocyclic compound represented by Formula 1: 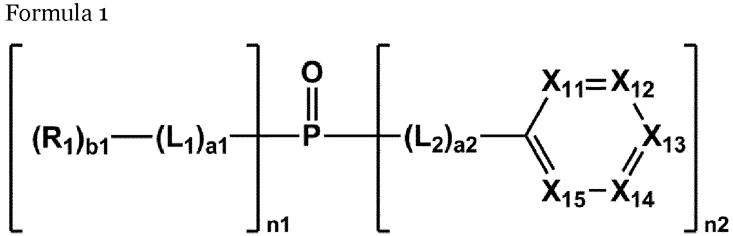 wherein, in Formula 1,
X_{11;} X₁₃, and X₁₅ are each N, X₁₂ is C-[(L₁₂)ₐ₁₂-(R₁₂)_{b12}], and X₁₄ is C-[(L₁₄)ₐ₁₄-(R₁₄)_{b14}]n1 is selected from 0, 1, and 2, n2 is selected from 1, 2, and 3, and the sum of n1+n2 is 3,
L₁, L₂, L₁₂, L₁₄, R₁, R₁₂ and R₁₄ are each independently selected from a substituted or unsubstituted C₅-C₆₀ carbocyclic group and a substituted or unsubstituted C₁-C₆₀ heterocyclic group,
a1, a2, a12 and a14 are each independently an integer from 0 to 5,
   when a1 is 0, *-(L₁)ₐ₁-*' is a single bond; when a2 is 0, *-(L₂)ₐ₂-*' is a single bond; when a₁₂ is 0, *-(L₁₂)ₐ₁₂-*' is a single bond; when a14 is 0, *-(L₁₄)ₐ₁₄-*' is a single bond;
when a1 is 2 or greater, at least two L₁ groups are identical to or different from each other; when a2 is 2 or greater, at least two L₂ groups are identical to or different from each other; when a12 is 2 or greater, at least two L₁₂ groups are identical to or different from each other; when a14 is 2 or greater, at least two L₁₄ groups are identical to or different from each other;
b1, b12 and b14 are each independently an integer from 1 to 10,
when b1 is 2 or greater, at least two R₁ groups are identical to or different from each other; when b12 is 2 or greater, at least two R₁₂ groups are identical to or different from each other; when b14 is 2 or greater, at least two R₁₄ groups are identical to or different from each other;
   two adjacent groups selected from L₁, L₂, L₁₂, L₁₄, R₁, R₁₂ and R₁₄ are optionally bound to form a substituted or unsubstituted C₅-C₆₀ carbocyclic group or a substituted or unsubstituted C₁-C₆₀ heterocyclic group,
the heterocyclic compound represented by Formula 1 includes at least one -F, and
the substituted C₅-C₆₀ carbocyclic group and the substituted C₁-C₆₀ heterocyclic group are substituted with one or more substituents selected from:
   deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
   a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, and a terphenyl group;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, and a terphenyl group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, a terphenyl group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and - P(=O)(Q₂₁)(Q₂₂); and
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
   wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group,
   * indicates a binding site to an adjacent atom; and (i) at least one of R₁₂ and R₁₄ is selected from a substituted or unsubstituted fluorine-containing C₅-C₆₀ carbocyclic group and a substituted or unsubstituted fluorine-containing C₁-C₆₀ heterocyclic group or (ii) at least one of R₁₂ and R₁₄ is selected from groups represented by Formulae 7-1 to 7-77: 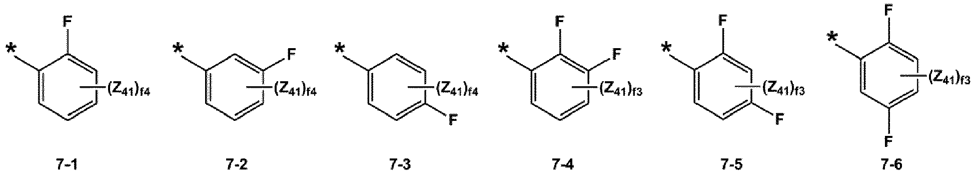 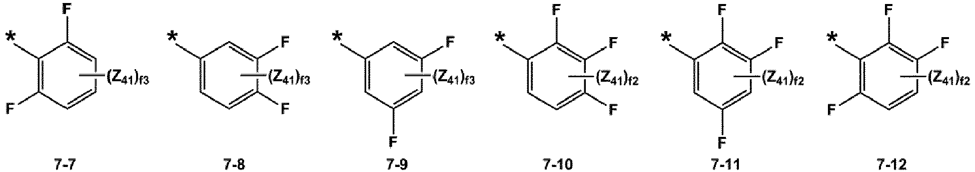 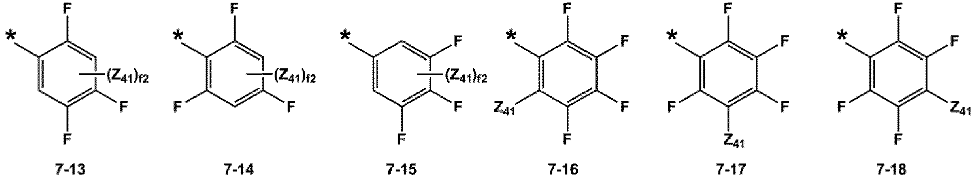 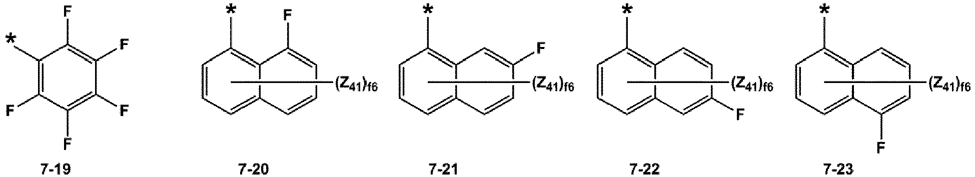 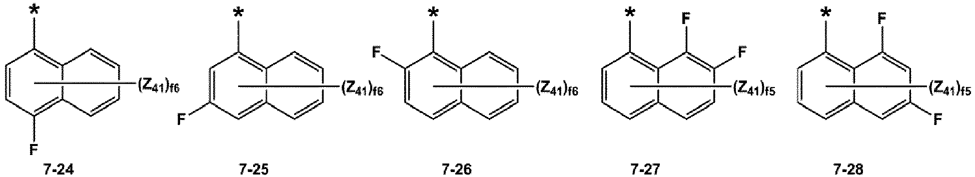 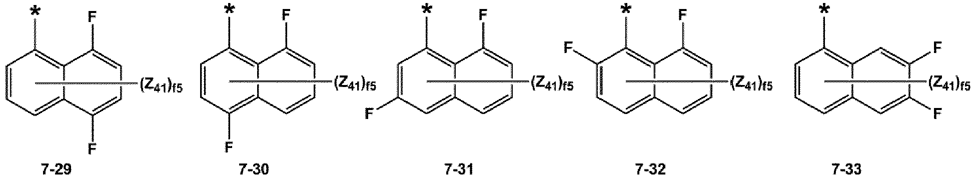 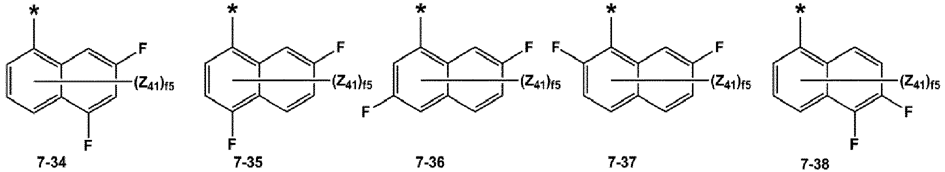 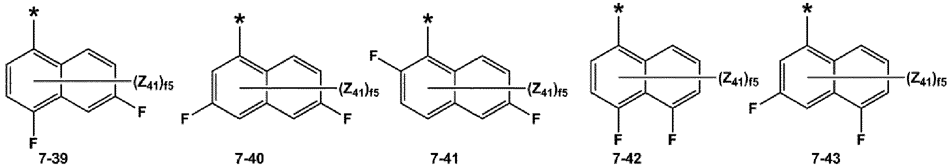 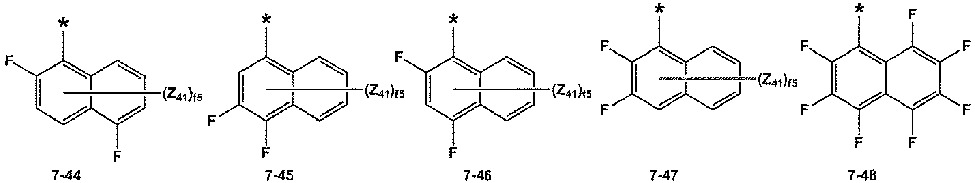 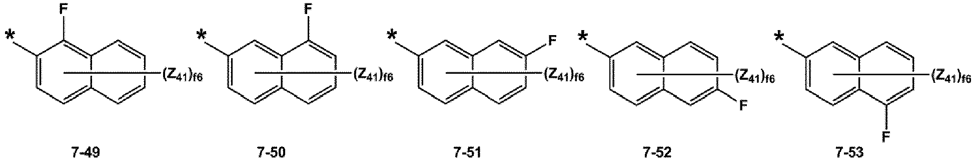 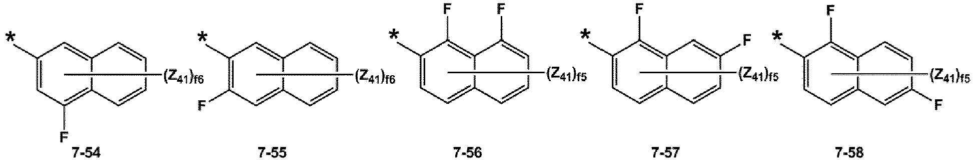 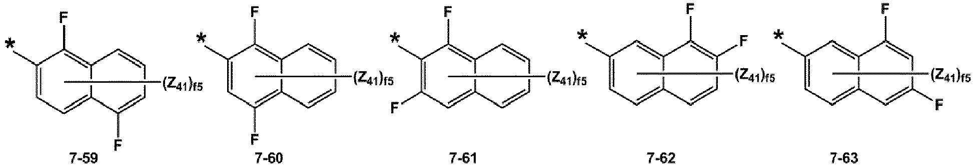 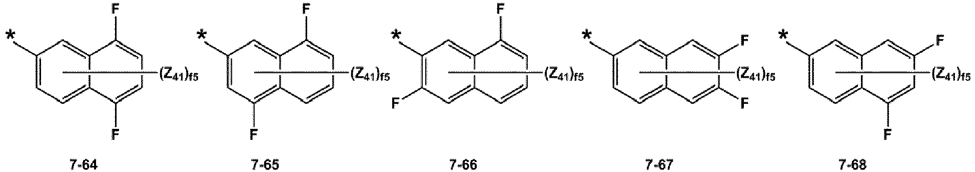 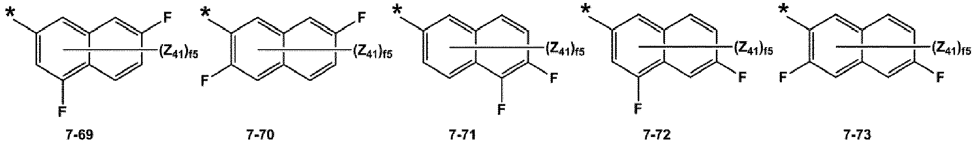 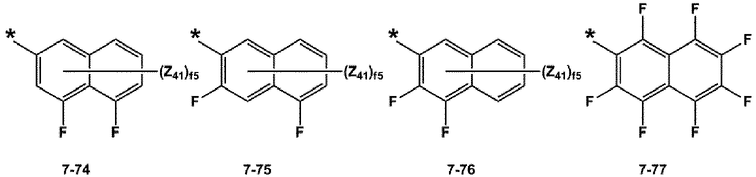
   wherein, in Formulae 7-1 to 7-77,
   Z₄₁ is selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a spiro-fluorene-benzofluorenyl group, a benzofluorenyl group, a dibenzofluorenyl group, a phenalenyl group, a phenanthrenyl group, an anthracenyl group, a fluoranthenyl group, a triphenylenyl group, a pyridinyl group, a pyrazinyl group, a pyrimidinyl group, a quinolinyl group, an isoquinolinyl group, a benzoquinolinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, and - Si(Q₃₁)(Q₃₂)(Q₃₃),
   f2 is an integer selected from 1 and 2; when f2 is 2, at least two Z₄₁ groups are identical to or different from each other,
   f3 is an integer from 1 to 3; when f3 is 2 or greater, at least two Z₄₁ groups are identical to or different from each other,
   f4 is an integer from 1 to 4; when f4 is 2 or greater, at least two Z₄₁ groups are identical to or different from each other,
   f5 is an integer from 1 to 5; when f5 is 2 or greater, at least two Z₄₁ groups are identical to or different from each other,
   f6 is an integer from 1 to 6; when f6 is 2 or greater, at least two Z₄₁ groups are identical to or different from each other,
   Q₃₁ to Q₃₃ are each independently selected from hydrogen, deuterium, -F, -Cl, - Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group, and
   * indicates a binding site to an adjacent atom.

According to one or more embodiments, an organic light-emitting device comprises: a first electrode; a second electrode facing the first electrode; and an organic layer disposed between the first electrode and the second electrode, wherein the organic layer comprises an emission layer and at least one of the heterocyclic compound described above.

### BRIEF DESCRIPTION OF THE DRAWINGS

FIG. 1 is schematic view of an organic light-emitting device according to an embodiment;
FIG. 2 is schematic view of an organic light-emitting device according to an embodiment;
FIG. 3 is schematic view of an organic light-emitting device according to an embodiment; and
FIG. 4 is schematic view of an organic light-emitting device according to an embodiment.

### DETAILED DESCRIPTION

Reference will now be made in more detail to embodiments, examples of which are illustrated in the accompanying drawings, wherein like reference numerals refer to like elements throughout.

A heterocyclic compound of the present invention is represented by Formula 1: 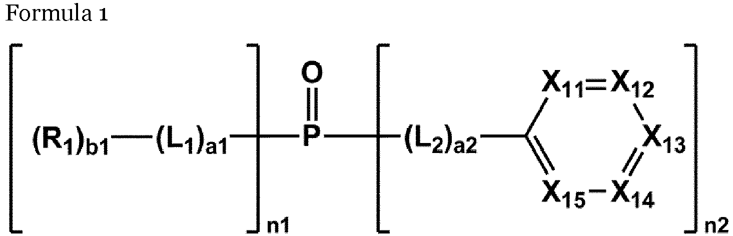
wherein, in Formula 1, X₁₁, X₁₂, X₁₃, X₁₄, X₁₅, n1, n2, a1, a2, b1, L₁, L₂, and R₁ are as defined in claim 1.
X₁₁, X₁₃, and X₁₅ are each be N, X₁₂ is C-[(L₁₂)ₐ₁₂-(R₁₂)_{b12}], and X₁₄ is C-[(L₁₄)ₐ₁₄-(R₁₄)_{b14}].
In Formula 1, n1 is selected from 0, 1, and 2, and n2 is selected from 1, 2, and 3, wherein a sum of ni+n2 is 3.

In some embodiments, n1 may be 0, and n2 may be 3; n1 may be 1, and n2 may be 2; or n1 may be 2, and n2 may be 1.

In some embodiments, n1 may be 2, and n2 may be 1, but embodiments are not limited thereto.

n1 represents the number of substituent(s) represented by *-[(L₁)ₐ₁-(R₁)_{b1}]; when n1 is 2, at least two substituents represented by *-[(L₁)ₐ₁-(R₁)_{b1}] may be identical to or different from each other. Descriptions for n2 may be understood by referring to the descriptions for n1 provided herein.

L₁, L₂, L₁₂, L₁₄, R₁, R₁₂ and R₁₄ are each independently selected from a substituted or unsubstituted C₅-C₆₀ carbocyclic group and a substituted or unsubstituted C₁-C₆₀ heterocyclic group.
In some embodiments, L₁, L₂, L₁₂, L₁₄, R₁, R₁₂ and R₁₄ may each independently be selected from:
a benzene group, a pentalene group, an indene group, a naphthalene group, an azulene group, a heptalene group, an indacene group, an acenaphthalene group, a fluorene group, a spiro-fluorene group, a benzofluorene group, a phenalene group, a phenanthrene group, an anthracene group, a fluoranthene group, a triphenylene group, a pyrene group, a chrysene group, a naphthacene group, a picene group, a perylene group, a pentaphenylene group, a hexacene group, a pyrrole group, an imidazole group, a pyrazole group, a pyridine group, a pyrazine group, a pyrimidine group, a pyridazine group, an isoindole group, an indole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzoxazole group, a benzimidazole group, a furan group, a benzofuran group, a thiophene group, a benzothiophene group, a thiazole group, an isothiazole group, a benzothiazole group, an isoxazole group, an oxazole group, a triazole group, a tetrazole group, an oxadiazole group, a triazine group, a benzoxazole group, a dibenzofuran group, a dibenzothiophene group, a benzocarbazole group, and a dibenzocarbazole group; and
a benzene group, a pentalene group, an indene group, a naphthalene group, an azulene group, a heptalene group, an indacene group, an acenaphthalene group, a fluorene group, a spiro-fluorene group, a benzofluorene group, a phenalene group, a phenanthrene group, an anthracene group, a fluoranthene group, a triphenylene group, a pyrene group, a chrysene group, a naphthacene group, a picene group, a perylene group, a pentaphenylene group, a hexacene group, a pyrrole group, an imidazole group, a pyrazole group, a pyridine group, a pyrazine group, a pyrimidine group, a pyridazine group, an isoindole group, an indole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzoxazole group, a benzimidazole group, a furan group, a benzofuran group, a thiophene group, a benzothiophene group, a thiazole group, an isothiazole group, a benzothiazole group, an isoxazole group, an oxazole group, a triazole group, a tetrazole group, an oxadiazole group, a triazine group, a benzoxazole group, a dibenzofuran group, a dibenzothiophene group, a benzocarbazole group, and a dibenzocarbazole group, each substituted with at least one selected from deuterium, -F, -Cl, -Br, -I, a hydroxyl group, a cyano group, a nitro group, an amino group, an amidino group, a hydrazino group, a hydrazono group, a C₁-C₂₀ alkyl group, a C₁-C₂₀ alkoxy group, a C₆-C₂₀ aryl group, a C₂-C₂₀ heteroaryl group, and -Si(Q₃₁)(Q₃₂)(Q₃₃), Q₃₁ to Q₃₃ may each independently be selected from hydrogen, deuterium, -F, -Cl, -Br, - I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group,
but embodiments are not limited thereto.

In some embodiments, L₁, L₂, L₁₂, and L₁₄ may each independently be selected from groups represented by Formulae 3-1 to 3-47, but embodiments are not limited thereto: 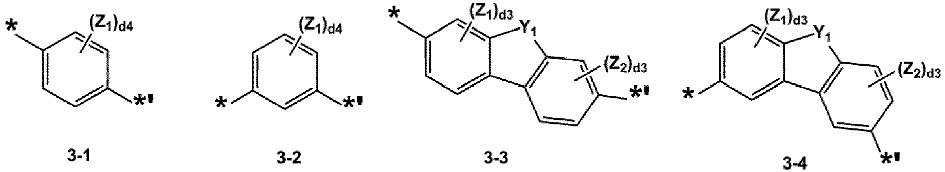 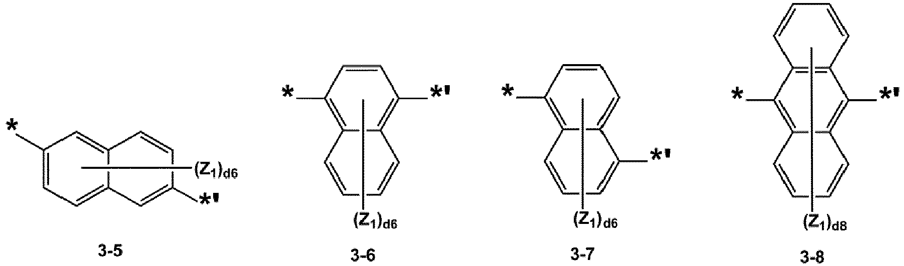 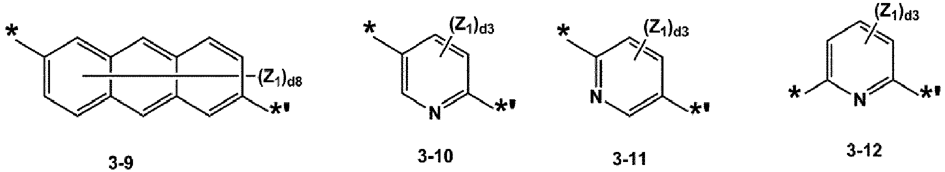 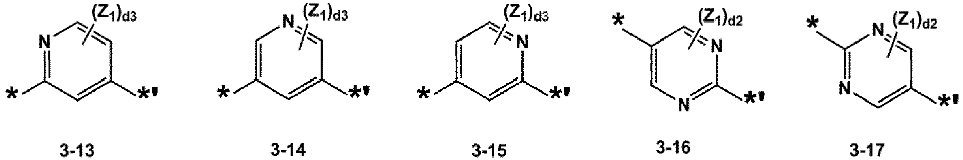 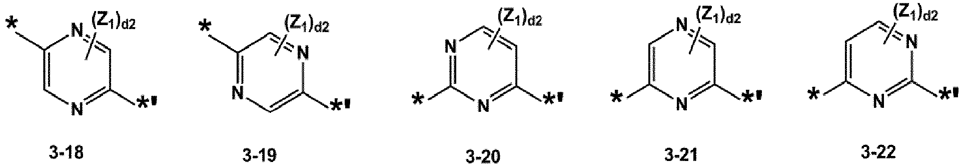 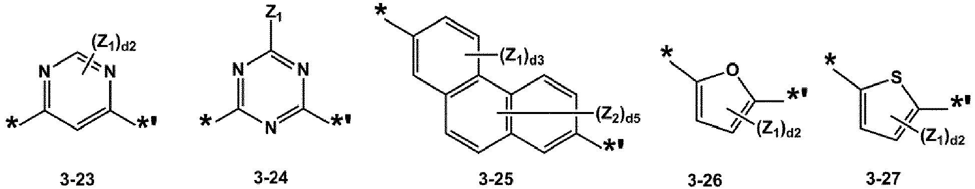 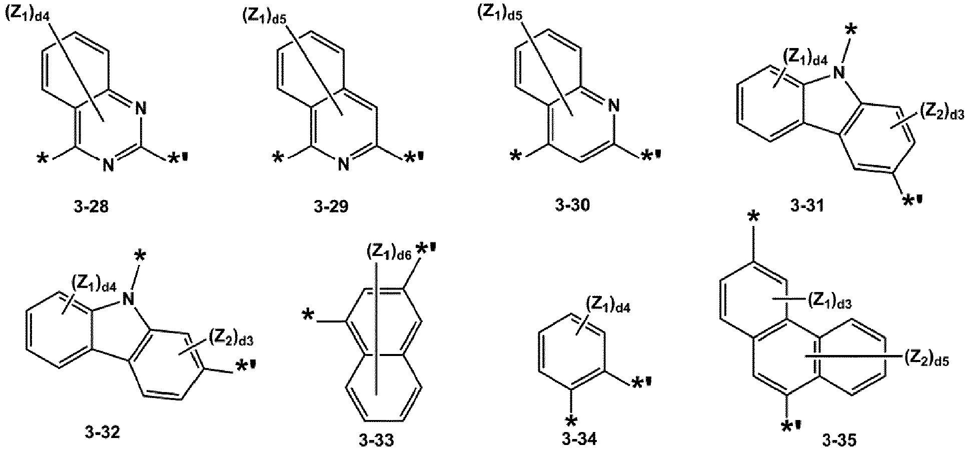 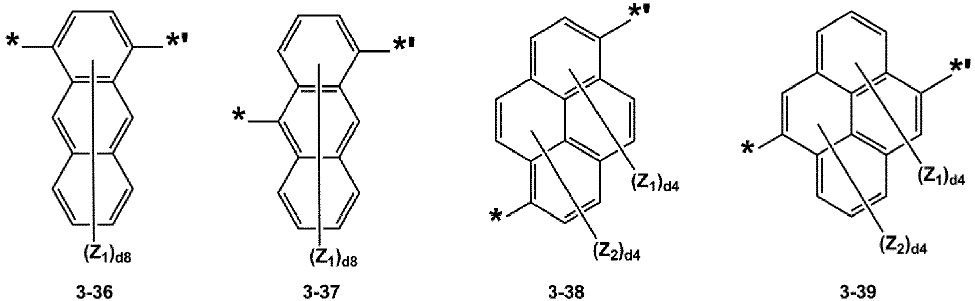 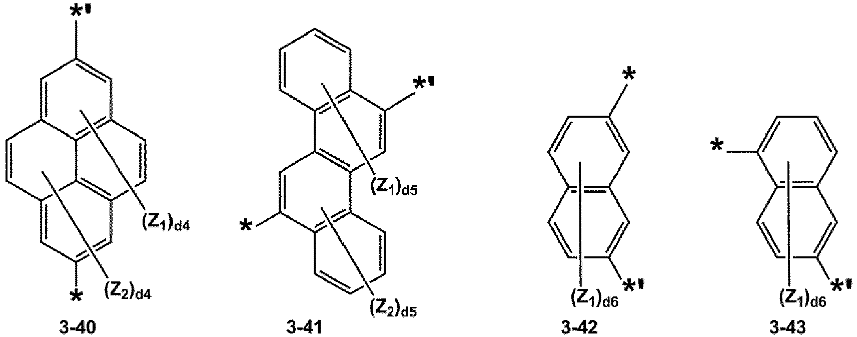 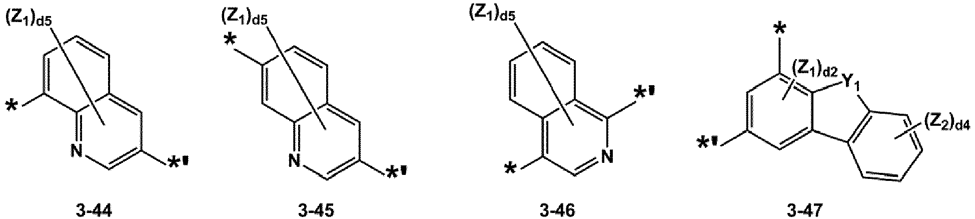
wherein, in Formulae 3-1 to 3-47,
Y₁ may be selected from O, S, C(Z₃)(Z₄), N(Z₅), and Si(Z₆)(Z₇),
   Z₁ to Z₇ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyridinyl group, a pyrazinyl group, a pyrimidinyl group, a quinolinyl group, an isoquinolinyl group, a benzoquinolinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, and - Si(Q₃₁)(Q₃₂)(Q₃₃),
d2 may be an integer from 0 to 2; when d2 is 2, at least two Z₁ groups may be identical to or different from each other,
d3 may be an integer from 0 to 3; when d3 is 2 or greater, at least two Z₁ groups may be identical to or different from each other, and at least two Z₂ groups may be identical to or different from each other,
d4 may be an integer from 0 to 4; when d4 is 2 or greater, at least two Z₁ groups may be identical to or different from each other, and at least two Z₂ groups may be identical to or different from each other,
d5 may be an integer from 0 to 5; when d5 is 2 or greater, at least two Z₁ groups may be identical to or different from each other, and at least two Z₂ groups may be identical to or different from each other,
d6 may be an integer from 0 to 6; when d6 is 2 or greater, at least two Z₁ groups may be identical to or different from each other, and at least two Z₂ groups may be identical to or different from each other,
   d8 may be an integer from 0 to 8; when d8 is 2 or greater, at least two Z₁ groups may be identical to or different from each other, and
* and *' each indicate a binding site to an adjacent atom.

In some embodiments, L₁, L₂, L₁₂, and L₁₄ may each independently be selected from groups represented by Formulae 4-1 to 4-24, but embodiments are not limited thereto: 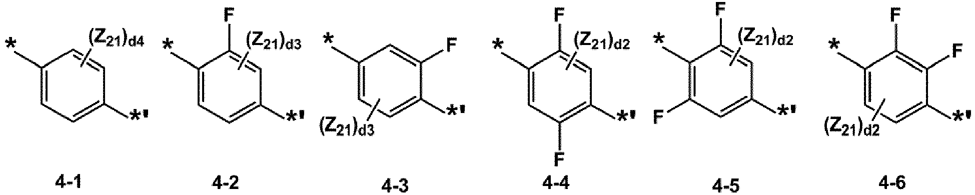 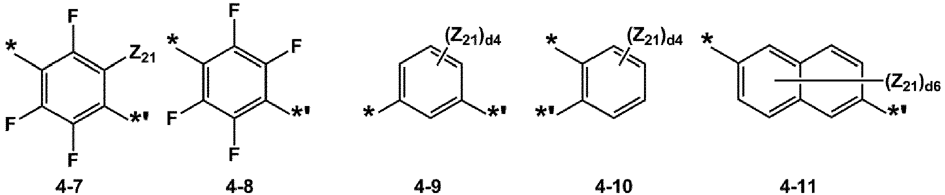 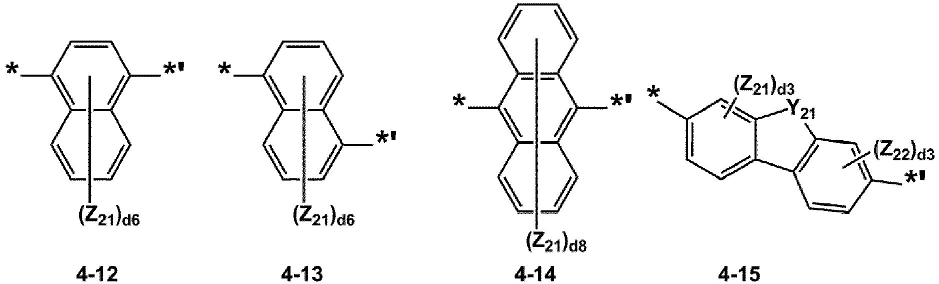 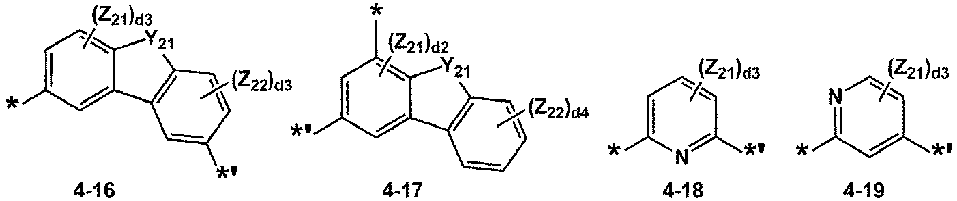 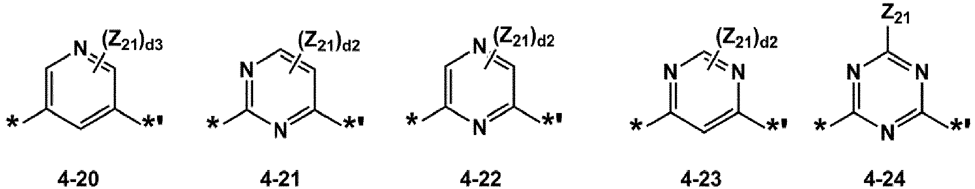
wherein, in Formulae 4-1 to 4-24,
Y₂₁ may be selected from O, S, C(Z₂₃)(Z₂₄), N(Z₂₅), and Si(Z₂₆)(Z₂₇),
Z₂₁ to Z₂₇ may each independently be selected from hydrogen, deuterium, -F, - Cl, -Br, -I, a hydroxyl group, a cyano group, a nitro group, a C₁-C₂₀ alkyl group, a C₁-C₂₀ alkoxy group, a phenyl group, and a naphthyl group,
d2 may be an integer from 0 to 2; when d2 is 2, at least two Z₂₁ groups may be identical to or different from each other,
d3 may be an integer from 0 to 3; when d3 is 2 or greater, at least two Z₂₁ groups may be identical to or different from each other, and at least two Z₂₂ groups may be identical to or different from each other,
d4 may be an integer from 0 to 4; when d4 is 2 or greater, at least two Z₂₁ groups may be identical to or different from each other, and at least two Z₂₂ groups may be identical to or different from each other,
d6 may be an integer from 0 to 6; when d6 is 2 or greater, at least two Z₂₁ groups may be identical to or different from each other,
d8 may be an integer from 0 to 8; when d8 is 2 or greater, at least two Z₂₁ groups may be identical to or different from each other, and
* and *' each indicate a binding site to an adjacent atom.

In Formula 1, a1, a2, a12 and a14 are each independently an integer from 0 to 5, but embodiments are not limited thereto.

a1 indicates the number of L₁ groups; when a1 is 2 or greater, at least two L₁ groups may be identical to or different from each other. Descriptions for a2 and a12 and a14 may each be understood by referring to the descriptions for a1 provided herein. When a1 is 0, *-(L₁)ₐ₁-*' is a single bond; when a2 is 0, *-(L₂)ₐ₂-*' is a single bond; when a12 is 0, *-(L₁₂)ₐ₁₂-*' is a single bond; and when a14 is 0, *-(L₁₄)ₐ₁₄-*' is a single bond.

In some embodiments, a1 may be 0, but embodiments are not limited thereto.

In some embodiments, a2 may be 0, 1, 2, 3, or 4, but embodiments are not limited thereto.

In some embodiments, a12 and a14 may each independently be 0, 1, or 2, but embodiments are not limited thereto.

In some embodiments, a1 may be 0, a2 may be 0, 1, 2, 3, or 4, and a12 and a14 may each independently be 0, 1, or 2, but embodiments are not limited thereto. In some embodiments, R₁, R₁₂ and R₁₄ may each independently be selected from groups represented by Formulae 5-1 to 5-79, but embodiments are not limited thereto: 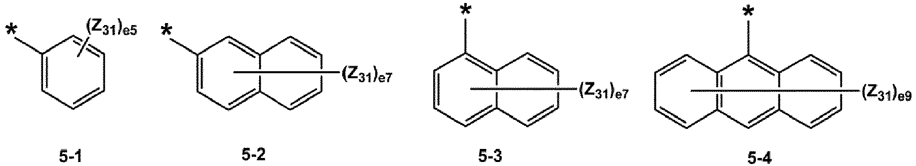 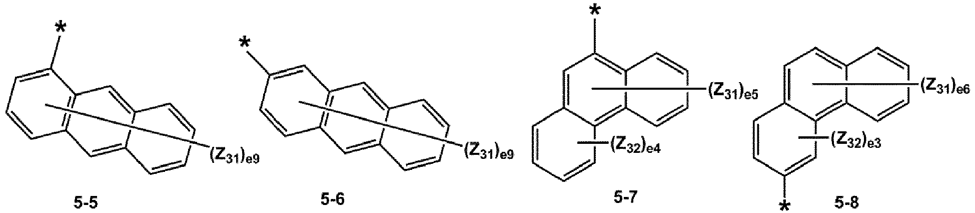 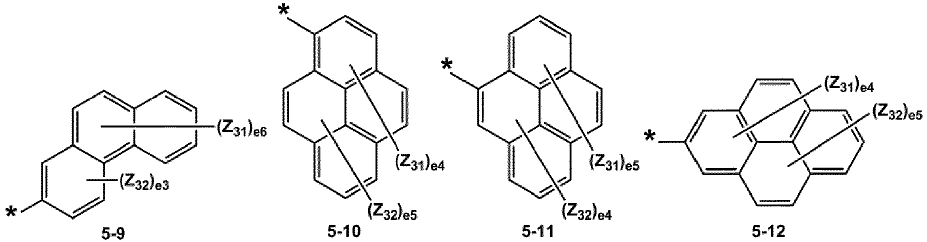 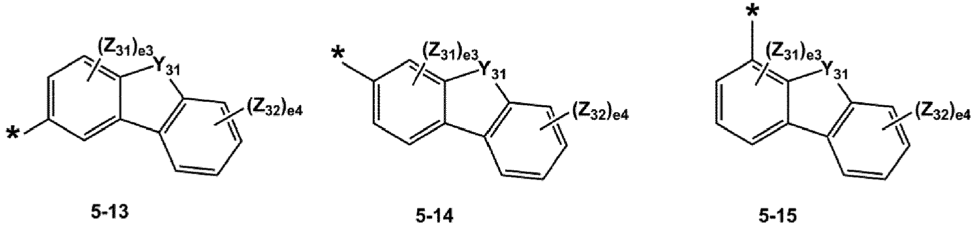 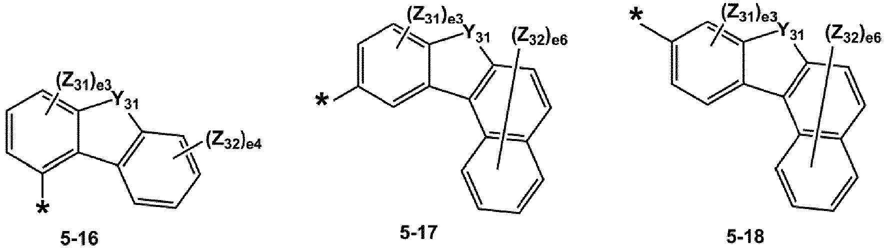 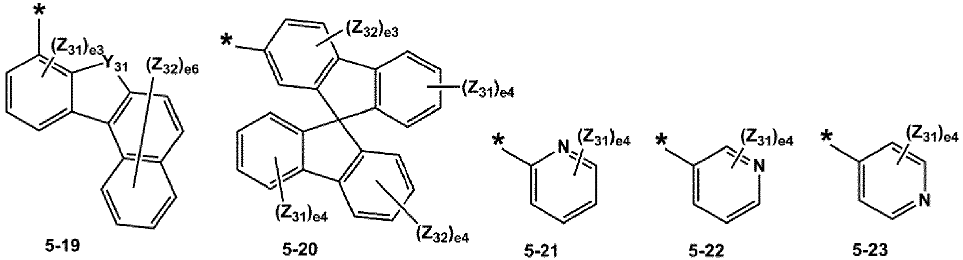 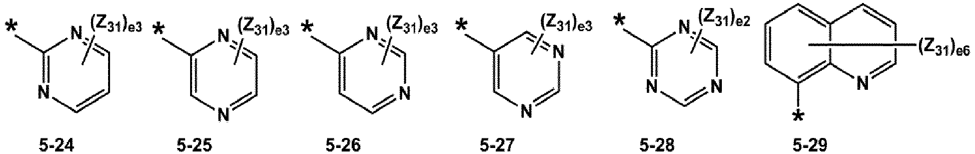 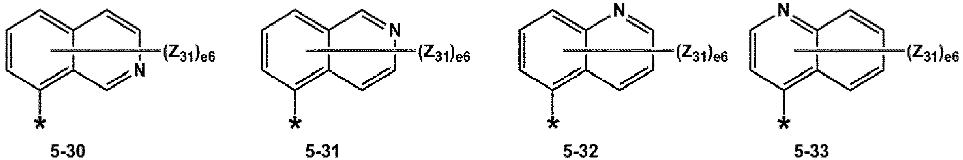 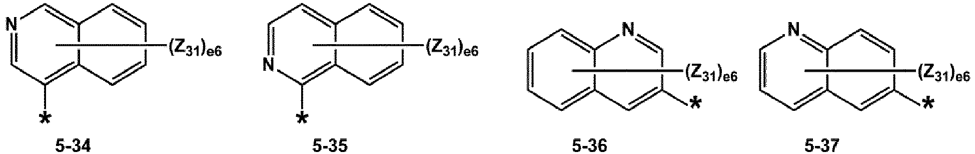 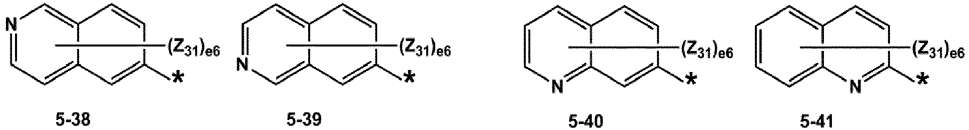 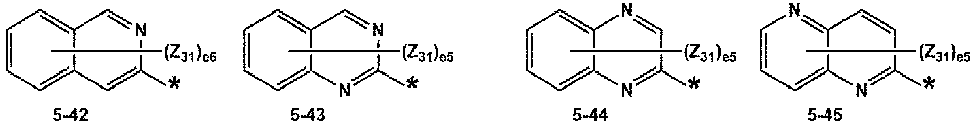 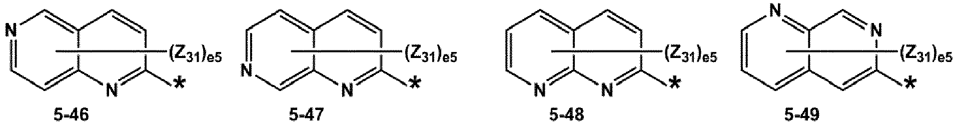 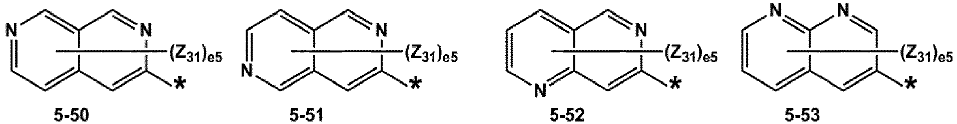 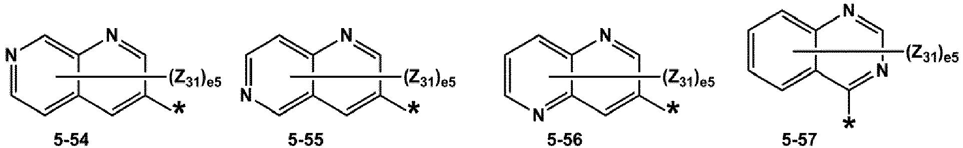 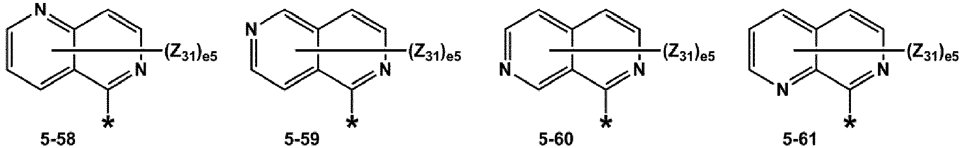 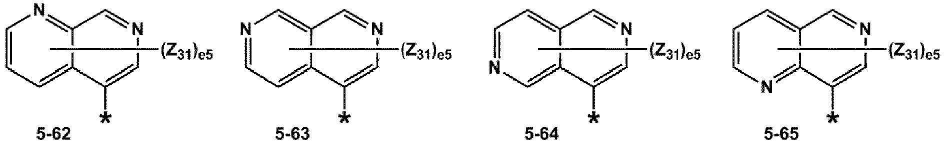 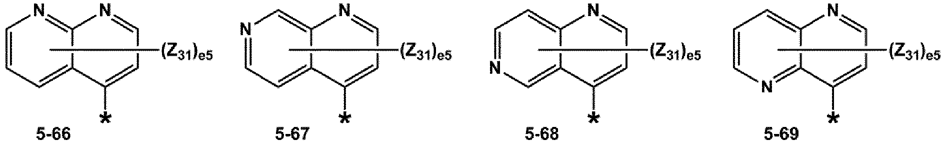 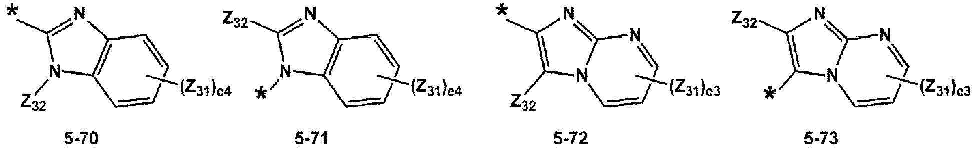 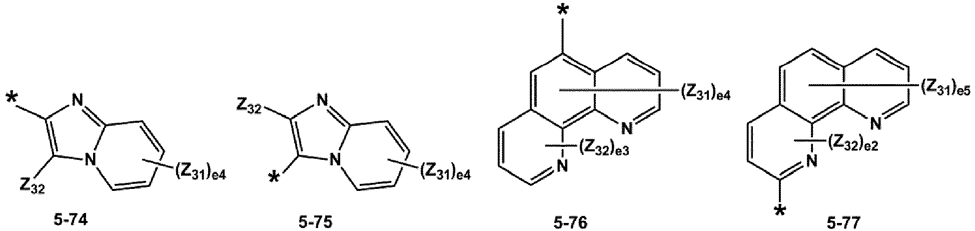 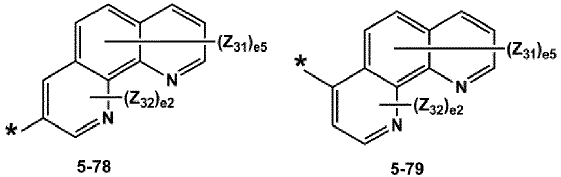
wherein, in Formulae 5-1 to 5-79,
Y₃₁ may be selected from O, S, C(Z₃₃)(Z₃₄), N(Z₃₅), and Si(Z₃₆)(Z₃₇),
Z₃₁ to Z₃₇ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a spiro-fluorene-benzofluorenyl group, a benzofluorenyl group, a dibenzo fluorenyl group, a phenalenyl group, a phenanthrenyl group, an anthracenyl group, a fluoranthenyl group, a triphenylenyl group, a pyridinyl group, a pyrazinyl group, a pyrimidinyl group, a quinolinyl group, an isoquinolinyl group, a benzoquinolinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, and -Si(Q₃₁)(Q₃₂)(Q₃₃),
e2 may be an integer from 0 to 2; when e2 is 2, at least two Z₃₁ groups may be identical to or different from each other, and at least two Z₃₂ groups may be identical to or different from each other,
e3 may be an integer from 0 to 3; when e3 is 2 or greater, at least two Z₃₁ groups may be identical to or different from each other, and at least two Z₃₂ groups may be identical to or different from each other,
e4 may be an integer from 0 to 4; when e4 is 2 or greater, at least two Z₃₁ groups may be identical to or different from each other, and at least two Z₃₂ groups may be identical to or different from each other,
e5 may be an integer from 0 to 5; when e5 is 2 or greater, at least two Z₃₁ groups may be identical to or different from each other, and at least two Z₃₂ groups may be identical to or different from each other,
e6 may be an integer from 0 to 6; when e6 is 2 or greater, at least two Z₃₁ groups may be identical to or different from each other, and at least two Z₃₂ groups may be identical to or different from each other,
e7 may be an integer from 0 to 7; when e7 is 2 or greater, at least two Z₃₁ groups may be identical to or different from each other,
e9 may be an integer from 0 to 9; when e9 is 2 or greater, at least two Z₃₁ groups may be identical to or different from each other, and
* indicates a binding site to an adjacent atom.

In some embodiments, R₁ may be selected from a benzene group and a naphthalene group; and
a benzene group and a naphthalene group, each substituted with at least one selected from -F, -Cl, -Br, -I, a hydroxyl group, a cyano group, a nitro group, an amino group, an amidino group, a hydrazino group, a hydrazono group, a C₁-C₂₀ alkyl group, a C₁-C₂₀ alkoxy group, a phenyl group, and a naphthyl group, but embodiments are not limited thereto.
b1, b12 and b14 may each independently be an integer from 1 to 10.
b1 indicates the number of R₁ groups; when b1 is 2 or greater, at least two R₁ groups may be identical to or different from each other. Descriptions for b12 and b14 may each be understood by referring to the descriptions for b1 provided herein.
In Formula 1, two adjacent groups selected from L₁, L₂, L₁₂, L₁₄, R₁, R₁₂ and R₁₄ may optionally be bound to form a substituted or unsubstituted C₅-C₆₀ carbocyclic group or a substituted or unsubstituted C₁-C₆₀ heterocyclic group.
In some embodiments, the heterocyclic compound may be represented by Formula 1-2 or 1-3: 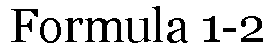 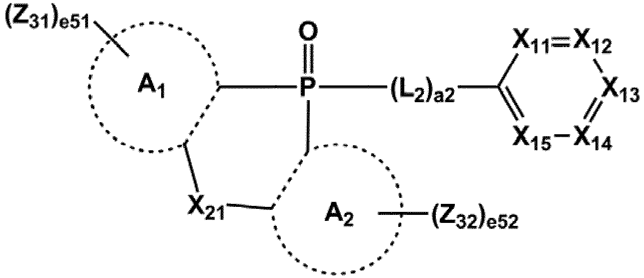 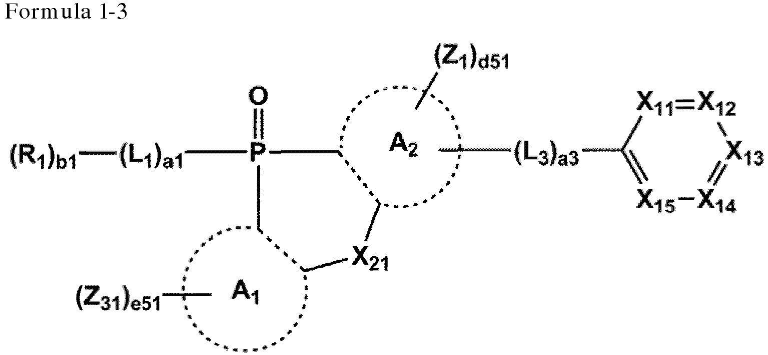
wherein, in Formulae 1-2 and 1-3,
   A₁ and A₂ may each independently be selected from a C₅-C₆₀ carbocyclic group and a C₁-C₆₀ heterocyclic group,
X₂₁ may be selected from a single bond, C(R₂₁)(R₂₂), N(R₂₁), O, S, and Si(R₂₁)(R₂₂),
descriptions for L₃ may be understood by referring to the descriptions for L₁ in Formula 1,
descriptions for a3 may be understood by referring to the descriptions for a1 in Formula 1,
R₂₁, R₂₂, Z₁, Z₃₁, and Z₃₂ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
e51, e52, and d51 may each independently be an integer from 1 to 10, and X₁₁ to X₁₅, L₁, L₂, a1, a2, R₁, and b1 may respectively be defined the same as those of Formula 1.

The heterocyclic compound represented by Formula 1 includes at least one -F.

In other words, at least one of L₁, L₂, L₁₂, L₁₄, R₁, R₁₂ and R₁₄ may include a substituted or unsubstituted fluorine-containing C₅-C₆₀ carbocyclic group and a substituted or unsubstituted fluorine-containing C₁-C₆₀ heterocyclic group.
The number of -F(s) included in the heterocyclic compound represented by Formula 1 may be an integer from 1 to 20, but embodiments are not limited thereto.
In some embodiments, the number of -F(s) included in the heterocyclic compound may be 1, 2, 3, 4, or 6, but embodiments are not limited thereto.

In some embodiments, at least one of R₁₂ and R₁₄ may be selected from a substituted or unsubstituted fluorine-containing C₅-C₆₀ carbocyclic group and a substituted or unsubstituted fluorine-containing C₁-C₆₀ heterocyclic group.

In some embodiments, at least one of R₁₂ and R₁₄ may be a substituted or unsubstituted fluorine-containing C₅-C₆₀ carbocyclic group.

In some embodiments, R₁₂ and R₁₄ may each independently be selected from a benzene group, a pentalene group, an indene group, a naphthalene group, an azulene group, a heptalene group, an indacene group, an acenaphthalene group, a fluorene group, a spiro-fluorene group, a benzofluorene group, a phenalene group, a phenanthrene group, an anthracene group, a fluoranthene group, a triphenylene group, a pyrene group, a chrysene group, a naphthacene group, a picene group, a perylene group, a pentaphenylene group, a hexacene group, a pyrrole group, an imidazole group, a pyrazole group, a pyridine group, a pyrazine group, a pyrimidine group, a pyridazine group, an isoindole group, an indole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzoxazole group, a benzimidazole group, a furan group, a benzofuran group, a thiophene group, a benzothiophene group, a thiazole group, an isothiazole group, a benzothiazole group, an isoxazole group, an oxazole group, a triazole group, a tetrazole group, an oxadiazole group, a triazine group, a benzoxazole group, a dibenzofuran group, a dibenzothiophene group, a benzocarbazole group, and a dibenzocarbazole group; and
a benzene group, a pentalene group, an indene group, a naphthalene group, an azulene group, a heptalene group, an indacene group, an acenaphthalene group, a fluorene group, a spiro-fluorene group, a benzofluorene group, a phenalene group, a phenanthrene group, an anthracene group, a fluoranthene group, a triphenylene group, a pyrene group, a chrysene group, a naphthacene group, a picene group, a perylene group, a pentaphenylene group, a hexacene group, a pyrrole group, an imidazole group, a pyrazole group, a pyridine group, a pyrazine group, a pyrimidine group, a pyridazine group, an isoindole group, an indole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzoxazole group, a benzimidazole group, a furan group, a benzofuran group, a thiophene group, a benzothiophene group, a thiazole group, an isothiazole group, a benzothiazole group, an isoxazole group, an oxazole group, a triazole group, a tetrazole group, an oxadiazole group, a triazine group, a benzoxazole group, a dibenzofuran group, a dibenzothiophene group, a benzocarbazole group, and a dibenzocarbazole group, each substituted with at least one selected from deuterium, -F, -Cl, -Br, -I, a hydroxyl group, a cyano group, a nitro group, an amino group, an amidino group, a hydrazino group, a hydrazono group, a C₁-C₂₀ alkyl group, a C₁-C₂₀ alkoxy group, a C₆-C₂₀ aryl group, a C₂-C₂₀ heteroaryl group, and -Si(Q₃₁)(Q₃₂)(Q₃₃), wherein at least one of R₁₂(s) in the number of b12, and R₁₄(s) in the number of b14 may be substituted with at least one -F, but embodiments are not limited thereto.

In some embodiments, at least one of R₁₂(s) in the number of b12 and R₁₄(s) in the number of biqmay be selected from groups represented by Formulae 7-1 to 7-77, but embodiments are not limited thereto: 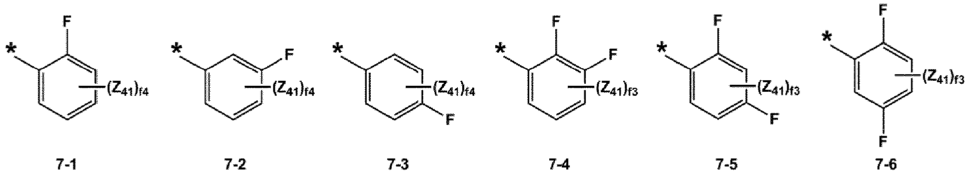 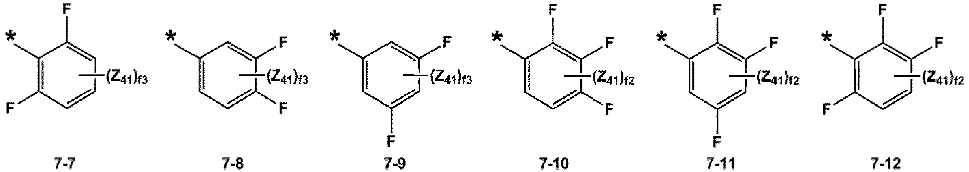 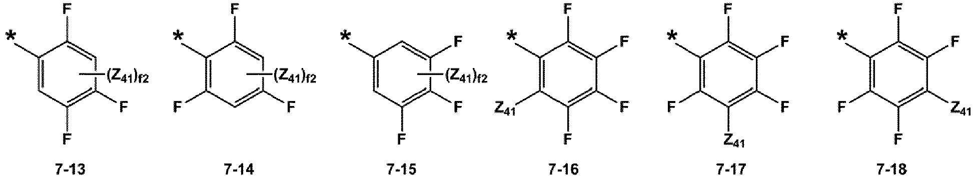 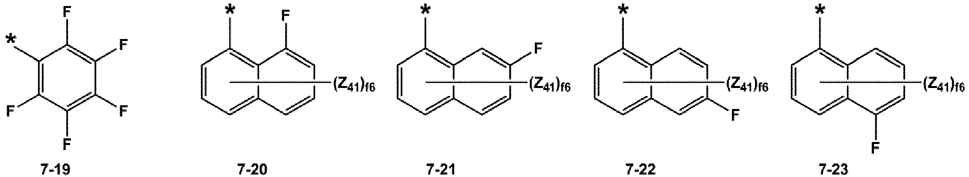 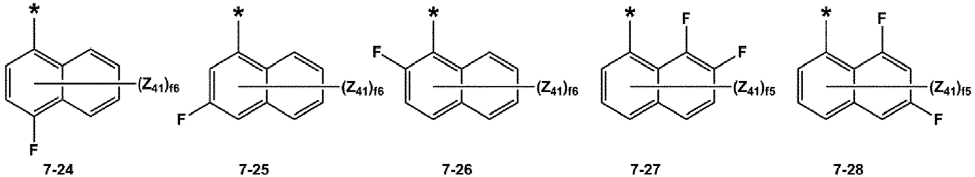 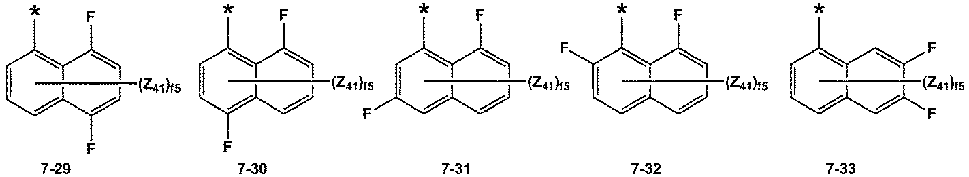 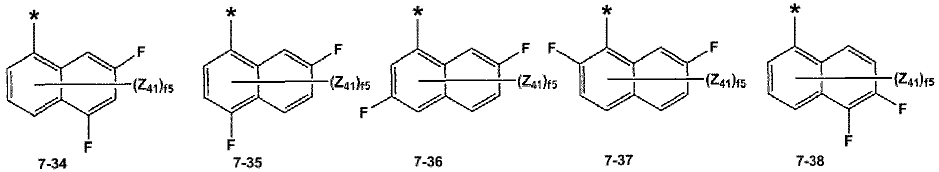 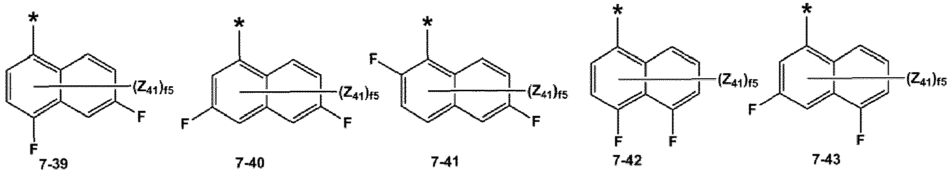 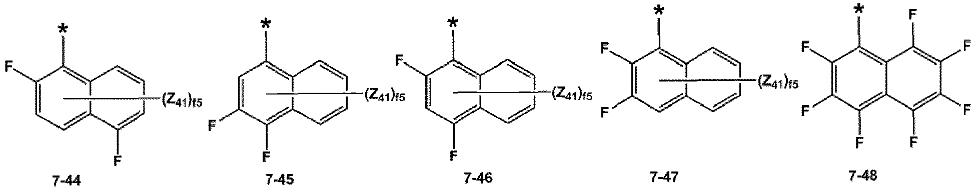 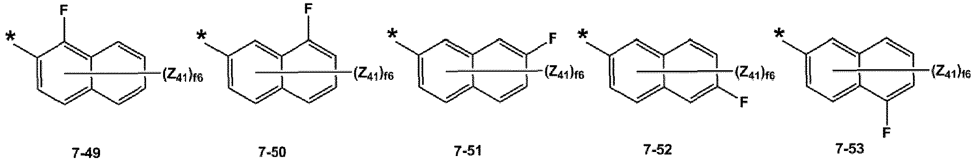 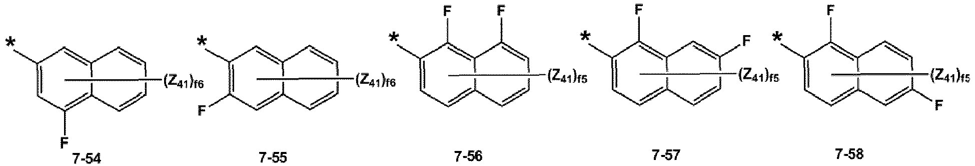 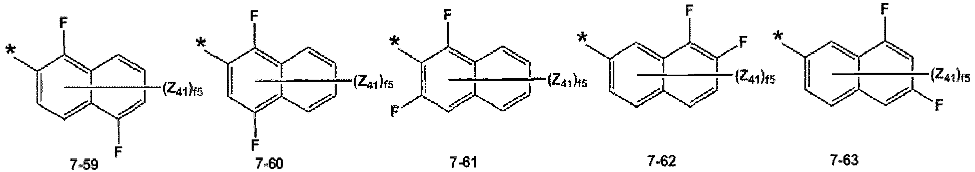 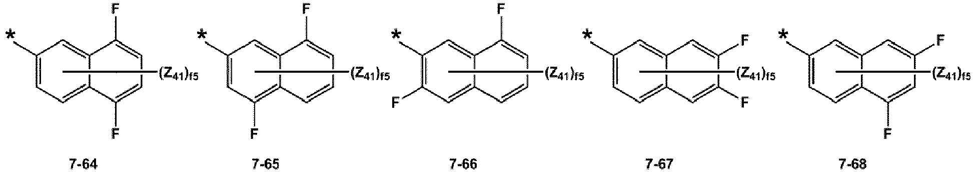 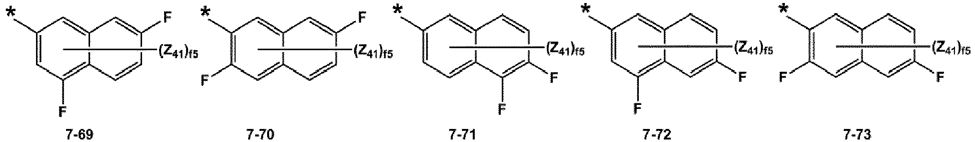 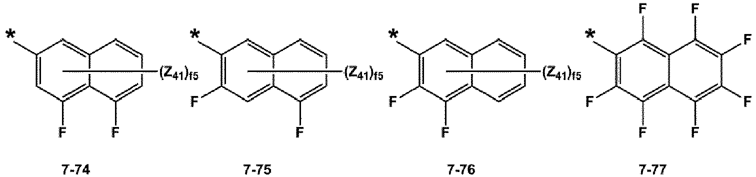
wherein, in Formulae 7-1 to 7-77,
   Z₄₁ may be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a spiro-fluorene-benzofluorenyl group, a benzofluorenyl group, a dibenzofluorenyl group, a phenalenyl group, a phenanthrenyl group, an anthracenyl group, a fluoranthenyl group, a triphenylenyl group, a pyridinyl group, a pyrazinyl group, a pyrimidinyl group, a quinolinyl group, an isoquinolinyl group, a benzoquinolinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, and - Si(Q₃₁)(Q₃₂)(Q₃₃),
f2 may be an integer selected from 1 and 2; when f2 is 2, at least two Z₄₁ groups may be identical to or different from each other,
f3 may be an integer from 1 to 3; when f3 is 2 or greater, at least two Z₄₁ groups may be identical to or different from each other,
f4 may be an integer from 1 to 4; when f4 is 2 or greater, at least two Z₄₁ groups may be identical to or different from each other,
f5 may be an integer from 1 to 5; when f5 is 2 or greater, at least two Z₄₁ groups may be identical to or different from each other,
f6 may be an integer from 1 to 6; when f6 is 2 or greater, at least two Z₄₁ groups may be identical to or different from each other, and
* indicates a binding site to an adjacent atom.

In some embodiments, R₁ may be selected from a benzene group and a naphthalene group; and
a benzene group and a naphthalene group, each substituted with at least one selected from -F, -Cl, -Br, -I, a hydroxyl group, a cyano group, a nitro group, an amino group, an amidino group, a hydrazino group, a hydrazono group, a C₁-C₂₀ alkyl group, a C₁-C₂₀ alkoxy group, a phenyl group, and a naphthyl group, and
at least one of R₁₂(s) in the number of b12, and R₁₄(s) in the number of b14 may be selected from groups represented by Formulae 7-1 to 7-77, but embodiments are not limited thereto:
In some embodiments, X₁₁, X₁₃, and X₁₅ may each be N, X₁₂ may be C-[(L₁₂)ₐ₁₂-(R₁₂)_{b12}], and X₁₄ may be C-[(L₁₄)ₐ₁₄-(R₁₄)_{b14}],
wherein at least one of R₁₂(s) in the number of b12 and R₁₄(s) in the number of b₁₄ may be selected from a substituted or unsubstituted fluorine-containing C₅-C₆₀ carbocyclic group and a substituted or unsubstituted fluorine-containing C₁-C₆₀ heterocyclic group, but embodiments are not limited thereto.
In some embodiments, X₁₁, X₁₃, and X₁₅ may each be N, X₁₂ may be C-[(L₁₂)ₐ₁₂-(R₁₂)_{b12}], and X₁₄ may be C-[(L₁₄)ₐ₁₄-(R₁₄)_{b14}],
at least one of R₁₂(s) in the number of b12 and R₁₄(s) in the number of b12 may be selected from groups represented by Formulae 7-1 to 7-77, but embodiments are not limited thereto:
   In some embodiments, the heterocyclic compound represented by Formula 1 may be selected from Compounds 1 to 132, but embodiments are not limited thereto:

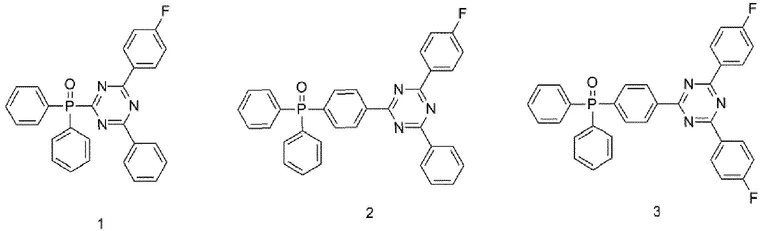

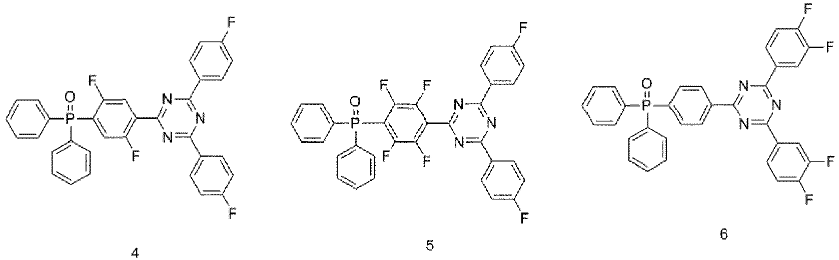

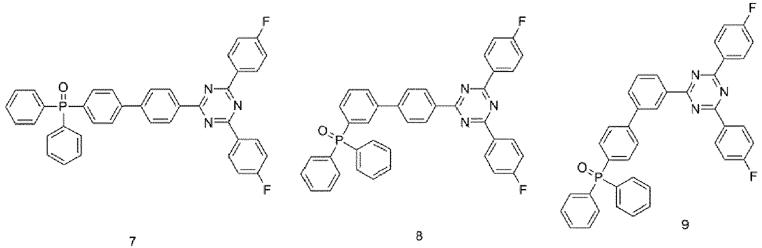

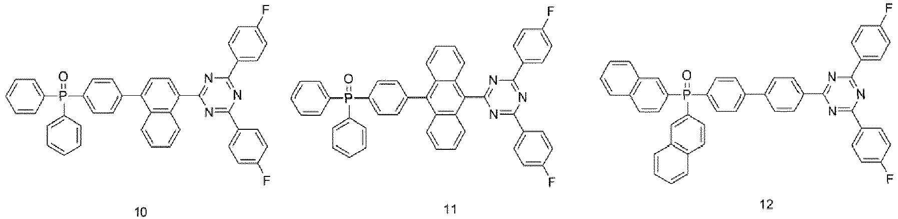

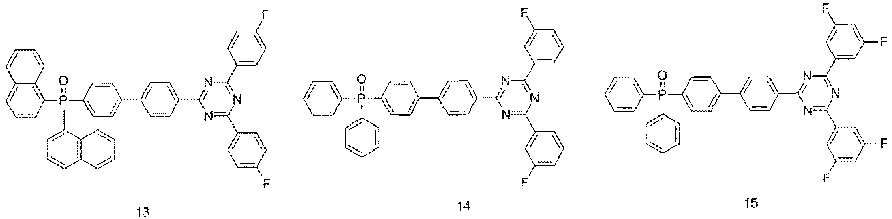

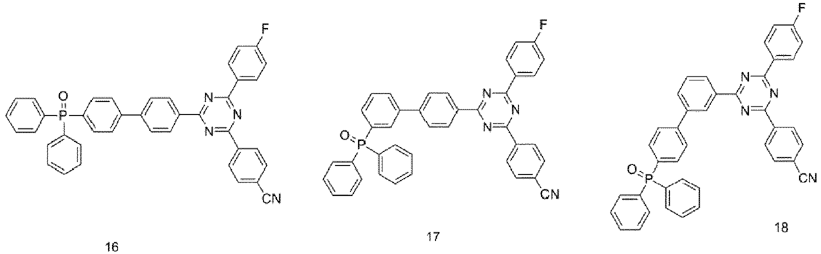

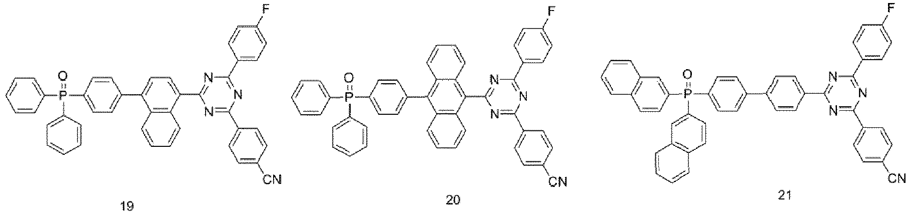

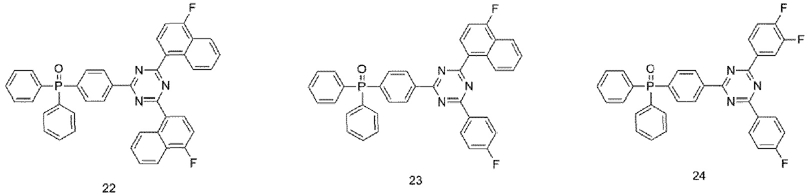

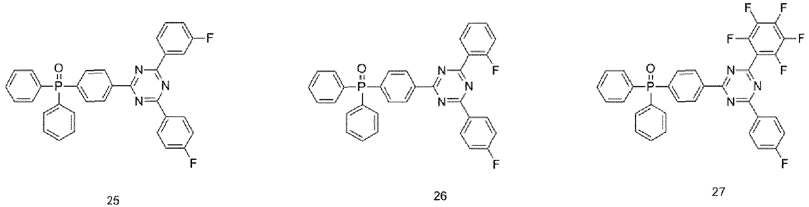

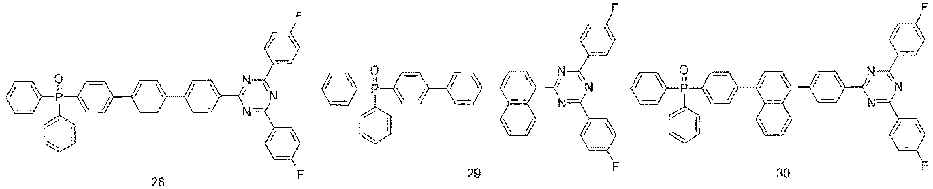

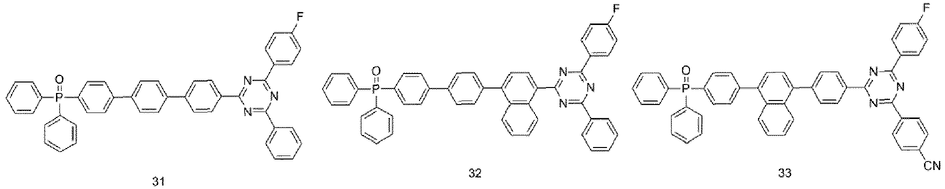

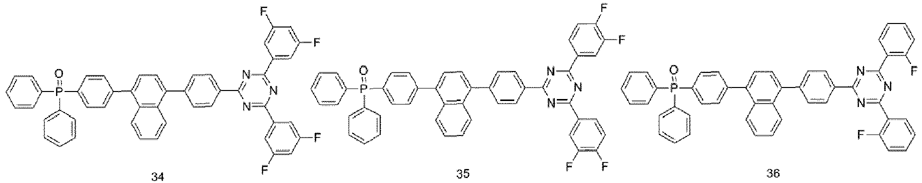

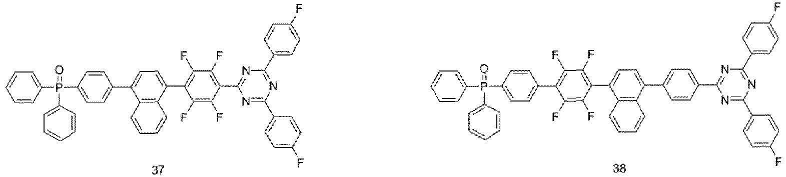

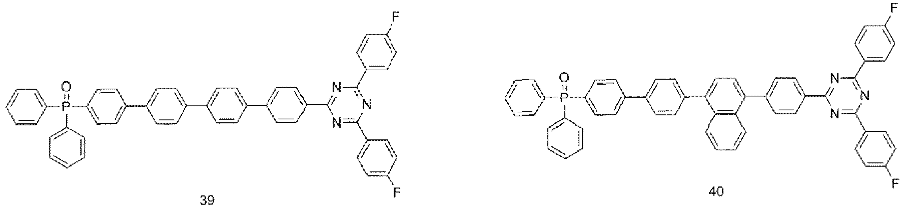

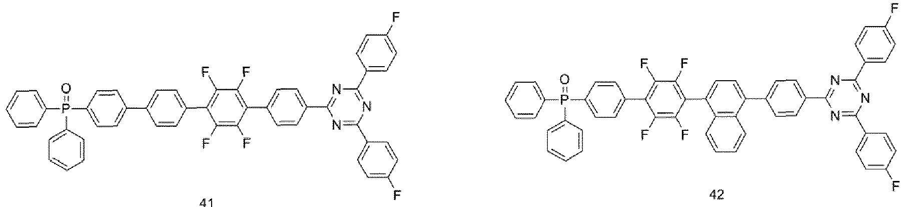

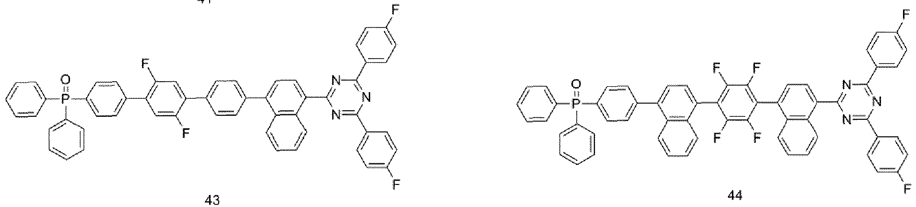

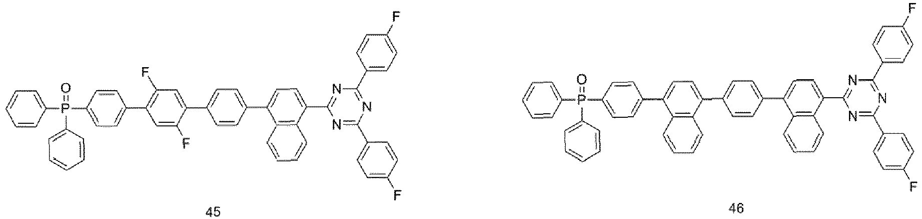

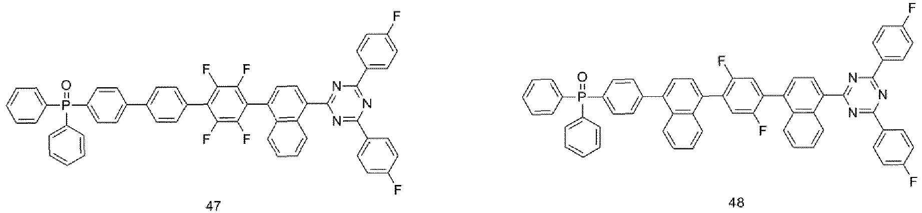

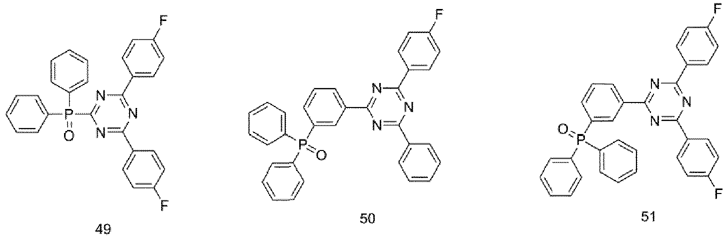

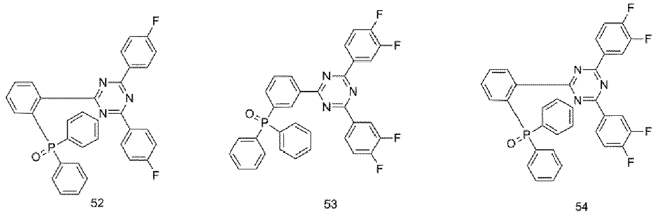

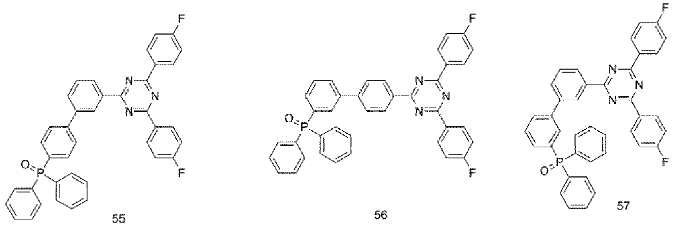

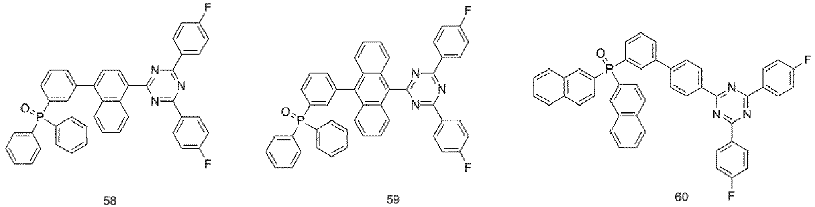

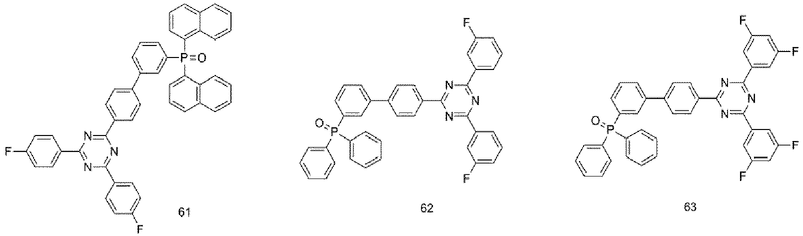

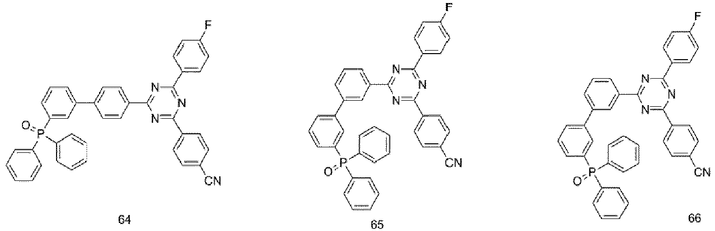

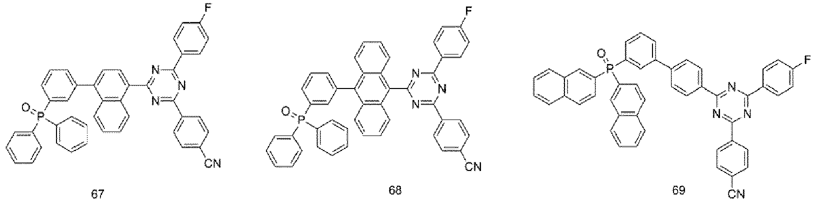

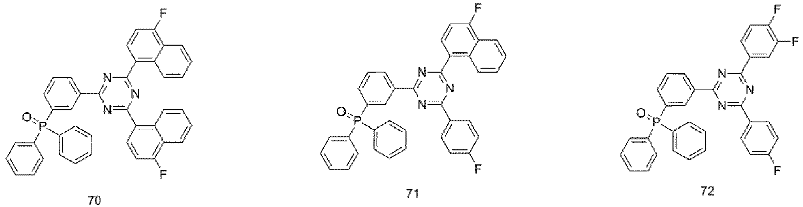

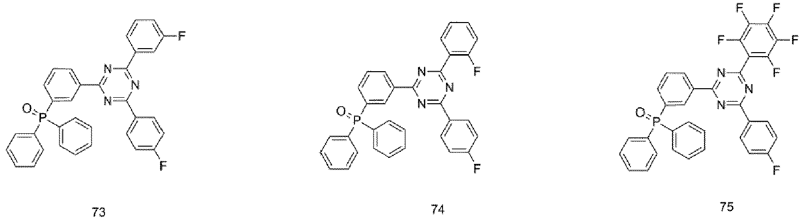

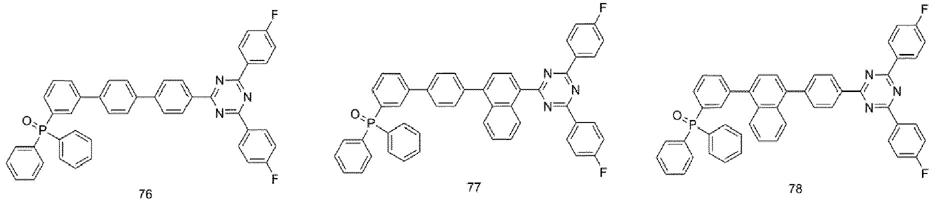

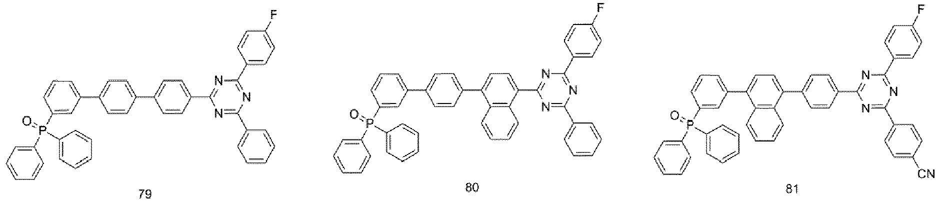

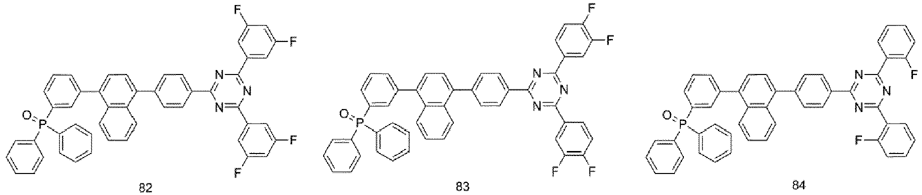

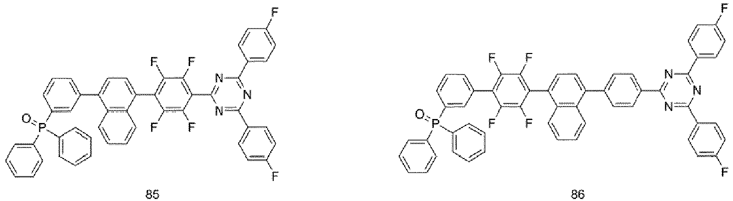

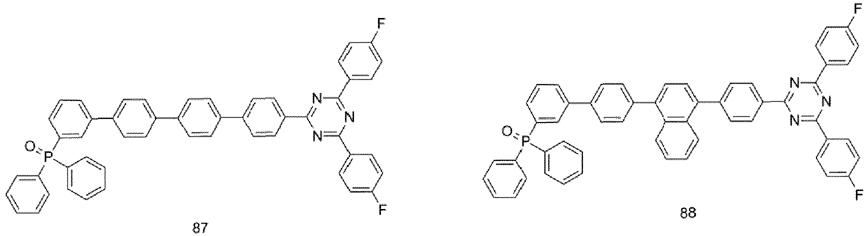

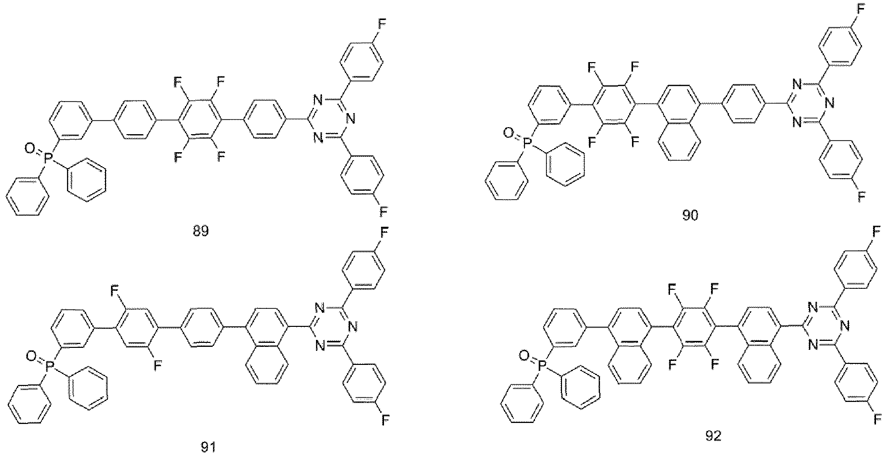

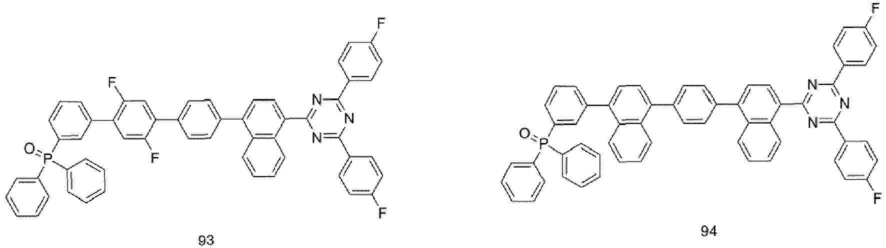

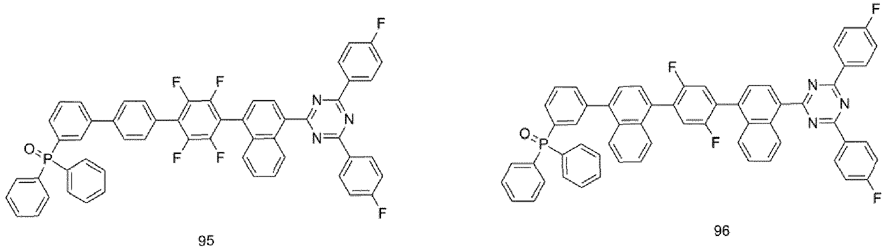

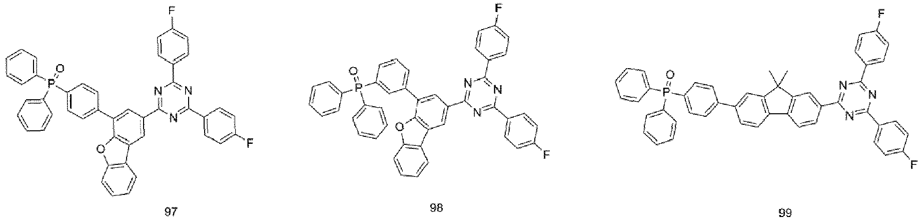

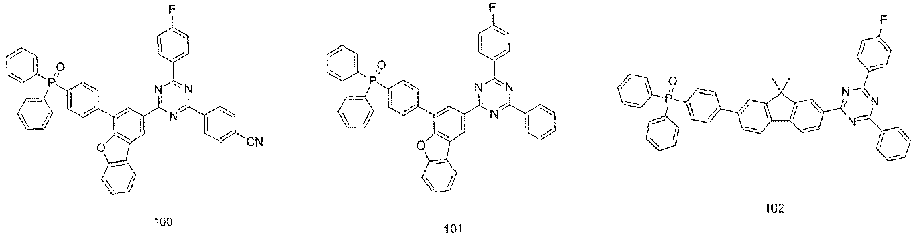

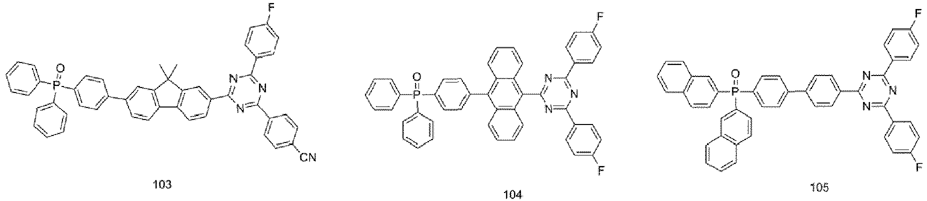

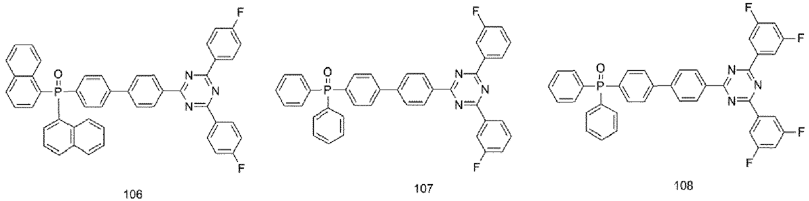

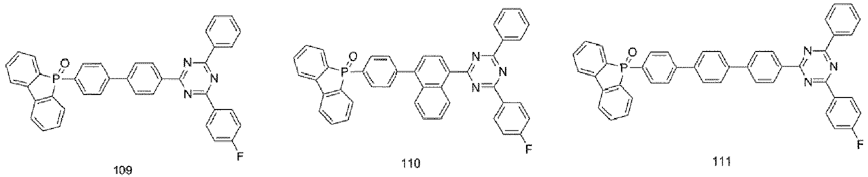

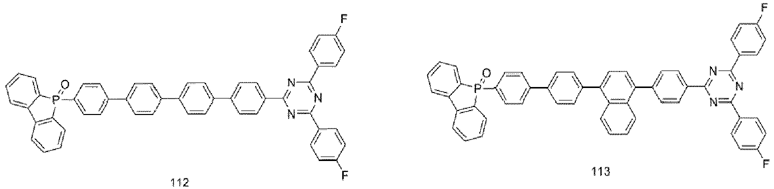

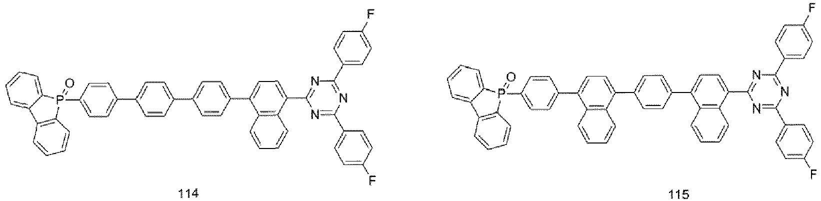

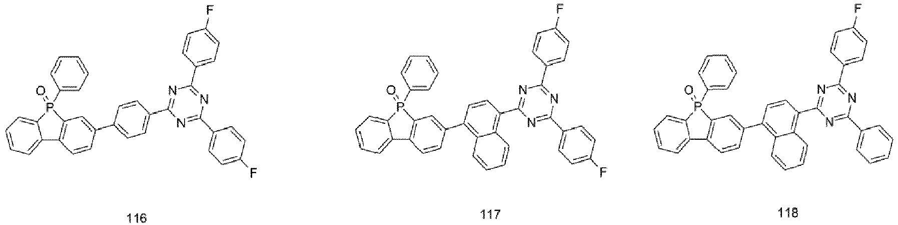

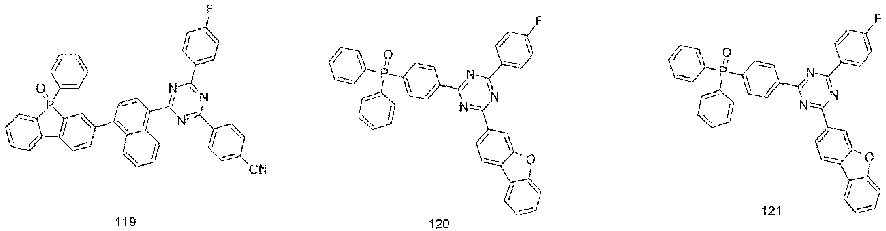

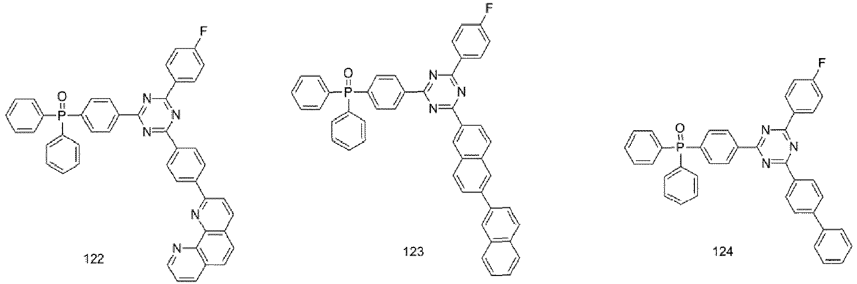

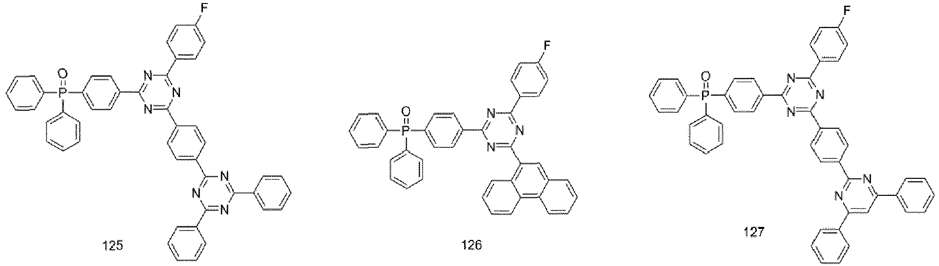

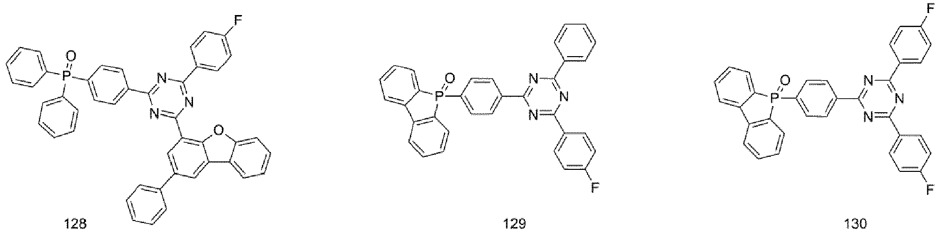

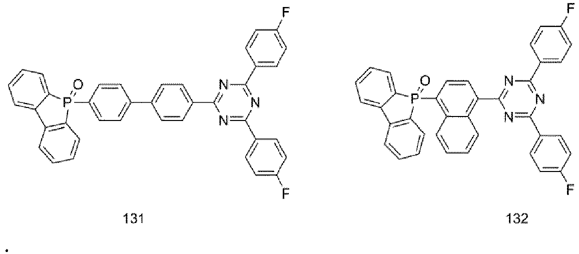

The heterocyclic compound represented by Formula 1 includes at least one fluorine substituent. As fluorine has high electronegativity and electron affinity, a dipole moment of a molecule may be increased, thereby improving electron injection ability and electron transport ability of a compound. Therefore, as the heterocyclic compound represented by Formula 1 includes at least one fluorine substituent, the heterocyclic compound may have improved electron injection ability and electron transport ability of a compound.

In addition, the heterocyclic compound represented by Formula 1 includes a phosphine oxide structure. As the phosphine oxide compound has a tetrahedral structure, an amorphous film may be formed due to its steric molecular structure. Also, as the phosphine oxide compound is capable of forming a negative hyper conjugation (back donation) and a hydrogen bond and has high electronegativity, a molecule may be stabilized; a dipole may be formed in a molecule, thereby improving electron transport ability.

In addition, an electronic device, e.g., an organic light-emitting device, employing the heterocyclic compound may have a low driving voltage, high current density, and high efficiency.

The heterocyclic compound represented by Formula 1 may be synthesized by using any suitable organic synthetic method available in the art. A method of synthesizing the heterocyclic compound may be understood by one of ordinary skill in the art by referring to Examples described herein.

At least one heterocyclic compound represented by Formula 1 may be included between a pair of electrodes in an organic light-emitting device. In some embodiments, the heterocyclic compound may be included in at least one selected from a hole transport region, an electron transport region, and an emission layer. In some embodiments, the heterocyclic compound represented by Formula 1 may be used as a material for forming a capping layer, which is disposed on outer sides of a pair of electrodes in an organic light-emitting device.
Accordingly, there is provided an organic light-emitting device including a first electrode; a second electrode facing the first electrode; and an organic layer between the first electrode and the second electrode, wherein the organic layer comprises an emission layer and at least one heterocyclic compound represented by Formula 1. As used herein, the statement "(for example, the organic layer) comprising at least one heterocyclic compound" means that "(the organic layer) comprising a heterocyclic compound of Formula 1, or at least two different heterocyclic compounds of Formula 1".

For example, the organic layer may comprise Compound 1 only as the heterocyclic compound. In this embodiment, Compound 1 may be included in the emission layer of the organic light-emitting device. In some embodiments, the organic layer may comprise Compounds 1 and 2 as the heterocyclic compounds. In this embodiment, Compounds 1 and 2 may be present in the same layer (for example, Compounds 1 and 2 may be both present in an emission layer), or in different layers (for example, Compound 1 may be present in an emission layer, and Compound 2 may be present in an electron transport layer).

The term "organic layer," as used herein, refers to a single and/or a plurality of layers disposed between the first electrode and the second electrode in an organic light-emitting device. A material included in the "organic layer" is not limited to an organic material.

In some embodiments, the first electrode may be an anode, the second electrode may be a cathode, and the organic layer may further comprise a hole transport region disposed between the first electrode and the emission layer and an electron transport region disposed between the emission layer and the second electrode, wherein the hole transport region may comprise a hole injection layer, a hole transport layer, an emission auxiliary layer, an electron blocking layer, or a combination thereof, and the electron transport region may comprise a buffer layer, a hole blocking layer, an electron control layer, an electron transport layer, an electron injection layer, or a combination thereof.
In some embodiments, the electron transport region may comprise the heterocyclic compound, but embodiments are not limited thereto.

In some embodiments, the electron transport region may comprise the electron transport layer, and the electron transport layer may comprise the heterocyclic compound.

In some embodiments, the emission layer maycomprise the heterocyclic compound, but embodiments are not limited thereto.

In some embodiments, the hole transport region may comprise a p-dopant, wherein the p-dopant may have the lowest unoccupied molecular orbital (LUMO) level of -3.5 electron Volts (eV) or less.

The p-dopant may comprise at least one selected from a quinone derivative, a metal oxide, and a cyano group-containing compound, but embodiments are not limited thereto. For example, the p-dopant may comprise a cyano group-containing compound, but embodiments are not limited thereto.

The organic light-emitting device may further comprise i) at least one second emission layer for emitting second color light or ii) at least one second emission layer for emitting second color light and at least one third emission layer for emitting third color light, between the first electrode and the second electrode, a maximum emission wavelength of the first color light, a maximum emission wavelength of the second color light, and a maximum emission wavelength of the third color light may be identical to or different from each other, and the first color light and the second color light are emitted in the form of mixed light, or the first color light, the second color light, and the third color light are emitted in the form of mixed light.

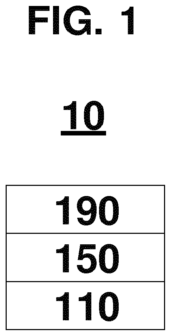

### Description of FIG. 1

FIG. 1 illustrates a schematic cross-sectional view of an organic light-emitting device 10 according to an embodiment. The organic light-emitting device 10 comprises a first electrode 110, an organic layer 150, and a second electrode 190.
Hereinafter, the structure of the organic light-emitting device 10 according to an embodiment and a method of manufacturing an organic light-emitting device according to an embodiment will be described in connection with FIG. 1.

### First electrode 110

Referring to FIG. 1, a substrate may be additionally disposed under the first electrode 110 or over the second electrode 190. The substrate may be a glass substrate or a plastic substrate, each having excellent mechanical strength, thermal stability, transparency, surface smoothness, ease of handling, and water resistance.

The first electrode 110 may be formed by depositing or sputtering, onto the substrate, a material for forming the first electrode 110. When the first electrode 110 is an anode, the material for forming the first electrode 110 may be selected from materials with a high work function that facilitate hole injection.

The first electrode 110 may be a reflective electrode, a semi-transmissive electrode, or a transmissive electrode. When the first electrode 110 is a transmissive electrode, a material for forming the first electrode 110 may be selected from indium tin oxide (ITO), indium zinc oxide (IZO), tin oxide (SnO₂), zinc oxide (ZnO), and any combinations thereof, but embodiments are not limited thereto. In some embodiments, when the first electrode 110 is a semi-transmissive electrode or a reflective electrode, as a material for forming the first electrode 110, at least one of magnesium (Mg), silver (Ag), aluminum (Al), aluminum-lithium (Al-Li), calcium (Ca), magnesium-indium (Mg-In), magnesium-silver (Mg-Ag), and any combination thereof may be used, but embodiments are not limited thereto.

The first electrode 110 may have a single-layered structure, or a multi-layered structure comprising two or more layers. In some embodiments, the first electrode 110 may have a triple-layered structure of ITO/Ag/ITO, but embodiments are not limited thereto.

### Organic layer 150

The organic layer 150 may be on the first electrode 110. The organic layer 150 may comprise an emission layer.

The organic layer 150 may further comprise a hole transport region between the first electrode 110 and the emission layer and an electron transport region between the emission layer and the second electrode 190.

### Hole transport region in organic layer 150

The hole transport region may have i) a single-layered structure including a single layer comprising a single material, ii) a single-layered structure including a single layer comprising a plurality of different materials, or iii) a multi-layered structure having a plurality of layers comprising a plurality of different materials.

The hole transport region may comprise at least one selected from a hole injection layer, an emission auxiliary layer, and an electron blocking layer.

For example, the hole transport region may have a single-layered structure including a single layer comprising a plurality of different materials or a multi-layered structure, e.g., a hole injection layer/hole transport layer structure, a hole injection layer/hole transport layer/emission auxiliary layer structure, a hole injection layer/ emission auxiliary layer structure, a hole transport layer/emission auxiliary layer structure, or a hole injection layer/hole transport layer/electron blocking layer structure, wherein layers of each structure are sequentially stacked on the first electrode 110 in each stated order, but embodiments are not limited thereto.
The hole transport region may comprise at least one selected from m-MTDATA, TDATA, 2-TNATA, NPB (NPD), β-NPB, TPD, a spiro-TPD, a spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), (polyaniline)/poly(4-styrenesulfonate) (PANI/PSS), a compound represented by Formula 201, and a compound represented by Formula 202: 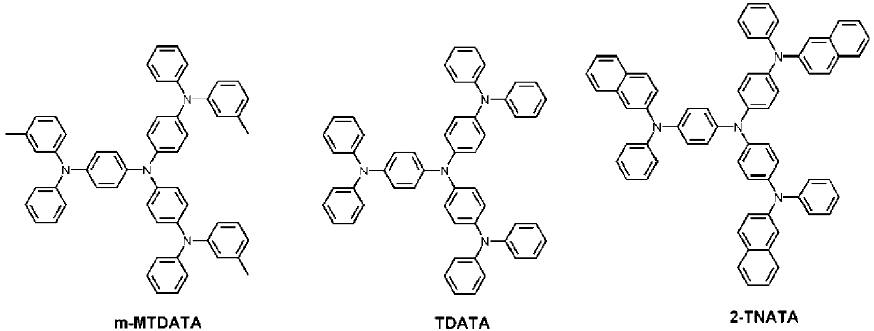 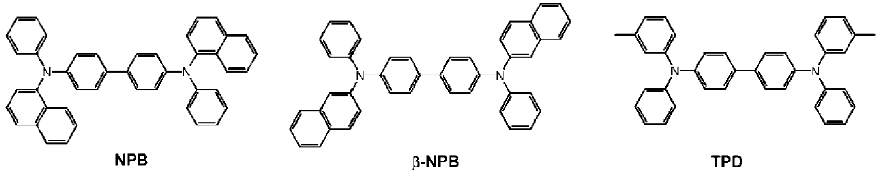 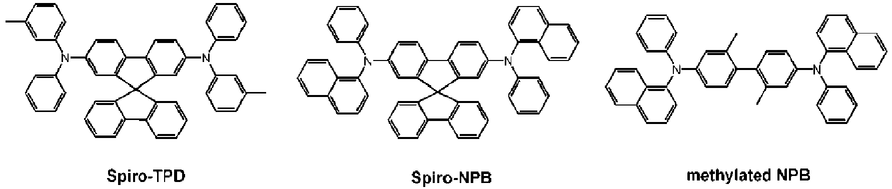 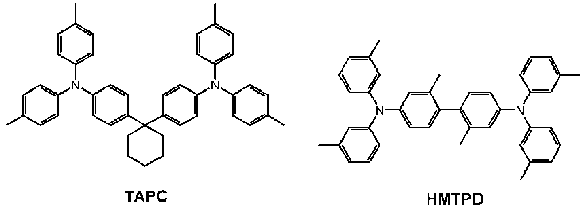 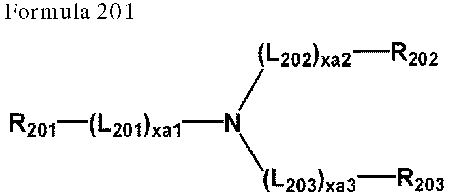 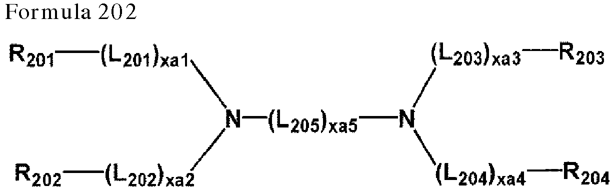 wherein, in Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xa1 to xa4 may each independently be an integer from 0 to 3,
xa5 may be an integer from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

In some embodiments, in Formula 202, R₂₀₁ and R₂₀₂ may optionally be linked via a single bond, a dimethyl-methylene group, or a diphenyl-methylene group, and R₂₀₃ and R₂₀₄ may optionally be linked via a single bond, a dimethyl-methylene group, or a diphenyl-methylene group.

In one embodiment, in Formulae 201 and 202, L₂₀₁ to L₂₀₅ may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be 0, 1, or 2. In one or more embodiments, xa5 may be 1, 2, 3, or 4.

In one or more embodiments, R₂₀₁ to R₂₀₄ and Q₂₀₁ may each independently be selected from a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzo fluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein descriptions for Q₃₁ to Q₃₃ may each independently be understood by referring to those provided herein.

In one or more embodiments, in Formula 201, at least one of R₂₀₁ to R₂₀₃ may each independently be selected from:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments are not limited thereto.

In one or more embodiments, in Formula 202, i) R₂₀₁ may be linked to R₂₀₂ via a single bond, and/or ii) R₂₀₃ may be linked to R₂₀₄ via a single bond.

In one or more embodiments, in Formula 202, at least one of R₂₀₁ to R₂₀₄ may be selected from: a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments are not limited thereto.
The compound represented by Formula 201 may be represented by Formula 201A:

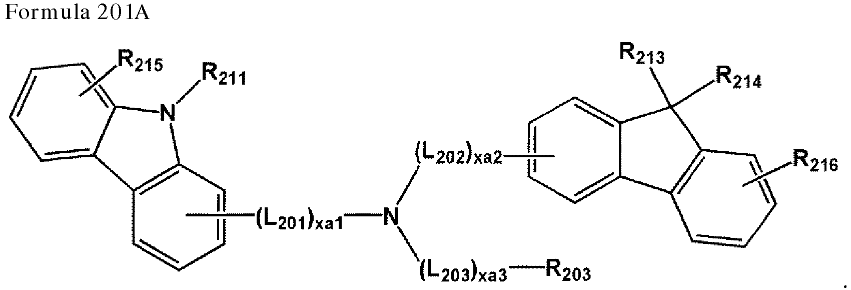

In some embodiments, the compound represented by Formula 201 may be represented by Formula 201A(1), but embodiments are not limited thereto:

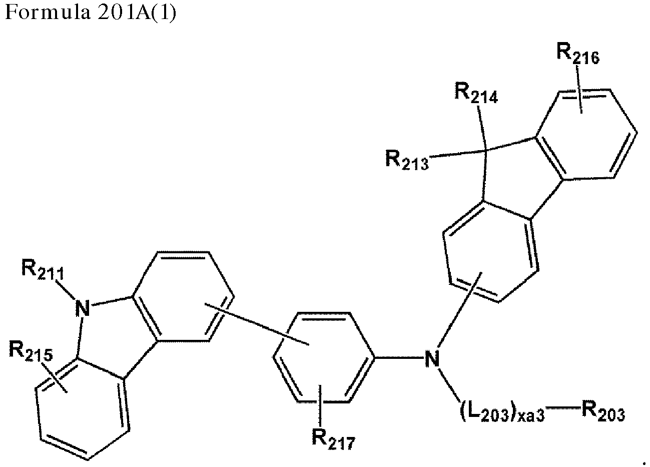

In some embodiments, the compound represented by Formula 201 may be represented by Formula 201A-1, but embodiments are not limited thereto:

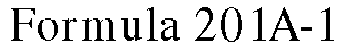

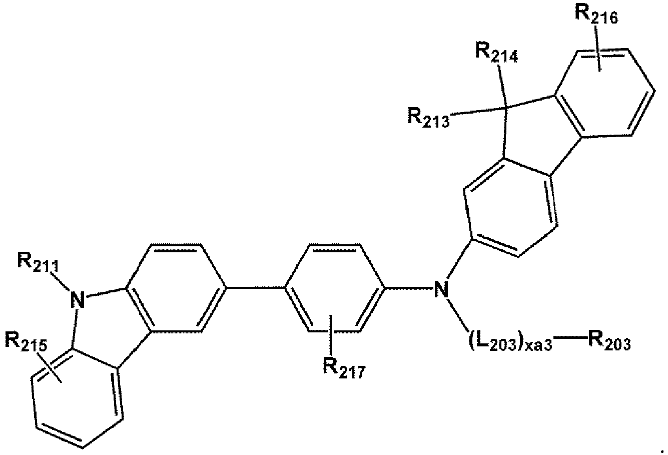

In some embodiments, the compound represented by Formula 202 may be represented by Formula 202A:

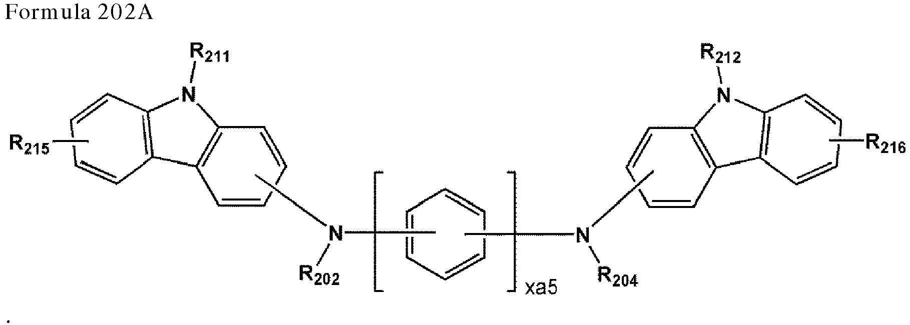

In some embodiments, the compound represented by Formula 202 may be represented by Formula 202A-1:

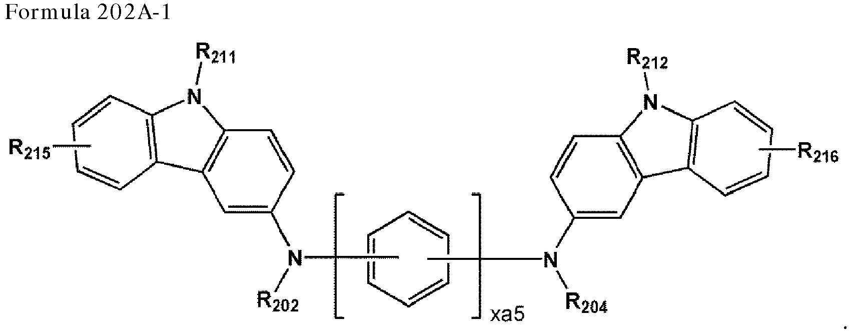

In Formulae 201A, 201A(1), 201A-1, 202A, and 202A-1,
descriptions for L₂₀₁ to L₂₀₃, xa1 to xa3, xa5, and R₂₀₂ to R₂₀₄ may each be understood by referring to those provided herein,
descriptions for R₂₁₁ and R₂₁₂ may each be understood by referring to those for R₂₀₃ provided herein, and
R₂₁₃ to R₂₁₇ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may comprise at least one compound selected from Compounds HT1 to HT39, but embodiments are not limited thereto:

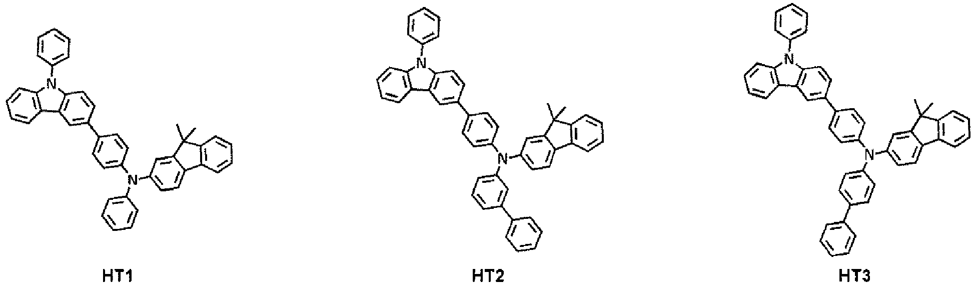

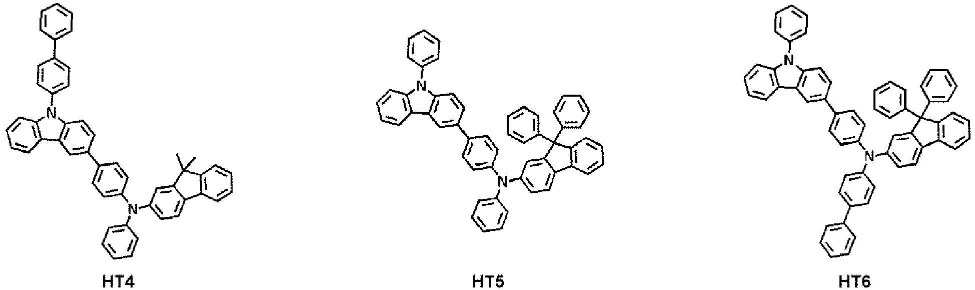

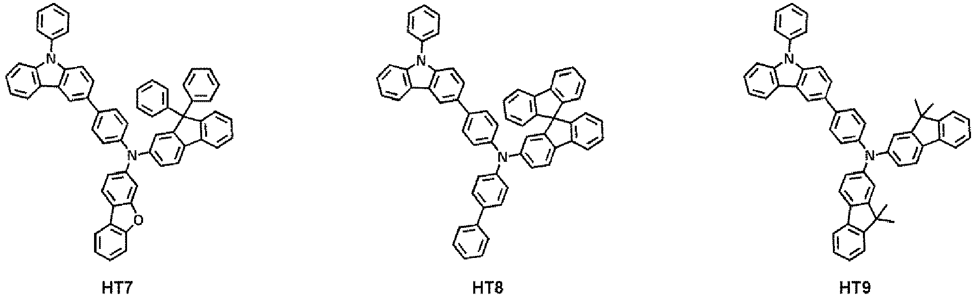

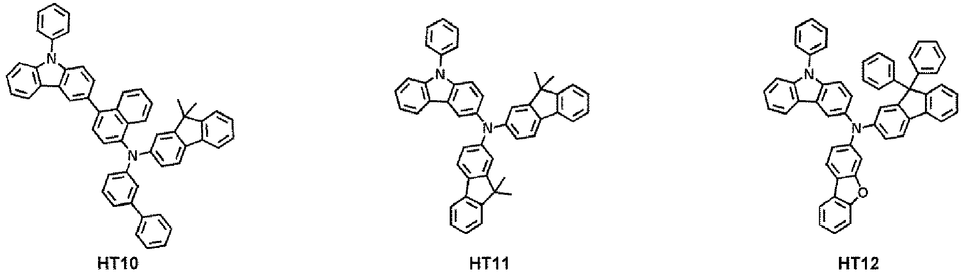

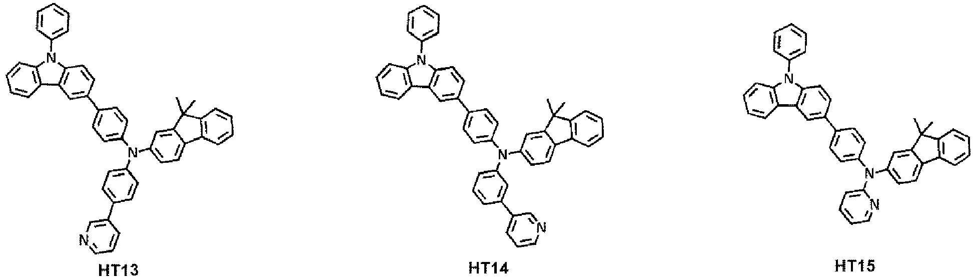

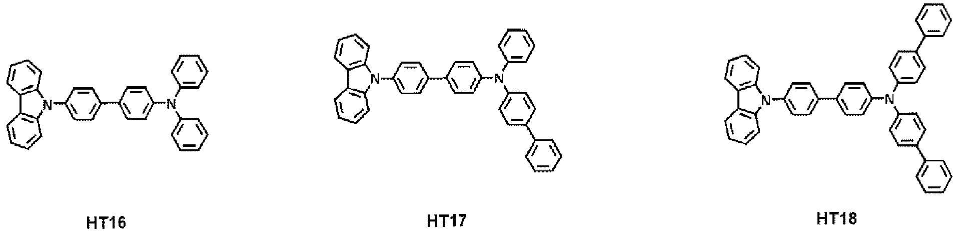

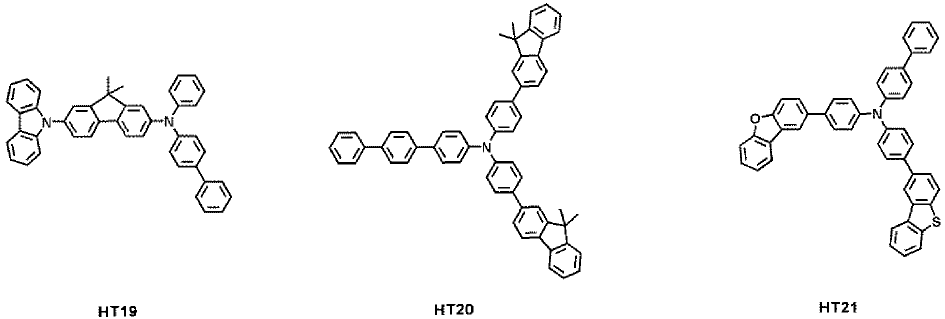

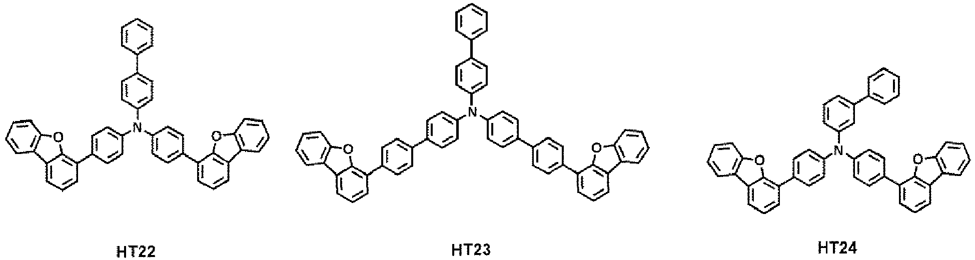

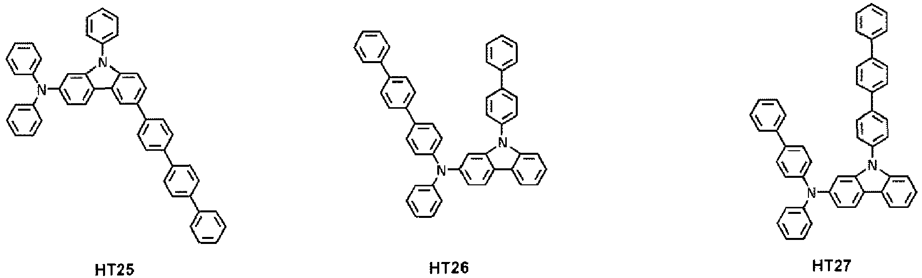

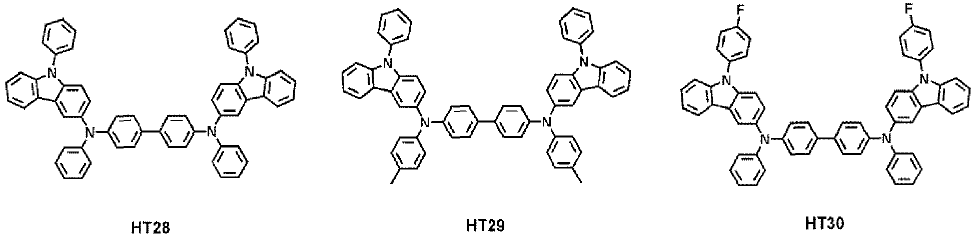

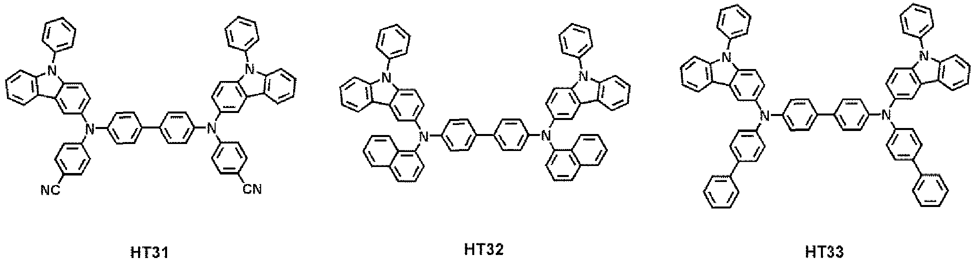

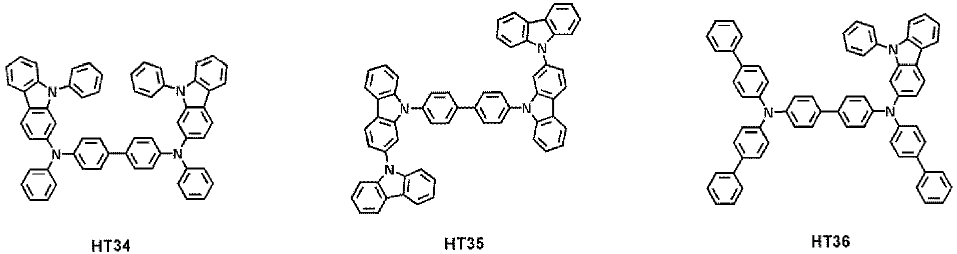

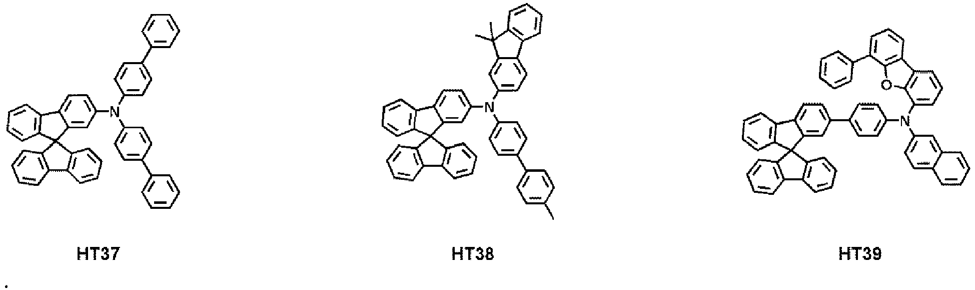

The thickness of the hole transport region may be in a range of about 100 (Angstroms) Å to about 10,000 Å, and in some embodiments, about 100 Å to about 1,000 Å. When the hole transport region comprises at least one selected from a hole injection layer and a hole transport layer, the thickness of the hole injection layer may be in a range of about 100 Å to about 9,000 Å, and in some embodiments, about 100 Å to about 1,000 Å, and the thickness of the hole transport layer may be in a range of about 50 Å to about 2,000 Å, and in some embodiments, about 100 Å to about 1,500 Å. When the thicknesses of the hole transport region, the hole injection layer, and the hole transport layer are within any of these ranges, excellent hole transport characteristics may be obtained without a substantial increase in driving voltage.

The emission auxiliary layer may increase light emission efficiency by compensating for an optical resonance distance according to the wavelength of light emitted by an emission layer. The electron blocking layer may reduce or eliminate the flow of electrons from an electron transport region. The emission auxiliary layer and the electron blocking layer may comprise the aforementioned materials.

### p-dopant

The hole transport region may comprise a charge generating material as well as the aforementioned materials, to improve conductive properties of the hole transport region. The charge generating material may be substantially homogeneously or non-homogeneously dispersed in the hole transport region.

The charge generating material maycomprise, for example, a p-dopant.
In some embodiments, the LUMO of the p-dopant may be about -3.5 eV or less.
The p-dopant may comprise at least one selected from a quinone derivative, a metal oxide, and a cyano group-containing compound, but embodiments are not limited thereto.

In some embodiments, the p-dopant may comprise at least one selected from a quinone derivative, such as tetracyanoquinodimethane (TCNQ) or 2,3,5,6-tetrafluoro-7,7,8,8-tetracyanoquinodimethane (F4-TCNQ);
a metal oxide, such as tungsten oxide or molybdenum oxide; 1,4,5,8,9,11-hexaazatriphenylene-hexacarbonitrile (HAT-CN); and a compound represented by Formula 221, but embodiments are not limited thereto: 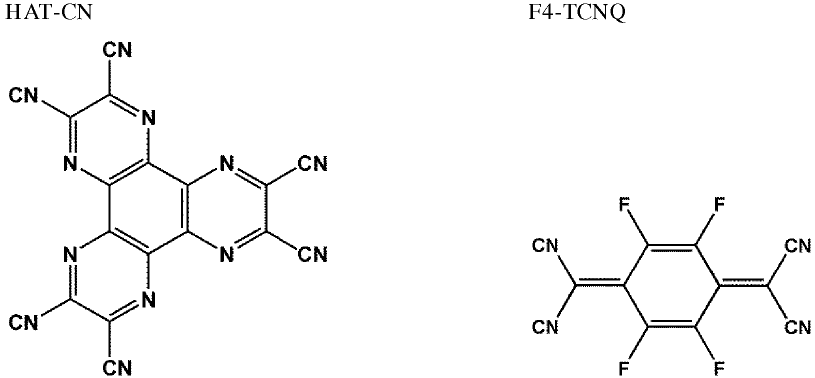 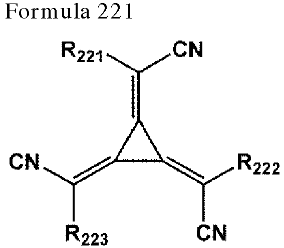
wherein, in Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, provided that at least one selected from R₂₂₁ to R₂₂₃ may include at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### Emission layer in organic layer 150

When the organic light-emitting device 10 is a full color organic light-emitting device, the emission layer may be patterned into a red emission layer, a green emission layer, or a blue emission layer, according to a sub-pixel. In one or more embodiments, the emission layer may have a stacked structure. The stacked structure may comprise two or more layers selected from a red emission layer, a green emission layer, and a blue emission layer. The two or more layers may be in direct contact with each other. In some embodiments, the two or more layers may be separated from each other. In one or more embodiments, the emission layer may comprise two or more materials. The two or more materials may comprise a red light-emitting material, a green light-emitting material, or a blue light-emitting material. The two or more materials may be mixed with each other in a single layer. The two or more materials mixed with each other in the single layer may emit white light.

The emission layer may comprise a host and a dopant. The dopant may comprise at least one of a fluorescent dopant and a phosphorescent dopant.
The amount of the dopant in the emission layer may be, in general, in a range of about 0.01 parts to about 15 parts by weight based on 100 parts by weight of the host, but embodiments are not limited thereto.

The thickness of the emission layer may be in a range of about 100 Å to about 1,000 Å, and in some embodiments, about 200 Å to about 600 Å. When the thickness of the emission layer is within any of these ranges, improved luminescence characteristics may be obtained without a substantial increase in driving voltage.

### Host in emission layer

The host may comprise a compound represented by Formula 301:

Formula 301 [Ar₃₀₁]_{xb11}-[(L₃₀₁)_{xb1}-R₃₀₁]_{xb21}

wherein, in Formula 301,
Ar₃₀₁ may be a substituted or unsubstituted C₅-C₆₀ carbocyclic group or a substituted or unsubstituted C₁-C₆₀ heterocyclic group,
   xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xb1 may be an integer from 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), and - P(=O)(Q₃₀₁)(Q₃₀₂), and
xb21 may be an integer from 1 to 5,
wherein Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments are not limited thereto.

In some embodiments, Ar₃₀₁ in Formula 301 may be selected from:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but embodiments are not limited thereto.

When xb11 in Formula 301 is 2 or greater, at least two Ar₃₀₁ groups may be linked via a single bond.

In one or more embodiments, the compound represented by Formula 301 may be represented by Formula 301-1 or 301-2: 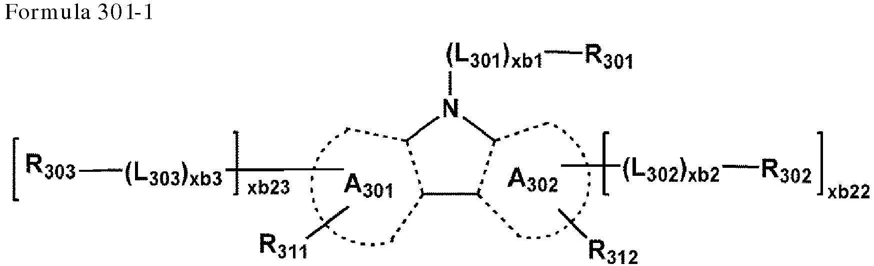 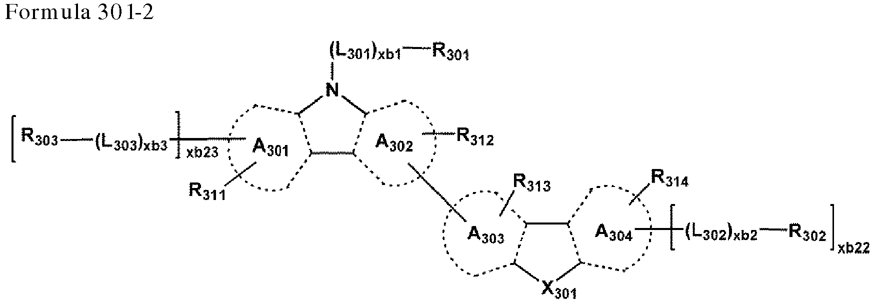
wherein, in Formulae 301-1 to 301-2,
A₃₀₁ to A₃₀₄ may each independently be selected from a benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonapthothiophene group, and a dinaphthothiophene group,
X₃₀₁ may be O, S, or N-[(L₃₀₄)_{xb4}-R₃₀₄],
   R₃₁₁ to R₃₁₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
xb22 and xb23 may each independently be 0, 1, or 2,
descriptions for L₃₀₁, xb1, R₃₀₁, and Q₃₁ to Q₃₃ may each independently be understood by referring to those provided herein,
descriptions for L₃₀₂ to may each independently be understood by referring to those for L₃₀₁ provided herein,
descriptions for xb2 to xb4 may each independently be understood by referring to those for xb1 provided herein, and
descriptions for R₃₀₂ to R₃₀₄ may each independently be understood by referring to those for R₃₀₁ provided herein.

In some embodiments, in Formulae 301, 301-1, and 301-2, L₃₀₁ to L₃₀₄ may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzo fluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein descriptions for Q₃₁ to Q₃₃ may each independently be understood by referring to those provided herein.

In some embodiments, in Formulae 301, 301-1, and 301-2, R₃₀₁ to R₃₀₄ may each independently be selected from:
a phenyl group, a biphenyl group, a terphenyl group, a naphthyl group, a fluorenyl group, a spiro-bifluorenyl group, a benzofluorenyl group, a dibenzo fluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein descriptions for Q₃₁ to Q₃₃ may each independently be understood by referring to those provided herein.

In some embodiments, the host may comprise an alkaline earth metal complex. For example, the host may comprise a beryllium (Be) complex, e.g., Compound H55, a magnesium (Mg) complex, or a zinc (Zn) complex.
The host may comprise at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and Compounds H1 to H55, but embodiments are not limited thereto:

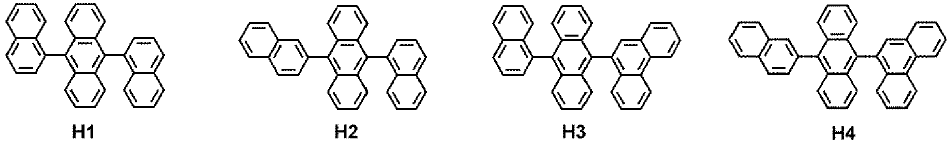

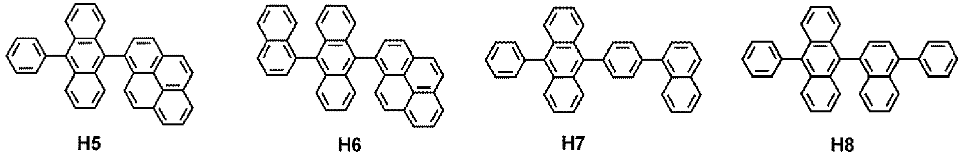

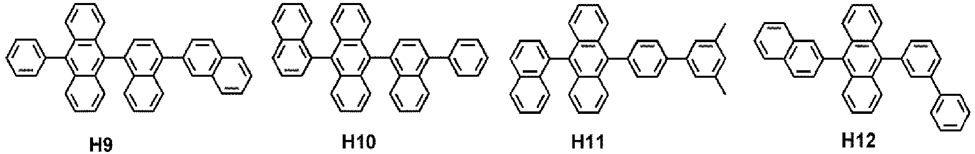

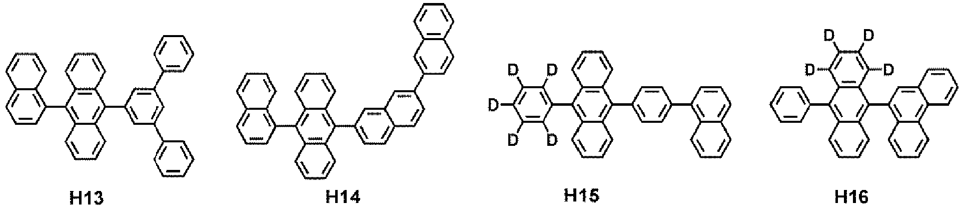

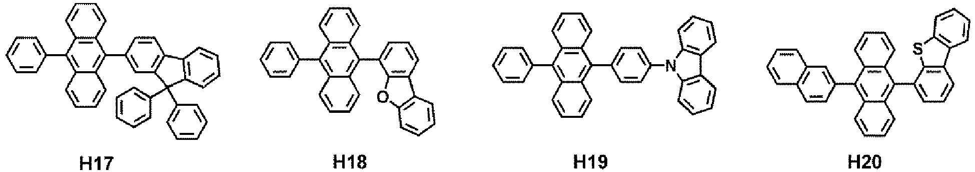

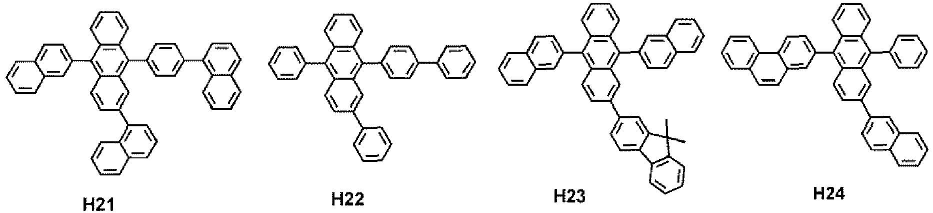

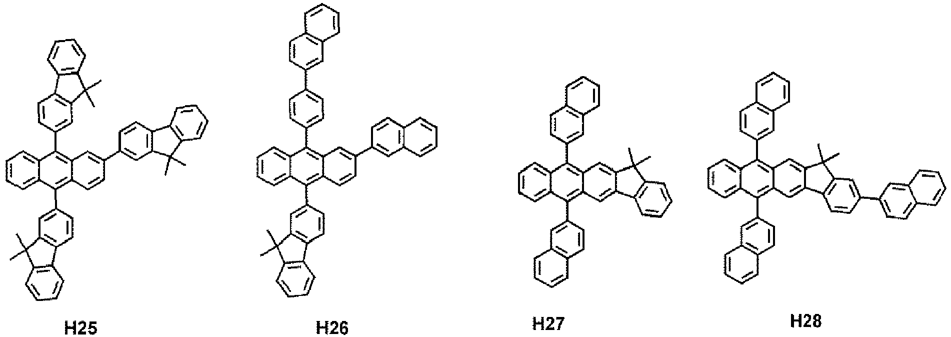

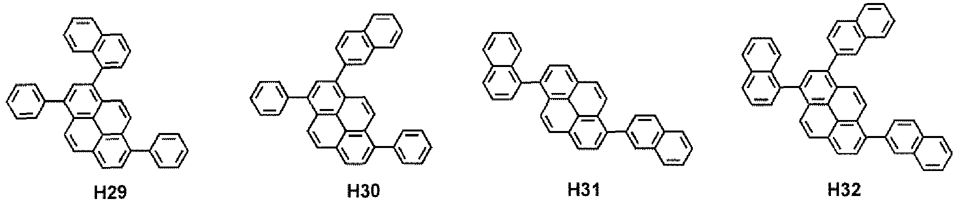

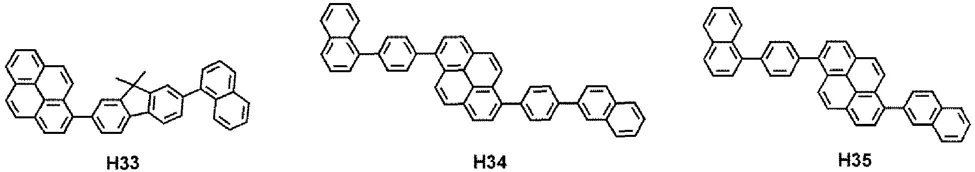

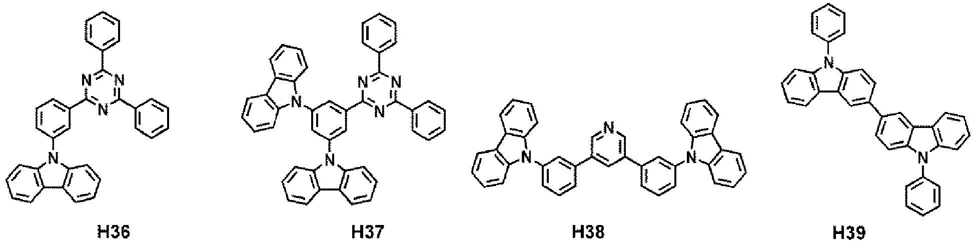

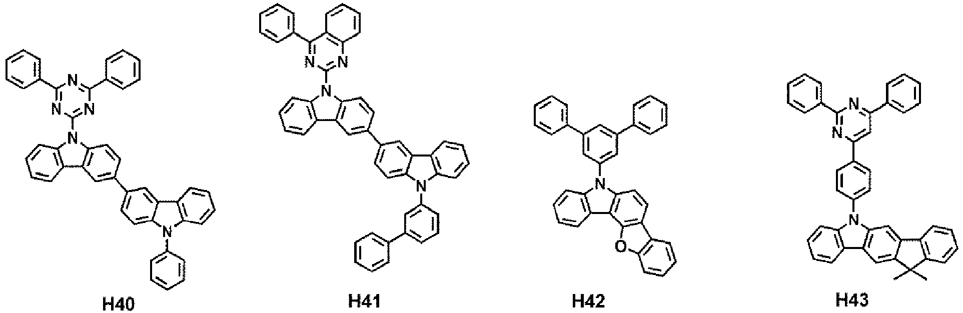

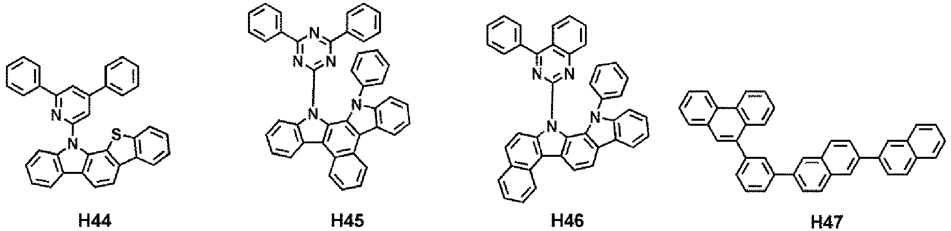

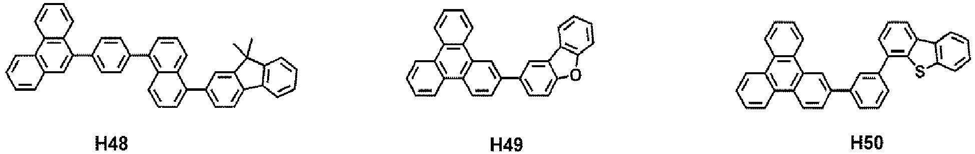

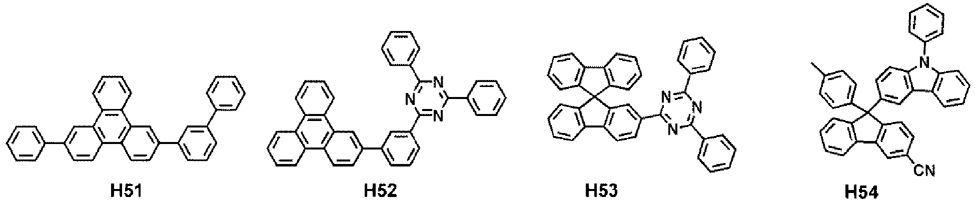

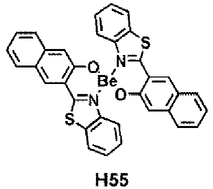

### Phosphorescent dopant included in emission layer of organic layer 150

The phosphorescent dopant may comprise an organometallic complex represented by Formula 401:

Formula 401 M(L₄₀₁)_{xc1}(L₄₀₂)_{xc2}

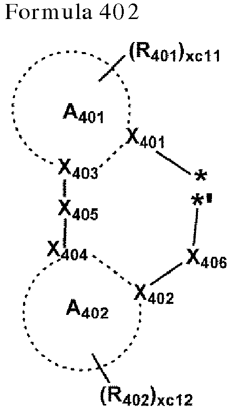

wherein, in Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
L₄₀₁ may be selected from ligands represented by Formula 402, xc1 may be an integer from 1, 2, and 3; when xc1 is two or greater, at least two L₄₀₁ groups may be identical to or different from each other,
L₄₀₂ may be an organic ligand, xc2 may be an integer from 0 to 4; when xc2 is 2 or greater, at least two L₄₀₂ groups may be identical to or different from each other,
   X₄₀₁ to X₄₀₄ may each independently be nitrogen (N) or carbon (C),
   X₄₀₁ and X₄₀₃ may be linked via a single bond or a double bond, X₄₀₂ and X₄₀₄ may be linked via a single bond or a double bond,
A₄₀₁ and A₄₀₂ may each independently be a C₅-C₆₀ carbocyclic group or a C₁-C₆₀ heterocyclic group,
X₄₀₅ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C(Q₄₁₁)=*', wherein Q₄₁₁ and Q₄₁₂ may each independently be hydrogen, deuterium, a C₁-C₂₀ alkyl group, a C₁-C₂₀ alkoxy group, a phenyl group, a biphenyl group, a terphenyl group, or a naphthyl group,
   X₄₀₆ may be a single bond, O, or S,
R₄₀₁ and R₄₀₂ may each independently be selected from hydrogen, deuterium, - F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and - P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer from 0 to 10, and
* and *' in Formula 402 each indicate a binding site to M in Formula 401.

In some embodiments, in Formula 402, A₄₀₁ and A₄₀₂ may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen, and X₄₀₂ may be carbon, or ii) X₄₀₁ and X₄₀₂ may each be nitrogen.
In one or more embodiments, in Formula 402, R₄₀₁ and R₄₀₂ may each independently be selected from:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantyl group, a norbornanyl group, and a norbornenyl group;
a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments are not limited thereto.

In one or more embodiments, when xc1 in Formula 401 is 2 or greater, two A₄₀₁ groups of at least two L₄₀₁ groups may optionally be linked to each other via X₄₀₇ as a linking group; or two A₄₀₂ groups may optionally be linked to each other via X₄₀₈ as a linking group (see Compounds PD1 to PD4 and PD7). X₄₀₇ and X₄₀₈ may each independently be selected from a single bond, *-O-*', *-S-*', *-C(=O)-*', *-N(Q₄₁₃)-*', *-C(Q₄₁₃)(Q₄₁₄)-*', and *-C(Q₄₁₃)=C(Q₄₁₄)-*', wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group, but embodiments are not limited thereto.

L₄₀₂ in Formula 401 may be any suitable monovalent, divalent, or trivalent organic ligand. For example, L₄₀₂ may be selected from halogen, diketone (e.g., acetylacetonate), a carboxylic acid (e.g., picolinate), -C(=O), isonitrile, -CN, and phosphorus (e.g., phosphine or phosphite), but embodiments are not limited thereto. In some embodiments, the phosphorescent dopant may comprise, for example, at least one selected from Compounds PD1 to PD25, but embodiments are not limited thereto:

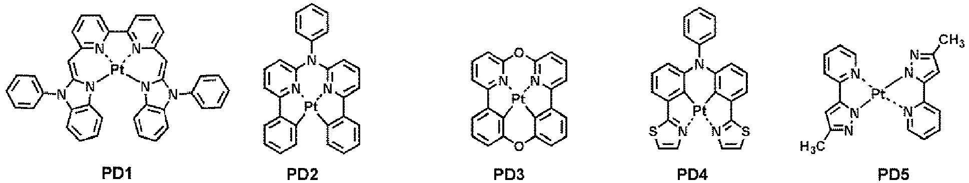

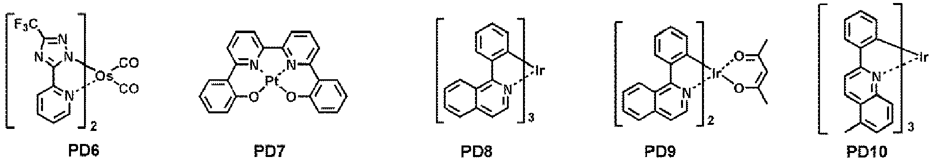

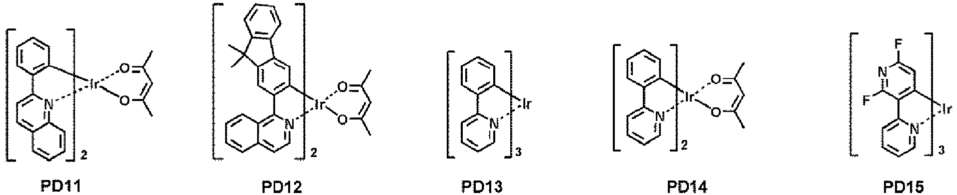

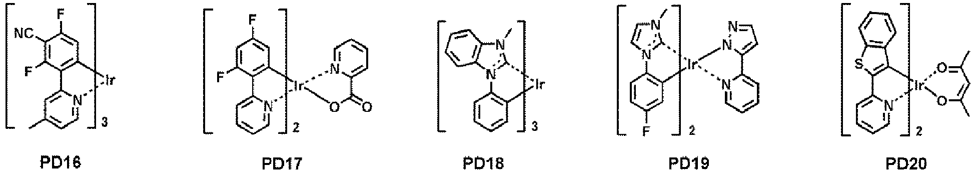

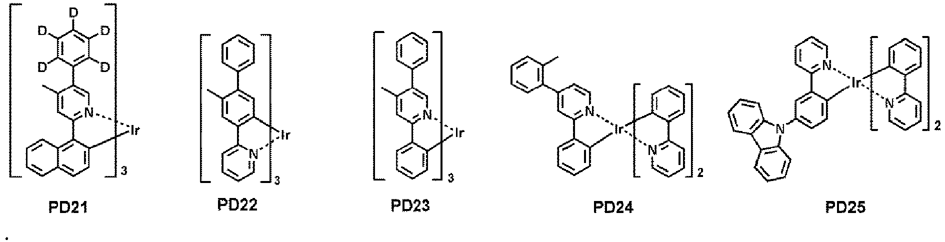

### Fluorescent dopant in emission layer

The fluorescent dopant may comprise an arylamine compound or a styrylamine compound.

In some embodiments, the fluorescent dopant may comprise a compound represented by Formula 501: 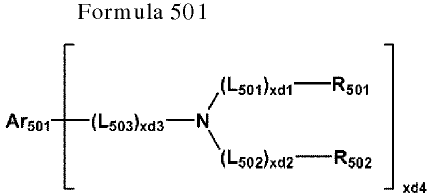 wherein, in Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,

xd1 to xd3 may each independently be an integer from 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and xd4 may be an integer from 1 to 6.

In some embodiments, Ar₅₀₁ in Formula 501 may be selected from
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, in Formula 501, L₅₀₁ to L₅₀₃ may each independently be selected from
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzo fluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, in Formula 501, R₅₀₁ and R₅₀₂ may each independently be selected from
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzo fluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments are not limited thereto.

In some embodiments, the fluorescent dopant may be selected from Compounds FD1 to FD22:

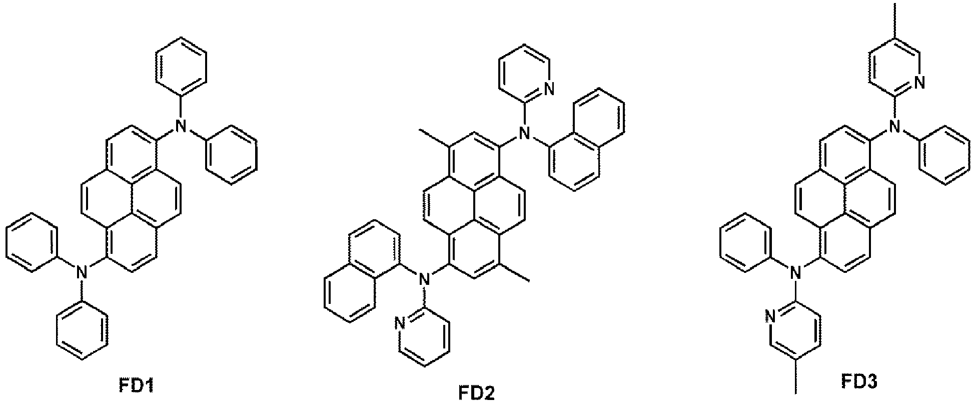

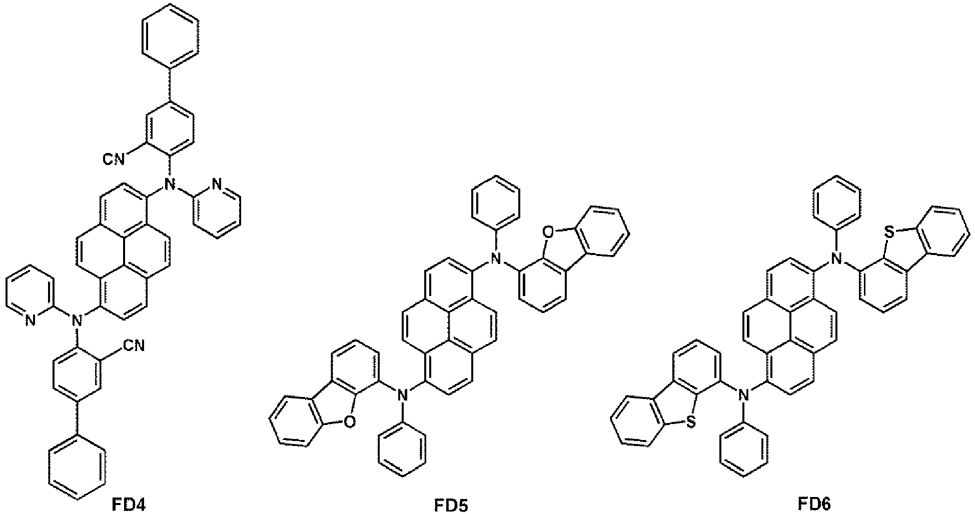

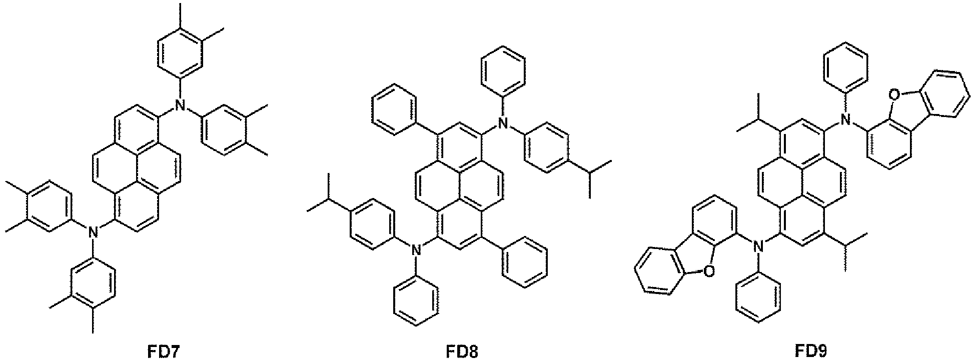

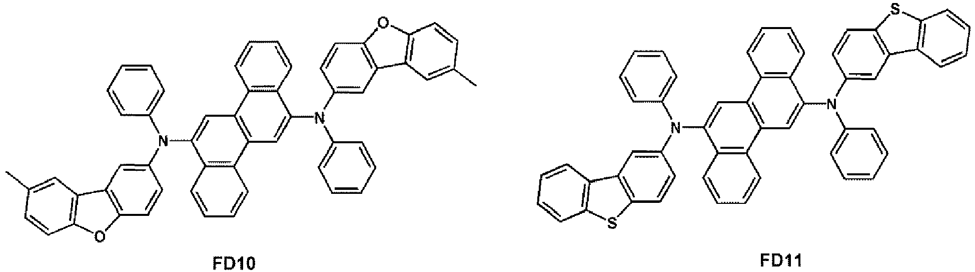

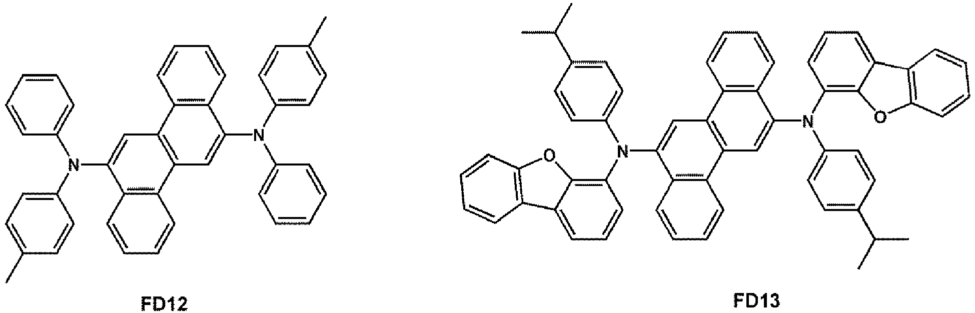

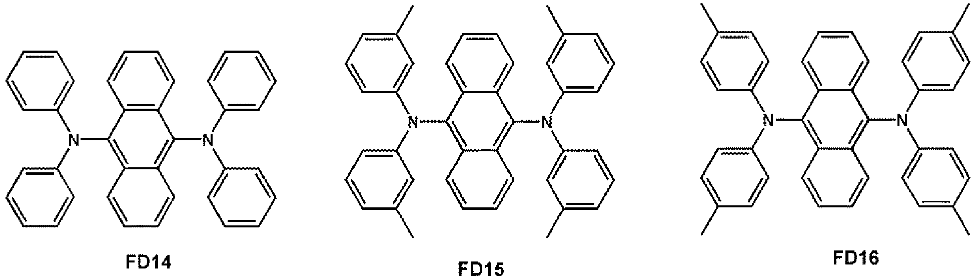

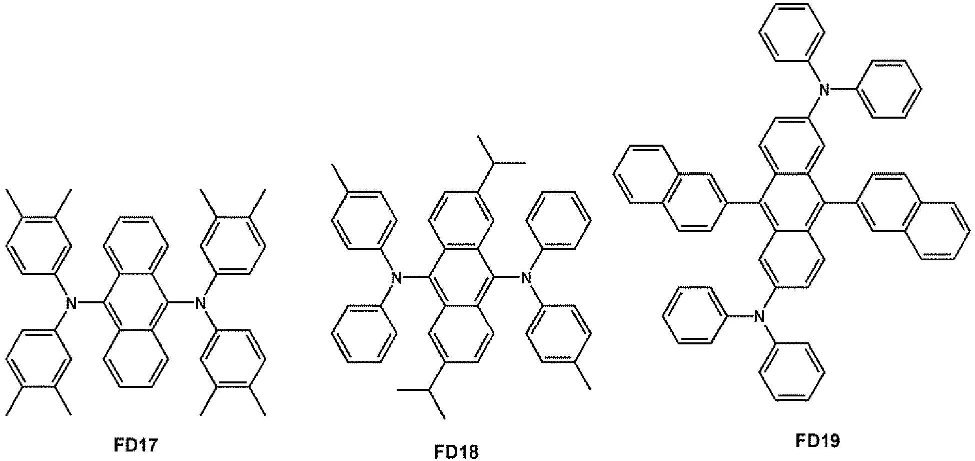

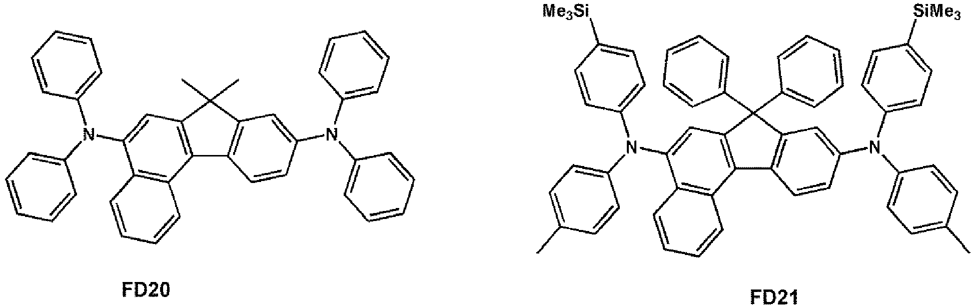

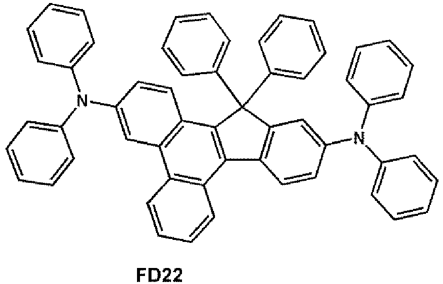

In some embodiments, the fluorescent dopant may be selected from the following compounds, but embodiments are not limited thereto:

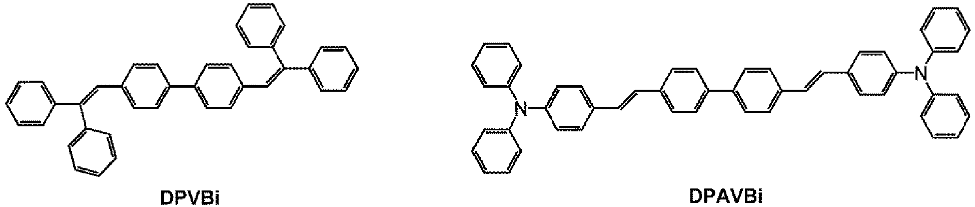

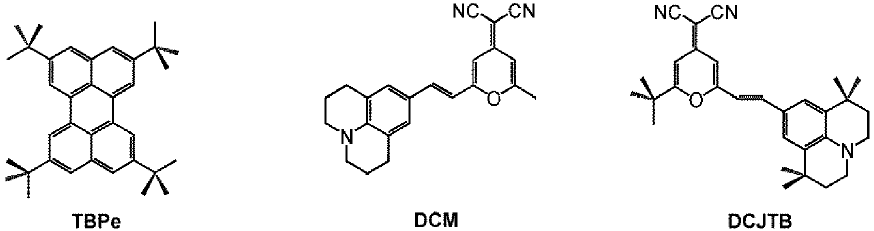

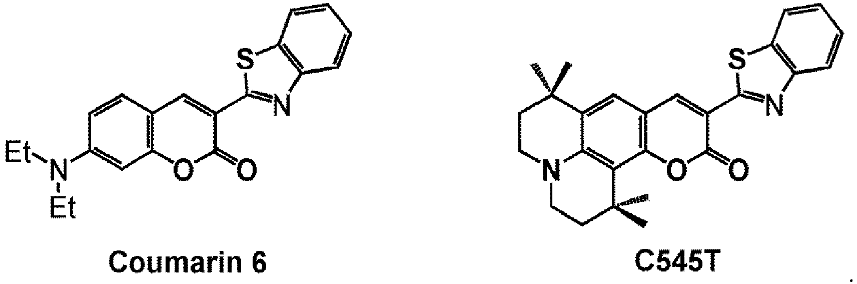

### Electron transport region in organic layer 150

The electron transport region may comprise i) a single-layered structure including a single layer comprising a single material, ii) a single-layered structure including a single layer comprising a plurality of different materials, or iii) a multi-layered structure each having a plurality of layers, each comprising a plurality of different materials.

The electron transport region may comprise at least one selected from a buffer layer, a hole blocking layer, an electron control layer, an electron transport layer, and an electron injection layer, but embodiments are not limited thereto.

In some embodiments, the electron transport region may comprise an electron transport layer/electron injection layer structure, a hole blocking layer/electron transport layer/electron injection layer structure, an electron control layer/electron transport layer/electron injection layer structure, or a buffer layer/electron transport layer/ electron injection layer structure, wherein layers of each structure are sequentially stacked on the emission layer in each stated order, but embodiments are not limited thereto.

The electron transport region may comprise the heterocyclic compound represented by Formula 1.

Further, the electron transport region, e.g., a buffer layer, a hole blocking layer, an electron control layer, or an electron transport layer in the electron transport region, may comprise a metal-free compound as well as the heterocyclic compound represented by Formula 1. The metal-free compound may comprise at least one π electron-depleted nitrogen-containing ring.

The term "π electron-depleted nitrogen-containing ring," as used herein, refers to a C₁-C₆₀ heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are condensed, or iii) a heteropolycyclic group in which at least one 5-membered to 7-membered heteromonocyclic group having at least one *-N=*' moiety is condensed with at least one C₅-C₆₀ carbocyclic group.

Examples of the π electron-depleted nitrogen-containing ring include an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzimidazole, an iso-benzothiazole, a benzoxazole, an isobenzoxazole, a triazole, a tetrazole, an oxadiazole, a triazine, a thiadiazole, an imidazopyridine, an imidazopyrimidine, and an azacarbazole, but embodiments are not limited thereto.

In some embodiments, the electron transport region may include a compound represented by Formula 601:

Formula 601 [Ar₆₀₁]ₓₑ₁₁-[(L₆₀₁)ₓₑ₁₋R-₆₀₁]ₓₑ₂₁

wherein, in Formula 601,
Ar₆₀₁ may be a substituted or unsubstituted C₅-C₆₀ carbocyclic group or a substituted or unsubstituted C₁-C₆₀ heterocyclic group,
   xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 may be an integer from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
wherein Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and xe21 may be an integer from 1 to 5.

In one embodiment, at least one of Ar₆₀₁ groups in the number of xe11 and R₆₀₁ groups in the number of xe21 may comprise the π electron-depleted nitrogen-containing ring.

In some embodiments, Ar₆₀₁ in Formula 601 may be selected from
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is 2 or greater, at least two Ar₆₀₁ groups may be linked via a single bond.

In one or more embodiments, Ar₆₀₁ in Formula 601 may be an anthracene group.

In some embodiments, the compound represented by Formula 601 may be represented by Formula 601-1: 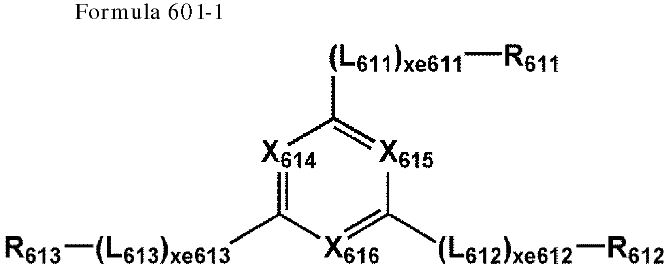 wherein, in Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
   descriptions for L₆₁₁ to L₆₁₃ may each independently be the same as those for L₆₀₁ as provided herein,
descriptions for xe611 to xe613 may each independently be the same as those for xe1 as provided herein,
descriptions for R₆₁₁ to R₆₁₃ may each independently be the same as those for R₆₀₁ as provided herein, and
R₆₁₄ to R₆₁₆ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one embodiment, in Formulae 601 and 601-1, L₆₀₁ and L₆₁₁ to L₆₁₃ may each independently be selected from
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzo fluorenyl group, a dibenzo fluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, but embodiments are not limited thereto.

In one or more embodiments, in Formulae 601 and 601-1, xe1 and xe611 to xe613, may each independently be 0, 1, or 2.
In one or more embodiments, in Formulae 601 and 601-1, R₆₀₁ and R₆₁₁ to R₆₁₃ may each independently be selected from
a phenyl group, a biphenyl group, a terphenyl group, a naphthyl group, a fluorenyl group, a spiro-bifluorenyl group, a benzo fluorenyl group, a dibenzo fluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzo fluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and -S(=O)₂(Q₆₀₁) and -P(=O)(Q₆₀₁)(Q₆₀₂),
wherein descriptions for Q₆₀₁ and Q₆₀₂ may each independently be understood by referring to those provided herein.

The electron transport region may comprise at least one compound selected from Compounds ET1 to ET36, but embodiments are not limited thereto:

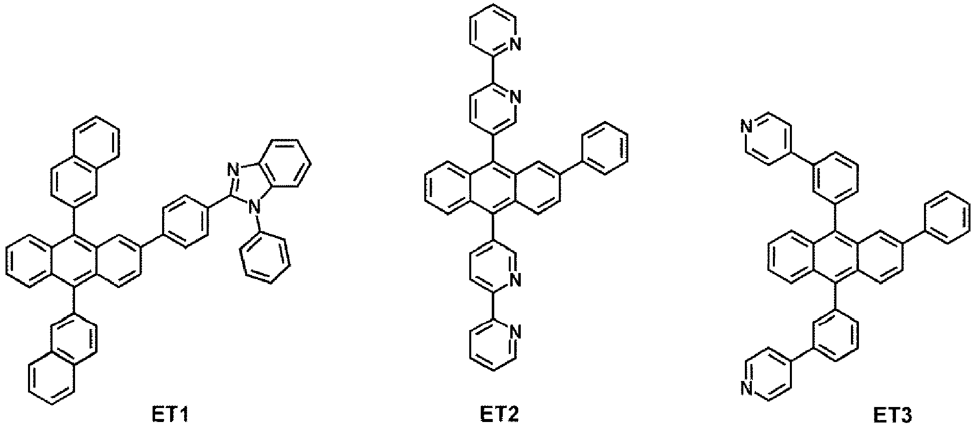

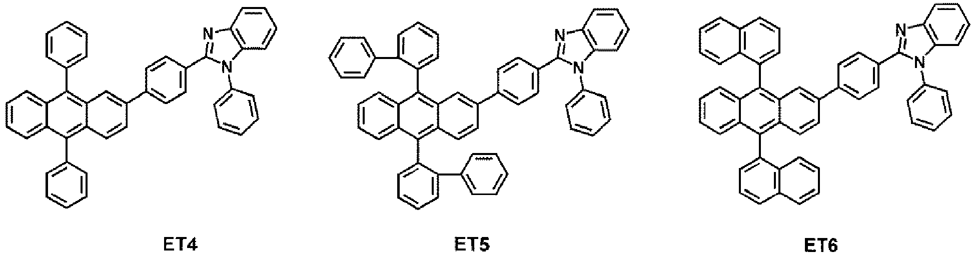

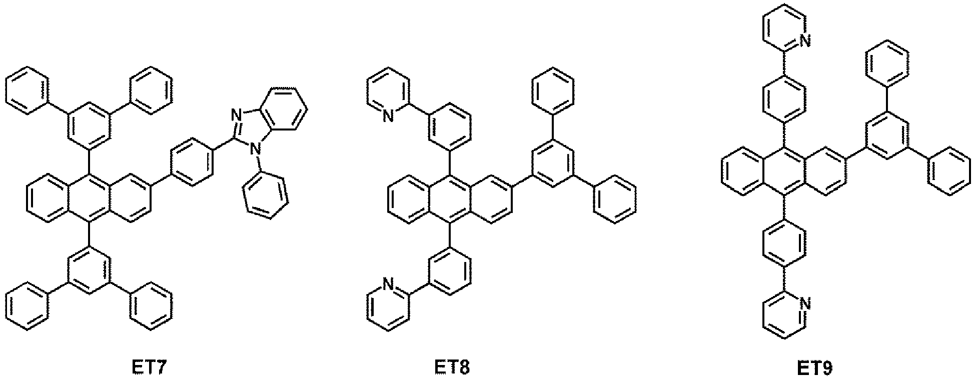

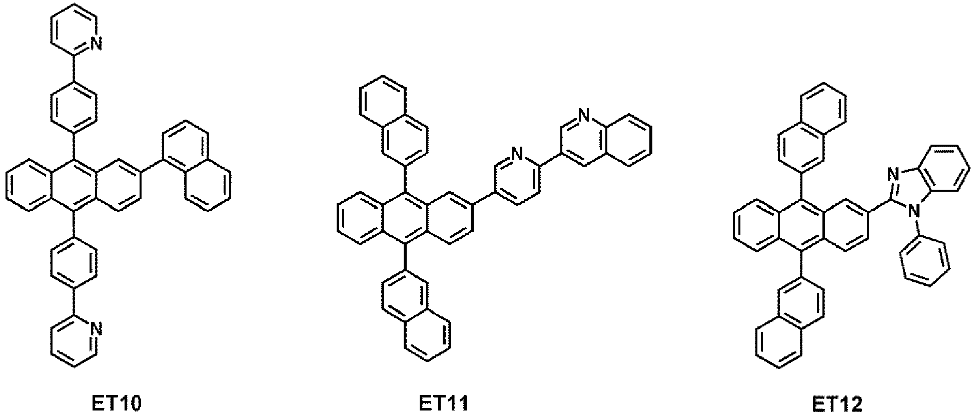

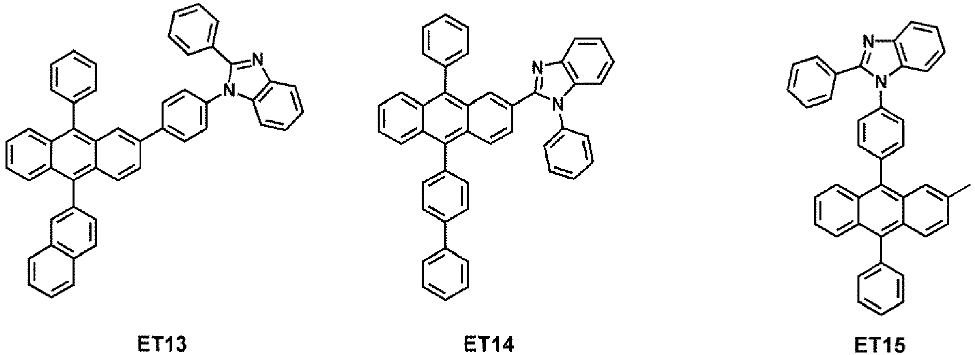

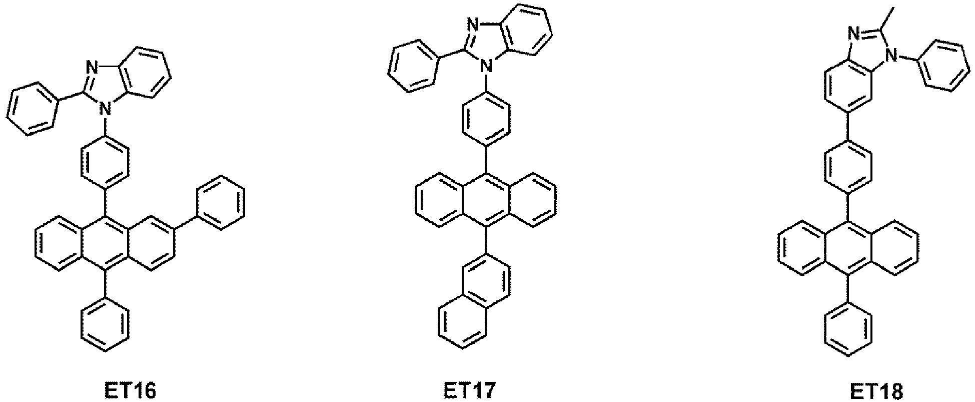

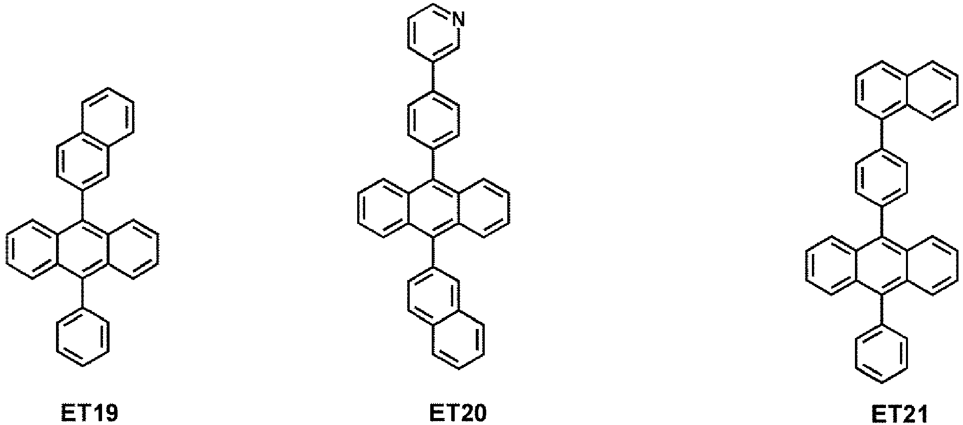

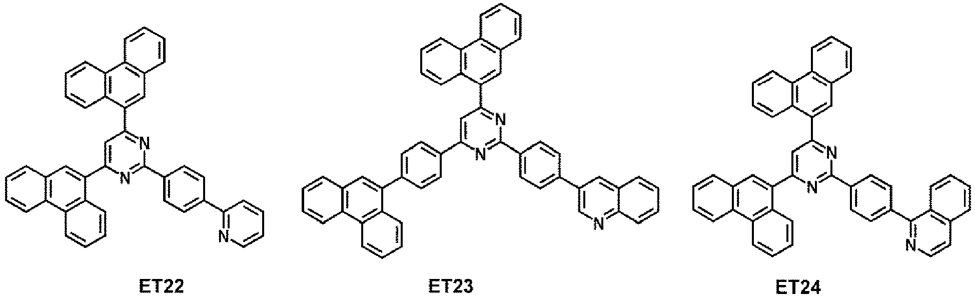

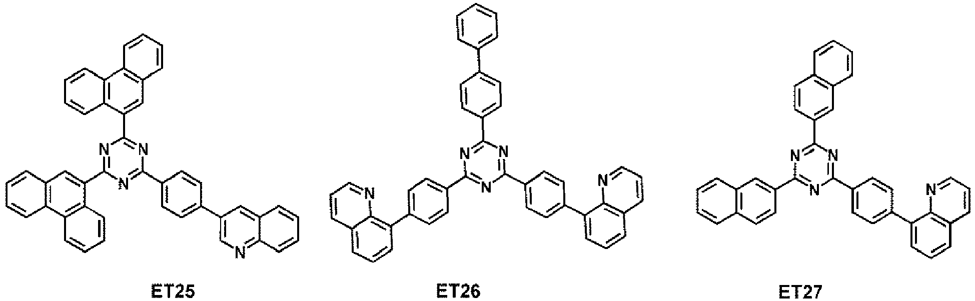

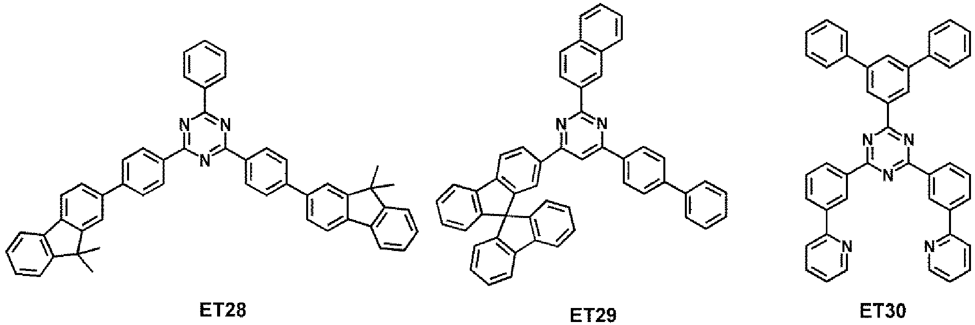

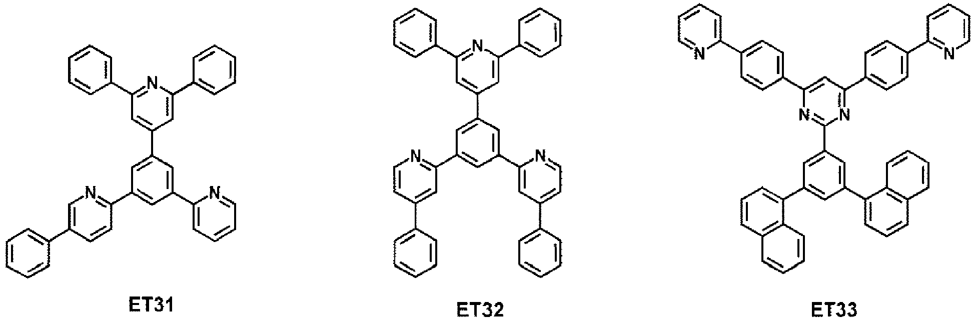

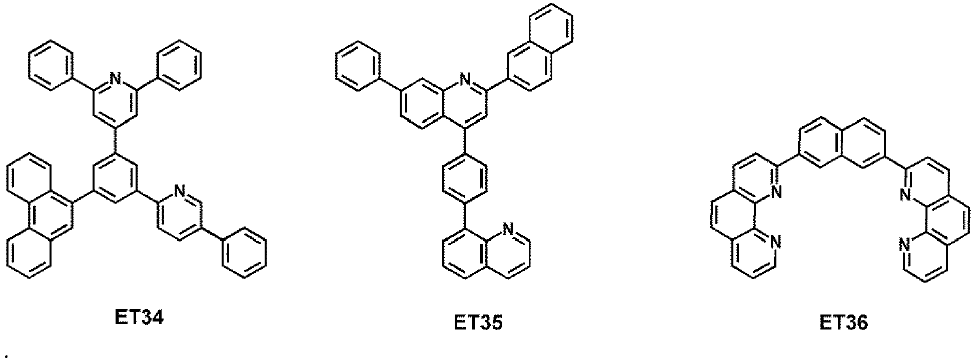

In one or more embodiments, the electron transport region may include at least one selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-tert-butylphenyl)-4-phenyl-4H-1,2,4-triazole (TAZ), and NTAZ:

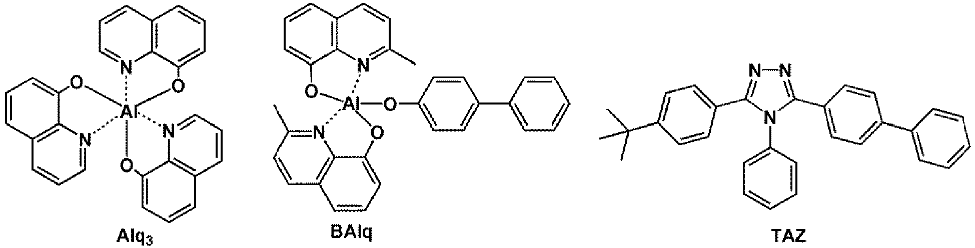

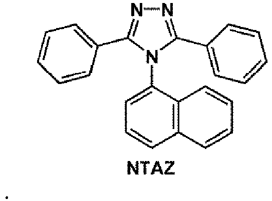

The thicknesses of the buffer layer, the hole blocking layer, or the electron control layer may each independently be in a range of about 20 Å to about 1,000 Å, and in some embodiments, about 30 Å to about 300 Å. When the thicknesses of the buffer layer, the hole blocking layer or the electron control layer are within any of these ranges, excellent hole blocking characteristics or excellent electron controlling characteristics may be obtained without a substantial increase in driving voltage.
The thickness of the electron transport layer may be in a range of about 100 Å to about 1,000 Å, and in some embodiments, about 150 Å to about 500 Å. When the thickness of the electron transport layer is within any of these ranges, excellent electron transport characteristics may be obtained without a substantial increase in driving voltage.
The electron transport region (e.g., the electron transport layer in the electron transport region) may further comprise, in addition to the materials described above, a material including metal.

The material comprising metal may comprise at least one selected from an alkali metal complex and an alkaline earth metal complex. The alkali metal complex may comprise a metal ion selected from a lithium (Li) ion, a sodium (Na) ion, a potassium (K) ion, a rubidium (Rb) ion, and a cesium (Cs) ion. The alkaline earth metal complex may comprise a metal ion selected from a beryllium (Be) ion, a magnesium (Mg) ion, a calcium (Ca) ion, an strontium (Sr) ion, and a barium (Ba) ion. Each ligand coordinated with the metal ion of the alkali metal complex and the alkaline earth metal complex may independently be selected from a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments are not limited thereto.

For example, the material including metal may include a Li complex. The Li complex may include, e.g., Compound ET-D1 (lithium quinolate, LiQ) or Compound ET-D2:

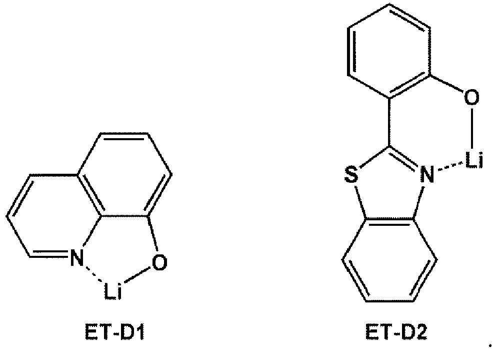

The electron transport region may comprise an electron injection layer that facilitates injection of electrons from the second electrode 190. The electron injection layer may be in direct contact with the second electrode 190.

The electron injection layer may comprise i) a single-layered structure including a single layer comprising a single material, ii) a single-layered structure including a single layer comprising a plurality of different materials, or iii) a multi-layered structure having a plurality of layers, each comprising a plurality of different materials.

The electron injection layer may comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

The alkali metal may be selected from Li, Na, K, Rb, and Cs. In one embodiment, the alkali metal may be Li, Na, or Cs. In one or more embodiments, the alkali metal may be Li or Cs, but embodiments are not limited thereto.

The alkaline earth metal may be selected from Mg, Ca, Sr, and Ba.
The rare earth metal may be selected from Sc, Y, Ce, Tb, Yb, and Gd.

The alkali metal compound, the alkaline earth metal compound, and the rare earth metal compound may each independently be selected from oxides and halides (e.g., fluorides, chlorides, bromides, or iodines) of the alkali metal, the alkaline earth metal, and the rare earth metal, respectively.

The alkali metal compound may be selected from alkali metal oxides, such as Li₂O, Cs₂O, or K₂O, and alkali metal halides, such as LiF, NaF, CsF, KF, LiI, NaI, CsI, KI, or RbI. In one embodiment, the alkali metal compound may be selected from LiF, Li₂O, NaF, LiI, NaI, CsI, and KI, but embodiments are not limited thereto.

The alkaline earth metal compound may be selected from alkaline earth metal compounds such as BaO, SrO, CaO, BaₓSr₁₋ₓO (where 0<x<1), and BaₓCa₁₋ₓO (where 0<x<1). In one embodiment, the alkaline earth metal compound may be selected from BaO, SrO, and CaO, but embodiments are not limited thereto.

The rare earth metal compound may be selected from YbF₃, ScF₃, ScOs, Y₂O₃, Ce₂O₃, GdF₃, and TbF₃. In one embodiment, the rare earth metal compound may be selected from YbF₃, ScF₃, TbF₃, YbI₃, ScI₃, and TbI₃, but embodiments are not limited thereto.

The alkali metal complex, the alkaline earth metal complex, and the rare earth metal complex may each comprise ions of the above-described alkali metal, alkaline earth metal, and rare earth metal. Each ligand coordinated with the metal ion of the alkali metal complex, the alkaline earth metal complex, and the rare earth metal complex may independently be selected from a hydroxyquinoline, a hydroxyisoquinoline, a hydroxybenzoquinoline, a hydroxyacridine, a hydroxyphenanthridine, a hydroxyphenyl oxazole, a hydroxyphenyl thiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments are not limited thereto.

The electron injection layer may comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof, as described above. In some embodiments, the electron injection layer may further comprise an organic material. When the electron injection layer further comprises an organic material, the alkali metal, the alkaline earth metal, the rare earth metal, the alkali metal compound, the alkaline earth metal compound, the rare earth metal compound, the alkali metal complex, the alkaline earth metal complex, the rare earth metal complex, or a combination thereof may be homogeneously or non-homogeneously dispersed in a matrix including the organic material.

The thickness of the electron injection layer may be in a range of about 1 Å to about 100 Å, and in some embodiments, about 3 Å to about 90 Å. When the thickness of the electron injection layer is within any of these ranges, excellent electron injection characteristics may be obtained without a substantial increase in driving voltage.

### Second electrode 190

The second electrode 190 may be disposed on the organic layer 150. In an embodiment, the second electrode 190 may be a cathode that is an electron injection electrode. In this embodiment, a material for forming the second electrode 190 may be a material having a low work function, for example, a metal, an alloy, an electrically conductive compound, or a combination thereof.

The second electrode 190 may comprise at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but embodiments are not limited thereto. The second electrode 190 may be a transmissive electrode, a semi-transmissive electrode, or a reflective electrode.

The second electrode 190 may comprise a single-layered structure, or a multi-layered structure including two or more layers.

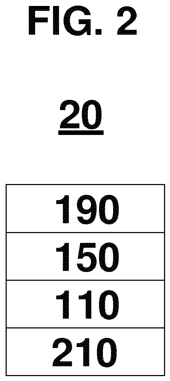

### Description of FIGS. 2 to 4

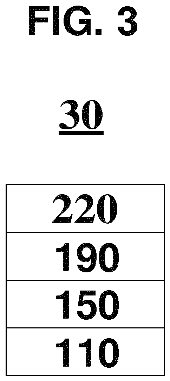

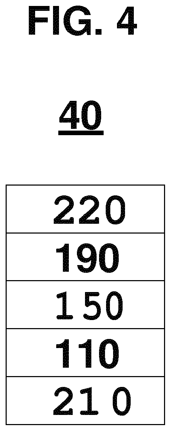

Referring to FIG. 2, an organic light-emitting device 20 has a first capping layer 210, the first electrode 110, the organic layer 150, and the second electrode 190 structure, wherein the layers are sequentially stacked in this stated order. Referring to FIG. 3, an organic light-emitting device 30 has the first electrode 110, the organic layer 150, the second electrode 190, and a second capping layer 220 structure, wherein the layers are sequentially stacked in this stated order. Referring to FIG. 4, an organic light-emitting device 40 has the first capping layer 210, the first electrode 110, the organic layer 150, the second electrode 190, and the second capping layer 220 structure, wherein the layers are stacked in this stated order.

The first electrode 110, the organic layer 150, and the second electrode 190 illustrated in FIGS. 2 to 4 may be substantially the same as those illustrated in FIG. 1. In the organic light-emitting devices 20 and 40, light emitted from the emission layer in the organic layer 150 may pass through the first electrode 110 (which may be a semi-transmissive electrode or a transmissive electrode) and through the first capping layer 210 to the outside. In the organic light-emitting devices 30 and 40, light emitted from the emission layer in the organic layer 150 may pass through the second electrode 190 (which may be a semi-transmissive electrode or a transmissive electrode) and through the second capping layer 220 to the outside.

The first capping layer 210 and the second capping layer 220 may improve the external luminescence efficiency based on the principle of constructive interference. The first capping layer 210 and the second capping layer 220 may each independently be a capping layer comprising an organic material, an inorganic capping layer comprising an inorganic material, or a composite capping layer comprising an organic material and an inorganic material.

At least one of the first capping layer 210 and the second capping layer 220 may each independently include at least one material selected from carbocyclic compounds, heterocyclic compounds, amine-based compounds, porphine derivatives, phthalocyanine derivatives, naphthalocyanine derivatives, alkali metal complexes, and alkaline earth metal complexes. The carbocyclic compound, the heterocyclic compound, and the amine-based compound may optionally be substituted with a substituent containing at least one element selected from O, N, S, Se, Si, F, Cl, Br, and I.

In one embodiment, at least one of the first capping layer 210 and the second capping layer 220 may each independently comprise an amine-based compound. In one or more embodiments, at least one of the first capping layer 210 and the second capping layer 220 may each independently comprise a compound represented by Formula 201 or a compound represented by 202.

In one or more embodiments, at least one of the first capping layer 210 and the second capping layer 220 may each independently comprise a compound selected from Compounds HT28 to HT33 and Compound CP1 to CP5, but embodiments are not limited thereto:

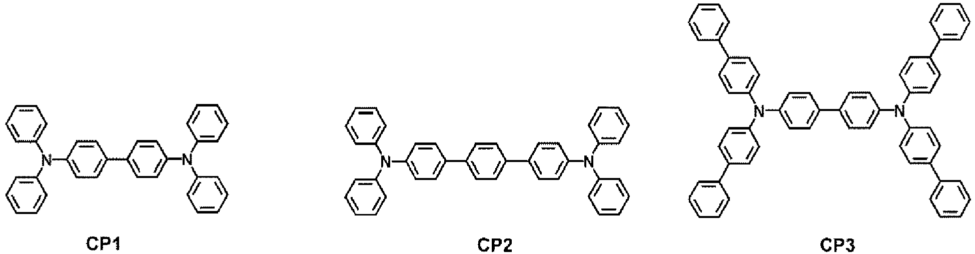

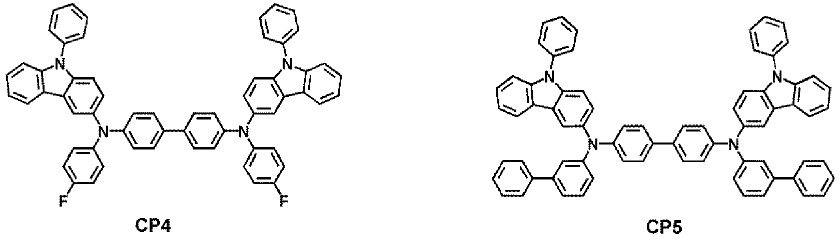

Hereinbefore, the organic light-emitting device has been described with reference to FIGS. 1 to 4, but embodiments are not limited thereto.

The layers comprising the hole transport region, the emission layer, and the layers comprising the electron transport region may be formed in a set or specific region by using one or more suitable methods such as vacuum deposition, spin coating, casting, Langmuir-Blodgett (LB) deposition, ink-jet printing, laser printing, and laser-induced thermal imaging.

When the layers comprising the hole transport region, the emission layer, and the layers comprising the electron transport region are each formed by vacuum deposition, the vacuum deposition may be performed at a deposition temperature in a range of about 100 °C to about 500 °C at a vacuum degree in a range of about 10⁻⁸ torr to about 10⁻³ torr, and at a deposition rate in a range of about 0.01 Angstroms per second (Å/ sec) to about 100 Å/ sec, depending on the material to be included in each layer and the structure of each layer to be formed.

When the layers comprising the hole transport region, the emission layer, and the layers comprising the electron transport region are each formed by spin coating, the spin coating may be performed at a coating rate of about 2,000 revolutions per minute (rpm) to about 5,000 rpm and at a heat treatment temperature of about 80 °C to about 200 °C, depending on the material to be included in each layer and the structure of each layer to be formed.

### General definitions of some of the substituents

The term "C₁-C₆₀ alkyl group," as used herein, refers to a linear or branched aliphatic hydrocarbon monovalent group having 1 to 60 carbon atoms, e.g. 1 to 30 carbon atoms, 1 to 20 carbon atoms, 1 to 10 carbon atoms, 1 to 6 carbon atoms or 1 to 4 carbon atoms. Examples thereof include a methyl group, an ethyl group, a propyl group, an iso-butyl group, a sec-butyl group, a tert-butyl group, a pentyl group, an isoamyl group, and a hexyl group. The term "C₁-C₆₀ alkylene group," as used herein, refers to a divalent group having substantially the same structure as the C₁-C₆₀ alkyl group.

The term "C₂-C₆₀ alkenyl group," as used herein, refers to a hydrocarbon group having at least one carbon-carbon double bond at a main chain (e.g., in the middle) or at the terminus of the C₂-C₆₀ alkyl group. Examples thereof include an ethenyl group, a propenyl group, and a butenyl group. The term "C₂-C₆₀ alkenylene group," as used herein, refers to a divalent group having substantially the same structure as the C₂-C₆₀ alkenyl group.

The term "C₂-C₆₀ alkynyl group," as used herein, refers to a hydrocarbon group having at least one carbon-carbon triple bond at a main chain (e.g., in the middle) or at the terminus of the C₂-C₆₀ alkyl group. Examples thereof include an ethynyl group and a propynyl group. The term "C₂-C₆₀ alkynylene group," as used herein, refers to a divalent group having substantially the same structure as the C₂-C₆₀ alkynyl group. The term "C₁-C₆₀ alkoxy group," as used herein, refers to a monovalent group represented by -OA₁₀₁ (wherein A₁₀₁ is a C₁-C₆₀ alkyl group). Examples thereof include a methoxy group, an ethoxy group, and an isopropyloxy group.

The term "C₃-C₁₀ cycloalkyl group," as used herein, refers to a monovalent monocyclic saturated hydrocarbon group including 3 to 10 carbon atoms. Examples thereof include a cyclopropyl group, a cyclobutyl group, a cyclopentyl group, a cyclohexyl group, and a cycloheptyl group. The term "C₃-C₁₀ cycloalkylene group," as used herein, refers to a divalent group having substantially the same structure as the C₃-C₁₀ cycloalkyl group.

The term "C₁-C₁₀ heterocycloalkyl group," as used herein, refers to a monovalent monocyclic group including at least one heteroatom (e.g. 1, 2, 3, 4 or 5 heteroatoms) selected from N, O, Si, P, and S as a ring-forming atom and 1 to 10 carbon atoms. Examples thereof include a 1,2,3,4-oxatriazolidinyl group, a tetrahydrofuranyl group, and a tetrahydrothiophenyl group. The term "C₁-C₁₀ heterocycloalkylene group," as used herein, refers to a divalent group having substantially the same structure as the C₁-C₁₀ heterocycloalkyl group.
The term "C₃-C₁₀ cycloalkenyl group," as used herein, refers to a monovalent monocyclic group that has 3 to 10 carbon atoms and at least one double bond in its ring, and is not aromatic. Examples thereof include a cyclopentenyl group, a cyclohexenyl group, and a cycloheptenyl group. The term "C₃-C₁₀ cycloalkenylene group," as used herein, refers to a divalent group having substantially the same structure as the C₃-C₁₀ cycloalkenyl group.

The term "C₁-C₁₀ heterocycloalkenyl group," as used herein, refers to a monovalent monocyclic group including at least one heteroatom (e.g. 1, 2, 3, 4 or 5 heteroatoms) selected from N, O, Si, P, and S as a ring-forming atom, 1 to 10 carbon atoms, e.g. 1, 2, 3, 4 or 5 ring carbon atoms, and at least one double bond in its ring. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group.

The term "C₁-C₁₀ heterocycloalkylene group," as used herein, refers to a divalent group having substantially the same structure as the C₁-C₁₀ heterocycloalkenyl group.

The term "C₆-C₆₀ aryl group," as used herein, refers to a monovalent group having a carbocyclic aromatic system having 6 to 60 carbon atoms. The term "C₆-C₆₀ arylene group," as used herein, refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each independently include two or more rings, the respective rings may be fused (e.g., combined together).

The term "C₁-C₆₀ heteroaryl group," as used herein, refers to a monovalent group having a heterocyclic aromatic system having at least one heteroatom (e.g. 1, 2, 3, 4 or 5 heteroatoms) selected from N, O, Si, P, and S as a ring-forming atom and 1 to 60 carbon atoms, e.g. 6 to 20 ring carbon atoms, 6 to 14 ring carbon atoms or 6 to 10 ring carbon atoms. The term "C₁-C₆₀ heteroarylene group," as used herein, refers to a divalent group having a heterocyclic aromatic system having at least one heteroatom (e.g. 1, 2, 3, 4 or 5 heteroatoms) selected from N, O, Si, P, and S as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each independently include two or more rings, the respective rings may be fused (e.g., combined together).

The term "C₆-C₆₀ aryloxy group," as used herein, refers to a group represented by -OA₁₀₂ (where A₁₀₂ is a C₆-C₆₀ aryl group). The term "C₆-C₆₀ arylthio group," as used herein, refers to a group represented by -SA₁₀₃ (where A₁₀₃ is a C₆-C₆₀ aryl group).

The term "monovalent non-aromatic condensed polycyclic group," as used herein, refers to a monovalent group that has two or more rings condensed and only carbon atoms as ring forming atoms (e.g., 8 to 60, 8 to 20, 8 to 14 or 8 to 10 ring carbon atoms), wherein the entire molecular structure is non-aromatic (e.g. the molecular structure does not have overall aromaticity). An example of the monovalent non-aromatic condensed polycyclic group may be a fluorenyl group. The term "divalent non-aromatic condensed polycyclic group," as used herein, refers to a divalent group having substantially the same structure as the monovalent non-aromatic condensed polycyclic group.

The term "monovalent non-aromatic condensed heteropolycyclic group," as used herein, refers to a monovalent group that has two or more condensed rings and at least one heteroatom (e.g. 1, 2, 3, 4 or 5 heteroatoms) selected from N, O, Si, P, and S, in addition to carbon atoms (e.g., 1 to 60 carbon atoms, more preferably 2 to 19, 2 to 13 or 2 to 9 ring carbon atoms), as a ring-forming atom, wherein the entire molecular structure is non-aromatic (e.g. the molecular structure does not have overall aromaticity). An example of the monovalent non-aromatic condensed heteropolycyclic group is a carbazolyl group. The term "divalent non-aromatic condensed heteropolycyclic group," as used herein, refers to a divalent group having substantially the same structure as the monovalent non-aromatic condensed heteropolycyclic group.

The term "C₅-C₆₀ carbocyclic group," as used herein, refers to a monocyclic or polycyclic group having 5 to 60 carbon atoms e.g. 5 to 20 carbon atoms, 5 to 14 carbon atoms or 5 to 10 carbon atoms in which carbon atoms are the only ring-forming atoms. The C₅-C₆₀ carbocyclic group may be an aromatic carbocyclic group or a non-aromatic carbocyclic group. The term "C₅-C₆₀ carbocyclic group," as used herein, refers to a ring (e.g., a benzene group), a monovalent group (e.g., a phenyl group), or a divalent group (e.g., a phenylene group). In one or more embodiments, depending on the number of substituents coupled or connected to the C₅-C₆₀ carbocyclic group, the C₅-C₆₀ carbocyclic group may be a trivalent group or a quadrivalent group.

The term "C₁-C₆₀ heterocyclic group," as used herein, refers to a group having substantially the same structure as the C₅-C₆₀ carbocyclic group, except that at least one heteroatom (e.g. 1, 2, 3, 4 or 5 heteroatoms) selected from N, O, Si, P, and S is used as a ring-forming atom, in addition to 1 to 60 carbon atoms (e.g., 1 to 20 ring carbon atoms, 1 to 14 ring carbon atoms or 1 to 10 ring carbon atoms).

The term "fluorine-containing C₅-C₆₀ carbocyclic group," as used herein, refers to the C₅-C₆₀ carbocyclic group having at least one substituent of -F. The term "substituted fluorine-containing C₅-C₆₀ carbocyclic group," as used herein, refers to the fluorine-containing C₅-C₆₀ carbocyclic group further substituted with at least one substituent defined herein. The term "unsubstituted fluorine-containing C₅-C₆₀ carbocyclic group," as used herein, refers to the fluorine-containing C₅-C₆₀ carbocyclic group having hydrogen only as a substituent, other than -F.

The term "fluorine-containing C₁-C₆₀ heterocyclic group," as used herein, refers to the C₁-C₆₀ heterocyclic group having at least one substituent of -F. The term "substituted fluorine-containing C₁-C₆₀ heterocyclic group," as used herein, refers to the fluorine-containing C₁-C₆₀ heterocyclic group further substituted with at least one substituent defined herein. The term "unsubstituted fluorine-containing C₁-C₆₀ heterocyclic group," as used herein, refers to the fluorine-containing C₁-C₆₀ heterocyclic group having hydrogen only as a substituent, other than -F.

In the present specification, at least one substituent of the substituted C₅-C₆₀ carbocyclic group, the substituted C₁-C₆₀ heterocyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, the substituted divalent non-aromatic condensed heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be selected from:
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group; a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group.

The term "Ph," as used herein, represents a phenyl group. The term "Me," as used herein, represents a methyl group. The term "Et," as used herein, represents an ethyl group. The term "ter-Bu" or "Bu^{t}," as used herein, represents a tert-butyl group. The term "OMe," as used herein, represents a methoxy group.

The term "biphenyl group," as used herein, refers to a phenyl group substituted with a phenyl group. In other words, the "biphenyl group" may be a substituted phenyl group having a C₆-C₆₀ aryl group as a substituent.

The term "terphenyl group," as used herein, refers to a phenyl group substituted with a biphenyl group. In other words, the "terphenyl group" may be a substituted phenyl group having a C₆-C₆₀ aryl group substituted with a C₆-C₆₀ aryl group as a substituent.

The symbols * and *', as used herein, unless defined otherwise, refer to a binding site to an adjacent atom in a corresponding formula.

Hereinafter, compounds and an organic light-emitting device according to one or more embodiments will be described in more detail with reference to Synthesis Examples and Examples. The wording "B was used instead of A" used in describing Synthesis Examples refers to that an identical (or substantially identical) number of molar equivalents ofB was used in place of A.

### Synthesis Examples

### Synthesis Example 1: Synthesis of Compound 2

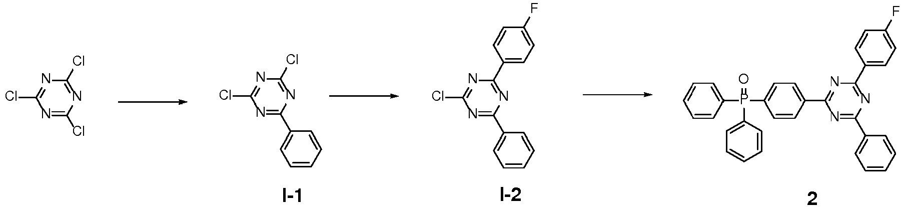

### Synthesis of Intermediate 1-1

1.84 g (10 mmol) of cyanuric chloride, 1.22 g (10 mmol) of phenylboronic acid, 1.15 g (1 mmol) of Pd(PPh₃)₄, and 4.14 g (30 mmol) of potassium carbonate were dissolved in 100 mL of a mixture solution of tetrahydrofuran (THF) and H₂O (at a ratio of 2:1). Subsequently, the mixture was stirred at a temperature of about 80 °C for about 24 hours. Distilled water was added to the resulting mixture, and an organic layer was extracted therefrom three times using 60 mL of ethyl acetate. The obtained organic layer was dried using magnesium sulfate (MgSO₄), and a solvent was removed therefrom by evaporation to obtain a residue. The residue was separated and purified through silica gel chromatography to thereby obtain 1.92 g of Intermediate I-1 (yield: 85%). The obtained compound was identified by liquid chromatography-mass spectrometry (LC-MS).
C₉H₅Cl₂N₃: M⁺ 225.03

### Synthesis of Intermediate 1-2

2.26 g (10 mmol) of Intermediate I-1 was dissolved in 100 mL of THF. Subsequently, 10 mL (10 mmol) of 4-fluorophenyl magnesiumbromide was added dropwise to the mixture solution at a temperature of 0 °C. Next, the resulting mixture was stirred for 12 hours at a temperature of 0 °C, which was then allowed to raise to room temperature. Distilled water was added to the resulting mixture, and an organic layer was extracted therefrom three times using 60 mL of ethyl acetate. The obtained organic layer was dried using MgSO₄, and a solvent was removed therefrom by evaporation to obtain a residue. The residue was separated and purified through silica gel chromatography to thereby obtain 2.14 g of Intermediate I-2 (yield: 75%). The obtained compound was identified by LC-MS.
C₁₅H₉ClFN₃: M⁺ 285.13

### Synthesis of Compound 2

2.85 g (10 mmol) of Intermediate I-2, 4.44 g (11 mmol) of diphenyl(4-(4,4,5,5-tetramethyl-1,3,2-dioxaborolan-2-yl)phenyl)phosphine oxide, 1.14 g (10 mol%) of Pd(PPh₃)₄, and 4.15 g (30 mmol) of K₂CO₃ were dissolved in 100 mL of a mixture solution of THF and H₂O (at a ratio of 2:1). Subsequently, the mixture was stirred at a temperature of about 80 °C for about 24 hours. The resulting mixture was cooled to room temperature, and an organic layer was extracted therefrom three times using 60 mL of ethyl acetate. The obtained organic layer was dried using MgSO₄, and a solvent was removed therefrom by evaporation to obtain a residue. The residue was separated and purified through silica gel chromatography to thereby obtain 4.06 g of Compound 2 (yield: 77%). The obtained compound was identified by LC-MS.
C₃₃H₂₃FN₃OP: M⁺ 527.17

### Synthesis Example 2: Synthesis of Compound 3

3.97 g of Compound 3 was obtained in substantially the same manner as in Synthesis of Compound 2, except that 1.84 g (10 mmol) of cyanuric chloride was used as a start material, and 20 mL (20 mmol) of 4-fluorophenyl magnesiumbromide was added dropwise instead of phenylboronic acid in Synthesis of Intermediate I-1 (yield: 73%).

The obtained compound was identified by mass spectroscopy/fast atom bombardment (MS/FAB) and ¹H nuclear magnetic resonance (NMR).
C₃₃H₂₂F₂N₃OP: M⁺ 545.14

### Synthesis Example 3: Synthesis of Compound 6

3.60 g of Compound 6 was obtained in substantially the same manner as in Synthesis of Compound 3, except that 10 mmol of 4-bromo-1,2-difluorobenzene was used instead of 4-fluorophenyl magnesium bromide (yield: 62%). The obtained compound was identified by MS/FAB and ¹H NMR.
C₃₃H₂₀ F₄N₃OP: M⁺ 581.15

### Synthesis Example 4: Synthesis of Compound 17

4.71 g of Compound 17 was obtained in substantially the same manner as in Synthesis of Compound 2, except that (4-cyanophenyl)boronic acid was used instead of phenylboronic acid, and diphenyl(3-(4,4,5,5-tetramethyl-1,3,2-dioxaborolan-2-yl)phenyl)phosphine oxide was used instead of diphenyl(4-(4,4,5,5-tetramethyl-1,3,2-dioxaborolan-2-yl)phenyl)phosphine oxide (yield: 75%). The obtained compound was identified by MS/ FAB and ¹H NMR.
C₄₀H₂₆FN₄OP: M⁺ 628.17

### Synthesis Example 5: Synthesis of Compound 30

4.78 g of Compound 30 was obtained in substantially the same manner as in Synthesis of Compound 3, except that diphenyl(4-(4-(4-(4,4,5,5-tetramethyl-1,3,2-dioxaborolan-2-yl)phenyl)naphthalen-1-yl)phenyl)phosphine oxide was used instead of diphenyl(4-(4,4,5,5-tetramethyl-1,3,2-dioxaborolan-2-yl)phenyl)phosphine oxide (yield: 64%). The obtained compound was identified by MS/ FAB and ¹H NMR.
C₄₉H₃₂F₂N₃OP: M⁺ 747.25

### Synthesis Example 6: Synthesis of Compound 78

4.49 g of Compound 78 was obtained in substantially the same manner as in Synthesis of Compound 3, except that diphenyl(3-(4-(4-(4,4,5,5-tetramethyl-1,3,2-dioxaborolan-2-yl)phenyl)naphthalen-1-yl)phenyl)phosphine oxide was used instead of diphenyl(4-(4,4,5,5-tetramethyl-1,3,2-dioxaborolan-2-yl)phenyl)phosphine oxide (yield: 60%). The obtained compound was identified by MS/ FAB and ¹H NMR.
C₄₉H₃₂F₂N₃OP: M⁺ 747.24

### Synthesis Example 7: Synthesis of Compound 98

4.13 g of Compound 98 was obtained in substantially the same manner as in Synthesis of Compound 3, except that diphenyl(3-(2-(4,4,5,5-tetramethyl-1,3,2-dioxaborolan-2-yl)dibenzo[b,d]furan-4-yl)phenyl)phosphine oxide was used instead of diphenyl(4-(4,4,5,5-tetramethyl-1,3,2-dioxaborolan-2-yl)phenyl)phosphine oxide (yield: 58%). The obtained compound was identified by MS/ FAB and ₁H NMR.
C₄₅H₂₈F₂N₃O₂P: M⁺ 711.20

### Synthesis Example 8: Synthesis of Compound 116

3.40 g of Compound 116 was obtained in substantially the same manner as in Synthesis of Compound 3, except that 5-phenyl-3-(4-(4,4,5,5-tetramethyl-1,3,2-dioxaborolan-2-yl)phenyl)benzo[b]phosphindole 5-oxide was used instead of diphenyl(4-(4,4,5,5-tetramethyl-1,3,2-dioxaborolan-2-yl)phenyl)phosphine oxide (yield: 55%). The obtained compound was identified by MS/ FAB and ₁H NMR.
C₃₉H₂₄F₂N₃OP: M⁺ 619.18

**Table 1**

| Compound | ¹H NMR (CDCl₃, 500 MHz) | HR-EIMS | |
|---|---|---|---|
| | | found | calc. |
| 2 | δ = 8.80-8.79(m, 2H), 8.47-8.45(m, 2H), 8.34-8.31(m, 2H), 8.07-8.02(m, 2H), 7.70-7.68(m, 4H), 7.63-7.59(m, 2H), 7.49-7.47(m, 2H), 7.44-7.39(m, 5H), 7.29-7.25(m, 2H) | 527.17 | 527.16 |
| 3 | δ = 8.47-8.45(m, 2H), 8.34-8.31(m, 4H), 8.07-8.02(m, 2H), 7.70-7.66(m, 4H), 7.52-7.48(m, 2H), 7.44-7.42(m, 4H), 7.29-7.25(m, 4H) | 545.14 | 545.15 |
| 6 | δ = 8.47-8.42(m, 4H), 7.19-7.16(m, 2H), 8.07-8.02(m, 2H), 7.70-7.66(m, 4H), 7.52-7.48(m, 2H), 7.44-7.41(m, 4H), 7.31-7.25(m, 2H) | 581.15 | 581.13 |
| 17 | δ = 8.58-8.56(m, 2H), 8.41-8.38(m, 2H), 8.34-8.31(m, 2H), 8.00-7.97(m, 1H), 7.89-7.84(m, 4H), 7.70-7.63(m, 5H), 7.57-7.48(m, 4H), 7.43-7.41(m, 4H), 7.29-7.25(m, 2H) | 628.17 | 628.18 |
| 30 | δ = 8.53-8.50(m, 2H), 8.34-8.31(m, 4H), 8.07-8.05(m, 2H), 7.73-7.66(m, 7H), 7.62-7.57(m, 4H), 7.5 2 - 7.4 2 (m, 7H), 7.29-7.25(m, 4H), 7.01-6.98(m, 2H) | 747.25 | 747.23 |
| 78 | δ = 8.53-8.50(m, 2H), 8.34-8.31(m, 4H), 8.07-8.01(m, 3H), 7.83-7.81(m, 1H), 7.70-7.63(m, 5H), 7.57-7.53(m, 2H), 7.51-7.46(m, 4H), 7.43-7.41(m, 4H), 7.29-7.25(m, 4H), 7.00-7.69(m, 2H) | 747.24 | 747.23 |
| 98 | δ = 9.08-9.06(m, 1H), 8.73-8.71(m, 1H), 8.34-8.31(m, 4H), 8.26-8.23(m, 1H), 7.96-7.94(m, 1H), 7.87-7.85(m, 1H), 7.68-7.62(m, 6H), 7.54-7.47(m, 4H), 7.43-7.41(m, 4H), 7.33-7.25(m, 5H) | 711.20 | 711.19 |
| 116 | δ = 8.43-8.41(m, 2H), 8.34-8.31(m, 4H), 8.00-7.96(m, 2H), 7.87-7.77(m, 6H), 7.57-7.52(m, 2H), 7.49-7.45(m, 1H), 7.41-7.37(m, 2H), 7.35-7.33(m, 1H), 7.29-7.25(m, 4H) | 619.18 | 619.16 |

### Examples

### Example 1

A15 Ohms per square centimeter (Ω/cm²) (1,200 Å) ITO glass substrate (available from Corning Inc.) was cut to a size of 50 millimeters (mm) x 50 mm x 0.7 mm, sonicated in isopropyl alcohol and pure water for 5 minutes in each solvent, and cleaned by exposure to ultraviolet rays and ozone for 30 minutes so as to use the ITO glass substrate as a substrate and an anode. Then, the glass substrate was mounted on a vacuum-deposition device.

2-TNATA was vacuum-deposited on the ITO anode formed on the glass substrate to form a hole injection layer having a thickness of about 600 Å. 4,4'-bis[N-(1-naphthyl)-N-phenylamino]biphenyl (hereinafter, referred to as "NPB") was then vacuum-deposited on the hole injection layer to form a hole transport layer having a thickness of about 300 Å.

On the hole transport layer, 9,10-di-naphthalene-2-yl-anthracene (hereinafter referred to as "ADN") as a host and 4,4'-bis[2-(4-(N,N-diphenylamino)phenyl)vinyl]biphenyl (hereinafter referred to as "DPAVBi") as a dopant were co-deposited to a weight ratio of about 98:2 to form an emission layer having a thickness of about 300 Å.
Compound 2 was deposited on the emission layer to form an electron transport layer having a thickness of 300 Å, LiF was deposited on the electron transport layer to form an electron injection layer having a thickness of 10 Å, and Al was vacuum-deposited on the electron injection layer to form a LiF/ Al electrode, i.e., a cathode, having a thickness of 3,000 Å, thereby completing the manufacture of an organic light-emitting device.

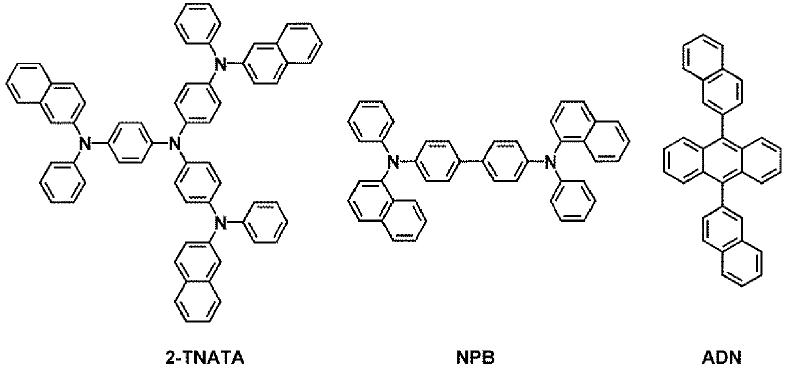

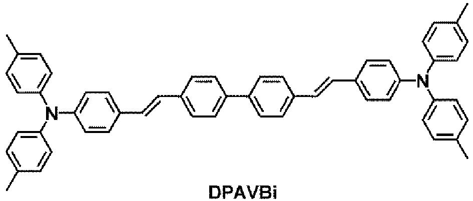

### Examples 2 to 8 and Comparative Examples 1 to 3

Organic light-emitting devices were manufactured in substantially the same manner as in Example 1, except that the compounds shown in Table 2 were used instead of Compound 2 in forming each electron transport layer.

The device performances (driving voltage, luminance, and efficiency) of the organic light-emitting device manufactured in Examples 1 to 8 and Comparative Examples 1 to 3 at a current density of 50 mA/cm² were measured, and the half lifespans of the devices were measured at a current density of 100 mA/cm². The results thereof are shown in Table 2.
- The efficiency and luminescence were measured using a luminance meter PR650 powered by a current voltmeter (Keithley SMU 236).

**Table 2**

| | Material | Driving voltage (V) | Current density (mA/cm²) | Luminescence (cd/ m²) | Efficiency (cd/ A) | Emission color | Half lifespan (hr @ 100mA/ cm²) |
|---|---|---|---|---|---|---|---|
| Example 1 | Compound 2 | 4.85 | 50 | 3,375 | 6.75 | blue | 371 hrs |
| Example 2 | Compound 3 | 4.51 | 50 | 3,595 | 7.19 | blue | 398 hrs |
| Example 3 | Compound 6 | 4.57 | 50 | 3,520 | 7.04 | blue | 382 hrs |
| Example 4 | Compound 17 | 4.64 | 50 | 3,425 | 6.85 | blue | 377 hrs |
| Example 5 | Compound 30 | 4.60 | 50 | 3,690 | 7.38 | blue | 422 hrs |
| Example 6 | Compound 78 | 4.68 | 50 | 3,635 | 7.27 | blue | 403 hrs |
| Example 7 | Compound 98 | 4.89 | 50 | 3,275 | 6.55 | blue | 375 hrs |
| Example 8 | Compound 116 | 4.84 | 50 | 3,320 | 6.64 | blue | 384 hrs |
| Comparative Example 1 | Compound 200 | 5.06 | 50 | 3,010 | 6.02 | blue | 325 hrs |
| Comparative Example 2 | Compound A | 5.17 | 50 | 3,185 | 6.37 | blue | 379 hrs |
| Comparative Example 3 | Compound B | 5.31 | 50 | 3,150 | 6.30 | blue | 297 hrs |

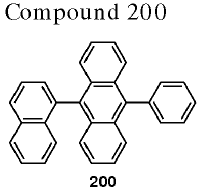

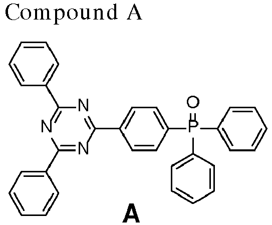

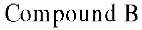

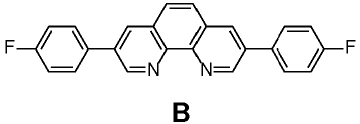

Referring to the results of Table 1, it was found that the organic light-emitting devices of Examples 1 to 8 have improved driving voltage, excellent I-V-L characteristics with improved efficiency, and for example, significantly improved lifespan, as compared with the organic light-emitting devices of Comparative Examples 1 to 3.

In other words, when the compound according to one or more embodiments are used as an electron transport material in a device, the device may have excellent effects in driving voltage, luminescence, efficiency, and lifespan.

As apparent from the foregoing description, an organic light-emitting device comprising the heterocyclic compound may have a low driving voltage, high efficiency, long lifespan, and high maximum quantum efficiency.

It should be understood that embodiments described herein should be considered in a descriptive sense only and not for purposes of limitation. Descriptions of features or aspects within each embodiment should typically be considered as available for other similar features or aspects in other embodiments.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.
As used herein, the terms "substantially," "about," and similar terms are used as terms of approximation and not as terms of degree, and are intended to account for the inherent deviations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively. Also, the term "exemplary" is intended to refer to an example or illustration.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

While one or more embodiments have been described with reference to the figures, it will be understood by those of ordinary skill in the art that various changes in form and details may be made therein without departing from the scope as defined by the following claims.

## Claims

1. A heterocyclic compound represented by Formula 1: 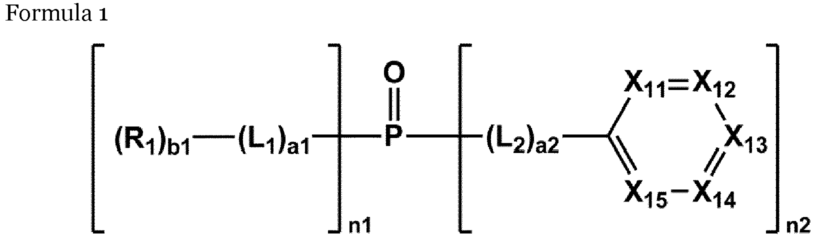
wherein, in Formula 1,
X₁₁, X₁₃, and X₁₅ are each N, X₁₂ is C-[(L₁₂)ₐ₁₂-(R₁₂)_{b12}], and X₁₄ is C-[(L₁₄)ₐ₁₄-(R₁₄)_{b14}]
n1 is selected from o, 1, and 2, n2 is selected from 1, 2, and 3, a sum of n1+n2 is 3,
L₁, L₂, L₁₂, L₁₄, R₁, R₁₂ and R₁₄ are each independently selected from a substituted or unsubstituted C₅-C₆₀ carbocyclic group and a substituted or unsubstituted C₁-C₆₀ heterocyclic group,
a1, a2, a12 and a14 are each independently an integer from 0 to 5,
when a1 is o, *-(L₁)ₐ₁-*' is a single bond; when a2 is 0, *-(L₂)ₐ₂-*' is a single bond; when a12 is 0, *-(L₁₂)ₐ₁₂-*' is a single bond; when a14 is o, *-(L₁₄)ₐ₁₄-*' is a single bond;
when a1 is 2 or greater, at least two L₁ groups are identical to or different from each other; when a2 is 2 or greater, at least two L₂ groups are identical to or different from each other; when a12 is 2 or greater, at least two L₁₂ groups are identical to or different from each other; when a14 is 2 or greater, at least two L₁₄ groups are identical to or different from each other;
b1, b12 and b14 are each independently an integer from 1 to 10,
when b1 is 2 or greater, at least two R₁ groups are identical to or different from each other; when b12 is 2 or greater, at least two R₁₂ groups are identical to or different from each other; when b14 is 2 or greater, at least two R₁₄ groups are identical to or different from each other;
two adjacent groups selected from L₁, L₂, L₁₂, L₁₄, R₁, R₁₂ and R₁₄ are optionally bound to form a substituted or unsubstituted C₅-C₆₀ carbocyclic group or a substituted or unsubstituted C₁-C₆₀ heterocyclic group,
wherein the heterocyclic compound represented by Formula 1 comprises at least one -F, and
the substituted C₅-C₆₀ carbocyclic group and the substituted C₁-C₆₀ heterocyclic group are substituted with one or more substituents selected from:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, and a terphenyl group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, a terphenyl group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and - P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group,
* indicates a binding site to an adjacent atom; and
(i) at least one of R₁₂ and R₁₄ is selected from a substituted or unsubstituted fluorine-containing C₅-C₆₀ carbocyclic group and a substituted or unsubstituted fluorine-containing C₁-C₆₀ heterocyclic group or (ii) at least one of R₁₂ and R₁₄ is selected from groups represented by Formulae 7-1 to 7-77: 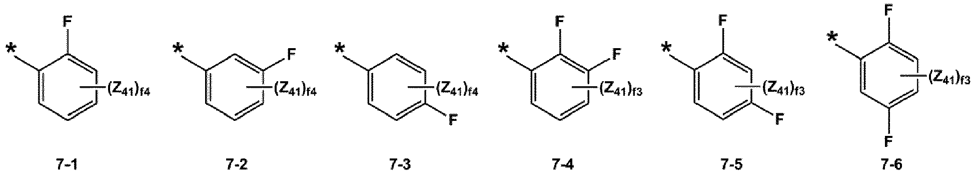 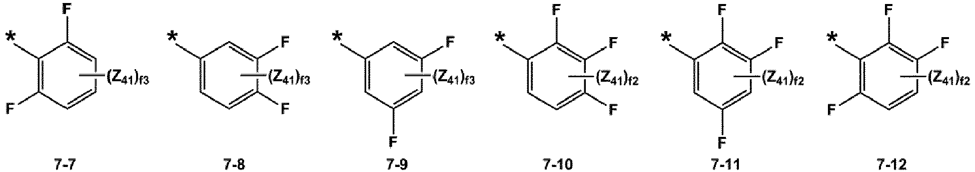 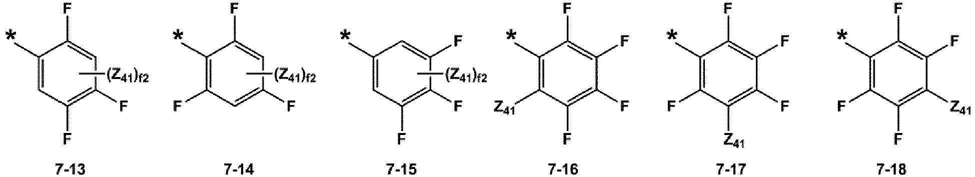 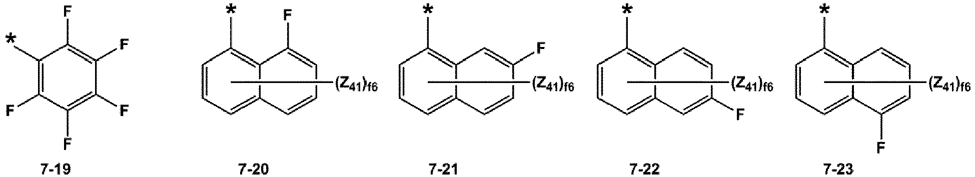 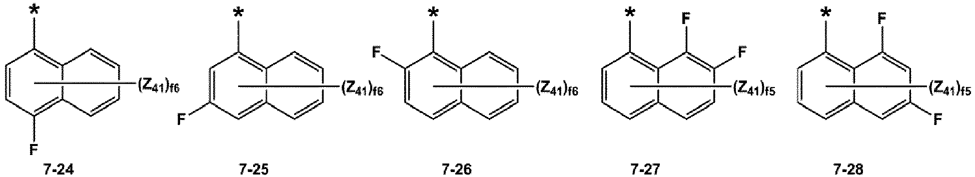 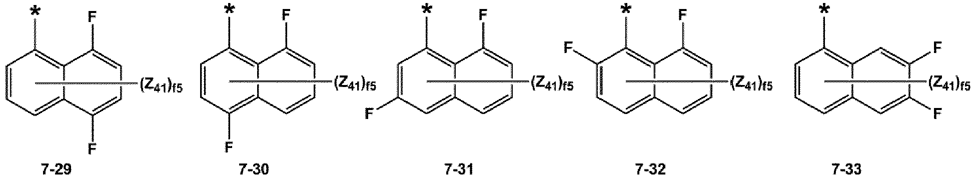 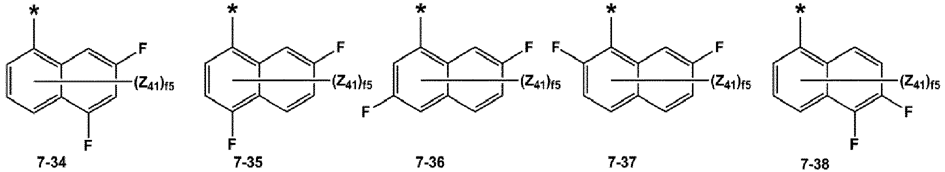 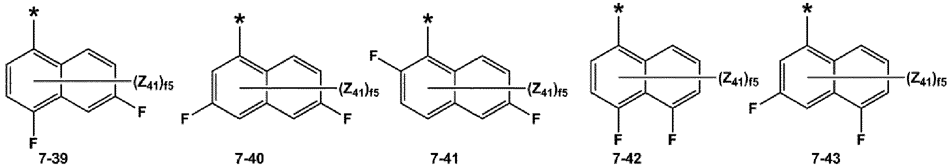 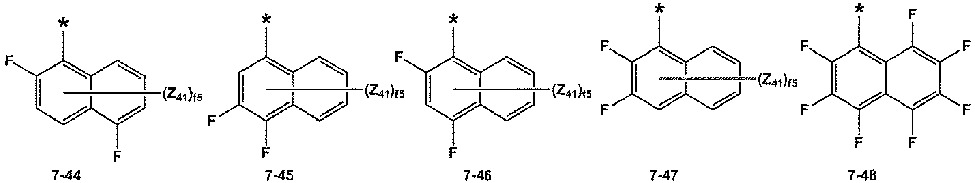 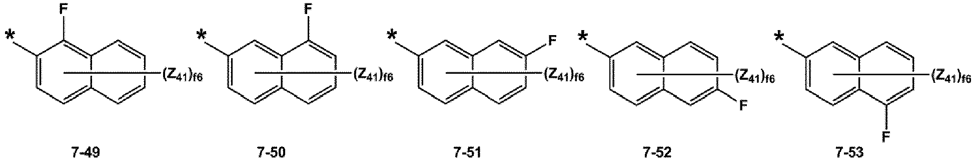 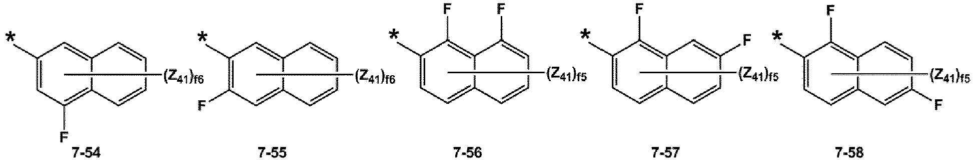 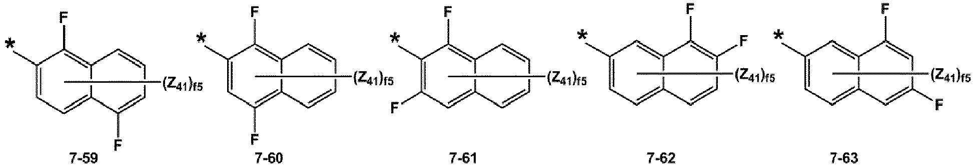 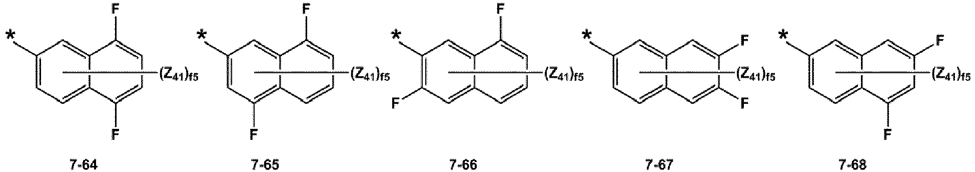 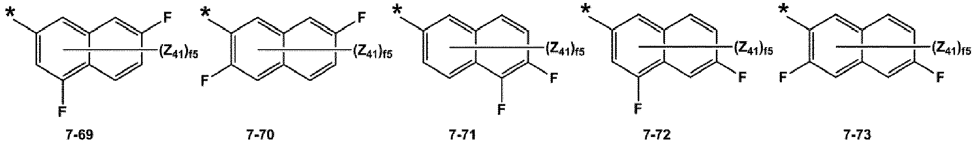 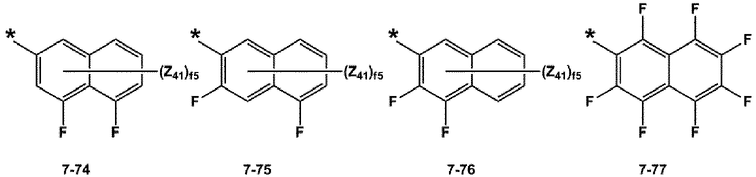
wherein, in Formulae 7-1 to 7-77,
Z₄₁ is selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a spiro-fluorene-benzofluorenyl group, a benzofluorenyl group, a dibenzofluorenyl group, a phenalenyl group, a phenanthrenyl group, an anthracenyl group, a fluoranthenyl group, a triphenylenyl group, a pyridinyl group, a pyrazinyl group, a pyrimidinyl group, a quinolinyl group, an isoquinolinyl group, a benzoquinolinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, and - Si(Q₃₁)(Q₃₂)(Q₃₃),
f2 is an integer selected from 1 and 2; when f2 is 2, at least two Z₄₁ groups are identical to or different from each other,
f3 is an integer from 1 to 3; when f3 is 2 or greater, at least two Z₄₁ groups are identical to or different from each other,
f4 is an integer from 1 to 4; when f4 is 2 or greater, at least two Z₄₁ groups are identical to or different from each other,
f5 is an integer from 1 to 5; when f5 is 2 or greater, at least two Z₄₁ groups are identical to or different from each other,
f6 is an integer from 1 to 6; when f6 is 2 or greater, at least two Z₄₁ groups are identical to or different from each other,
Q₃₁ to Q₃₃ are each independently selected from hydrogen, deuterium, -F, -Cl, - Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group, and
* indicates a binding site to an adjacent atom.

2. The heterocyclic compound of claim 1, wherein L₁, L₂, L₁₂, L₁₄, R₁, R₁₂, and R₁₄ are each independently selected from:
a benzene group, a pentalene group, an indene group, a naphthalene group, an azulene group, a heptalene group, an indacene group, an acenaphthalene group, a fluorene group, a spiro-fluorene group, a benzofluorene group, a phenalene group, a phenanthrene group, an anthracene group, a fluoranthene group, a triphenylene group, a pyrene group, a chrysene group, a naphthacene group, a picene group, a perylene group, a pentaphenylene group, a hexacene group, a pyrrole group, an imidazole group, a pyrazole group, a pyridine group, a pyrazine group, a pyrimidine group, a pyridazine group, an isoindole group, an indole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzoxazole group, a benzimidazole group, a furan group, a benzofuran group, a thiophene group, a benzothiophene group, a thiazole group, an isothiazole group, a benzothiazole group, an isoxazole group, an oxazole group, a triazole group, a tetrazole group, an oxadiazole group, a triazine group, a benzoxazole group, a dibenzofuran group, a dibenzothiophene group, a benzocarbazole group, and a dibenzocarbazole group; and
a benzene group, a pentalene group, an indene group, a naphthalene group, an azulene group, a heptalene group, an indacene group, an acenaphthalene group, a fluorene group, a spiro-fluorene group, a benzofluorene group, a phenalene group, a phenanthrene group, an anthracene group, a fluoranthene group, a triphenylene group, a pyrene group, a chrysene group, a naphthacene group, a picene group, a perylene group, a pentaphenylene group, a hexacene group, a pyrrole group, an imidazole group, a pyrazole group, a pyridine group, a pyrazine group, a pyrimidine group, a pyridazine group, an isoindole group, an indole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzoxazole group, a benzimidazole group, a furan group, a benzofuran group, a thiophene group, a benzothiophene group, a thiazole group, an isothiazole group, a benzothiazole group, an isoxazole group, an oxazole group, a triazole group, a tetrazole group, an oxadiazole group, a triazine group, a benzoxazole group, a dibenzofuran group, a dibenzothiophene group, a benzocarbazole group, and a dibenzocarbazole group, each substituted with at least one selected from deuterium, -F, -Cl, -Br, -I, a hydroxyl group, a cyano group, a nitro group, an amino group, an amidino group, a hydrazino group, a hydrazono group, a C₁-C₂₀ alkyl group, a C₁-C₂₀ alkoxy group, a C₆-C₂₀ aryl group, a C₂-C₂₀ heteroaryl group, and -Si(Q₃₁)(Q₃₂)(Q₃₃)
wherein Q₃₁ to Q₃₃ are each independently selected from hydrogen, deuterium, - F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group.

3. The heterocyclic compound of claim 1 or claim 2, wherein L₁, L₂, L₁₂, and L₁₄ are each independently selected from groups represented by Formulae 3-1 to 3-47: 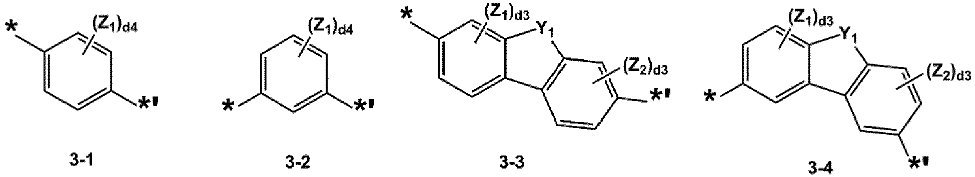 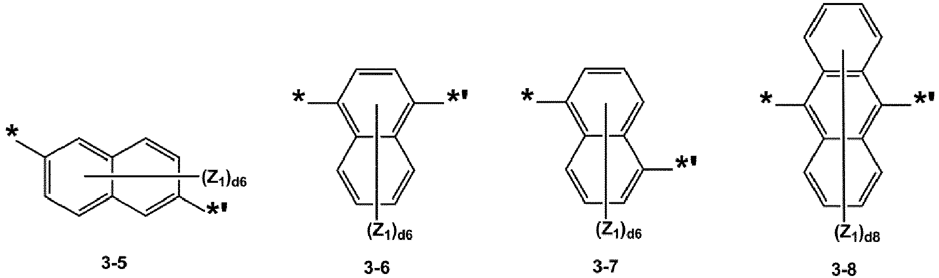 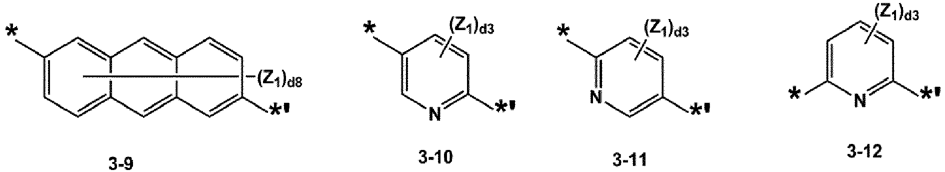 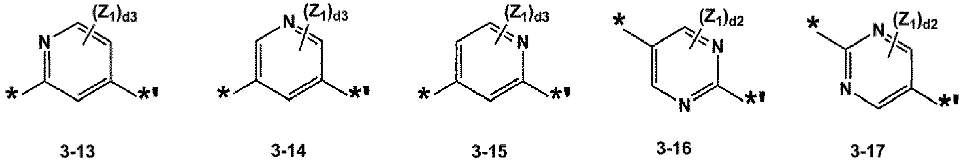 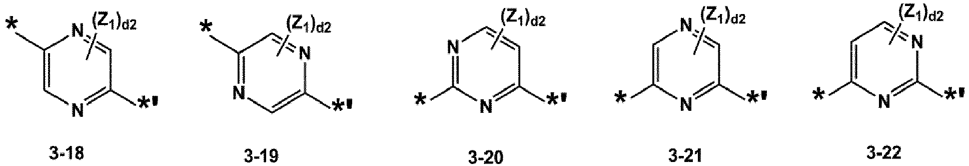 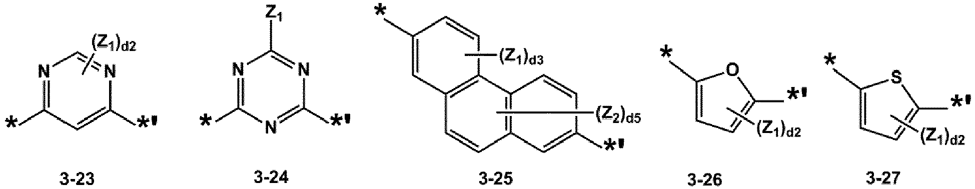 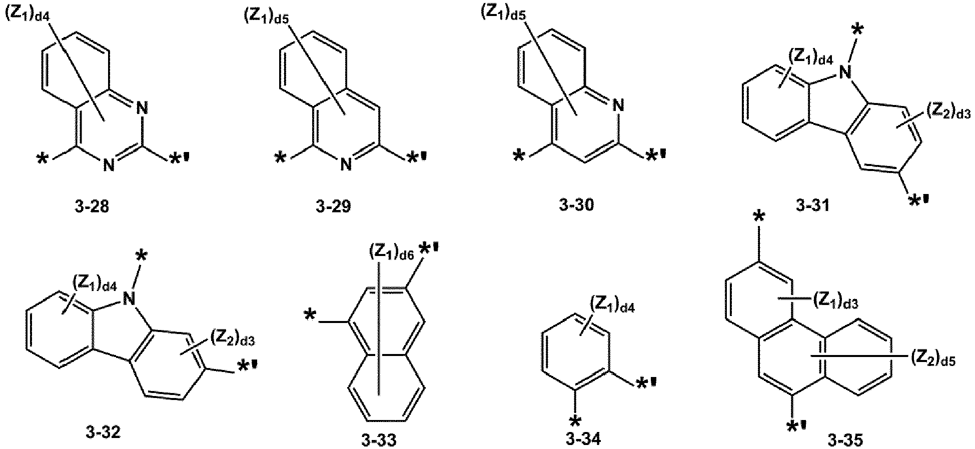 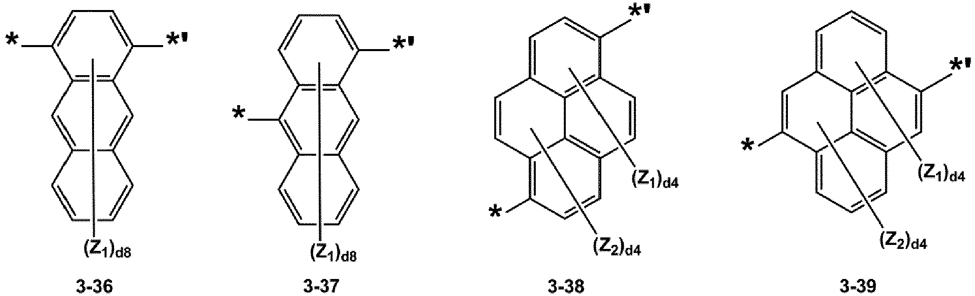 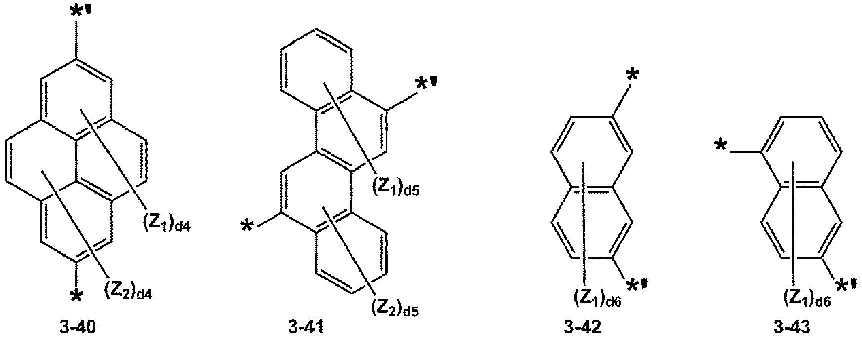 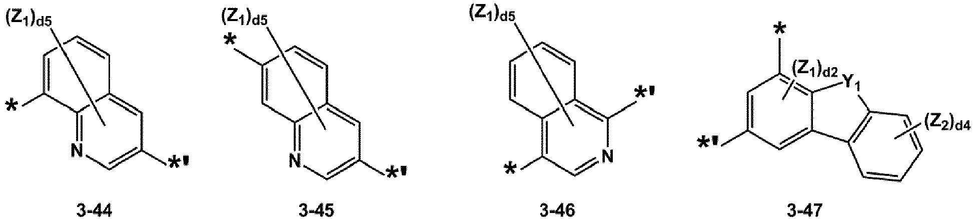
wherein, in Formulae 3-1 to 3-47,
Y₁ is selected from O, S, C(Z₃)(Z₄), N(Z₅), and Si(Z₆)(Z₇),
Z₁ to Z₇ are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a phenalenyl group, a phenanthrenyl group, an anthracenyl group, a fluoranthenyl group, a triphenylenyl group, a pyridinyl group, a pyrazinyl group, a pyrimidinyl group, a quinolinyl group, an isoquinolinyl group, a benzoquinolinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, and - Si(Q₃₁)(Q₃₂)(Q₃₃),
d₂ is an integer from o to 2; when d2 is 2, at least two Z₁ groups are identical to or different from each other,
d3 is an integer from o to 3; when d3 is 2 or greater, at least two Z₁ groups are identical to or different from each other, and at least two Z₂ groups are identical to or different from each other,
d4 is an integer from o to 4; when d4 is 2 or greater, at least two Z₁ groups are identical to or different from each other, and at least two Z₂ groups are identical to or different from each other,
d5 is an integer from o to 5; when d5 is 2 or greater, at least two Z₁ groups are identical to or different from each other, and at least two Z₂ groups are identical to or different from each other,
d6 is an integer from o to 6; when d6 is 2 or greater, at least two Z₁ groups are identical to or different from each other, and at least two Z₂ groups are identical to or different from each other,
d8 is an integer from o to 8; when d8 is 2 or greater, at least two Z₁ groups are identical to or different from each other,
Q₃₁ to Q₃₃ are each independently selected from hydrogen, deuterium, -F, -Cl, - Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group, and
* and *' each indicate a binding site to an adjacent atom.

4. The heterocyclic compound of any one of claims 1 to 3, wherein R₁, R₁₂ and R₁₄ are each independently selected from groups represented by Formulae 5-1 to 5-79: 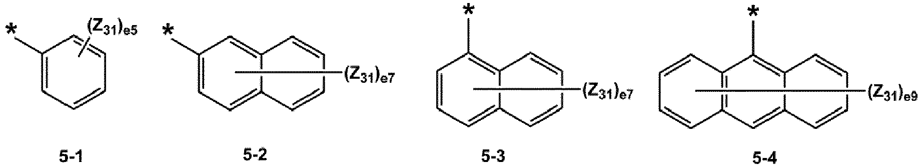 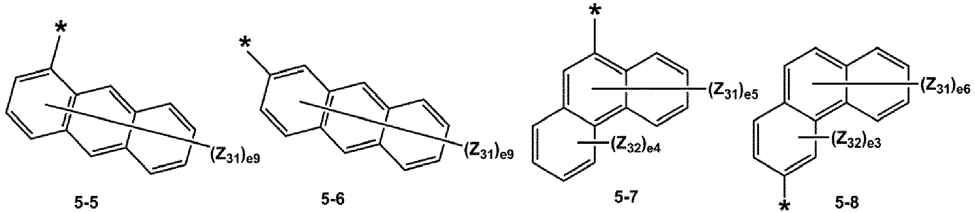 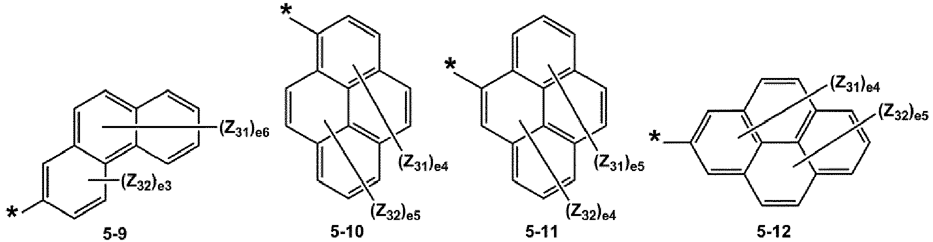 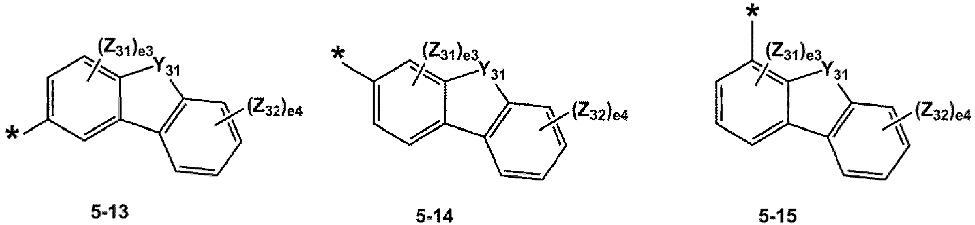 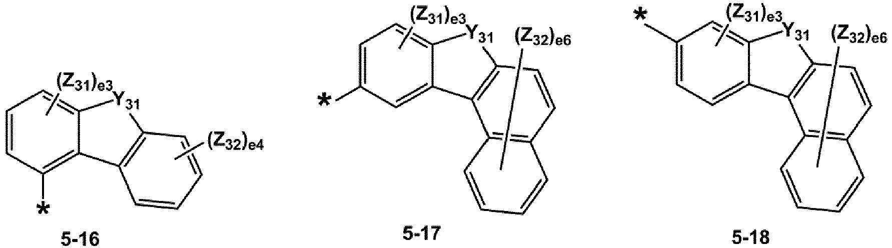 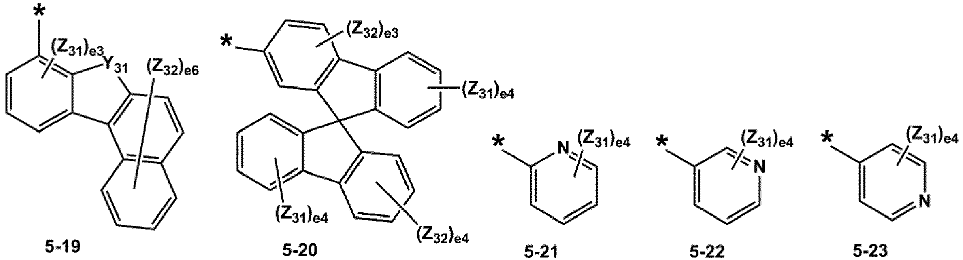 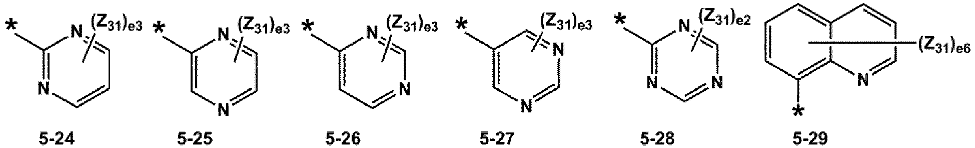 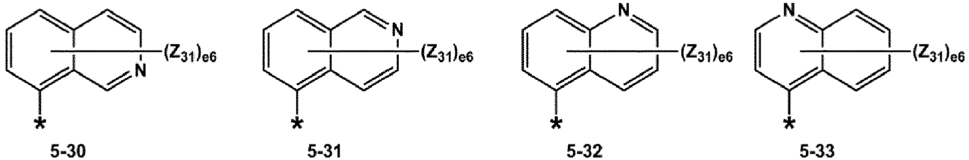 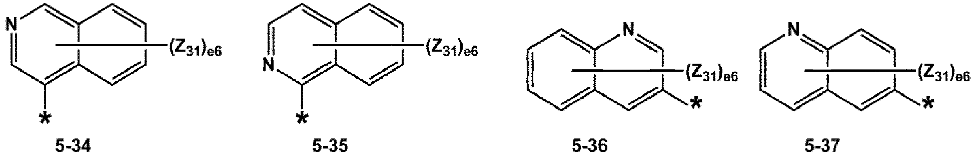 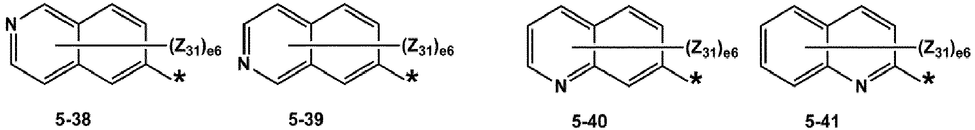 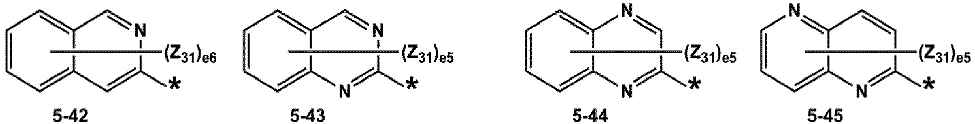 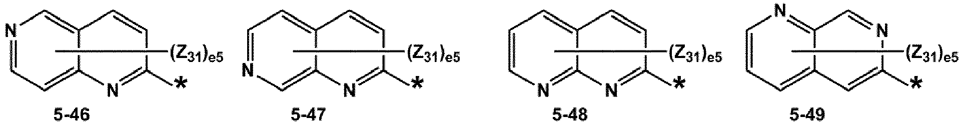 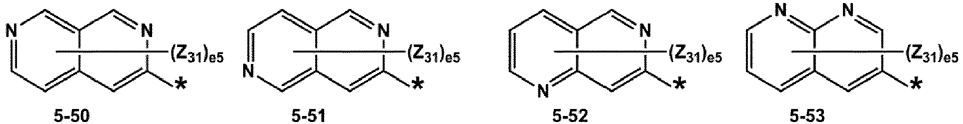 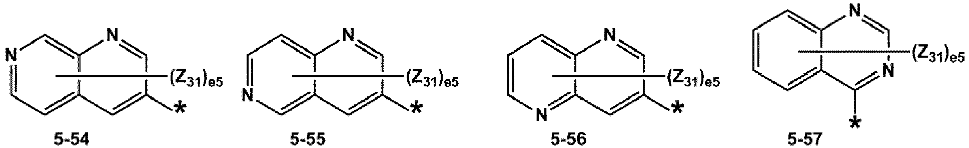 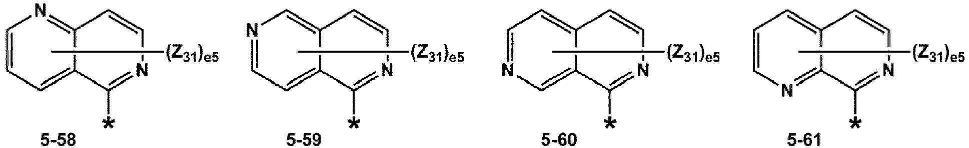 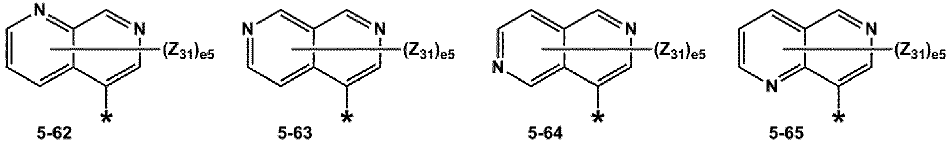 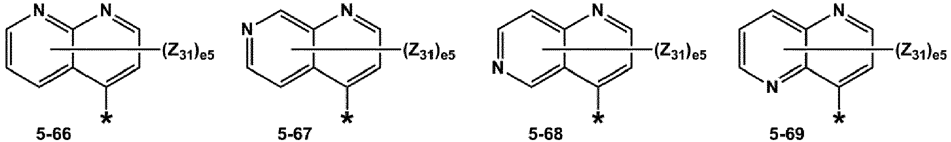 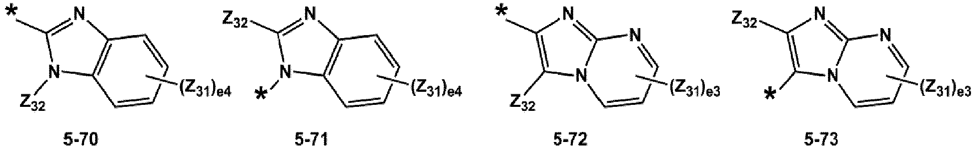 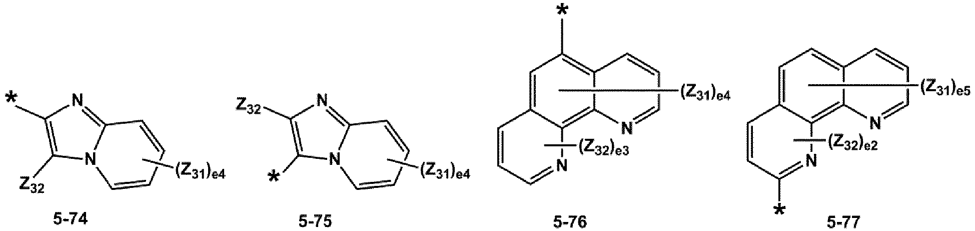 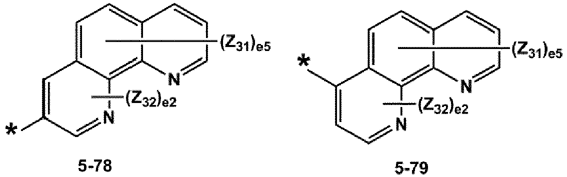
wherein, in Formulae 5-1 to 5-79,
Y₃₁ is selected from O, S, C(Z₃₃)(Z₃₄), N(Z₃₅), and Si(Z₃₆)(Z₃₇),
Z₃₁ to Z₃₇ are each independently selected from hydrogen, deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a spiro-fluorene-benzofluorenyl group, a benzofluorenyl group, a dibenzofluorenyl group, a phenalenyl group, a phenanthrenyl group, an anthracenyl group, a fluoranthenyl group, a triphenylenyl group, a pyridinyl group, a pyrazinyl group, a pyrimidinyl group, a quinolinyl group, an isoquinolinyl group, a benzoquinolinyl group, a naphthyridinyl group, a quinoxalinyl group, a quinazolinyl group, a carbazolyl group, a phenanthridinyl group, an acridinyl group, a phenanthrolinyl group, a phenazinyl group, a triazinyl group, a dibenzofuranyl group, a dibenzothiophenyl group, and -Si(Q₃₁)(Q₃₂)(Q₃₃),
e2 is an integer from o to 2; when e2 is 2, at least two Z₃₁ groups are identical to or different from each other, and at least two Z₃₂ groups are identical to or different from each other,
e3 is an integer from o to 3; when e3 is 2 or greater, at least two Z₃₁ groups are identical to or different from each other, at least two Z₃₂ groups are identical to or different from each other,
e4 is an integer from o to 4; when e4 is 2 or greater, at least two Z₃₁ groups are identical to or different from each other, at least two Z₃₂ groups are identical to or different from each other,
e5 is an integer from o to 5; when e5 is 2 or greater, at least two Z₃₁ groups are identical to or different from each other, at least two Z₃₂ groups are identical to or different from each other,
e6 is an integer from o to 6; when e6 is 2 or greater, at least two Z₃₁ groups are identical to or different from each other, at least two Z₃₂ groups are identical to or different from each other,
e7 is an integer from o to 7; when e7 is 2 or greater, at least two Z₃₁ groups are identical to or different from each other,
e9 is an integer from o to 9; when e9 is 2 or greater, at least two Z₃₁ groups are identical to or different from each other,
Q₃₁ to Q₃₃ are each independently selected from hydrogen, deuterium, -F, -Cl, - Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group, and
* indicates a binding site to an adjacent atom.

5. The heterocyclic compound of any one of claims 1 to 4, wherein n1 is 2, and n2 is 1.

6. The heterocyclic compound of any one of claims 1 to 5, wherein at least one selected from R₁₂ and R₁₄ is selected from:
a benzene group, a pentalene group, an indene group, a naphthalene group, an azulene group, a heptalene group, an indacene group, an acenaphthalene group, a fluorene group, a spiro-fluorene group, a benzofluorene group, a phenalene group, a phenanthrene group, an anthracene group, a fluoranthene group, a triphenylene group, a pyrene group, a chrysene group, a naphthacene group, a picene group, a perylene group, a pentaphenylene group, a hexacene group, a pyrrole group, an imidazole group, a pyrazole group, a pyridine group, a pyrazine group, a pyrimidine group, a pyridazine group, an isoindole group, an indole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzoxazole group, a benzimidazole group, a furan group, a benzofuran group, a thiophene group, a benzothiophene group, a thiazole group, an isothiazole group, a benzothiazole group, an isoxazole group, an oxazole group, a triazole group, a tetrazole group, an oxadiazole group, a triazine group, a benzoxazole group, a dibenzofuran group, a dibenzothiophene group, a benzocarbazole group, and a dibenzocarbazole group; and
a benzene group, a pentalene group, an indene group, a naphthalene group, an azulene group, a heptalene group, an indacene group, an acenaphthalene group, a fluorene group, a spiro-fluorene group, a benzofluorene group, a phenalene group, a phenanthrene group, an anthracene group, a fluoranthene group, a triphenylene group, a pyrene group, a chrysene group, a naphthacene group, a picene group, a perylene group, a pentaphenylene group, a hexacene group, a pyrrole group, an imidazole group, a pyrazole group, a pyridine group, a pyrazine group, a pyrimidine group, a pyridazine group, an isoindole group, an indole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzoxazole group, a benzimidazole group, a furan group, a benzofuran group, a thiophene group, a benzothiophene group, a thiazole group, an isothiazole group, a benzothiazole group, an isoxazole group, an oxazole group, a triazole group, a tetrazole group, an oxadiazole group, a triazine group, a benzoxazole group, a dibenzofuran group, a dibenzothiophene group, a benzocarbazole group, and a dibenzocarbazole group, each substituted with at least one selected from deuterium, -F, -Cl, -Br, -I, a hydroxyl group, a cyano group, a nitro group, an amino group, an amidino group, a hydrazino group, a hydrazono group, a C₁-C₂₀ alkyl group, a C₁-C₂₀ alkoxy group, a C₆-C₂₀ aryl group, a C₂-C₂₀ heteroaryl group, and -Si(Q₃₁)(Q₃₂)(Q₃₃),
wherein Q₃₁ to Q₃₃ are each independently selected from hydrogen, deuterium, - F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group,
wherein at least one selected from R₁₂ and R₁₄ is substituted with -F.

7. The heterocyclic compound of any one of claims 1 to 6, wherein a number of -F(s) comprised in the heterocyclic compound is an integer from 1 to 20.

8. The heterocyclic compound of any one of claims 1 to 7, wherein the heterocyclic compound represented by Formula 1 is represented by one selected from Formulae 1-2 and 1-3: 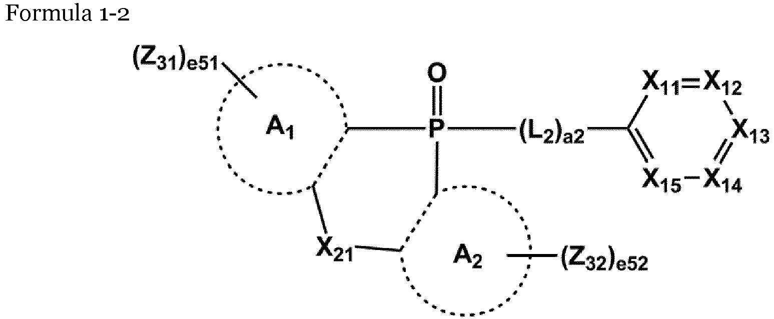 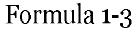 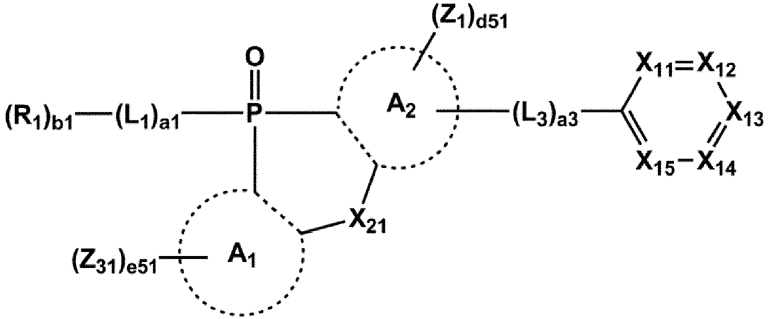
wherein, in Formulae 1-2 and 1-3,
A₁ and A₂ are each independently selected from a C₅-C₆₀ carbocyclic group and a C₁-C₆₀ heterocyclic group,
X₂₁ is selected from a single bond, C(R₂₁)(R₂₂), N(R₂₁), O, S, and Si(R₂₁)(R₂₂),
L₃ is as defined as in any one of the preceding claims,
a3 is as defined as in any one of the preceding claims,
R₂₁, R₂₂, Z₁, Z₃₁, and Z₃₂ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
e51, e52, and d51 are each independently an integer from 1 to 10,
X₁₁ to X₁₅, L₁, L₂, a1, a2, R₁, and b1 are respectively as defined in any one of the preceding claims, and
Q₃₁ to Q₃₃ are each independently selected from hydrogen, deuterium, -F, -Cl, - Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₁-C₆₀ heteroaryl group, a monovalent non-aromatic condensed polycyclic group, a monovalent non-aromatic condensed heteropolycyclic group, a biphenyl group, and a terphenyl group.

9. The heterocyclic compound of any one of claims 1 to 8, being selected from Compounds 1 to 132:

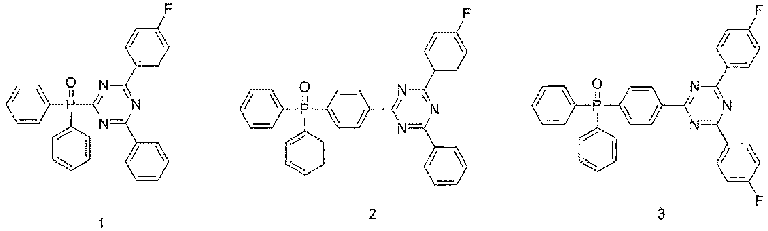

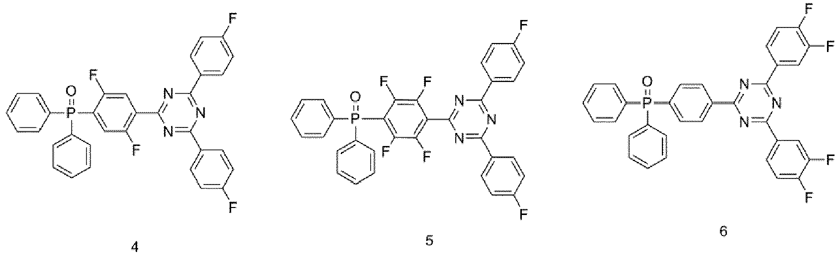

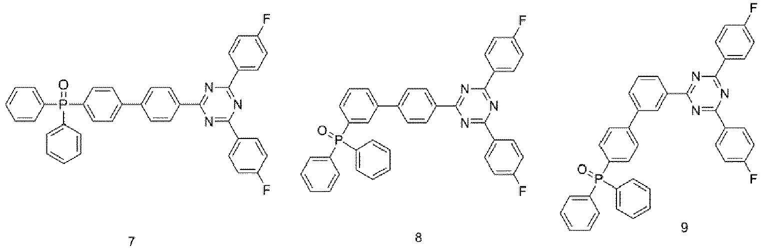

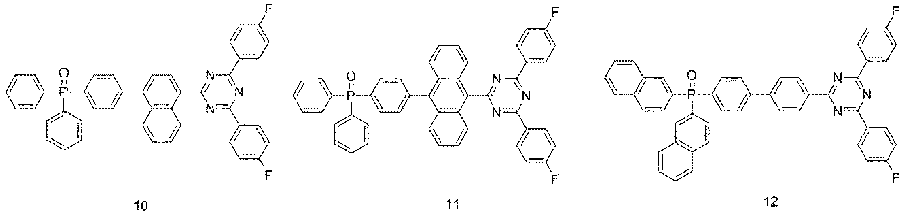

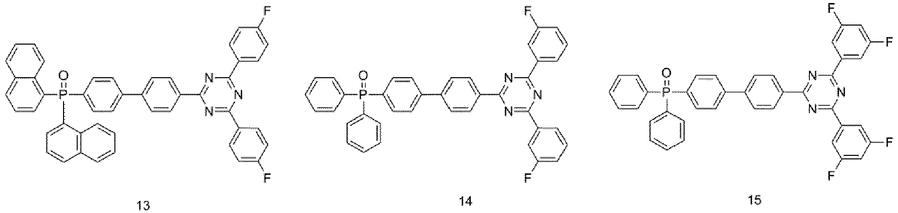

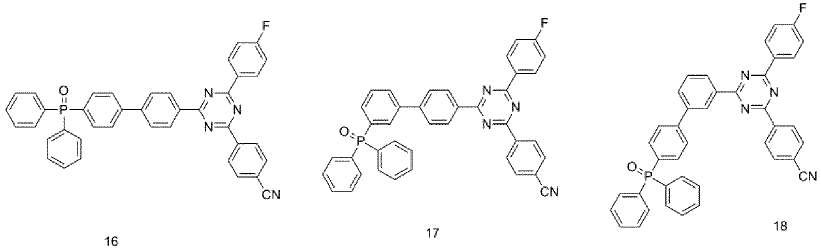

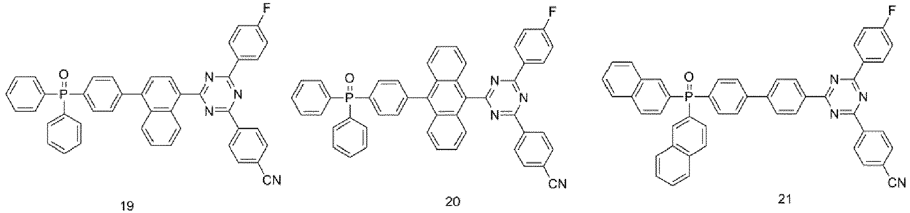

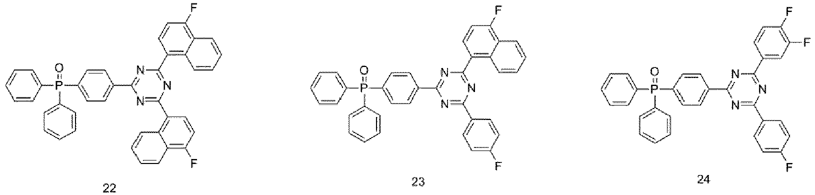

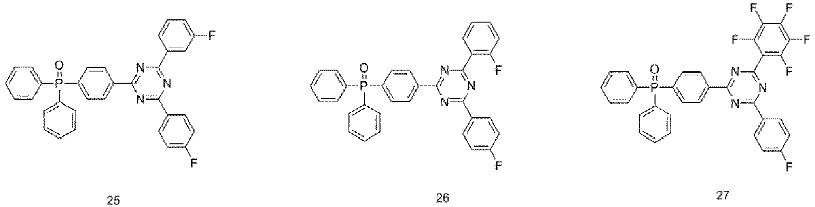

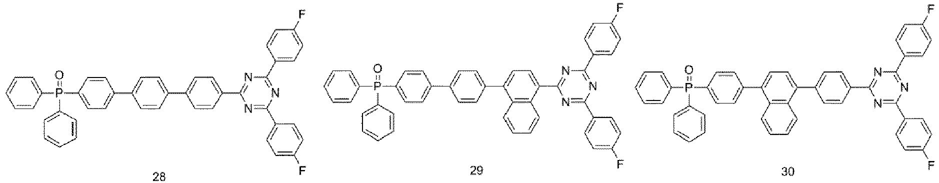

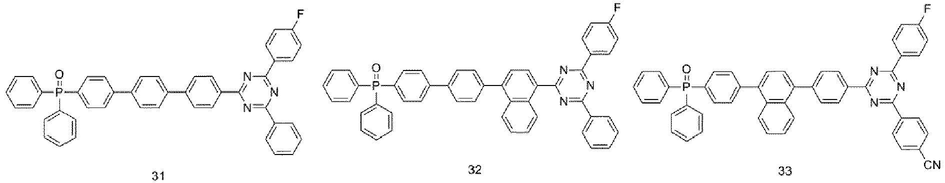

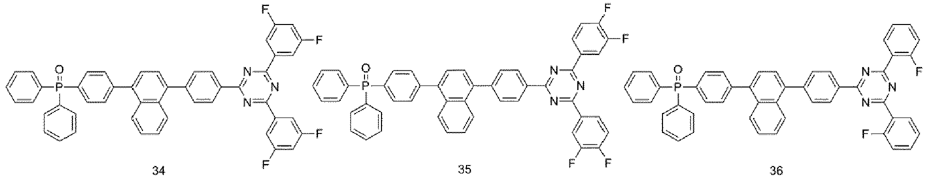

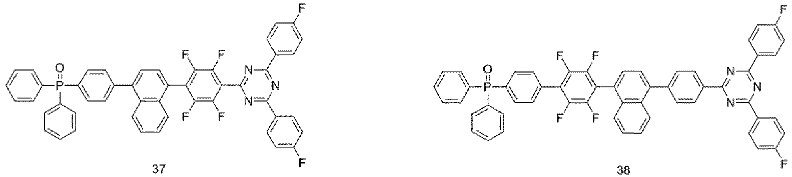

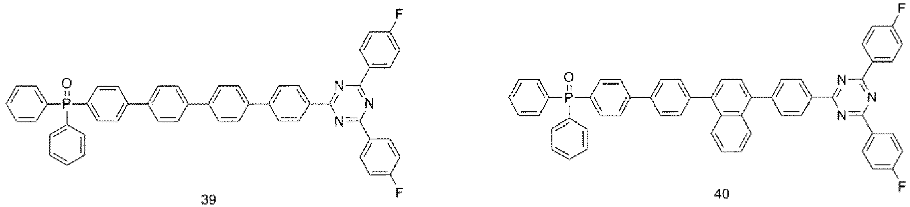

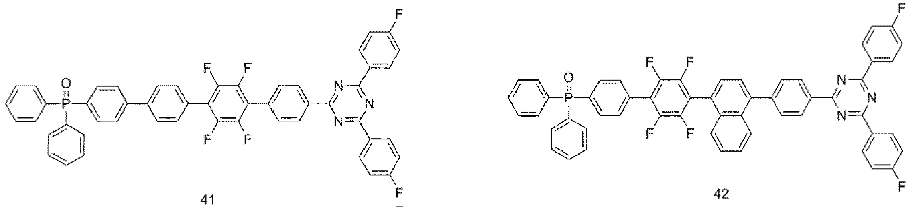

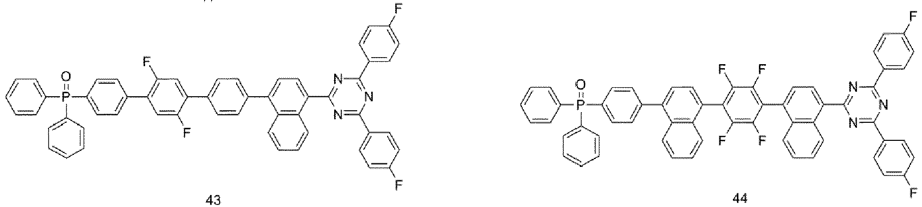

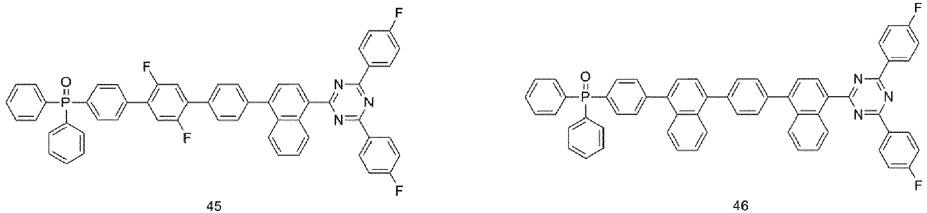

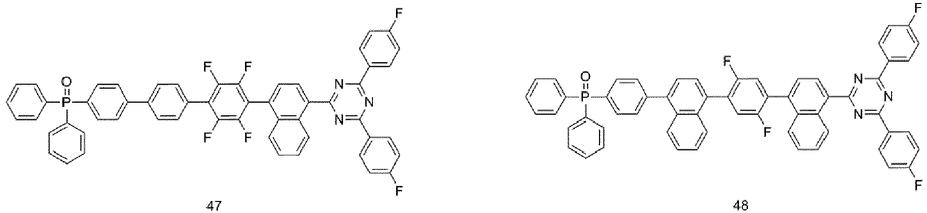

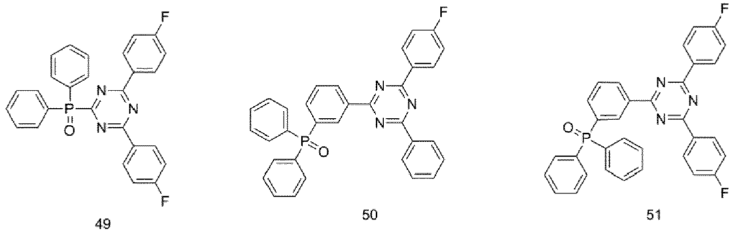

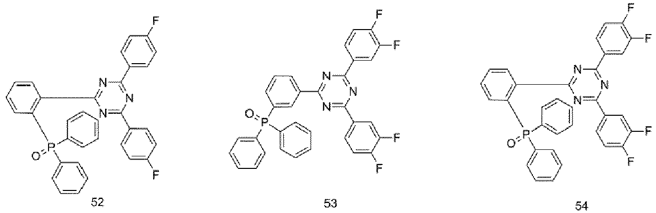

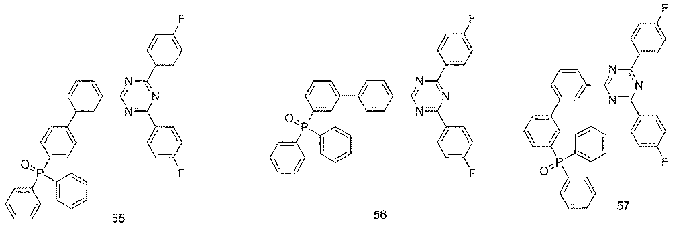

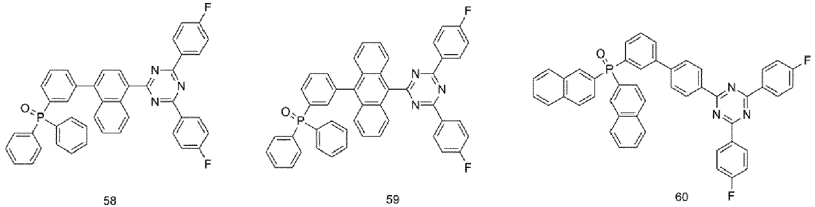

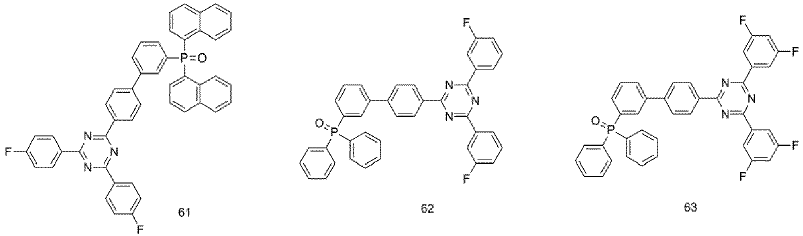

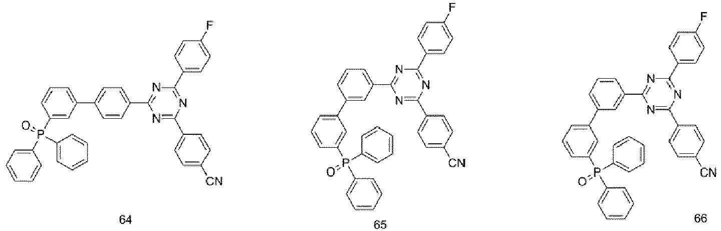

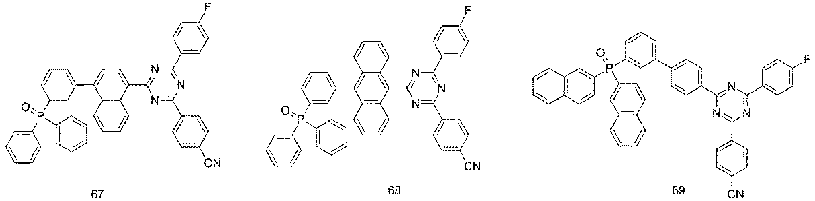

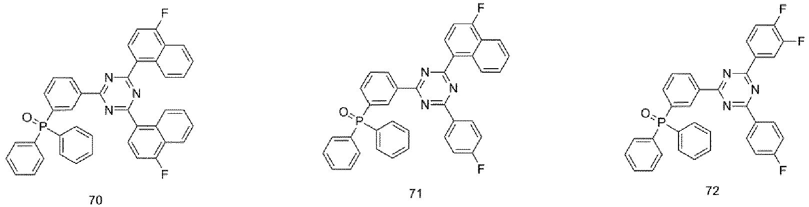

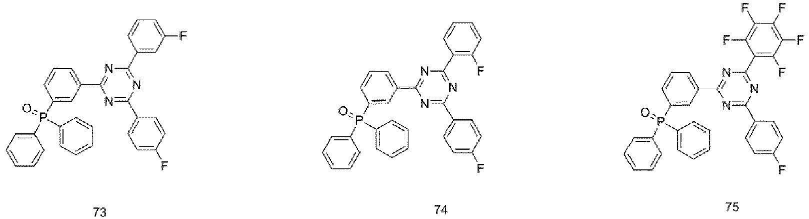

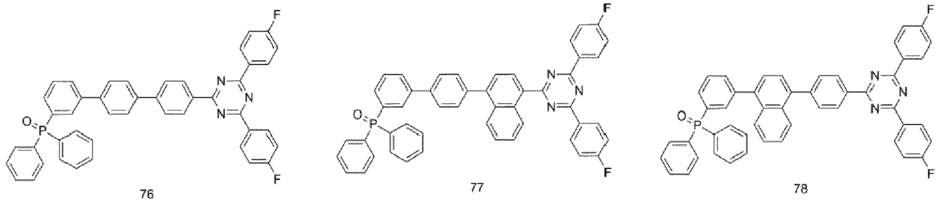

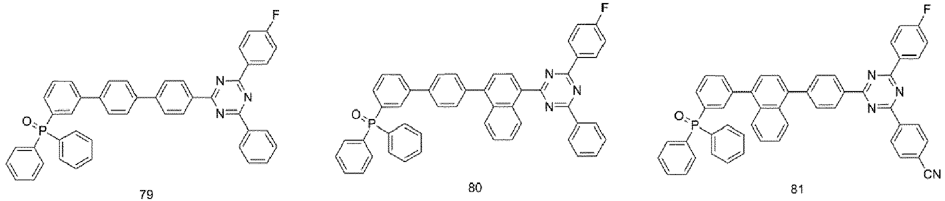

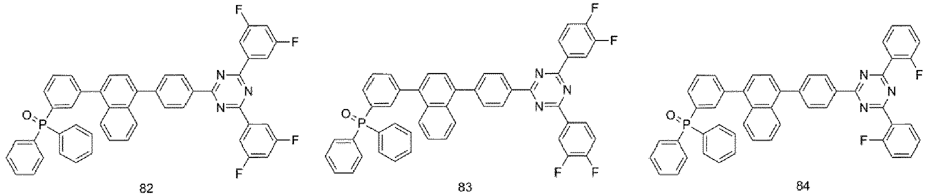

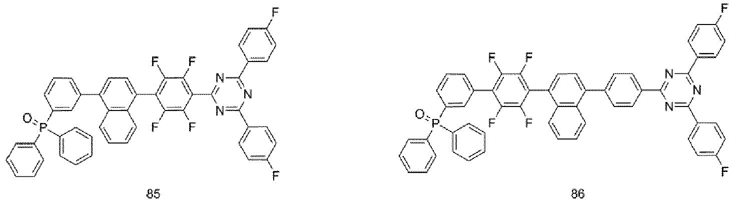

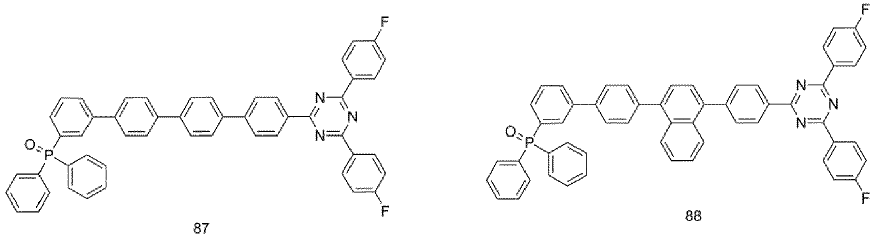

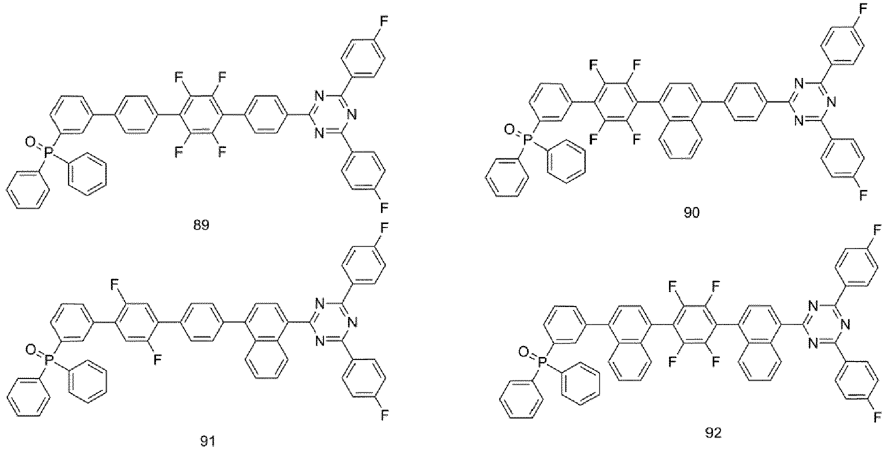

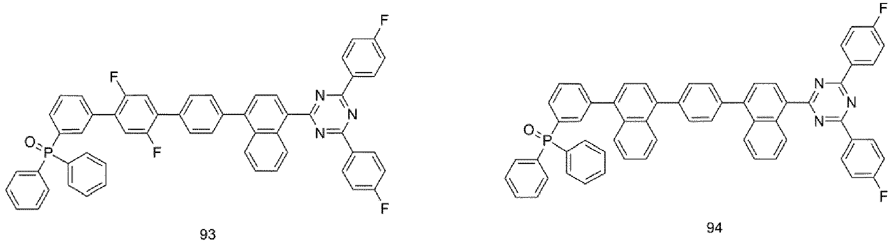

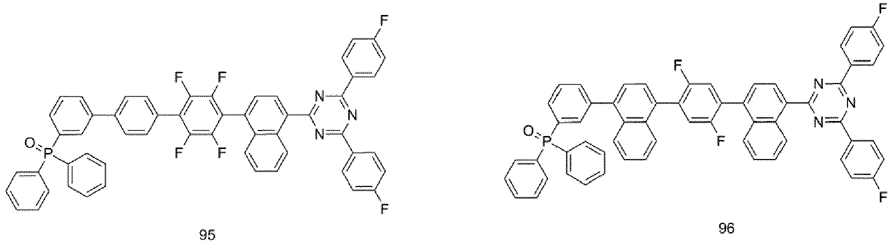

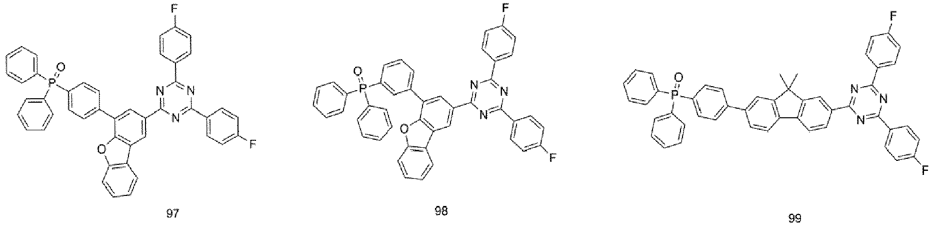

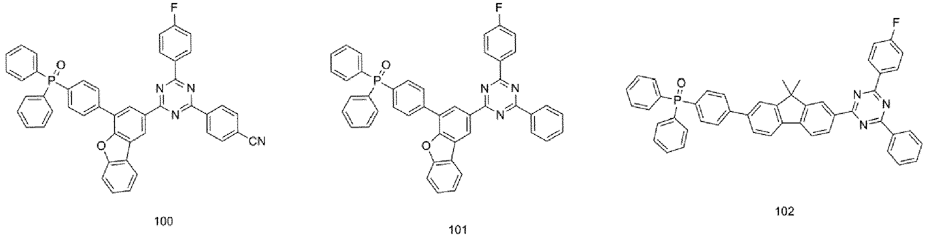

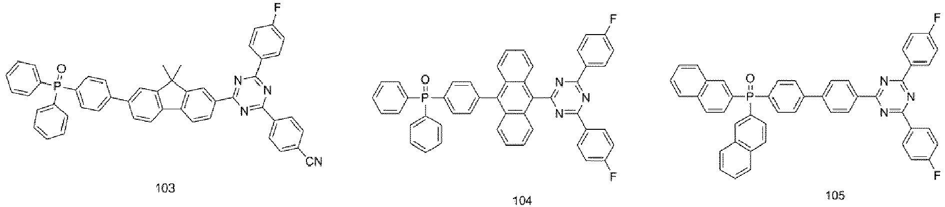

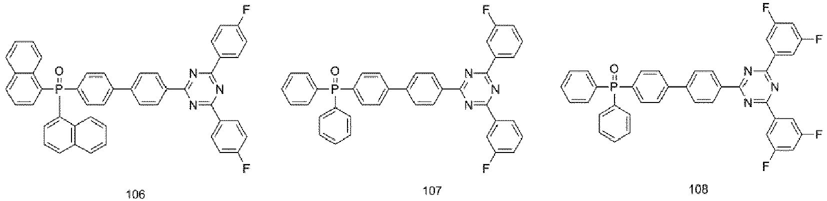

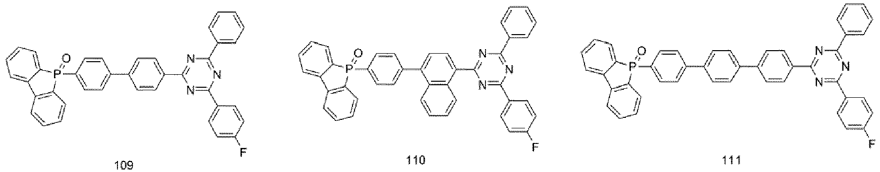

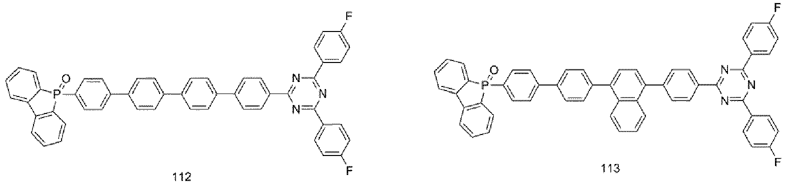

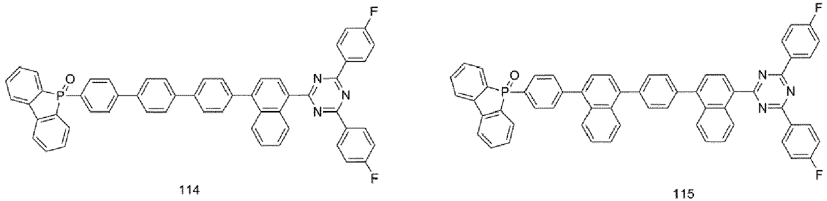

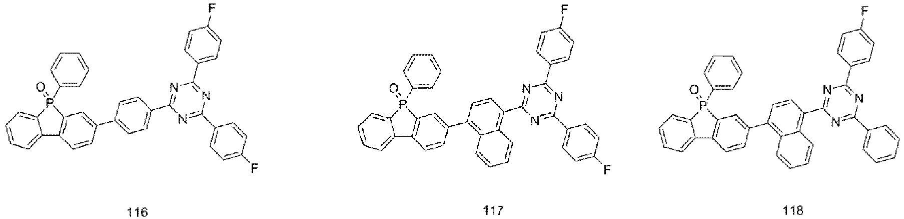

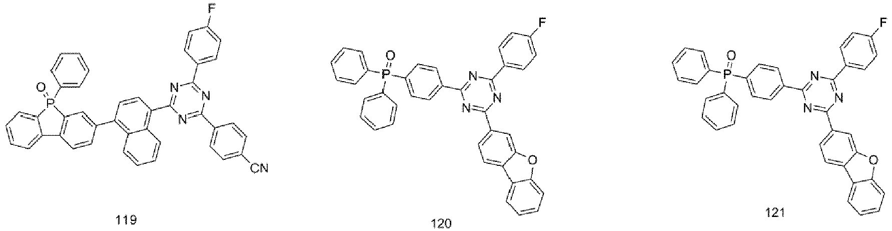

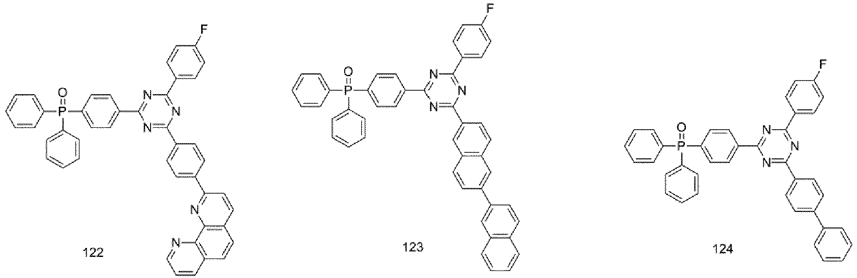

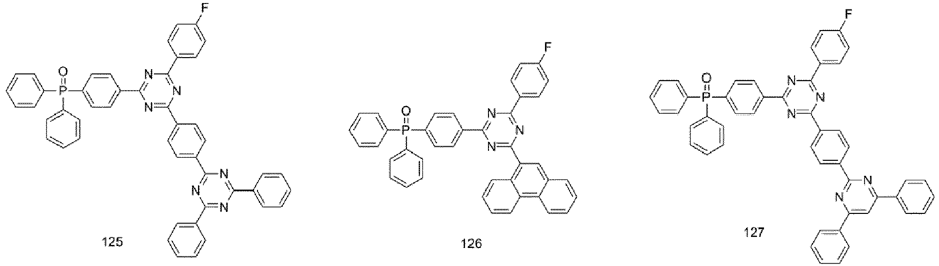

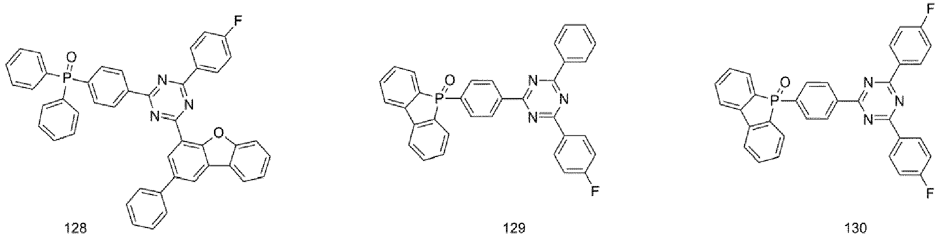

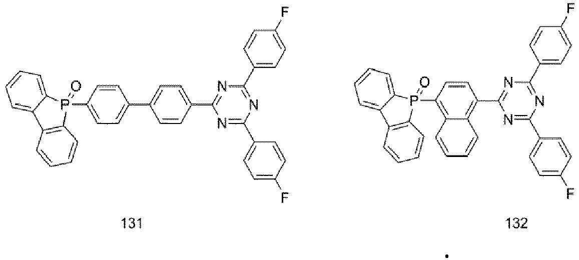

10. An organic light-emitting device comprising:
a first electrode;
a second electrode facing the first electrode; and
an organic layer between the first electrode and the second electrode; the organic layer comprising an emission layer and at least one heterocyclic compound of any one of claims 1 to 9; preferably wherein the emission layer comprises the heterocyclic compound.

11. The organic light-emitting device claim 10, wherein:
the first electrode is an anode,
the second electrode is a cathode,
the organic layer further comprises a hole transport region between the first electrode and the emission layer and an electron transport region between the emission layer and the second electrode,
the hole transport region comprises a hole injection layer, a hole transport layer, an emission auxiliary layer, an electron blocking layer, or a combination thereof, and
the electron transport region comprises a buffer layer, a hole blocking layer, an electron control layer, an electron transport layer, an electron injection layer, or a combination thereof.

12. The organic light-emitting device of claim 11, wherein
(i) the electron transport region comprises the heterocyclic compound, and/or
(ii) the electron transport region comprises the electron transport layer, and the electron transport layer comprises the heterocyclic compound, and/or
(iii) the hole transport region comprises a p-dopant having a lowest unoccupied molecular orbital (LUMO) energy level of -3.5 eV or less, preferably
wherein
the p-dopant comprises a cyano-group-containing compound.

13. The organic light-emitting device claim 10, wherein:
the emission layer is a first emission layer for emitting first color light,
the organic light-emitting device further comprises i) at least one second emission layer for emitting second color light or ii) at least one second emission layer for emitting second color light and at least one third emission layer for emitting third color light, between the first electrode and the second electrode,
a maximum emission wavelength of the first color light, a maximum emission wavelength of the second color light, and a maximum emission wavelength of the third color light are identical to or different from each other, and
the first color light and the second color light are emitted in the form of mixed light, or the first color light, the second color light, and the third color light are emitted in the form of mixed light.

## Patentansprüche

1. Heterocyclische Verbindung, dargestellt durch Formel 1: 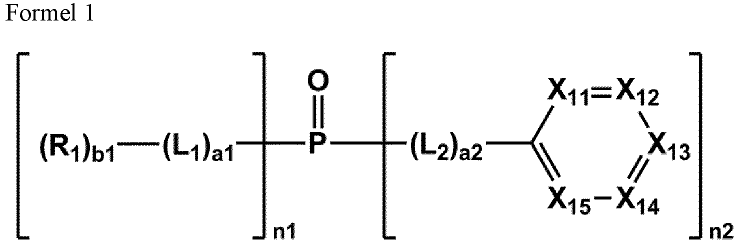
wobei in Formel 1
X₁₁, X₁₃ und X₁₅ jeweils N sind, X₁₂ C-[(L₁₂)ₐ₁₂-(R₁₂)_{b12}] ist und X₁₄ C-[(L₁₄)ₐ₁₄-(R₁₄)_{b14}] ist,
n1 ausgewählt ist aus 0, 1 und 2, n2 ausgewählt ist aus 1, 2 und 3, eine Summe von n1+n2 3 ist,
L₁, L₂, L₁₂, L₁₄, R₁, R₁₂ und R₁₄ jeweils unabhängig aus einer substituierten oder unsubstituierten carbocyclischen C₅-C₆₀-Gruppe und einer substituierten oder unsubstituierten heterocyclischen C₁-C₆₀-Gruppe ausgewählt sind,
a1, a2, a12 und a14 jeweils unabhängig eine Ganzzahl von 0 bis 5 sind,
wenn a1 0 ist, *-(L₁)ₐ₁-*' eine Einfachbindung ist; wenn a2 0 ist, *-(L₂)ₐ₂-*' eine Einfachbindung ist; wenn a12 0 ist, *-(L₁₂)ₐ₁₂-*' eine Einfachbindung ist; wenn a14 0 ist, *-(L₁₄)ₐ₁₄-*' eine Einfachbindung ist;
wenn a1 2 oder größer ist, mindestens zwei L₁-Gruppen identisch oder voneinander verschieden sind; wenn a2 2 oder größer ist, mindestens zwei L₂-Gruppen identisch oder voneinander verschieden sind; wenn a12 2 oder größer ist, mindestens zwei L₁₂-Gruppen identisch oder voneinander verschieden sind; wenn a14 2 oder größer ist, mindestens zwei L₁₄-Gruppen identisch oder voneinander verschieden sind;
b1, b 12 und b 14 jeweils unabhängig eine Ganzzahl von 1 bis 10 sind,
wenn b1 2 oder größer ist, mindestens zwei R₁-Gruppen identisch oder voneinander verschieden sind; wenn b 12 2 oder größer ist, mindestens zwei R₁₂-Gruppen identisch oder voneinander verschieden sind; wenn b 14 2 oder größer ist, mindestens zwei R₁₄-Gruppen identisch oder voneinander verschieden sind;
zwei benachbarte Gruppen, ausgewählt aus L₁, L₂, L₁₂, L₁₄, R₁, R₁₂ und R₁₄, optional gebunden sind, um eine substituierte oder unsubstituierte carbocyclische C₅-C₆₀-Gruppe oder eine substituierte oder unsubstituierte heterocyclische C₁-C₆₀-Gruppe zu bilden,
wobei die heterocyclische Verbindung dargestellt durch Formel 1 mindestens ein -F umfasst, und
die substituierte carbocyclische C₅-C₆₀-Gruppe und die substituierte heterocyclische C₁-C₆₀-Gruppe mit einem oder mehreren Substituenten substituiert sind, ausgewählt aus:
Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe und einer C₁-C₆₀-Alkoxygruppe;
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit mindestens einem, ausgewählt aus Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe,
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe, jeweils substituiert mit mindestens einem, ausgewählt aus Deuterium, -F, -Cl, - Br, -I, einer Hydroxygruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe, einer Terphenylgruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe substituiert mit einer C₁-C₆₀-Alkylgruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe,
* eine Bindungsstelle zu einem benachbarten Atom anzeigt; und
(i) mindestens eines von R₁₂ und R₁₄ ausgewählt ist aus einer substituierten oder unsubstituierten fluorhaltigen carbocyclischen C₅-C₆₀-Gruppe und einer substituierten oder unsubstituierten fluorhaltigen heterocyclischen C₁-C₆₀-Gruppe oder (ii) mindestens eines von R₁₂ und R₁₄ ausgewählt ist aus Gruppen, die durch die Formeln 7-1 bis 7-77 dargestellt werden: 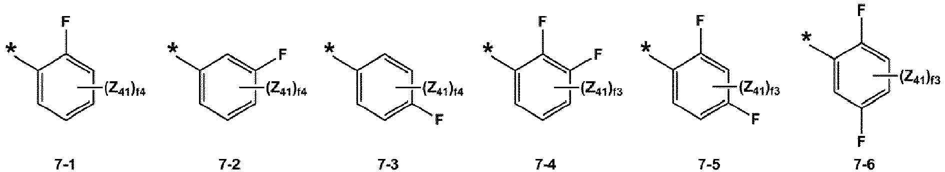 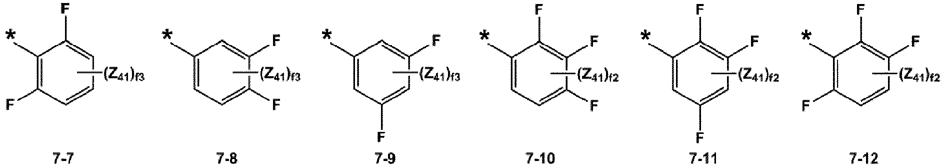 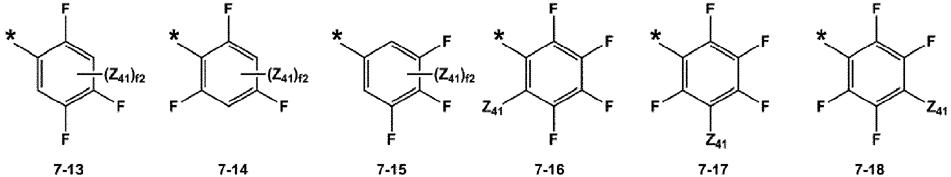 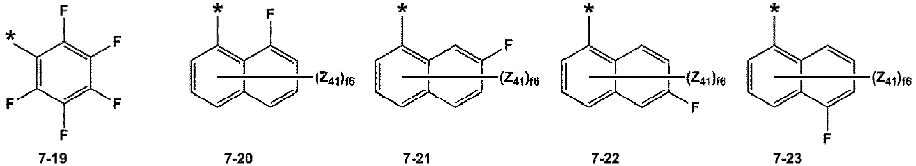 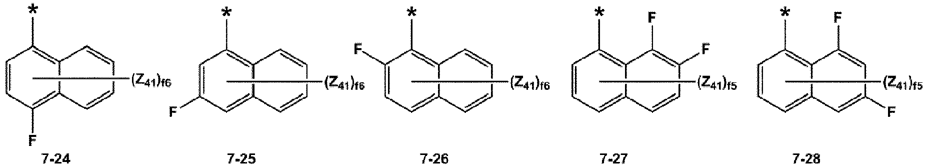 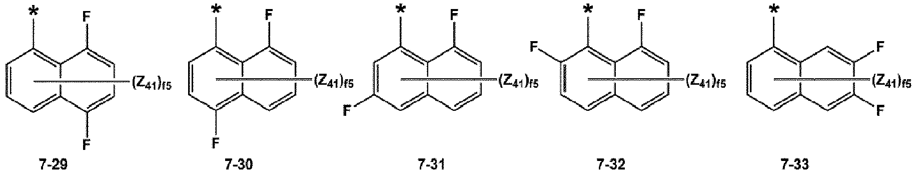 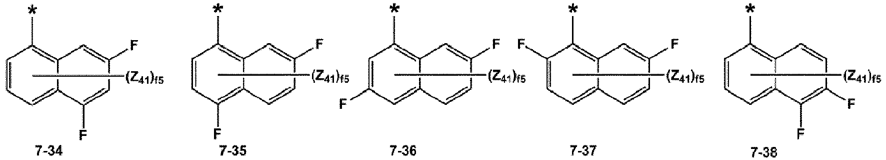 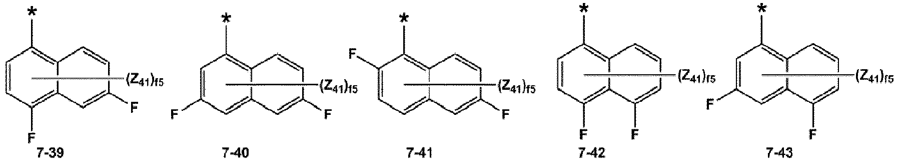 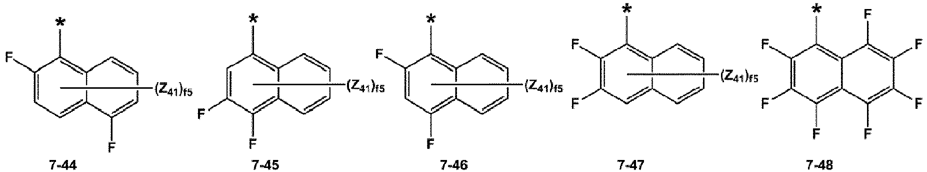 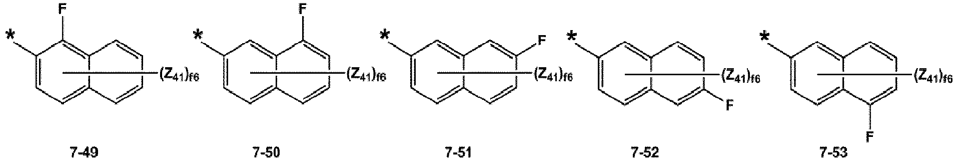 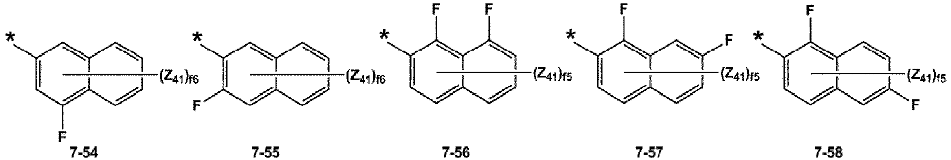 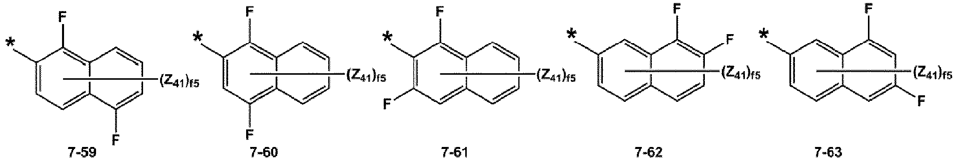 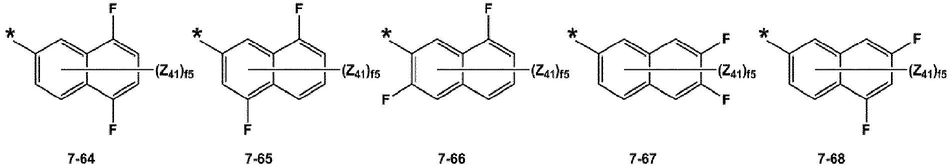 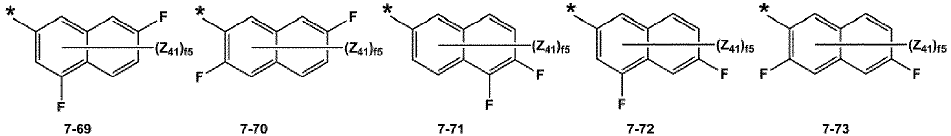 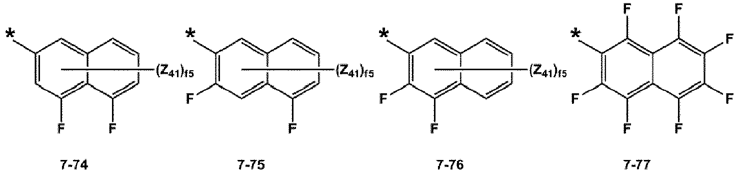
wobei in Formeln 7-1 bis 7-77,
Z₄₁ ausgewählt ist aus Wasserstoff, Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Naphthylgruppe, einer Fluorenylgruppe, einer Spiro-Bifluorenylgruppe, einer Spiro-Fluoren-Benzofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyridinylgruppe, einer Pyrazinylgruppe, einer Pyrimidinylgruppe, einer Chinolinylgruppe, einer Isochinolinylgruppe, einer Benzochinolinylgruppe, einer Naphthyridinylgruppe, einer Chinoxalinylgruppe, einer Chinazolinylgruppe, einer Carbazolylgruppe, einer Phenanthridinylgruppe, einer Acridinylgruppe, einer Phenanthrolinylgruppe, einer Phenazinylgruppe, einer Triazinylgruppe, einer Dibenzofuranylgruppe, einer Dibenzothiophenylgruppe, und -Si(Q₃₁)(Q₃₂)(Q₃₃),
f2 eine Ganzzahl ist, ausgewählt aus 1 und 2; wenn f2 2 ist, mindestens zwei Z₄₁-Gruppen identisch oder voneinander verschieden sind,
f3 eine Ganzzahl von 1 bis 3 ist; wenn f3 2 oder größer ist, mindestens zwei Z₄₁-Gruppen identisch oder voneinander verschieden sind,
f4 eine Ganzzahl von 1 bis 4 ist; wenn f4 2 oder größer ist, mindestens zwei Z₄₁-Gruppen identisch oder voneinander verschieden sind,
f5 eine Ganzzahl von 1 bis 5 ist; wenn f5 2 oder größer ist, mindestens zwei Z₄₁-Gruppen identisch oder voneinander verschieden sind,
f6 eine Ganzzahl von 1 bis 6 ist; wenn f6 2 oder größer ist, mindestens zwei Z₄₁-Gruppen identisch oder voneinander verschieden sind,
Q₃₁ bis Q₃₃ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer mit einer C₁-C₆₀-Alkylgruppe substituierten C₆-C₆₀-Arylgruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe, und
* eine Bindungsstelle zu einem benachbarten Atom anzeigt.

2. Heterocyclische Verbindung nach Anspruch 1, wobei L₁, L₂, L₁₂, L₁₄, R₁, R₁₂ und R₁₄ jeweils unabhängig ausgewählt sind aus:
einer Benzolgruppe, einer Pentalengruppe, einer Indengruppe, einer Naphthalingruppe, einer Azulengruppe, einer Heptalengruppe, einer Indacengruppe, einer Acenaphthalingruppe, einer Fluorengruppe, einer Spirofluorengruppe, einer Benzofluorengruppe, einer Phenalengruppe, einer Phenanthrengruppe, einer Anthracengruppe, einer Fluoranthengruppe, einer Triphenylengruppe, einer Pyrengruppe, einer Chrysengruppe, einer Naphthacengruppe, einer Picengruppe, einer Perylengruppe, einer Pentaphenylengruppe, einer Hexacengruppe, einer Pyrrolgruppe, einer Imidazolgruppe, einer Pyrazolgruppe, einer Pyridingruppe, einer Pyrazingruppe, einer Pyrimidingruppe, einer Pyridazingruppe, einer Isoindolgruppe, einer Indolgruppe, einer Indazolgruppe, einer Puringruppe, einer Chinolingruppe, einer Isochinolingruppe, einer Benzochinolingruppe, einer Phthalazingruppe, einer Naphthyridingruppe, einer Chinoxalingruppe, einer Chinazolingruppe, einer Cinnolingruppe, einer Carbazolgruppe, einer Phenanthridingruppe, einer Acridingruppe, einer Phenanthrolingruppe, einer Phenazingruppe, einer Benzoxazolgruppe, einer Benzimidazolgruppe, einer Furangruppe, einer Benzofurangruppe, einer Thiophengruppe, einer Benzothiophengruppe, einer Thiazolgruppe, einer Isothiazolgruppe, einer Benzothiazolgruppe, einer Isoxazolgruppe, einer Oxazolgruppe, einer Triazolgruppe, einer Tetrazolgruppe, einer Oxadiazolgruppe, einer Triazingruppe, einer Benzoxazolgruppe, einer Dibenzofurangruppe, einer Dibenzothiophengruppe, einer Benzocarbazolgruppe, und einer Dibenzocarbazolgruppe, und
einer Benzolgruppe, einer Pentalengruppe, einer Indengruppe, einer Naphthalingruppe, einer Azulengruppe, einer Heptalengruppe, einer Indacengruppe, einer Acenaphthalingruppe, einer Fluorengruppe, einer Spirofluorengruppe, einer Benzofluorengruppe, einer Phenalengruppe, einer Phenanthrengruppe, einer Anthracengruppe, einer Fluoranthengruppe, einer Triphenylengruppe, einer Pyrengruppe, einer Chrysengruppe, einer Naphthacengruppe, einer Picengruppe, einer Perylengruppe, einer Pentaphenylengruppe, einer Hexacengruppe, einer Pyrrolgruppe, einer Imidazolgruppe, einer Pyrazolgruppe, einer Pyridingruppe, einer Pyrazingruppe, einer Pyrimidingruppe, einer Pyridazingruppe, einer Isoindolgruppe, einer Indolgruppe, einer Indazolgruppe, einer Puringruppe, einer Chinolingruppe, einer Isochinolingruppe, einer Benzochinolingruppe, einer Phthalazingruppe, einer Naphthyridingruppe, einer Chinoxalingruppe, einer Chinazolingruppe, einer Cinnolingruppe, einer Carbazolgruppe, einer Phenanthridingruppe, einer Acridingruppe, einer Phenanthrolingruppe, einer Phenazingruppe, einer Benzoxazolgruppe, einer Benzimidazolgruppe, einer Furangruppe, einer Benzofurangruppe, einer Thiophengruppe, einer Benzothiophengruppe, einer Thiazolgruppe, einer Isothiazolgruppe, einer Benzothiazolgruppe, einer Isoxazolgruppe, einer Oxazolgruppe, einer Triazolgruppe, einer Tetrazolgruppe, einer Oxadiazolgruppe, einer Triazingruppe, einer Benzoxazolgruppe, einer Dibenzofurangruppe, einer Dibenzothiophengruppe, einer Benzocarbazolgruppe und einer Dibenzocarbazolgruppe, jeweils substituiert mit mindestens einem ausgewählt aus Deuterium, -F, -Cl, -Br, -I, einer Hydroxygruppe, einer Cyanogruppe, einer Nitrogruppe, einer Aminogruppe, einer Amidinogruppe, einer Hydrazingruppe, einer Hydrazongruppe, einer C₁-C₂₀-Alkylgruppe, einer C₁-C₂₀-Alkoxygruppe, einer C₆-C₂₀-Arylgruppe, einer C₂-C₂₀-Heteroarylgruppe und - Si(Q₃₁)(Q₃₂)(Q₃₃)
wobei Q₃₁ bis Q₃₃ jeweils unabhängig ausgewählt sind aus Wasserstoff, Deuterium, -F, - Cl, -Br, -I, einer Hydroxygruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer mit einer C₁-C₆₀-Alkylgruppe substituierten C₆-C₆₀-Arylgruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe.

3. Heterocyclische Verbindung nach Anspruch 1 oder Anspruch 2, wobei L₁, L₂, L₁₂ und
L₁₄ jeweils unabhängig ausgewählt sind aus Gruppen, dargestellt durch Formeln 3-1 bis 3-47: 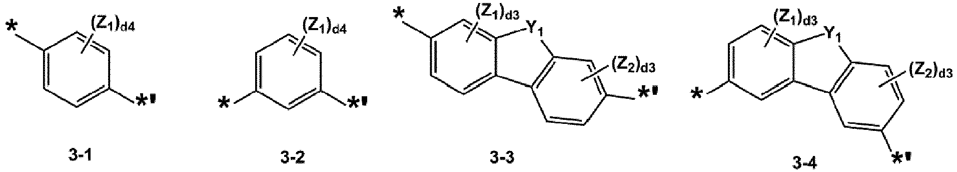 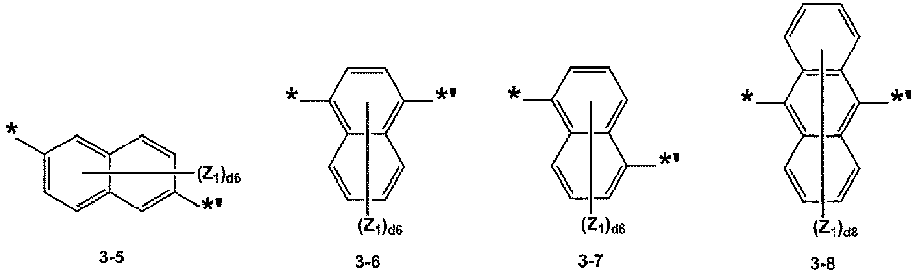 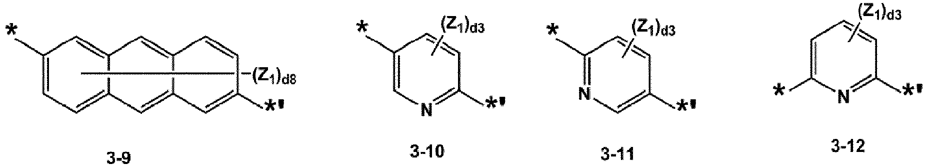 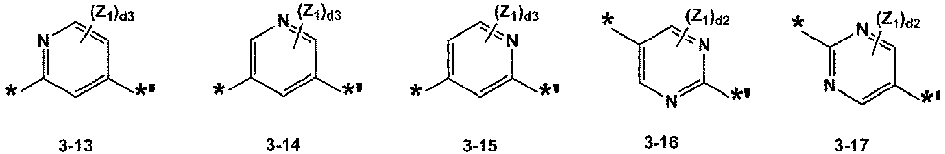 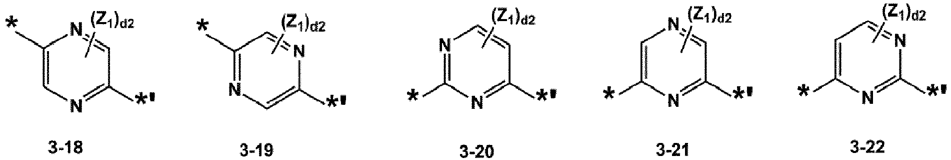 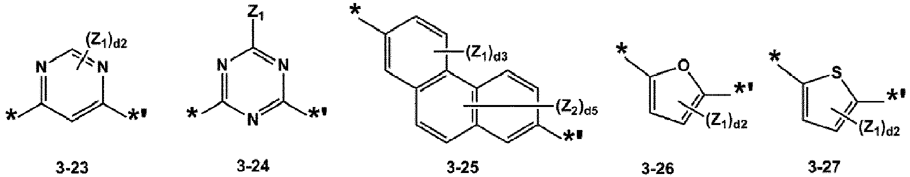 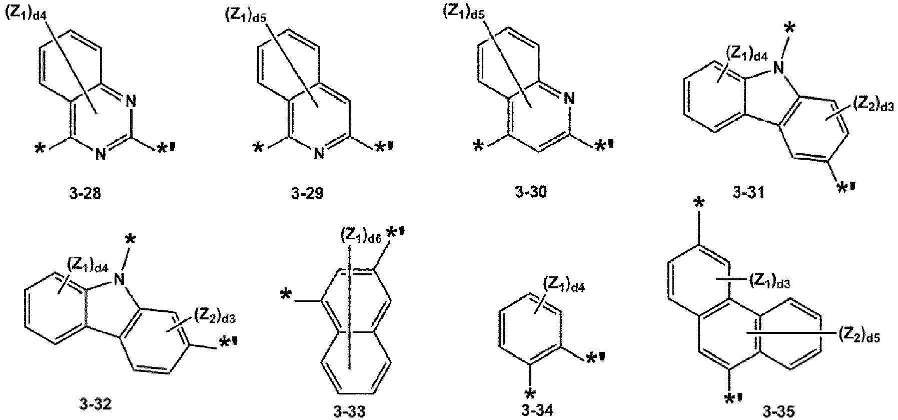 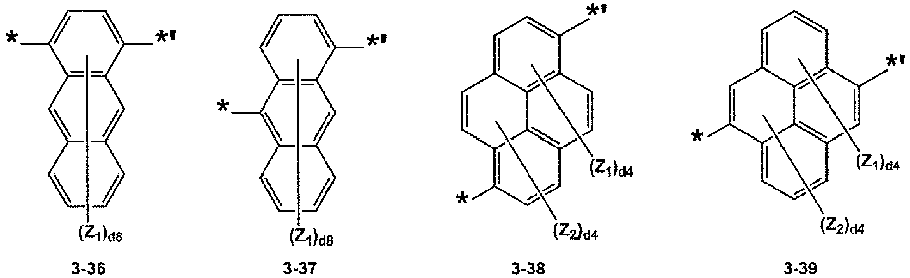 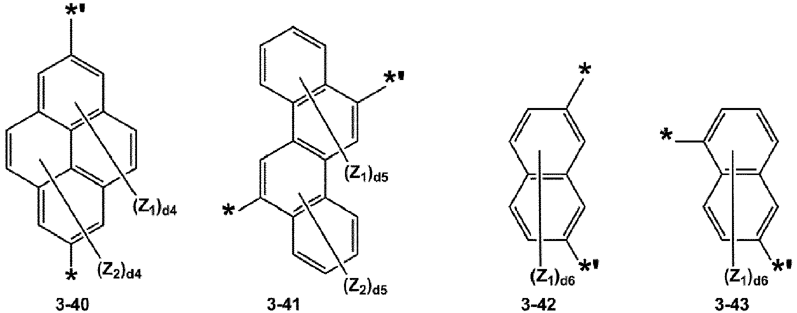 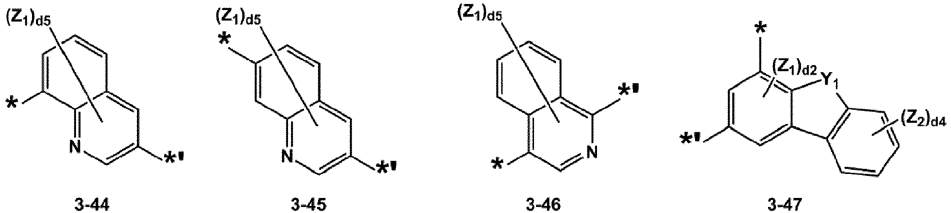
wobei, in Formeln 3-1 bis 3-47,
Y₁ ausgewählt ist aus O, S, C(Z₃)(Z₄), N(Zs) und Si(Z₆)(Z₇),
Z₁ bis Z₇ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Naphthylgruppe, einer Fluorenylgruppe, einer Spiro-Bifluorenylgruppe, einer Phenalenylgruppe, einer Phenanthrenylgruppe, einer Anthracenylgruppe, einer Fluoranthenylgruppe, einer Triphenylenylgruppe, einer Pyridinylgruppe, einer Pyrazinylgruppe, einer Pyrimidinylgruppe, einer Chinolinylgruppe, einer Isochinolinylgruppe, einer Benzochinolinylgruppe, einer Naphthyridinylgruppe, einer Chinoxalinylgruppe, einer Chinazolinylgruppe, einer Carbazolylgruppe, einer Phenanthridinylgruppe, einer Acridinylgruppe, einer Phenanthrolinylgruppe, einer Phenazinylgruppe, einer Triazinylgruppe, einer Dibenzofuranylgruppe, einer Dibenzothiophenylgruppe und -Si(Q₃₁)(Q₃₂)(Q₃₃),
d2 eine Ganzzahl von 0 bis 2 ist; wenn d2 2 ist, mindestens zwei Z₁-Gruppen identisch oder voneinander verschieden sind,
d3 eine Ganzzahl von 0 bis 3 ist; wenn d3 2 oder größer ist, mindestens zwei Z₁-Gruppen identisch oder voneinander verschieden sind und mindestens zwei Z₂-Gruppen identisch oder voneinander verschieden sind,
d4 eine Ganzzahl von 0 bis 4 ist; wenn d4 2 oder größer ist, mindestens zwei Z₁-Gruppen identisch oder voneinander verschieden sind und mindestens zwei Z₂-Gruppen identisch oder voneinander verschieden sind,
d5 eine Ganzzahl von 0 bis 5 ist; wenn d5 2 oder größer ist, mindestens zwei Z₁-Gruppen identisch oder voneinander verschieden sind und mindestens zwei Z₂-Gruppen identisch oder voneinander verschieden sind,
d6 eine Ganzzahl von 0 bis 6 ist; wenn d6 2 oder größer ist, mindestens zwei Z₁-Gruppen identisch oder voneinander verschieden sind und mindestens zwei Z₂-Gruppen identisch oder voneinander verschieden sind,
d8 eine Ganzzahl von 1 bis 8 ist; wenn d8 2 oder größer ist, mindestens zwei Z₁-Gruppen identisch oder voneinander verschieden sind,
Q₃₁ bis Q₃₃ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer mit einer C₁-C₆₀-Alkylgruppe substituierten C₆-C₆₀-Arylgruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe, und
* und *'jeweils eine Bindungsstelle zu einem benachbarten Atom anzeigen.

4. Heterocyclische Verbindung nach einem der Ansprüche 1 bis 3, wobei R₁, R₁₂ und R₁₄ jeweils unabhängig ausgewählt sind aus Gruppen, dargestellt durch Formeln 5-1 bis 5-79: 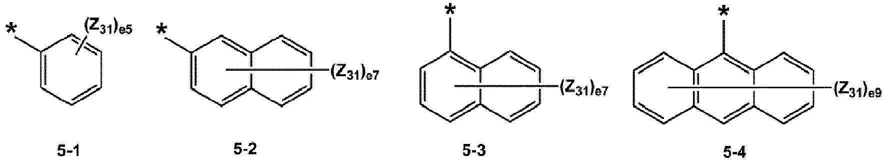 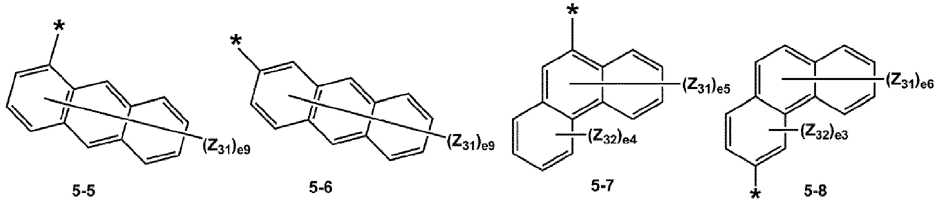 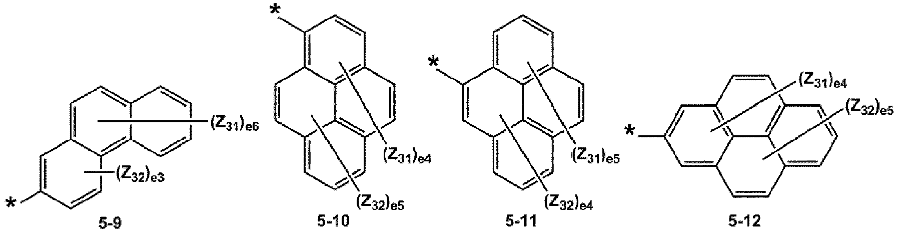 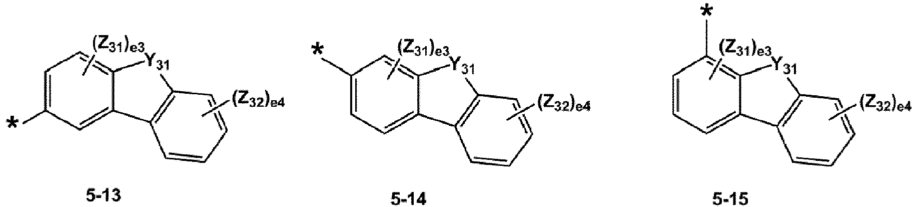 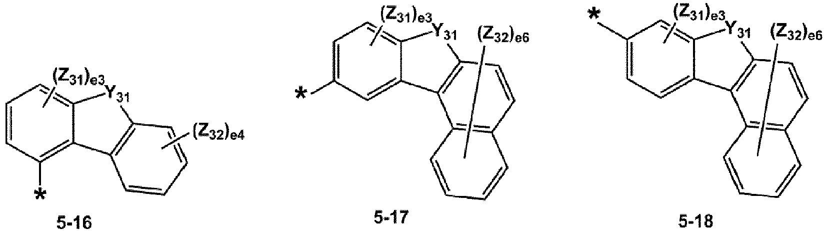 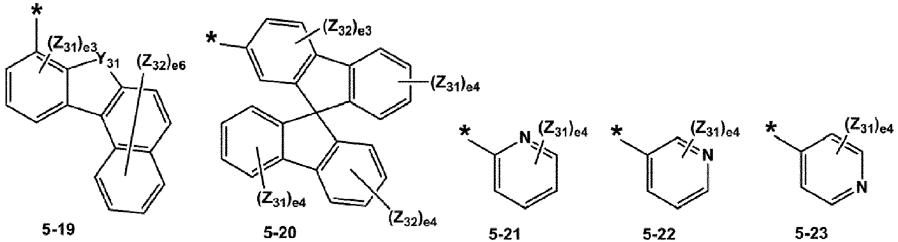 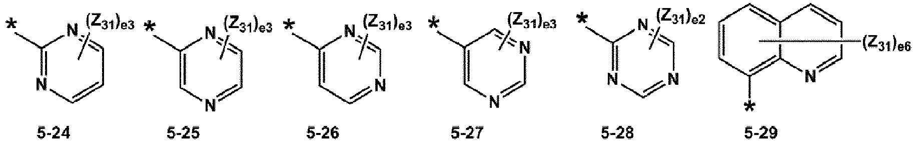 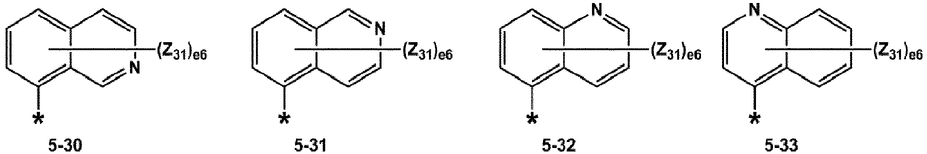 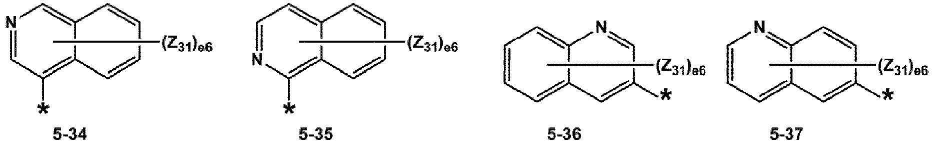 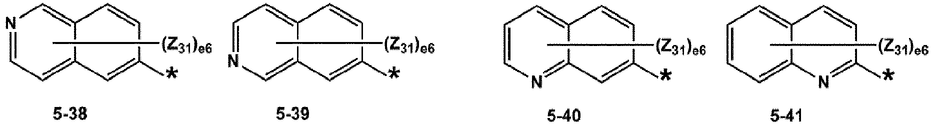 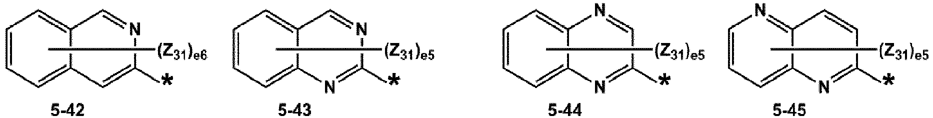 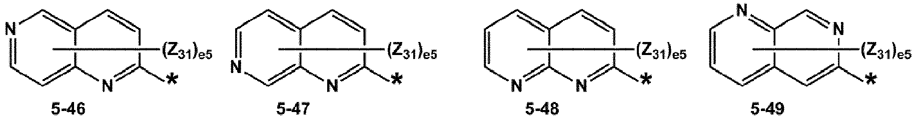 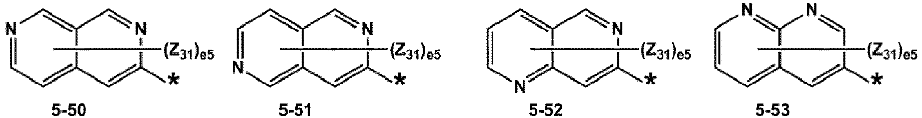 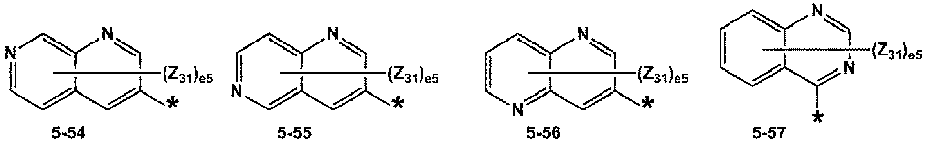 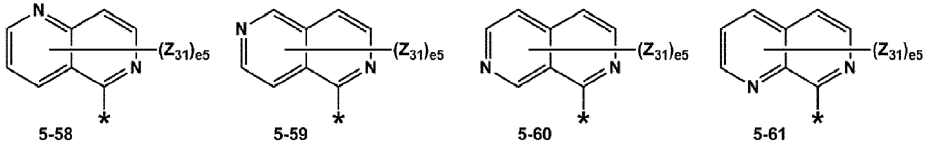 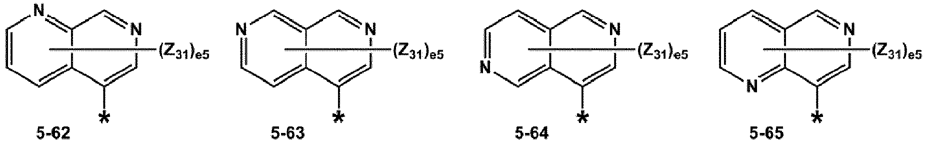 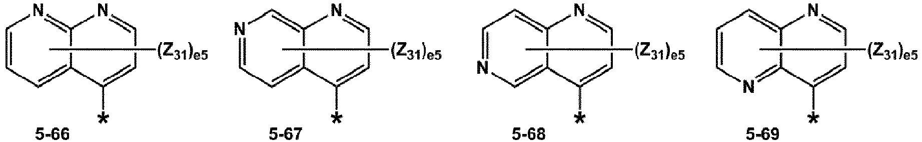 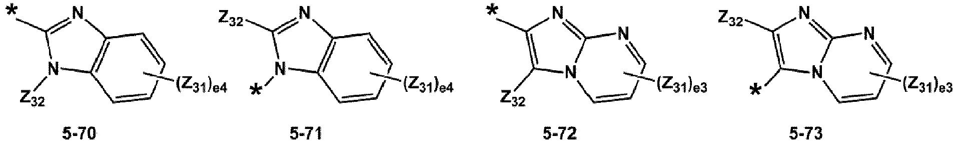 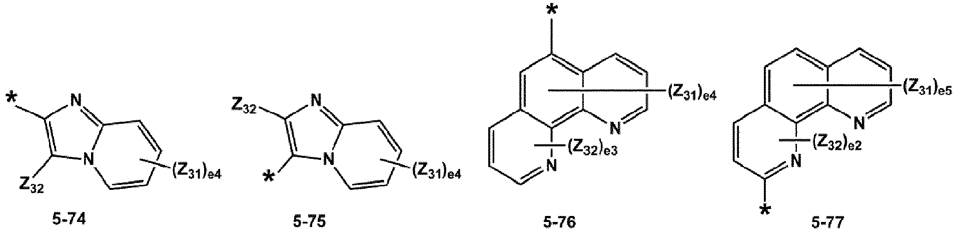 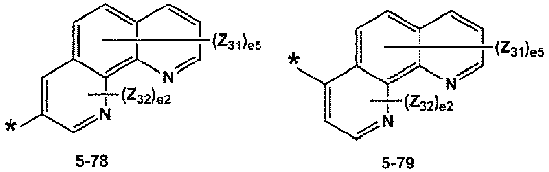
wobei in Formeln 5-1 bis 5-79,
Y₃₁ ausgewählt ist aus O, S, C(Z₃₃)(Z₃₄), N(Z₃₅) und Si(Z₃₆)(Z₃₇),
Z₃₁ bis Z₃₇ jeweils unabhängig ausgewählt sind aus Wasserstoff, Deuterium, -F, -Cl, -Br, - I, einer Hydroxygruppe, einer Cyanogruppe, einer Nitrogruppe, einer Amidinogruppe, einer Hydrazingruppe, einer Hydrazongruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Naphthylgruppe, einer Fluorenylgruppe, einer Spiro-Bifluorenylgruppe, einer Spiro-Fluoren-Benzofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyridinylgruppe, einer Pyrazinylgruppe, einer Pyrimidinylgruppe, einer Chinolinylgruppe, einer Isochinolinylgruppe, einer Benzochinolinylgruppe, einer Naphthyridinylgruppe, einer Chinoxalinylgruppe, einer Chinazolinylgruppe, einer Carbazolylgruppe, einer Phenanthridinylgruppe, einer Acridinylgruppe, einer Phenanthrolinylgruppe, einer Phenazinylgruppe, einer Triazinylgruppe, einer Dibenzofuranylgruppe, einer Dibenzothiophenylgruppe und -Si(Q₃₁)(Q₃₂)(Q₃₃),
e2 eine Ganzzahl von 0 bis 2 ist; wenn e2 2 ist, mindestens zwei Z₃₁-Gruppen identisch oder voneinander verschieden sind und mindestens zwei Z₃₂-Gruppen identisch oder voneinander verschieden sind,
e3 eine Ganzzahl von 0 bis 3 ist; wenn e3 2 oder größer ist, mindestens zwei Z₃₁-Gruppen identisch oder voneinander verschieden sind, mindestens zwei Z₃₂-Gruppen identisch oder voneinander verschieden sind,
e4 eine Ganzzahl von 0 bis 4 ist; wenn e4 2 oder größer ist, mindestens zwei Z₃₁-Gruppen identisch oder voneinander verschieden sind, mindestens zwei Z₃₂-Gruppen identisch oder voneinander verschieden sind,
e5 eine Ganzzahl von 0 bis 5 ist; wenn e5 2 oder größer ist, mindestens zwei Z₃₁-Gruppen identisch oder voneinander verschieden sind, mindestens zwei Z₃₂-Gruppen identisch oder voneinander verschieden sind,
e6 eine Ganzzahl von 0 bis 6 ist; wenn e6 2 oder größer ist, mindestens zwei Z₃₁-Gruppen identisch oder voneinander verschieden sind, mindestens zwei Z₃₂-Gruppen identisch oder voneinander verschieden sind,
e7 eine Ganzzahl von 0 bis 7 ist; wenn e7 2 oder größer ist, mindestens zwei Z₃₁-Gruppen identisch oder voneinander verschieden sind,
e9 eine Ganzzahl von 0 bis 9 ist; wenn e9 2 oder größer ist, mindestens zwei Z₃₁-Gruppen identisch oder voneinander verschieden sind,
Q₃₁ bis Q₃₃ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer mit einer C₁-C₆₀-Alkylgruppe substituierten C₆-C₆₀-Arylgruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe, und
* eine Bindungsstelle zu einem benachbarten Atom anzeigt.

5. Heterocyclische Verbindung nach einem der Ansprüche 1 bis 4, wobei n1 2 ist und n2 1 ist.

6. Heterocyclische Verbindung nach einem der Ansprüche 1 bis 5, wobei mindestens eines von R₁₂ und R₁₄ ausgewählt ist aus:
einer Benzolgruppe, einer Pentalengruppe, einer Indengruppe, einer Naphthalingruppe, einer Azulengruppe, einer Heptalengruppe, einer Indacengruppe, einer Acenaphthalingruppe, einer Fluorengruppe, einer Spirofluorengruppe, einer Benzofluorengruppe, einer Phenalengruppe, einer Phenanthrengruppe, einer Anthracengruppe, einer Fluoranthengruppe, einer Triphenylengruppe, einer Pyrengruppe, einer Chrysengruppe, einer Naphthacengruppe, einer Picengruppe, einer Perylengruppe, einer Pentaphenylengruppe, einer Hexacengruppe, einer Pyrrolgruppe, einer Imidazolgruppe, einer Pyrazolgruppe, einer Pyridingruppe, einer Pyrazingruppe, einer Pyrimidingruppe, einer Pyridazingruppe, einer Isoindolgruppe, einer Indolgruppe, einer Indazolgruppe, einer Puringruppe, einer Chinolingruppe, einer Isochinolingruppe, einer Benzochinolingruppe, einer Phthalazingruppe, einer Naphthyridingruppe, einer Chinoxalingruppe, einer Chinazolingruppe, einer Cinnolingruppe, einer Carbazolgruppe, einer Phenanthridingruppe, einer Acridingruppe, einer Phenanthrolingruppe, einer Phenazingruppe, einer Benzoxazolgruppe, einer Benzimidazolgruppe, einer Furangruppe, einer Benzofurangruppe, einer Thiophengruppe, einer Benzothiophengruppe, einer Thiazolgruppe, einer Isothiazolgruppe, einer Benzothiazolgruppe, einer Isoxazolgruppe, einer Oxazolgruppe, einer Triazolgruppe, einer Tetrazolgruppe, einer Oxadiazolgruppe, einer Triazingruppe, einer Benzoxazolgruppe, einer Dibenzofurangruppe, einer Dibenzothiophengruppe, einer Benzocarbazolgruppe, und einer Dibenzocarbazolgruppe, und
einer Benzolgruppe, einer Pentalengruppe, einer Indengruppe, einer Naphthalingruppe, einer Azulengruppe, einer Heptalengruppe, einer Indacengruppe, einer Acenaphthalingruppe, einer Fluorengruppe, einer Spirofluorengruppe, einer Benzofluorengruppe, einer Phenalengruppe, einer Phenanthrengruppe, einer Anthracengruppe, einer Fluoranthengruppe, einer Triphenylengruppe, einer Pyrengruppe, einer Chrysengruppe, einer Naphthacengruppe, einer Picengruppe, einer Perylengruppe, einer Pentaphenylengruppe, einer Hexacengruppe, einer Pyrrolgruppe, einer Imidazolgruppe, einer Pyrazolgruppe, einer Pyridingruppe, einer Pyrazingruppe, einer Pyrimidingruppe, einer Pyridazingruppe, einer Isoindolgruppe, einer Indolgruppe, einer Indazolgruppe, einer Puringruppe, einer Chinolingruppe, einer Isochinolingruppe, einer Benzochinolingruppe, einer Phthalazingruppe, einer Naphthyridingruppe, einer Chinoxalingruppe, einer Chinazolingruppe, einer Cinnolingruppe, einer Carbazolgruppe, einer Phenanthridingruppe, einer Acridingruppe, einer Phenanthrolingruppe, einer Phenazingruppe, einer Benzoxazolgruppe, einer Benzimidazolgruppe, einer Furangruppe, einer Benzofurangruppe, einer Thiophengruppe, einer Benzothiophengruppe, einer Thiazolgruppe, einer Isothiazolgruppe, einer Benzothiazolgruppe, einer Isoxazolgruppe, einer Oxazolgruppe, einer Triazolgruppe, einer Tetrazolgruppe, einer Oxadiazolgruppe, einer Triazingruppe, einer Benzoxazolgruppe, einer Dibenzofurangruppe, einer Dibenzothiophengruppe, einer Benzocarbazolgruppe und einer Dibenzocarbazolgruppe, jeweils substituiert mit mindestens einem ausgewählt aus Deuterium, -F, -Cl, -Br, -I, einer Hydroxygruppe, einer Cyanogruppe, einer Nitrogruppe, einer Aminogruppe, einer Amidinogruppe, einer Hydrazingruppe, einer Hydrazongruppe, einer C₁-C₂₀-Alkylgruppe, einer C₁-C₂₀-Alkoxygruppe, einer C₆-C₂₀-Arylgruppe, einer C₂-C₂₀-Heteroarylgruppe und - Si(Q₃₁)(Q₃₂)(Q₃₃),
wobei Q₃₁ bis Q₃₃ jeweils unabhängig ausgewählt sind aus Wasserstoff, Deuterium, -F, - Cl, -Br, -I, einer Hydroxygruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer mit einer C₁-C₆₀-Alkylgruppe substituierten C₆-C₆₀-Arylgruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe,
wobei mindestens eines ausgewählt aus R₁₂ und R₁₄, mit -F substituiert ist.

7. Heterocyclische Verbindung nach einem der Ansprüche 1 bis 6, wobei die Anzahl der in der heterocyclischen Verbindung umfassten -F(s) eine Ganzzahl von 1 bis 20 ist.

8. Heterocyclische Verbindung nach einem der Ansprüche 1 bis 7, wobei die durch Formel 1 dargestellte heterocyclische Verbindung durch eine, ausgewählt aus Formeln 1-2 und 1-3, dargestellt wird: 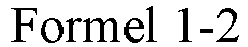 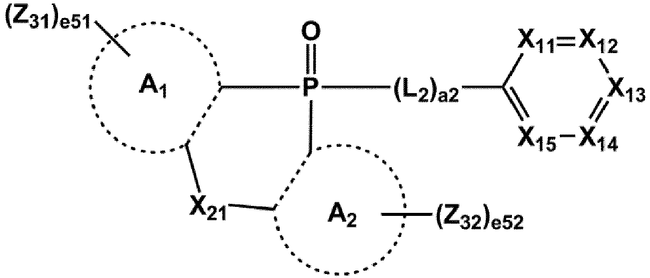 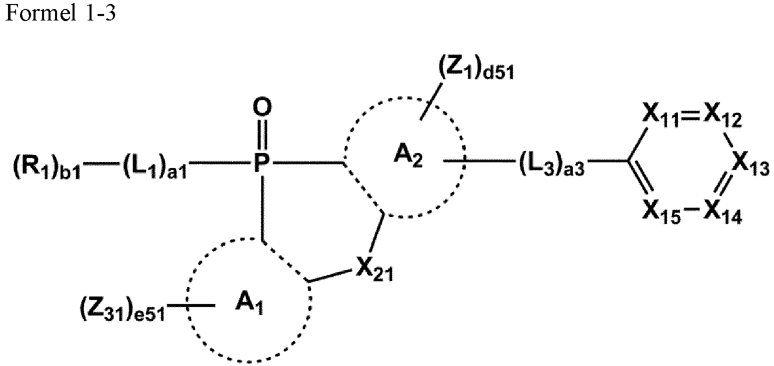
wobei in Formeln 1-2 und 1-3,
A₁ und A₂ jeweils unabhängig ausgewählt sind aus einer carbocyclischen C₅-C₆₀-Gruppe und einer heterocyclischen C₁-C₆₀-Gruppe,
X₂₁ ausgewählt ist aus einer Einfachbindung, C(R₂₁)(R₂₂), N(R₂₁), O, S, und Si(R₂₁)(R₂₂),
L₃ wie in einem der vorhergehenden Ansprüche definiert ist,
a3 wie in einem der vorhergehenden Ansprüche definiert ist,
R₂₁, R₂₂, Z₁, Z₃₁ und Z₃₂ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁) und -P(=O)(Q₃₁)(Q₃₂),
e51, e52 und d51 jeweils unabhängig eine Ganzzahl von 1 bis 10 sind,
X₁₁ bis X₁₅, L₁, L₂, a1, a2, R₁ und b1 jeweils wie in einem der vorhergehenden Ansprüche definiert sind, und
Q₃₁ bis Q₃₃ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer mit einer C₁-C₆₀-Alkylgruppe substituierten C₆-C₆₀-Arylgruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe.

9. Heterocyclische Verbindung nach einem der Ansprüche 1 bis 8, ausgewählt aus den Verbindungen 1 bis 132:

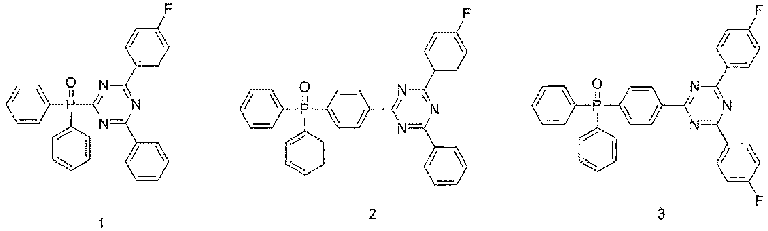

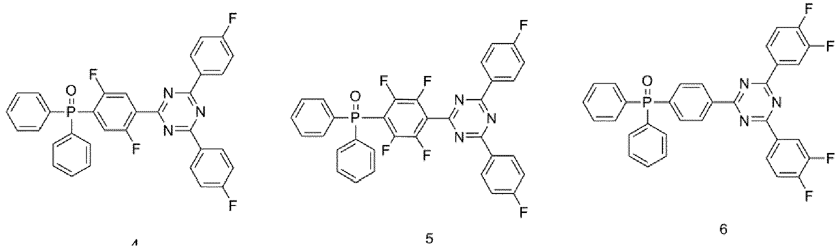

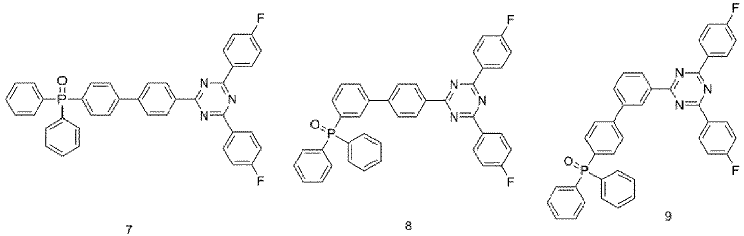

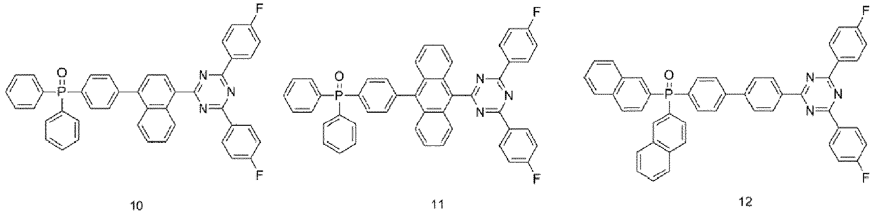

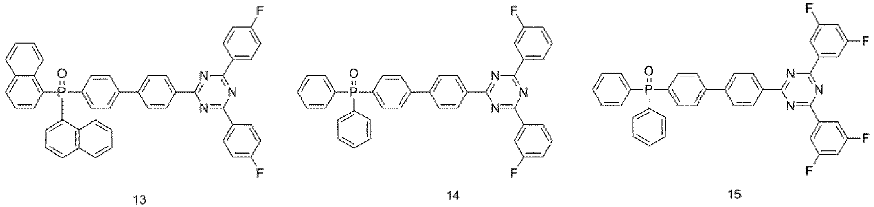

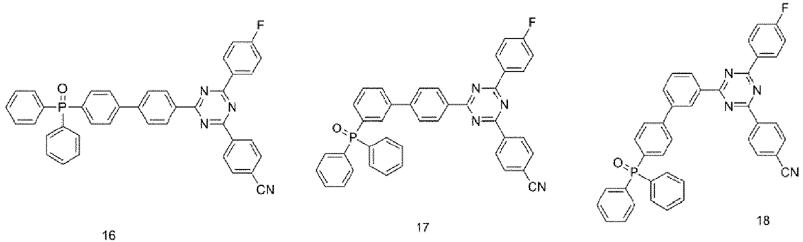

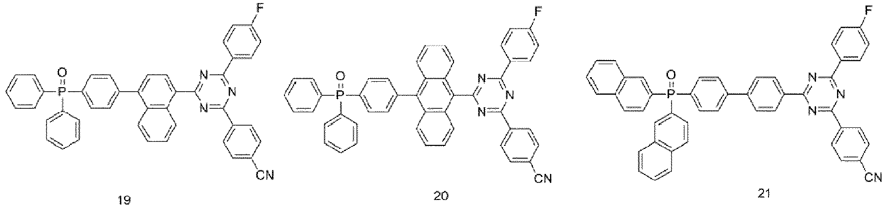

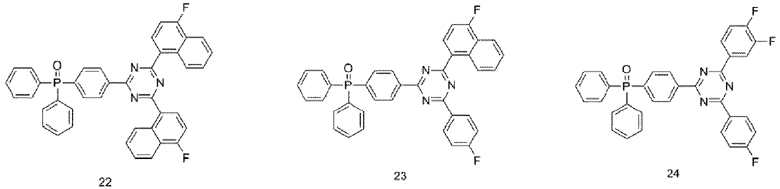

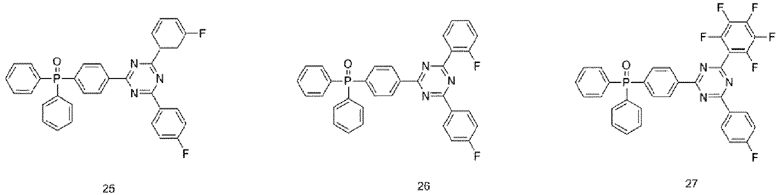

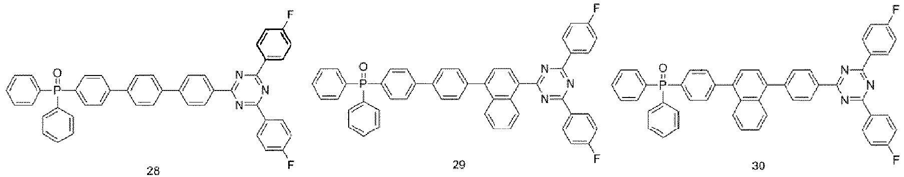

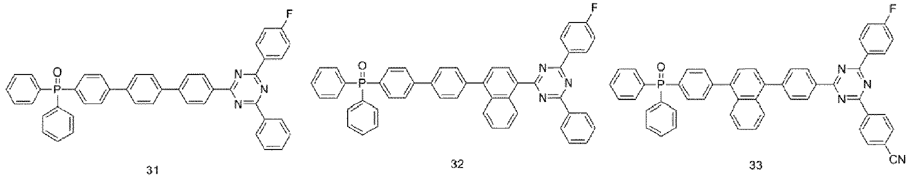

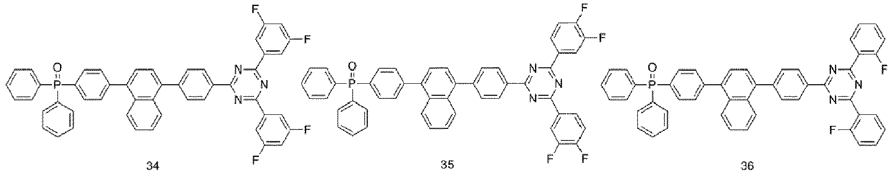

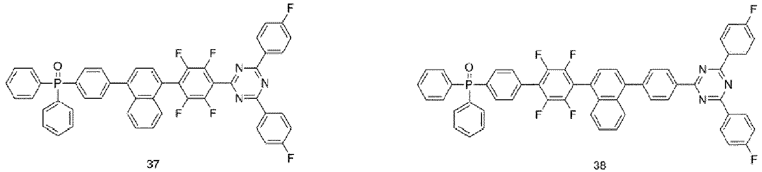

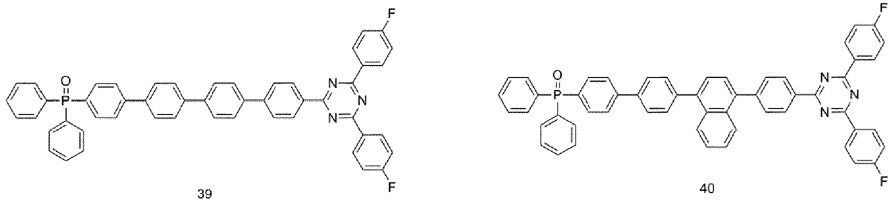

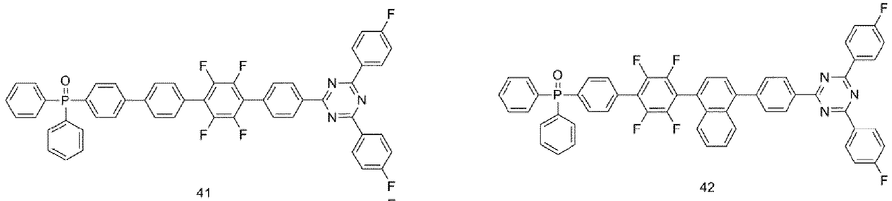

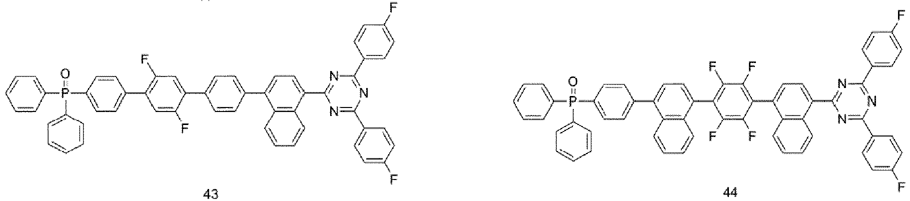

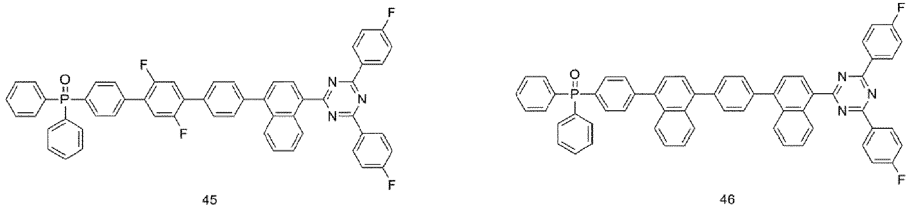

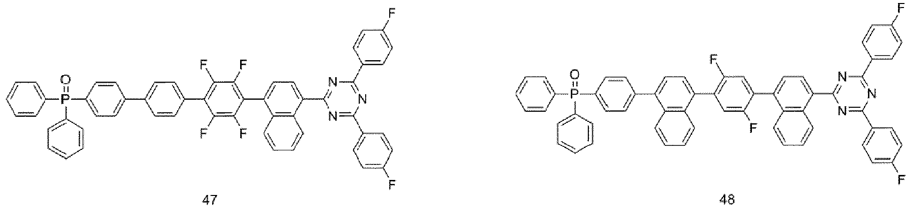

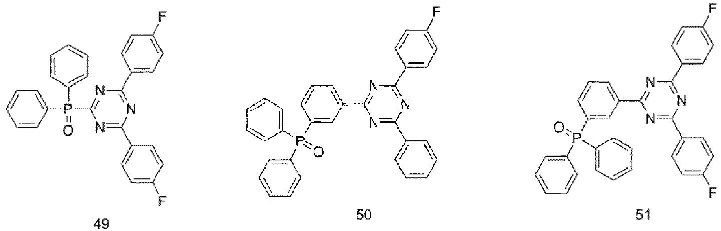

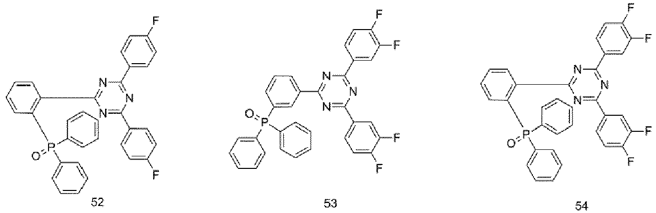

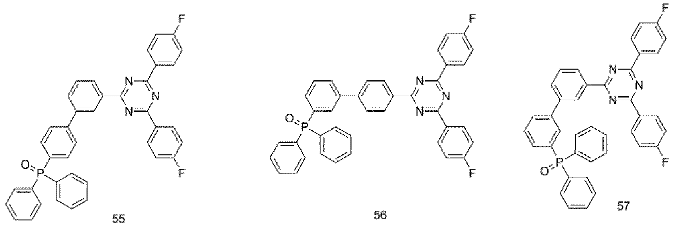

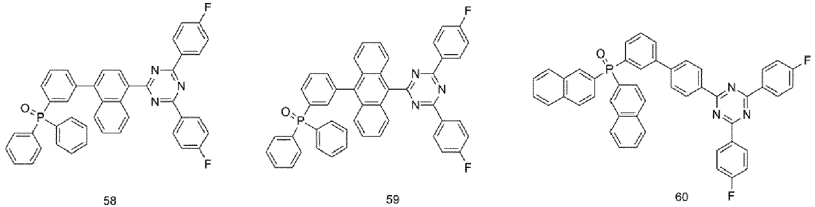

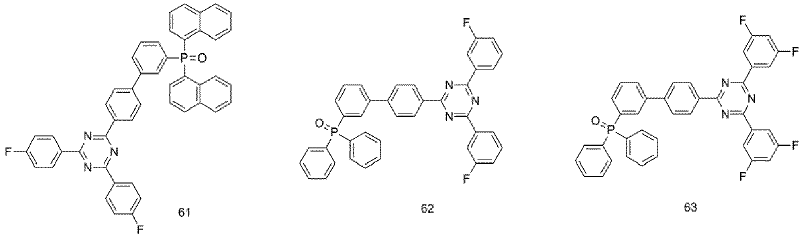

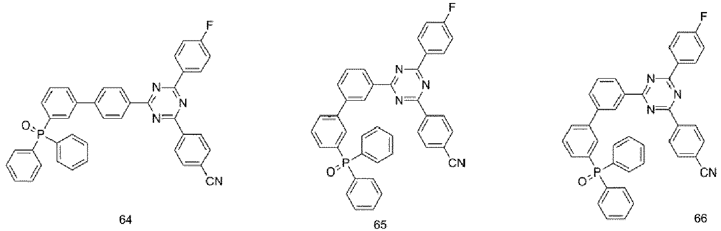

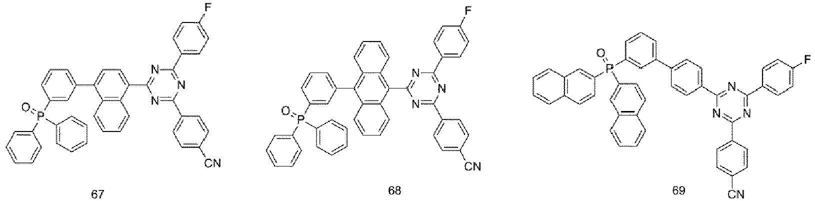

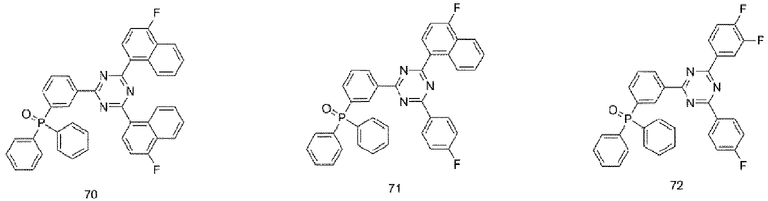

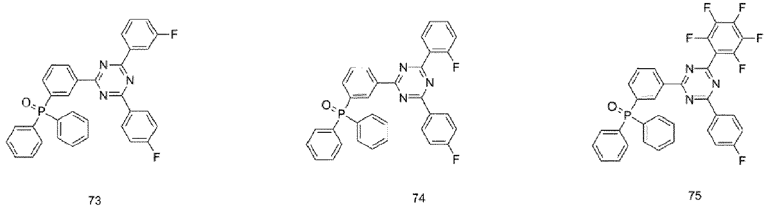

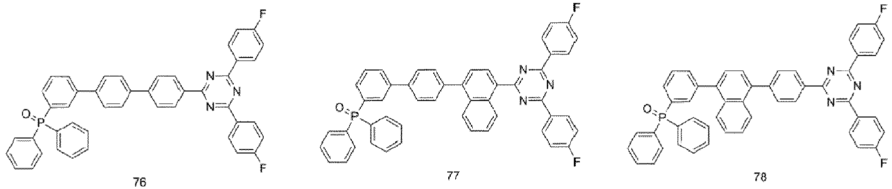

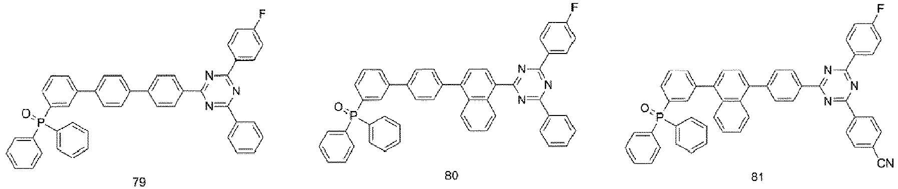

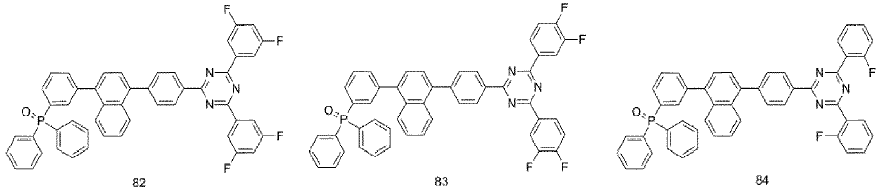

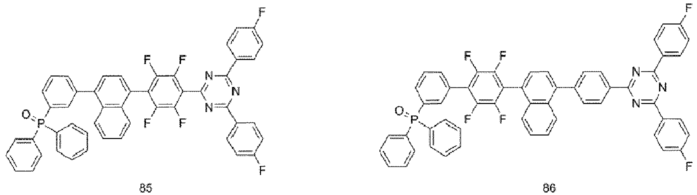

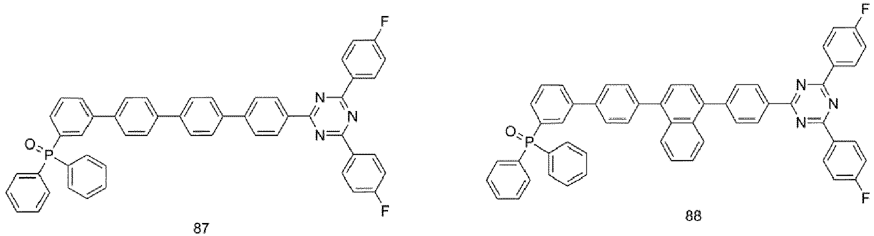

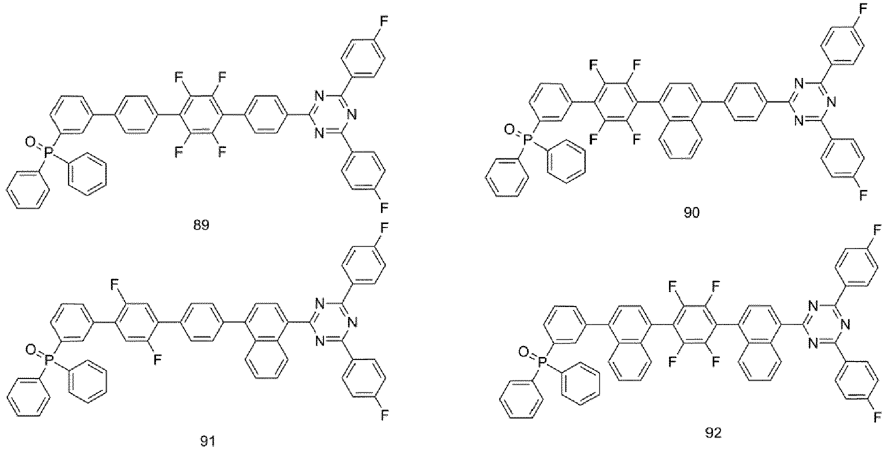

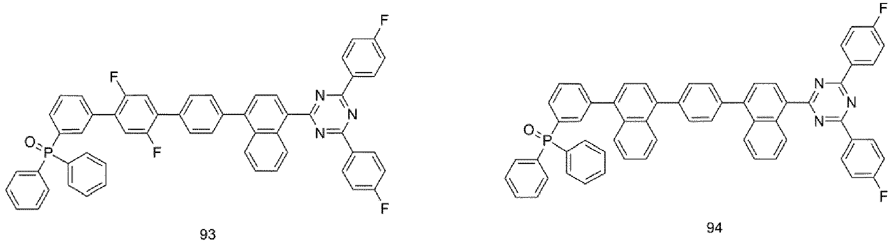

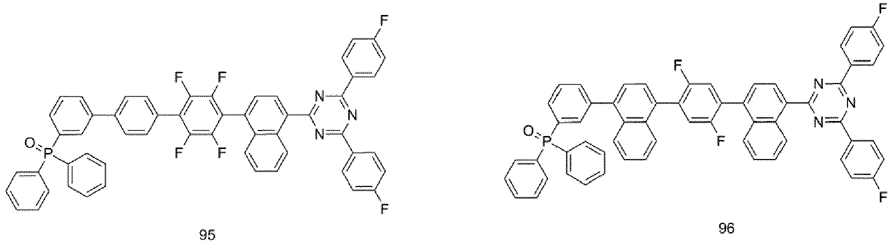

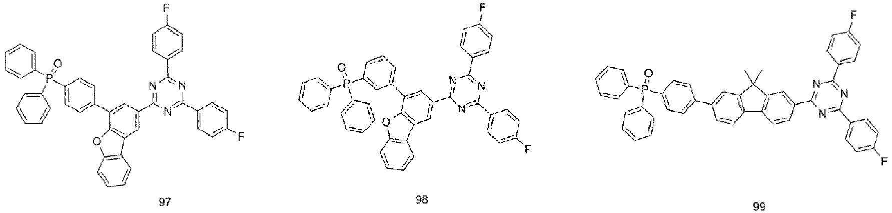

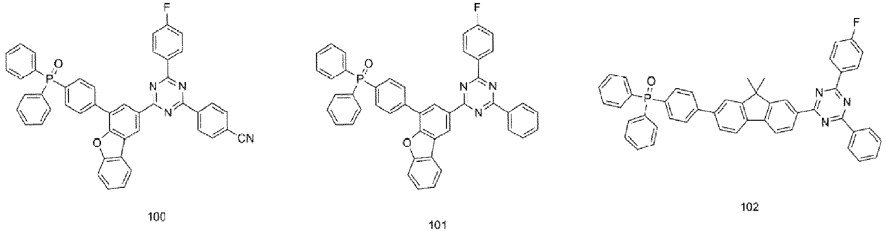

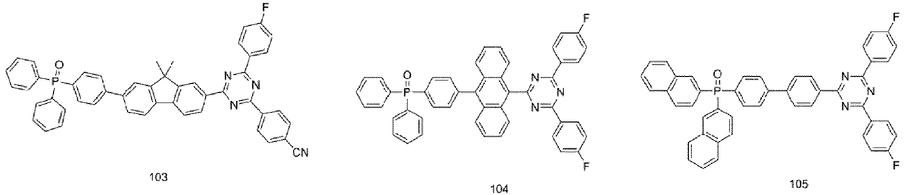

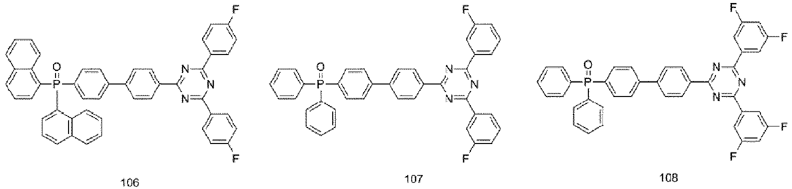

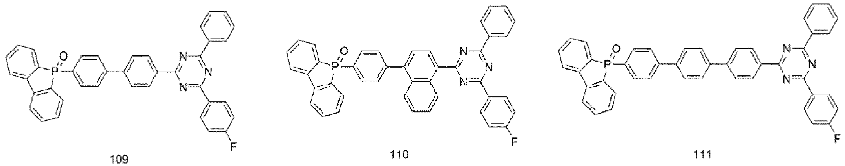

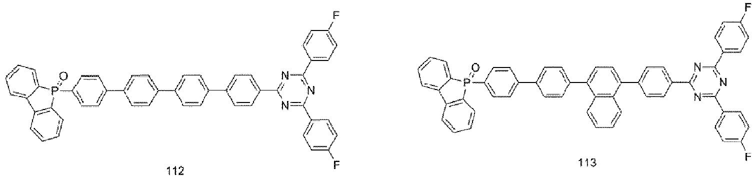

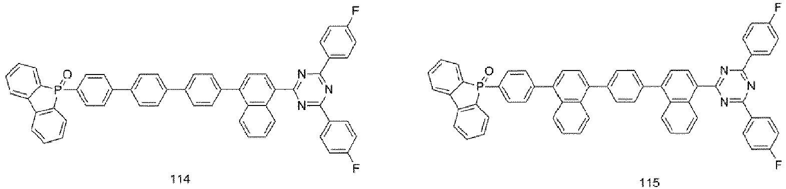

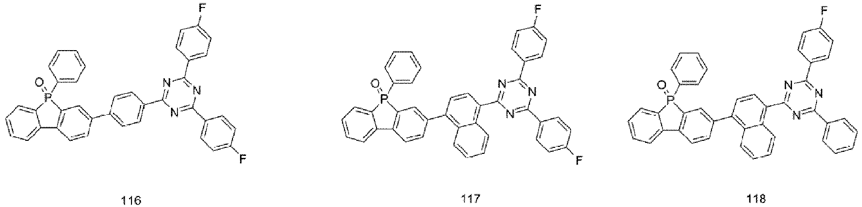

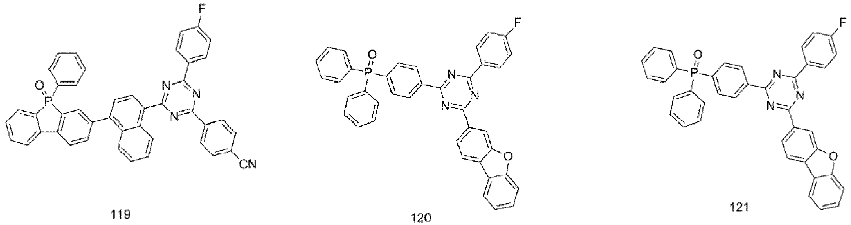

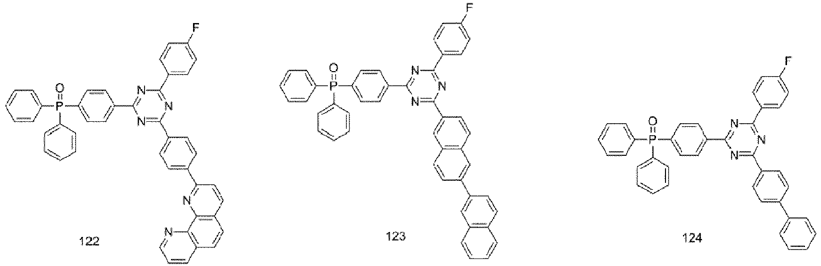

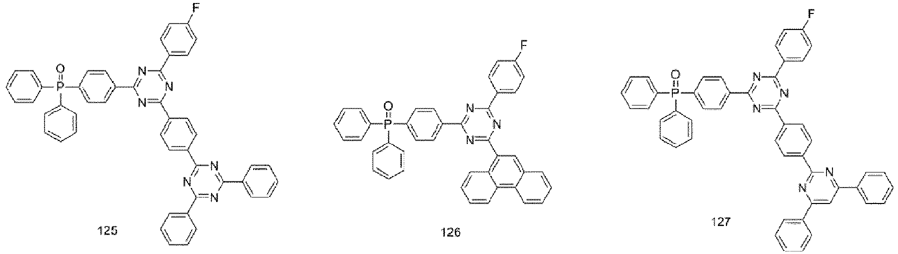

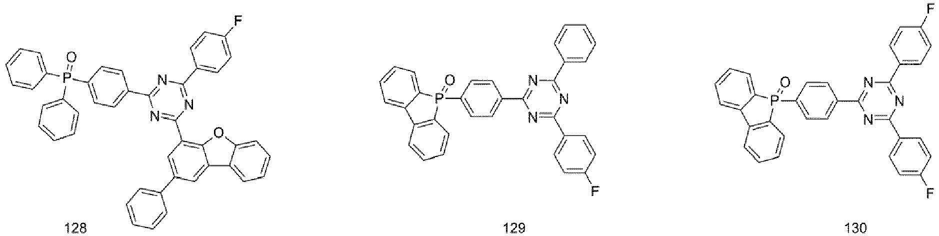

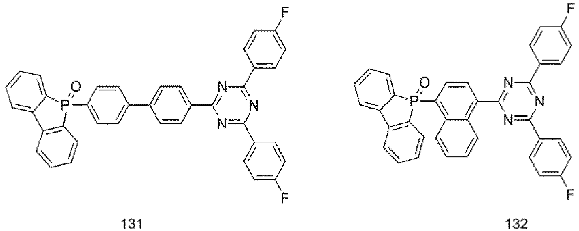

10. Organische lichtemittierende Vorrichtung, umfassend:
eine erste Elektrode;
eine zweite Elektrode, die der ersten Elektrode zugewandt ist; und
eine organische Schicht zwischen der ersten Elektrode und der zweiten Elektrode; wobei die organische Schicht eine Emissionsschicht und mindestens eine heterocyclische Verbindung nach einem der Ansprüche 1 bis 9 umfasst; wobei vorzugsweise die Emissionsschicht die heterocyclische Verbindung umfasst.

11. Organische lichtemittierende Vorrichtung nach Anspruch 10, wobei:
die erste Elektrode eine Anode ist,
die zweite Elektrode eine Kathode ist,
die organische Schicht ferner einen Lochtransportbereich zwischen der ersten Elektrode und der Emissionsschicht und einen Elektronentransportbereich zwischen der Emissionsschicht und der zweiten Elektrode umfasst,
der Lochtransportbereich eine Lochinjektionsschicht, eine Lochtransportschicht, eine Emissionshilfsschicht, eine Elektronenblockierschicht oder eine Kombination davon umfasst, und
der Elektronentransportbereich eine Pufferschicht, eine Lochblockierschicht, eine Elektronenkontrollschicht, eine Elektronentransportschicht, eine Elektroneninj ektionsschicht oder eine Kombination davon umfasst.

12. Organische lichtemittierende Vorrichtung nach Anspruch 11, wobei
(i) der Elektronentransportbereich die heterocyclische Verbindung umfasst, und/oder
(ii) der Elektronentransportbereich die Elektronentransportschicht umfasst und die Elektronentransportschicht die heterocyclische Verbindung umfasst, und/oder
(iii) der Lochtransportbereich einen p-Dotierstoff mit einem niedrigsten unbesetzten Molekülorbital (LUMO)-Energieniveau von -3,5 eV oder weniger umfasst, vorzugsweise
wobei
der p-Dotierstoff eine Cyanogruppen-haltige Verbindung umfasst.

13. Organische lichtemittierende Vorrichtung nach Anspruch 10, wobei:
die Emissionsschicht eine erste Emissionsschicht zum Emittieren von Licht einer ersten Farbe ist,
die organische lichtemittierende Vorrichtung ferner i) mindestens eine zweite Emissionsschicht zum Emittieren von Licht einer zweiten Farbe oder ii) mindestens eine zweite Emissionsschicht zum Emittieren von Licht einer zweiten Farbe und mindestens eine dritte Emissionsschicht zum Emittieren von Licht einer dritten Farbe zwischen der ersten Elektrode und der zweiten Elektrode umfasst,
eine maximale Emissionswellenlänge von Licht der ersten Farbe, eine maximale Emissionswellenlänge von Licht der zweiten Farbe und eine maximale Emissionswellenlänge von Licht der dritten Farbe identisch oder voneinander verschieden sind, und
das Licht einer ersten Farbe und das Licht einer zweiten Farbe in Form von Mischlicht emittiert werden, oder das Licht einer ersten Farbe, das Licht einer zweiten Farbe und das Licht einer dritten Farbe in Form von Mischlicht emittiert werden.

## Revendications

1. Composé hétérocyclique représenté par la Formule 1 : 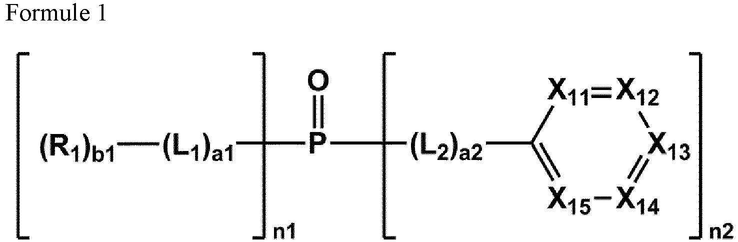
dans lequel, dans la Formule 1,
Xn, X₁₃, et X₁₅ sont chacun N, X₁₂ est C-[(L₁₂)ₐ₁₂-(R₁₂)_{b12}], et X₁₄ est C-[(L₁₄)ₐ₁₄-(R₁₄)_{b14}]
n1 est sélectionné parmi 0, 1 et 2, n2 est sélectionné parmi 1, 2 et 3, une somme de n1+n2 est 3,
L₁, L₂, L₁₂, L₁₄, R₁, R₁₂ et R₁₄ sont chacun indépendamment sélectionnés entre un groupe C₅-C₆₀ carbocyclique substitué ou non substitué et un groupe C₁-C₆₀ hétérocyclique substitué ou non substitué,
a1, a2, a12 et a14 sont chacun indépendamment un nombre entier de 0 à 5,
quand a1 est 0, *-(L₁)ₐ₁-*' est une liaison simple ; quand a2 est 0, *-(L₂)ₐ₂-*' est une liaison simple ; quand a12 est 0, *-(L₁₂)ₐ₁₂-*' est une liaison simple ; quand a14 est 0, *-(L₁₄)ₐ₁₄-*' est une liaison simple;
quand a1 est 2 ou plus, au moins deux groupes L₁ sont identiques ou différents l'un de l'autre ; quand a2 est 2 ou plus, au moins deux groupes L₂ sont identiques ou différents l'un de l'autre ; quand a12 est 2 ou plus, au moins deux groupes L₁₂ sont identiques ou différents l'un de l'autre ; quand a14 est 2 ou plus, au moins deux groupes L₁₄ sont identiques ou différents l'un de l'autre ;
b1, b12 et b14 sont chacun indépendamment un nombre entier de 1 à 10,
quand b1 est 2 ou plus, au moins deux groupes R₁ sont identiques ou différents l'un de l'autre ; quand b12 est 2 ou plus, au moins deux groupes R₁₂ sont identiques ou différents l'un de l'autre ; quand b14 est 2 ou plus, au moins deux groupes R₁₄ sont identiques ou différents l'un de l'autre ;
deux groupes adjacents sélectionnés parmi L₁, L₂, L₁₂, L₁₄, R₁, R₁₂ et R₁₄ sont éventuellement liés pour former un groupe C₅-C₆₀ carbocyclique substitué ou non substitué ou un groupe C₁-C₆₀ hétérocyclique substitué ou non substitué,
le composé hétérocyclique représenté par la Formule 1 comprenant au moins un -F, et
le groupe C₅-C₆₀ carbocyclique substitué et le groupe C₁-C₆₀ hétérocyclique substitué étant substitués par un ou plusieurs substituants sélectionnés parmi :
deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle , un groupe C₂-C₆₀ alkynyle, et un groupe C₁-C₆₀ alkoxy ;
un groupe C₁-C₆₀ alkyle, un groupe C₂-C₆₀ alkényle, un groupe C₂-C₆₀ alkynyle, et un groupe C₁-C₆₀ alkoxy, chacun substitué par au moins un élément sélectionné parmi : deutérium, - F, -Cl, -Br, -I, un groupe hydroxyle, un groupe cyano, un groupe nitro, un groupe amidino, un groupe hydrazino, un groupe hydrazono, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), et -P(=O)(Q₁₁)(Q₁₂) ;
un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, un groupe biphényle, et un groupe terphényle ;
un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, un groupe biphényle, et un groupe terphényle, chacun substitué par au moins un élément sélectionné parmi : deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, un groupe biphényle, un groupe terphényle, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et - P(=O)(Q₃₁)(Q₃₂),
dans lequel Q₁ à Q₃, Q₁₁ à Q₁₃, Q₂₁ à Q₂₃, et Q₃₁ à Q₃₃ sont chacun indépendamment sélectionnés parmi : hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryle substitué par un groupe C₁-C₆₀ alkyle, un groupe C₁-C₆₀ hétéroaryle, un groupe polycyclique condensé non aromatique monovalent, un groupe hétéropolycyclique condensé non aromatique monovalent, un groupe biphényle et un groupe terphényle,
* indique un site de liaison à un atome adjacent ; et
(i) au moins l'un de R₁₂ et R₁₄ est sélectionné parmi : un groupe C₅-C₆₀ carbocyclique substitué ou non substitué contenant du fluoré et un groupe C₁-C₆₀ hétérocyclique substitué ou non substitué contenant du fluoré ou (ii) au moins l'un de R₁₂ et R₁₄ est sélectionné parmi les groupes représentés par les Formules 7-1 à 7-77 : 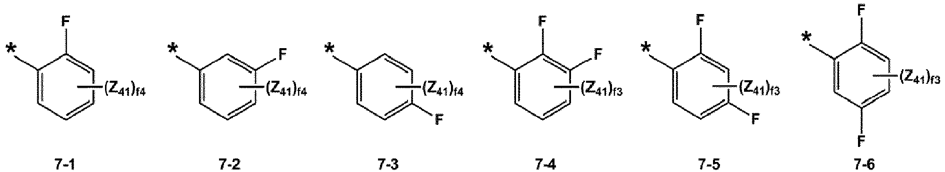 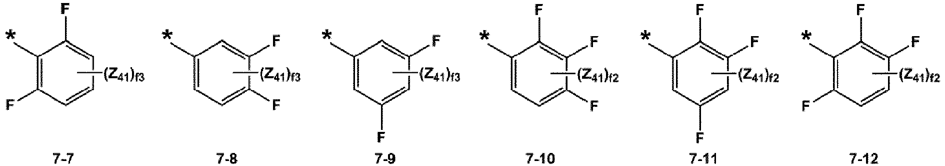 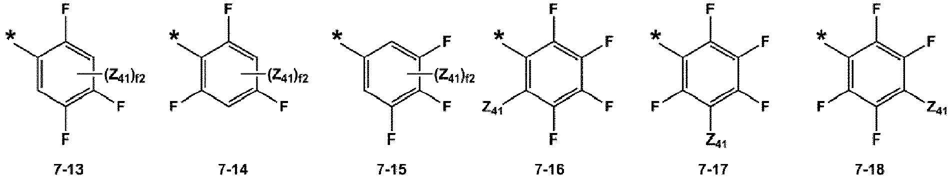 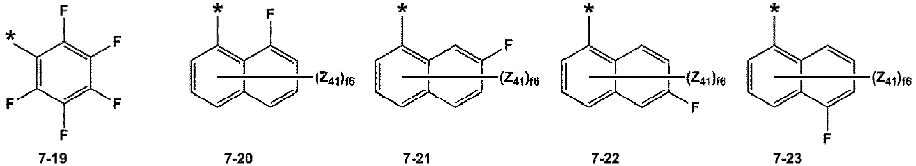 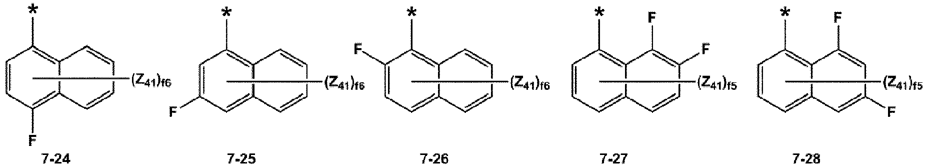 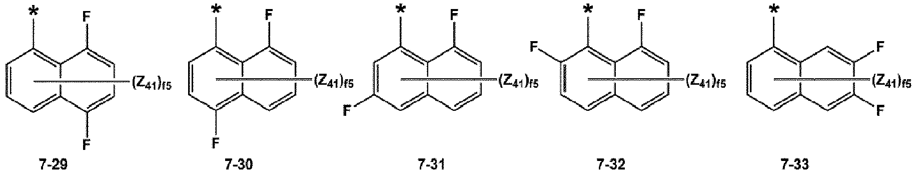 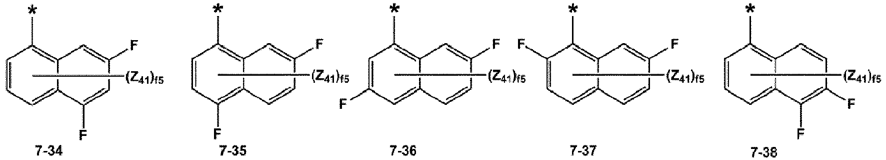 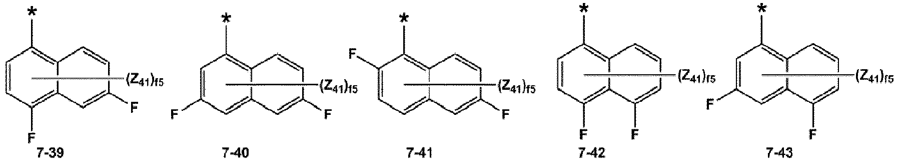 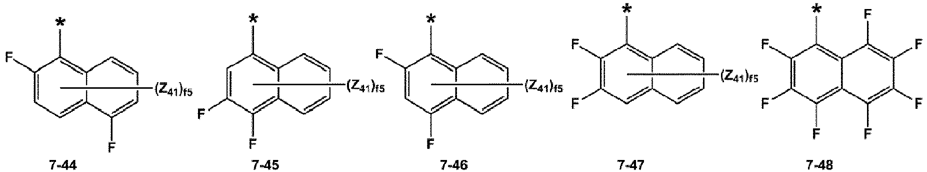 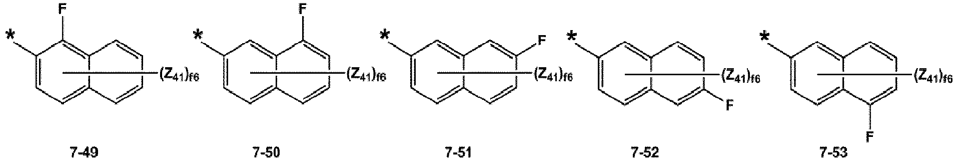 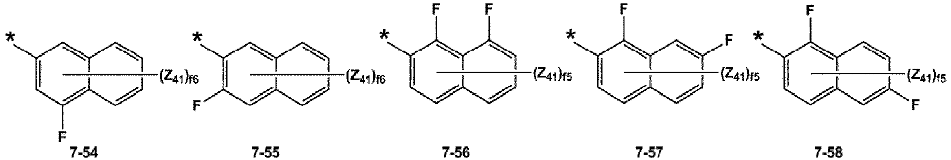 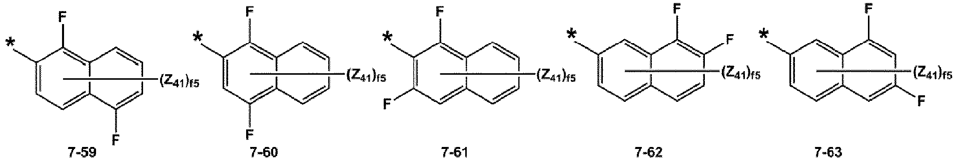 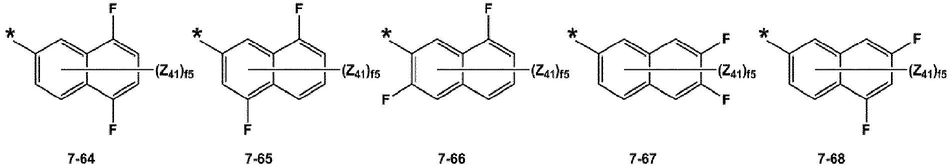 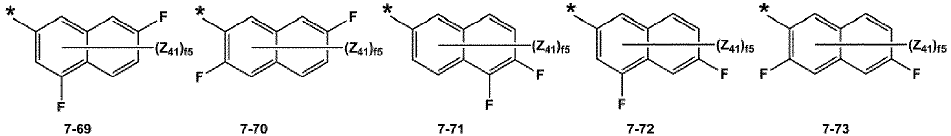 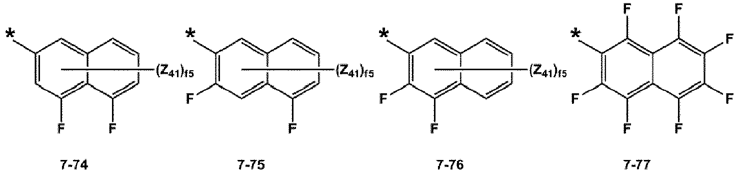
dans lequel, dans les Formules 7-1 à 7-77,
Z₄₁ est sélectionné parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₂₀ alkyle, un groupe C₁-C₂₀ alkoxy, un groupe cyclopentyle, un groupe cyclohexyle, un groupe cycloheptyle, un groupe cyclopentényle, un groupe cyclohexényle, un groupe phényle, un groupe biphényle, un groupe naphtyle, un groupe fluorényle, un groupe spiro-bifluorényle, un groupe spiro-fluorène-benzofluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyridinyle, un groupe pyrazinyle, un groupe pyrimidinyle, un groupe quinolinyle, un groupe isoquinolinyle, un groupe benzoquinolinyle, un groupe naphtyridinyle, un groupe quinoxalinyle, un groupe quinazolinyle, un groupe carbazolyle, un groupe phénanthridinyle, un groupe acridinyle, un groupe phénanthrolinyle, un groupe phénazinyle, un groupe triazinyle, un groupe dibenzofuranyle, un groupe dibenzothiophényle, et - Si(Q₃₁)(Q₃₂)(Q₃₃),
f2 est un nombre entier sélectionné entre 1 et 2 ; quand f2 est 2, au moins deux groupes Z₄₁ sont identiques ou différents l'un de l'autre,
f3 est un nombre entier de 1 à 3 ; quand f3 est 2 ou plus, au moins deux groupes Z₄₁ sont identiques ou différents l'un de l'autre,
f4 est un nombre entier de 1 à 4 ; quand f4 est 2 ou plus, au moins deux groupes Z₄₁ sont identiques ou différents l'un de l'autre,
f5 est un nombre entier de 1 à 5 ; quand f5 est 2 ou plus, au moins deux groupes Z₄₁ sont identiques ou différents l'un de l'autre,
f6 est un nombre entier de 1 à 6 ; quand f6 est 2 ou plus, au moins deux groupes Z₄₁ sont identiques ou différents l'un de l'autre,
Q₃₁ à Q₃₃ sont chacun indépendamment sélectionnés parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryle substitué par un groupe C₁-C₆₀ alkyle, un groupe C₁-C₆₀ hétéroaryle, un groupe polycyclique condensé non aromatique monovalent, un groupe hétéropolycyclique condensé non aromatique monovalent, un groupe biphényle et un groupe terphényle, et
* indique un site de liaison à un atome adjacent.

2. Composé hétérocyclique selon la revendication 1, dans lequel L₁, L₂, L₁₂, L₁₄, R₁, R₁₂ et R₁₄ sont chacun indépendamment sélectionnés parmi :
un groupe benzène, un groupe pentalène, un groupe indène, un groupe naphtalène, un groupe azulène, un groupe heptalène, un groupe indacène, un groupe acénaphtalène, un groupe fluorène, un groupe spiro-fluorène, un groupe benzofluorène, un groupe phénalène, un groupe phénanthrène, un groupe anthracène, un groupe fluoranthène, un groupe triphénylène, un groupe pyrène, un groupe chrysène, un groupe naphtacène, un groupe picène, un groupe pérylène, un groupe pentaphénylène, un groupe hexacène, un groupe pyrrole, un groupe imidazole, un groupe pyrazole, un groupe pyridine, un groupe pyrazine, un groupe pyrimidine, un groupe pyridazine, un groupe isoindole, un groupe indole, un groupe indazole, un groupe purine, un groupe quinoline, un groupe isoquinoline, un groupe benzoquinoline, un groupe phtalazine, un groupe naphtyridine, un groupe quinoxaline, un groupe quinazoline, un groupe cinnoline, un groupe carbazole, un groupe phénanthridine, un groupe acridine, un groupe phénanthroline, un groupe phénazine, un groupe benzoxazole, un groupe benzimidazole, un groupe furane, un groupe benzofurane, un groupe thiophène, un groupe benzothiophène, un groupe thiazole, un groupe isothiazole, un groupe benzothiazole, un groupe isoxazole, un groupe oxazole, un groupe triazole, un groupe tétrazole, un groupe oxadiazole, un groupe triazine, un groupe benzoxazole, un groupe dibenzofurane, un groupe dibenzothiophène, un groupe benzocarbazole, et un groupe dibenzocarbazole ; et
un groupe benzène, un groupe pentalène, un groupe indène, un groupe naphtalène, un groupe azulène, un groupe heptalène, un groupe indacène, un groupe acénaphtalène, un groupe fluorène, un groupe spiro-fluorène, un groupe benzofluorène, un groupe phénalène, un groupe phénanthrène, un groupe anthracène, un groupe fluoranthène, un groupe triphénylène, un groupe pyrène, un groupe chrysène, un groupe naphtacène, un groupe picène, un groupe pérylène, un groupe pentaphénylène, un groupe hexacène, un groupe pyrrole, un groupe imidazole, un groupe pyrazole, un groupe pyridine, un groupe pyrazine, un groupe pyrimidine, un groupe pyridazine, un groupe isoindole, un groupe indole, un groupe indazole, un groupe purine, un groupe quinoline, un groupe isoquinoline, un groupe benzoquinoline, un groupe phtalazine, un groupe naphtyridine, un groupe quinoxaline, un groupe quinazoline, un groupe cinnoline, un groupe carbazole, un groupe phénanthridine, un groupe acridine, un groupe phénanthroline, un groupe phénazine, un groupe benzoxazole, un groupe benzimidazole, un groupe furane, un groupe benzofurane, un groupe thiophène, un groupe benzothiophène, un groupe thiazole, un groupe isothiazole, un groupe benzothiazole, un groupe isoxazole, un groupe oxazole, un groupe triazole, un groupe tétrazole, un groupe oxadiazole, un groupe triazine, un groupe benzoxazole, un groupe dibenzofurane, un groupe dibenzothiophène, un groupe benzocarbazole, et un groupe dibenzocarbazole, chacun substitué par au moins un élément sélectionné parmi deutérium, -F, -Cl, -Br, -I, un groupe hydroxyle, un groupe cyano, un groupe nitro, un groupe amino, un groupe amidino, un groupe hydrazino, un groupe hydrazono, un groupe C₁-C₂₀ alkyle, un groupe C₁-C₂₀ alkoxy, un groupe C₆-C₂₀ aryle, un groupe C₂-C₂₀ hétéroaryle, et -Si(Q₃₁)(Q₃₂)(Q₃₃)
dans lequel Q₃₁ à Q₃₃ sont chacun indépendamment sélectionnés parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryle substitué par un groupe C₁-C₆₀ alkyle, un groupe C₁-C₆₀ hétéroaryle, un groupe polycyclique condensé non aromatique monovalent, un groupe hétéropolycyclique condensé non aromatique monovalent, un groupe biphényle, et un groupe terphényle.

3. Composé hétérocyclique selon la revendication 1 ou la revendication 2, dans lequel L₁, L₂, L₁₂ et L₁₄ sont chacun indépendamment sélectionnés parmi les groupes représentés par les Formules 3-1 à 3-47 : 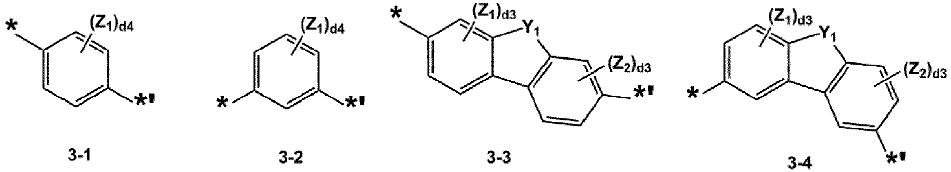 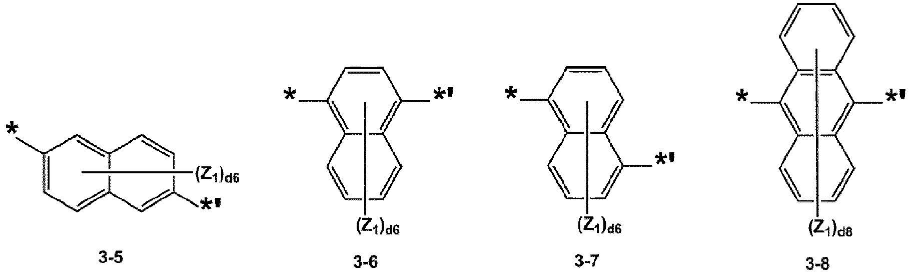 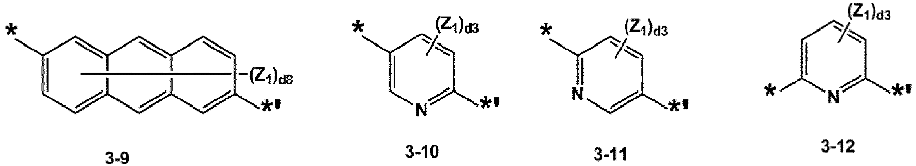 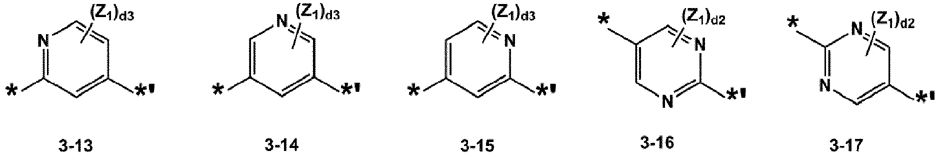 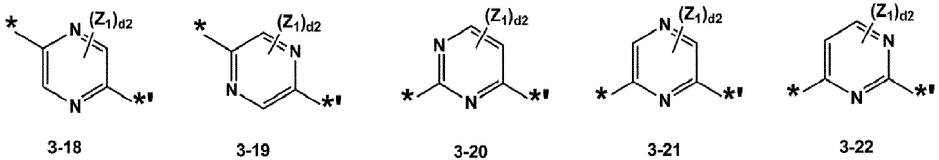 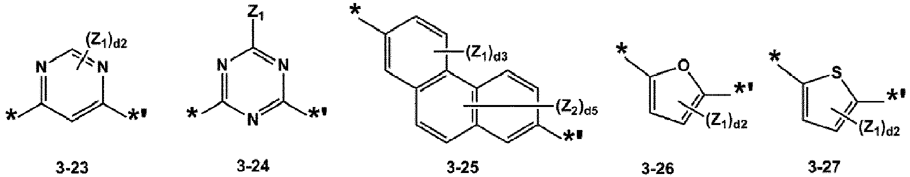 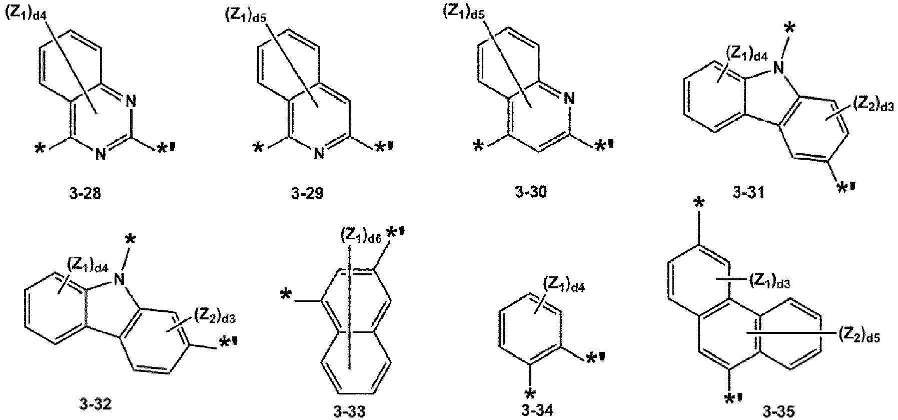 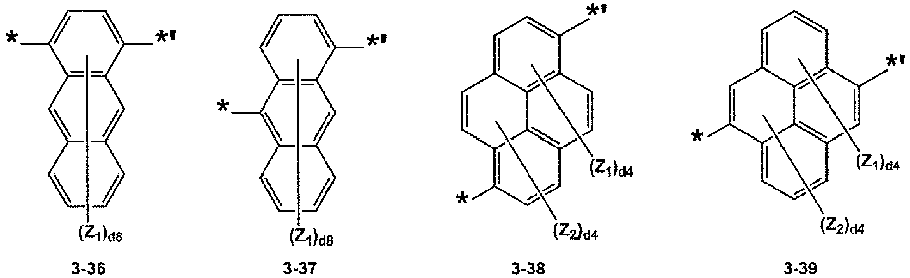 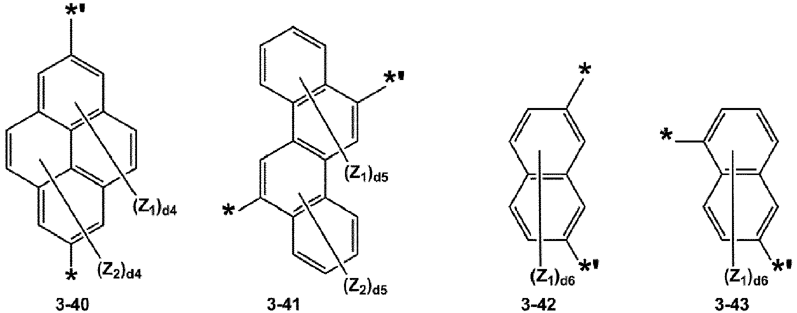 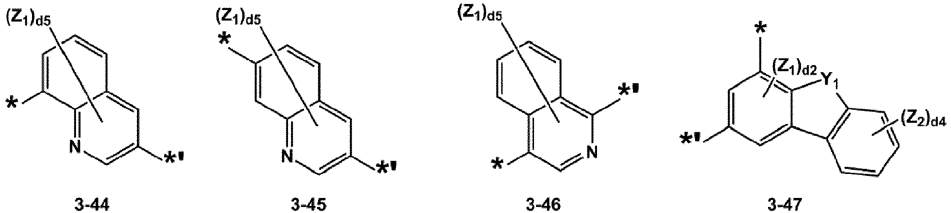
dans lequel, dans les Formules 3-1 à 3-47,
Y₁ est sélectionné parmi O, S, C(Z₃)(Z₄), N(Z₅), et Si(Z₆)(Z₇),
Z₁ à Z₇ sont chacun indépendamment sélectionnés parmi : hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₂₀ alkyle, un groupe C₁-C₂₀ alkoxy, un groupe cyclopentyle, un groupe cyclohexyle, un groupe cycloheptyle, un groupe cyclopentényle, un groupe cyclohexényle, un groupe phényle, un groupe biphényle, un groupe naphtyle, un groupe fluorényle, un groupe spiro-bifluorényle, un groupe phénalényle, un groupe phénanthrényle, un groupe anthracényle, un groupe fluoranthényle, un groupe triphénylényle, un groupe pyridinyle, un groupe pyrazinyle, un groupe pyrimidinyle, un groupe quinolinyle, un groupe isoquinolinyle, un groupe benzoquinolinyle, un groupe naphtyridinyle, un groupe quinoxalinyle, un groupe quinazolinyle, un groupe carbazolyle, un groupe phénanthridinyle, un groupe acridinyle, un groupe phénanthrolinyle, un groupe phénazinyle, un groupe triazinyle, un groupe dibenzofuranyle, un groupe dibenzothiophényle, et -Si(Q₃₁)(Q₃₂)(Q₃₃),
d2 est un nombre entier de 0 à 2 ; quand d2 est 2, au moins deux groupes Z₁ sont identiques ou différents l'un de l'autre,
d3 est un nombre entier de 0 à 3 ; quand d3 est 2 ou plus, au moins deux groupes Z₁ sont identiques ou différents l'un de l'autre, et au moins deux groupes Z₂ sont identiques ou différents l'un de l'autre,
d4 est un nombre entier de 0 à 4 ; quand d4 est 2 ou plus, au moins deux groupes Z₁ sont identiques ou différents l'un de l'autre, et au moins deux groupes Z₂ sont identiques ou différents l'un de l'autre,
d5 est un nombre entier de 0 à 5 ; quand d5 est 2 ou plus, au moins deux groupes Z₁ sont identiques ou différents l'un de l'autre, et au moins deux groupes Z₂ sont identiques ou différents l'un de l'autre,
d6 est un nombre entier de 0 à 6 ; quand d6 est 2 ou plus, au moins deux groupes Z₁ sont identiques ou différents l'un de l'autre, et au moins deux groupes Z₂ sont identiques ou différents l'un de l'autre,
d8 est un nombre entier de 0 à 8 ; quand d8 est 2 ou plus, au moins deux groupes Z₁ sont identiques ou différents l'un de l'autre,
Q₃₁ à Q₃₃ sont chacun indépendamment sélectionnés parmi : hydrogène, deutérium, -F, - Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryle substitué par un groupe C₁-C₆₀ alkyle, un groupe C₁-C₆₀ hétéroaryle, un groupe polycyclique condensé non aromatique monovalent, un groupe hétéropolycyclique condensé non aromatique monovalent, un groupe biphényle, et un groupe terphényle, et
* et *' indiquent chacun un site de liaison à un atome adjacent.

4. Composé hétérocyclique selon l'une quelconque des revendications 1 à 3, dans lequel R₁, R₁₂ et R₁₄ sont chacun indépendamment sélectionnés parmi les groupes représentés par les Formules 5-1 à 5-79 : 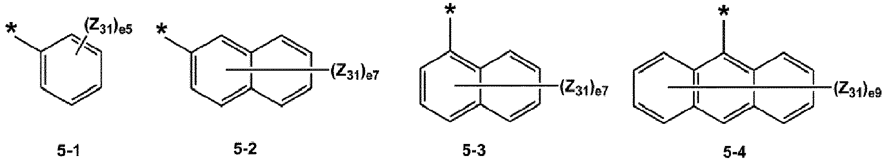 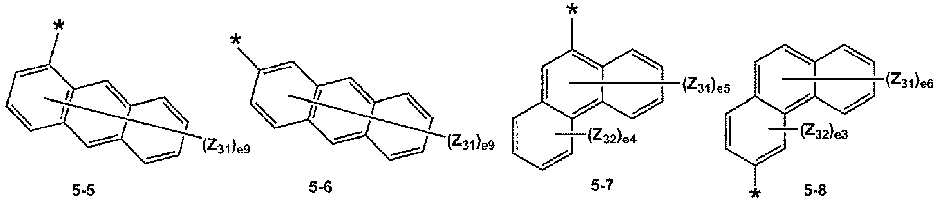 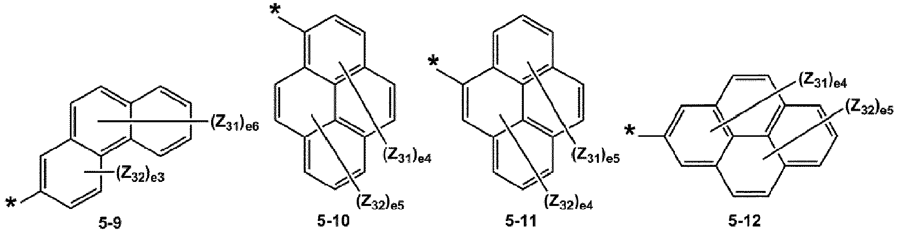 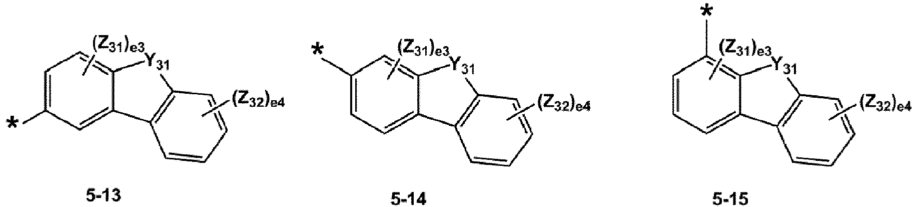 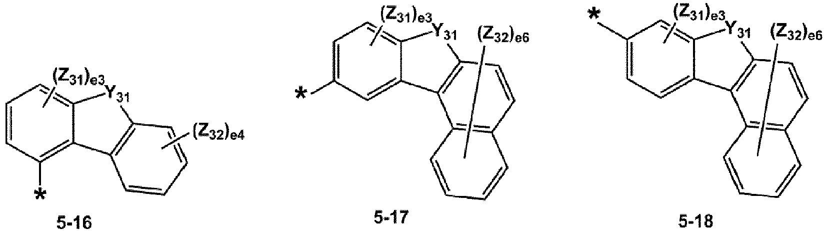 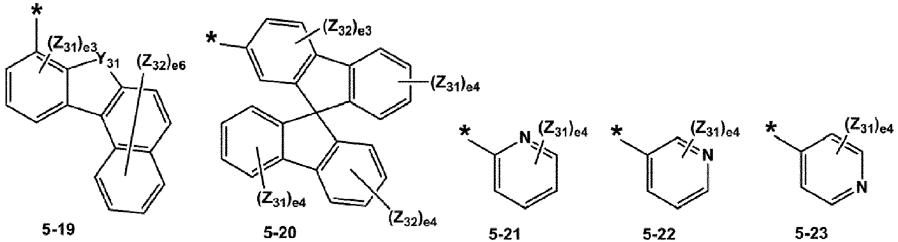 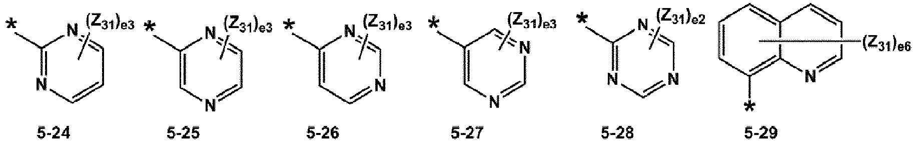 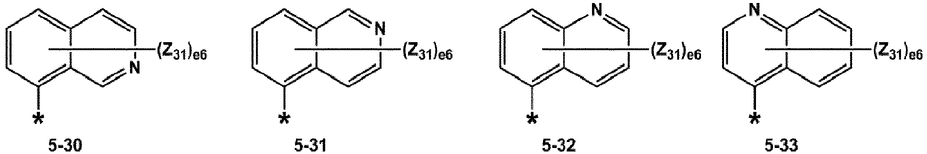 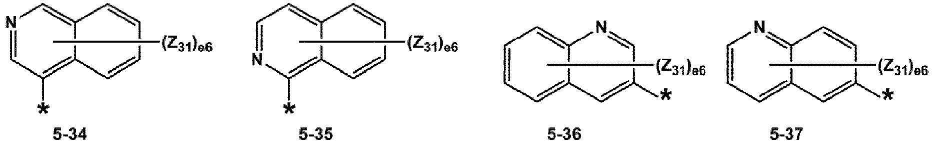 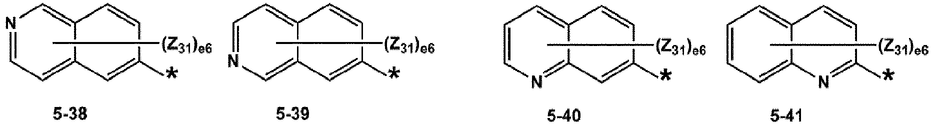 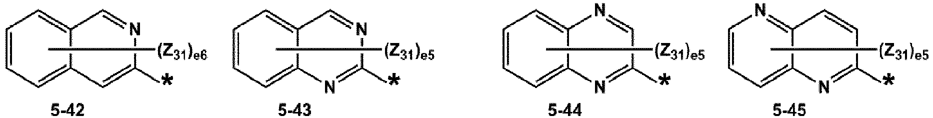 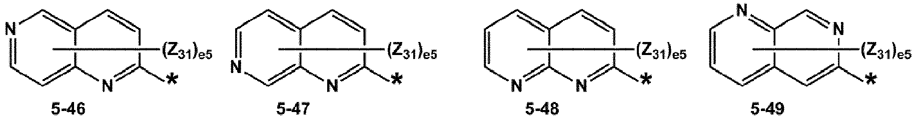 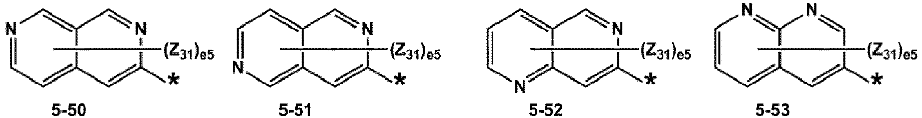 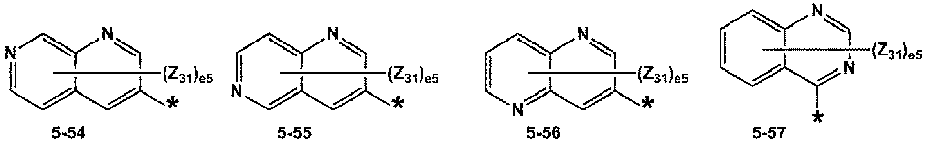 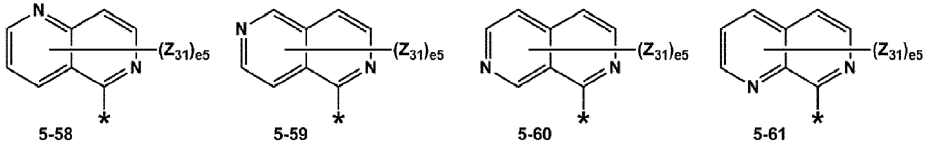 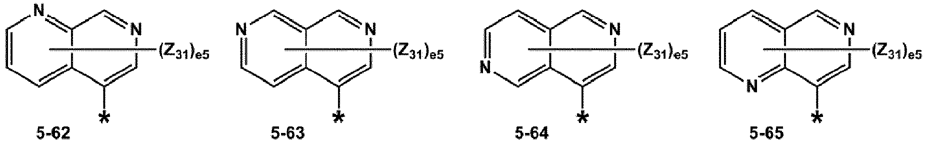 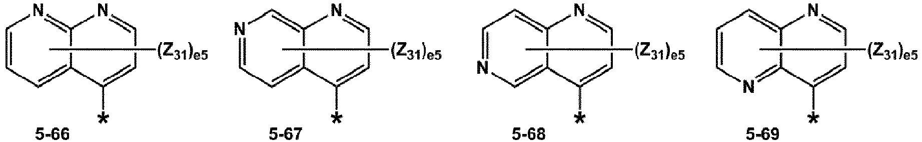 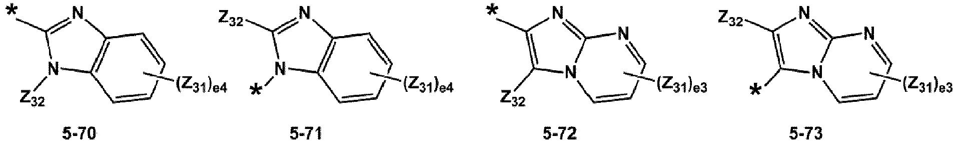 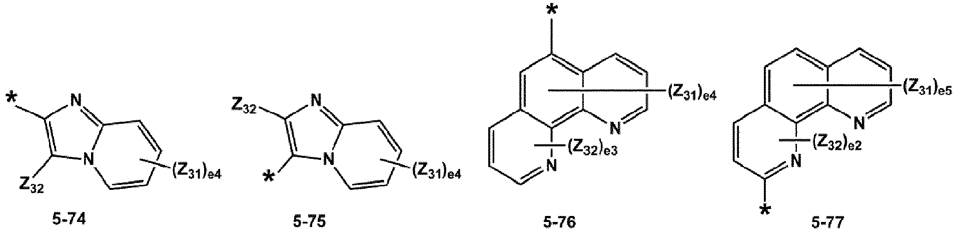 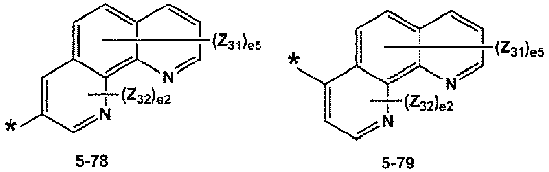
dans lequel, dans les Formules 5-1 à 5-79,
Y₃₁ est sélectionné parmi O, S, C(Z₃₃)(Z₃₄), N(Z₃₅), et Si(Z₃₆)(Z₃₇),
Z₃₁ à Z₃₇ sont chacun indépendamment sélectionnés parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₂₀ alkyle, un groupe C₁-C₂₀ alkoxy, un groupe cyclopentyle, un groupe cyclohexyle, un groupe cycloheptyle, un groupe cyclopentényle, un groupe cyclohexényle, un groupe phényle, un groupe biphényle, un groupe naphtyle, un groupe fluorényle, un groupe spiro-bifluorényle, un groupe spiro-fluorène-benzofluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyridinyle, un groupe pyrazinyle, un groupe pyrimidinyle, un groupe quinolinyle, un groupe isoquinolinyle, un groupe benzoquinolinyle, un groupe naphtyridinyle, un groupe quinoxalinyle, un groupe quinazolinyle, un groupe carbazolyle, un groupe phénanthridinyle, un groupe acridinyle, un groupe phénanthrolinyle, un groupe phénazinyle, un groupe triazinyle, un groupe dibenzofuranyle, un groupe dibenzothiophényle, et -Si(Q₃₁)(Q₃₂)(Q₃₃),
e2 est un nombre entier de 0 à 2 ; quand e2 est 2, au moins deux groupes Z₃₁ sont identiques ou différents l'un de l'autre, et au moins deux groupes Z₃₂ sont identiques ou différents l'un de l'autre,
e3 est un nombre entier de 0 à 3 ; quand e3 est 2 ou plus, au moins deux groupes Z₃₁ sont identiques ou différents l'un de l'autre, au moins deux groupes Z₃₂ sont identiques ou différents l'un de l'autre,
e4 est un nombre entier de 0 à 4 ; quand e4 est 2 ou plus, au moins deux groupes Z₃₁ sont identiques ou différents l'un de l'autre, au moins deux groupes Z₃₂ sont identiques ou différents l'un de l'autre,
e5 est un nombre entier de 0 à 5 ; quand e5 est 2 ou plus, au moins deux groupes Z₃₁ sont identiques ou différents l'un de l'autre, au moins deux groupes Z₃₂ sont identiques ou différents l'un de l'autre,
e6 est un nombre entier de 0 à 6 ; quand e6 est 2 ou plus, au moins deux groupes Z₃₁ sont identiques ou différents l'un de l'autre, au moins deux groupes Z₃₂ sont identiques ou différents l'un de l'autre,
e7 est un nombre entier de 0 à 7 ; quand e7 est 2 ou plus, au moins deux groupes Z₃₁ sont identiques ou différents l'un de l'autre,
e9 est un nombre entier de 0 à 9 ; quand e9 est 2 ou plus, au moins deux groupes Z₃₁ sont identiques ou différents l'un de l'autre,
Q₃₁ à Q₃₃ sont chacun indépendamment sélectionnés parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryle substitué par un groupe C₁-C₆₀ alkyle, un groupe C₁-C₆₀ hétéroaryle, un groupe polycyclique condensé non aromatique monovalent, un groupe hétéropolycyclique condensé non aromatique monovalent, un groupe biphényle, et un groupe terphényle, et
* indique un site de liaison à un atome adjacent.

5. Composé hétérocyclique selon l'une quelconque des revendications 1 à 4, dans lequel n1 est 2, et n2 est 1.

6. Composé hétérocyclique selon l'une quelconque des revendications 1 à 5, dans lequel au moins un élément sélectionné entre R₁₂ et R₁₄ est sélectionné parmi :
un groupe benzène, un groupe pentalène, un groupe indène, un groupe naphtalène, un groupe azulène, un groupe heptalène, un groupe indacène, un groupe acénaphtalène, un groupe fluorène, un groupe spiro-fluorène, un groupe benzofluorène, un groupe phénalène, un groupe phénanthrène, un groupe anthracène, un groupe fluoranthène, un groupe triphénylène, un groupe pyrène, un groupe chrysène, un groupe naphtacène, un groupe picène, un groupe pérylène, un groupe pentaphénylène, un groupe hexacène, un groupe pyrrole, un groupe imidazole, un groupe pyrazole, un groupe pyridine, un groupe pyrazine, un groupe pyrimidine, un groupe pyridazine, un groupe isoindole, un groupe indole, un groupe indazole, un groupe purine, un groupe quinoline, un groupe isoquinoline, un groupe benzoquinoline, un groupe phtalazine, un groupe naphtyridine, un groupe quinoxaline, un groupe quinazoline, un groupe cinnoline, un groupe carbazole, un groupe phénanthridine, un groupe acridine, un groupe phénanthroline, un groupe phénazine, un groupe benzoxazole, un groupe benzimidazole, un groupe furane, un groupe benzofurane, un groupe thiophène, un groupe benzothiophène, un groupe thiazole, un groupe isothiazole, un groupe benzothiazole, un groupe isoxazole, un groupe oxazole, un groupe triazole, un groupe tétrazole, un groupe oxadiazole, un groupe triazine, un groupe benzoxazole, un groupe dibenzofurane, un groupe dibenzothiophène, un groupe benzocarbazole, et un groupe dibenzocarbazole ; et
un groupe benzène, un groupe pentalène, un groupe indène, un groupe naphtalène, un groupe azulène, un groupe heptalène, un groupe indacène, un groupe acénaphtalène, un groupe fluorène, un groupe spiro-fluorène, un groupe benzofluorène, un groupe phénalène, un groupe phénanthrène, un groupe anthracène, un groupe fluoranthène, un groupe triphénylène, un groupe pyrène, un groupe chrysène, un groupe naphtacène, un groupe picène, un groupe pérylène, un groupe pentaphénylène, un groupe hexacène, un groupe pyrrole, un groupe imidazole, un groupe pyrazole, un groupe pyridine, un groupe pyrazine, un groupe pyrimidine, un groupe pyridazine, un groupe isoindole, un groupe indole, un groupe indazole, un groupe purine, un groupe quinoline, un groupe isoquinoline, un groupe benzoquinoline, un groupe phtalazine, un groupe naphtyridine, un groupe quinoxaline, un groupe quinazoline, un groupe cinnoline, un groupe carbazole, un groupe phénanthridine, un groupe acridine, un groupe phénanthroline, un groupe phénazine, un groupe benzoxazole, un groupe benzimidazole, un groupe furane, un groupe benzofurane, un groupe thiophène, un groupe benzothiophène, un groupe thiazole, un groupe isothiazole, un groupe benzothiazole, un groupe isoxazole, un groupe oxazole, un groupe triazole, un groupe tétrazole, un groupe oxadiazole, un groupe triazine, un groupe benzoxazole, un groupe dibenzofurane, un groupe dibenzothiophène, un groupe benzocarbazole, et un groupe dibenzocarbazole, chacun substitué par au moins un élément sélectionné parmi : deutérium, -F, -Cl, -Br, -I, un groupe hydroxyle, un groupe cyano, un groupe nitro, un groupe amino, un groupe amidino, un groupe hydrazino, un groupe hydrazono, un groupe C₁-C₂₀ alkyle, un groupe C₁-C₂₀ alkoxy, un groupe C₆-C₂₀ aryle, un groupe C₂-C₂₀ hétéroaryle, et -Si(Q₃₁)(Q₃₂)(Q₃₃),
dans lequel Q₃₁ à Q₃₃ sont chacun indépendamment sélectionnés parmi : hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryle substitué par un groupe C₁-C₆₀ alkyle, un groupe C₁-C₆₀ hétéroaryle, un groupe polycyclique condensé non aromatique monovalent, un groupe hétéropolycyclique condensé non aromatique monovalent, un groupe biphényle, et un groupe terphényle,
dans lequel au moins un élément sélectionné entre R₁₂ et R₁₄ est substitué par -F.

7. Composé hétérocyclique selon l'une quelconque des revendications 1 à 6, dans lequel un nombre de -F(s) compris dans le composé hétérocyclique est un nombre entier de 1 à 20.

8. Composé hétérocyclique selon l'une quelconque des revendications 1 à 7, le composé hétérocyclique représenté par la Formule 1 étant représenté par un élément sélectionné entre les Formules 1-2 et 1-3 : 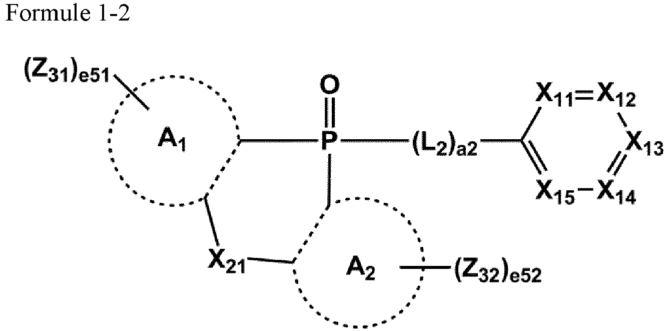 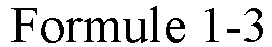 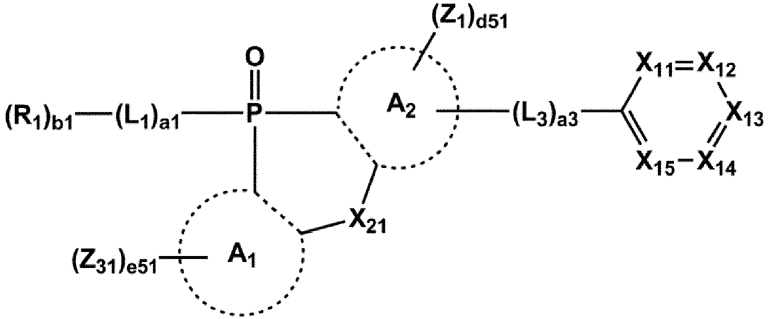
dans lequel, dans les Formules 1-2 et 1-3,
A₁ et A₂ sont chacun indépendamment sélectionnés entre un groupe C₅-C₆₀ carbocyclique et un groupe C₁-C₆₀ hétérocyclique,
X₂₁ est sélectionné parmi une liaison simple, C(R₂₁)(R₂₂), N(R₂₁), O, S, et Si(R₂₁)(R₂₂),
L₃ est tel que défini selon l'une quelconque des revendications précédentes,
a3 est tel que défini selon l'une quelconque des revendications précédentes,
R₂₁, R₂₂, Z₁, Z₃₁, et Z₃₂ sont chacun indépendamment sélectionnés parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), et -P(=O)(Q₃₁)(Q₃₂),
e51, e52, et d51 sont chacun indépendamment un nombre entier de 1 à 10,
X₁₁ à X₁₅, L₁, L₂, a1, a2, R₁, et b1 sont respectivement tels que définis selon l'une quelconque des revendications précédentes, et
Q₃₁ à Q₃₃ sont chacun indépendamment sélectionnés parmi : hydrogène, deutérium, -F, - Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryle substitué par un groupe C₁-C₆₀ alkyle, un groupe C₁-C₆₀ hétéroaryle, un groupe polycyclique condensé non aromatique monovalent, un groupe hétéropolycyclique condensé non aromatique monovalent, un groupe biphényle, et un groupe terphényle.

9. Composé hétérocyclique selon l'une quelconque des revendications 1 à 8, sélectionné parmi les composés 1 à 132 :

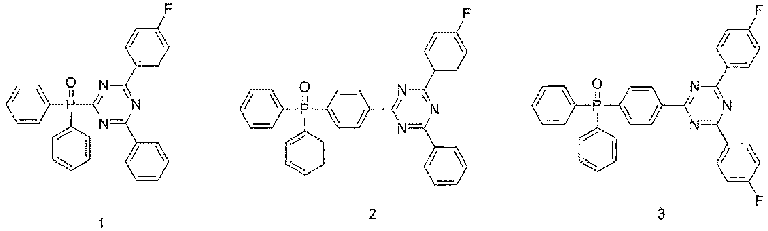

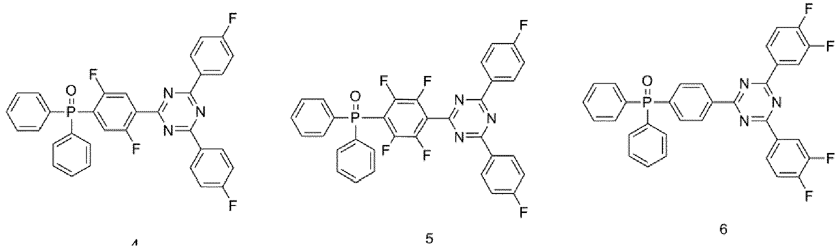

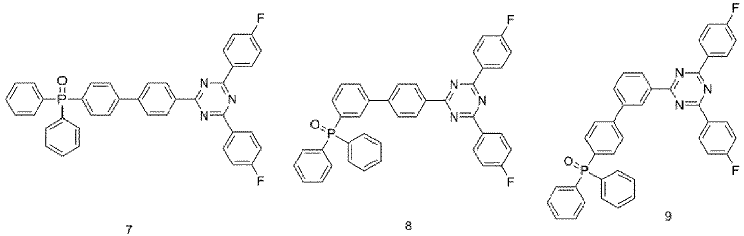

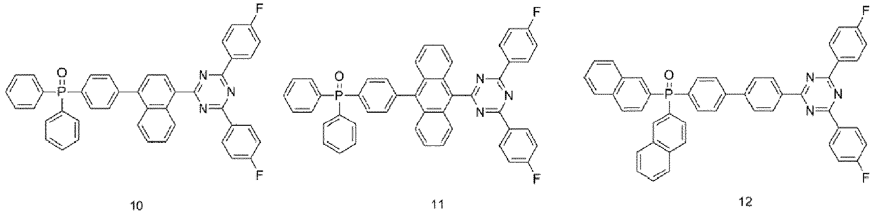

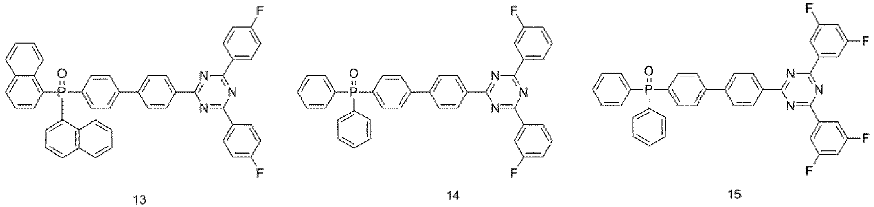

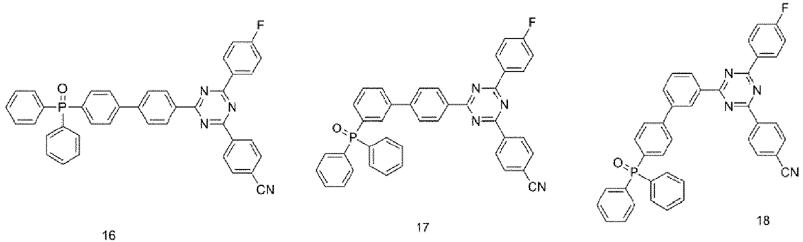

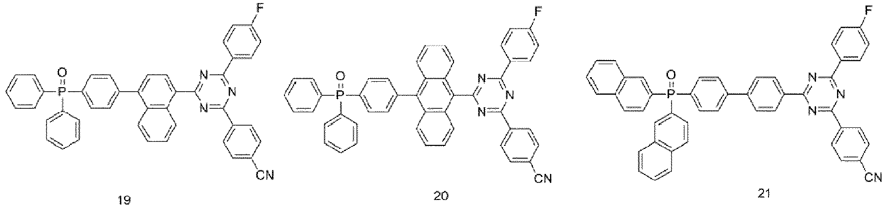

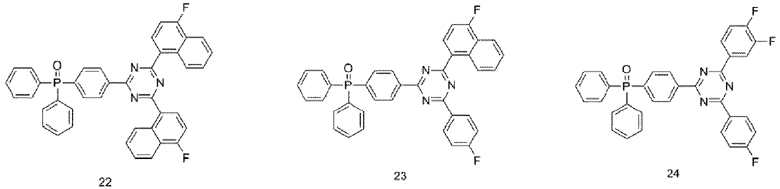

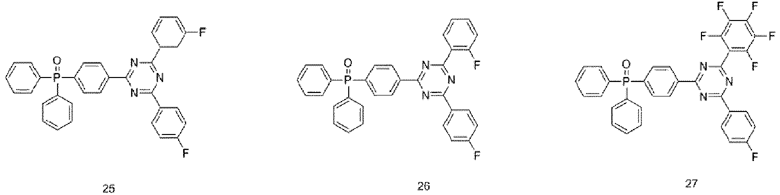

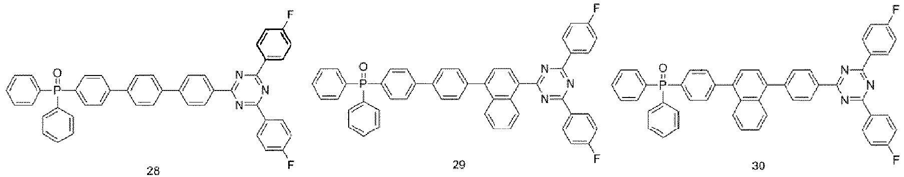

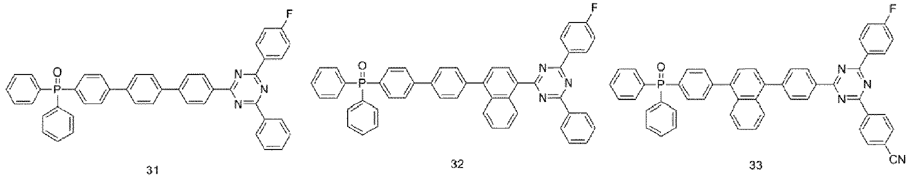

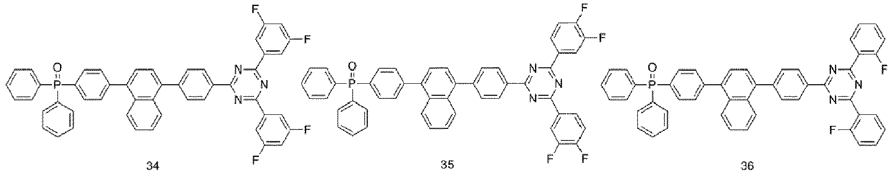

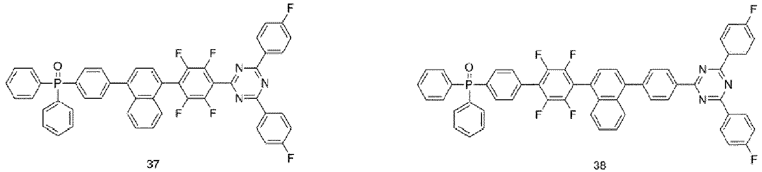

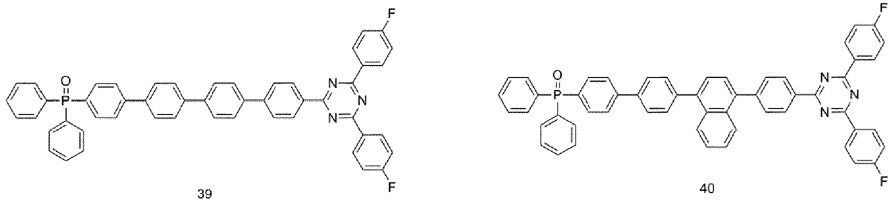

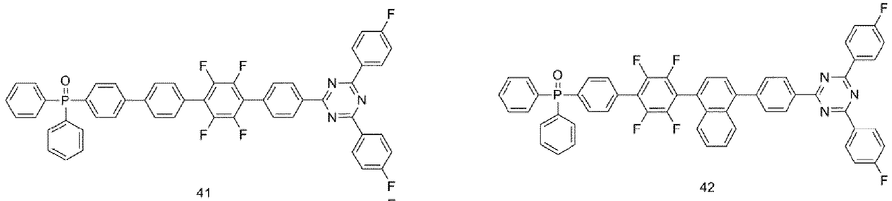

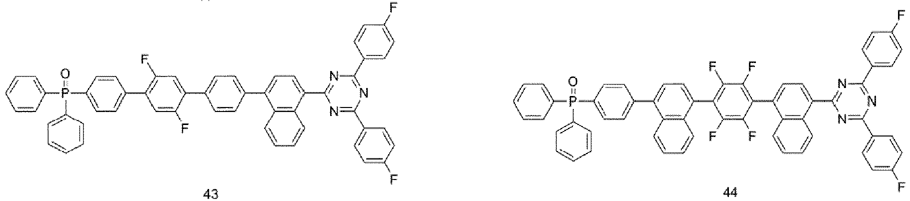

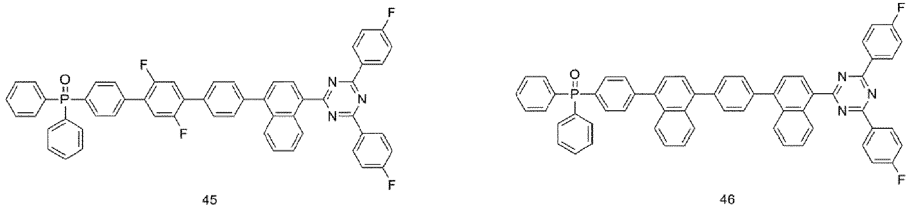

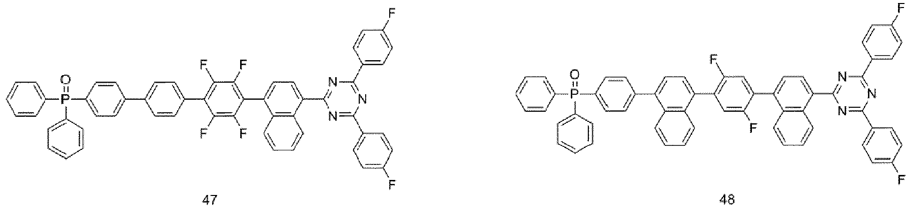

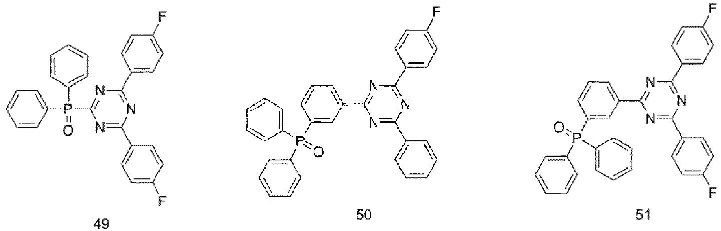

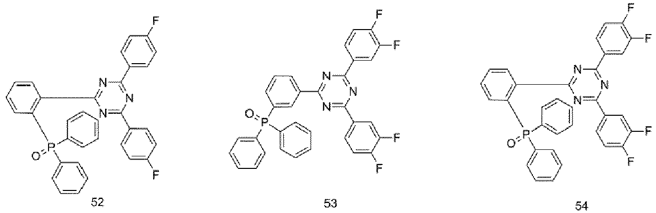

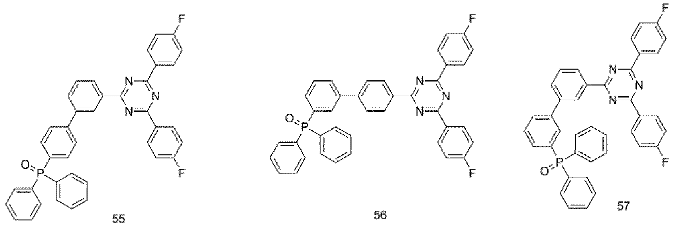

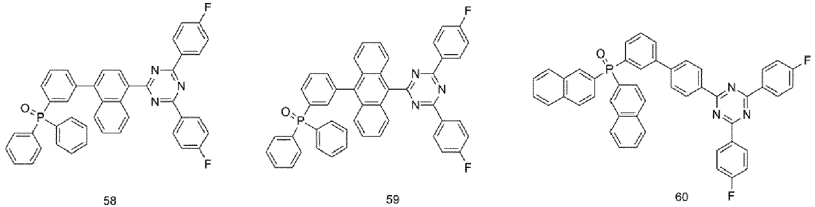

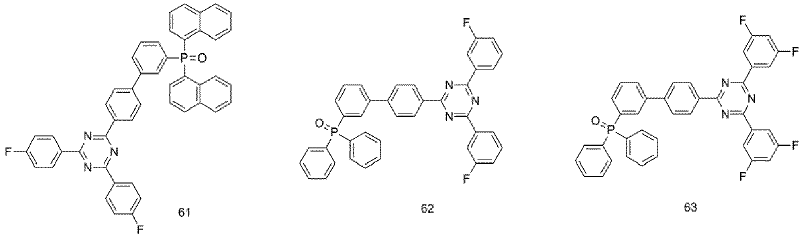

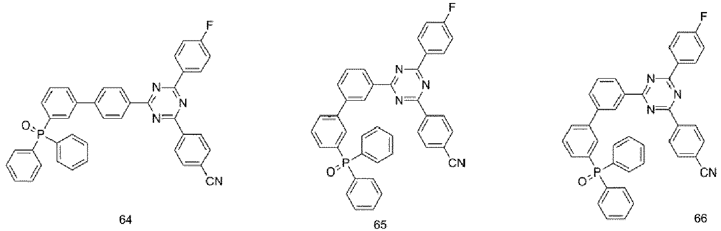

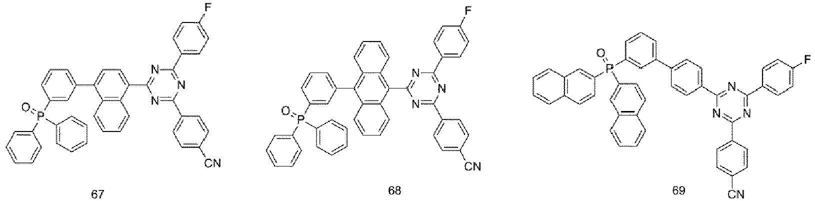

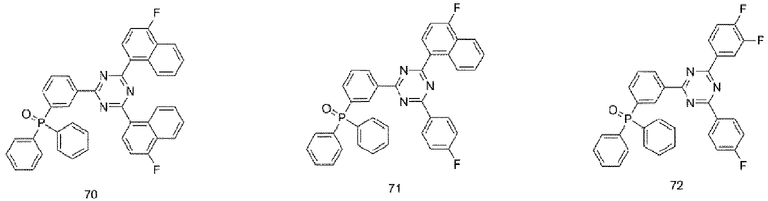

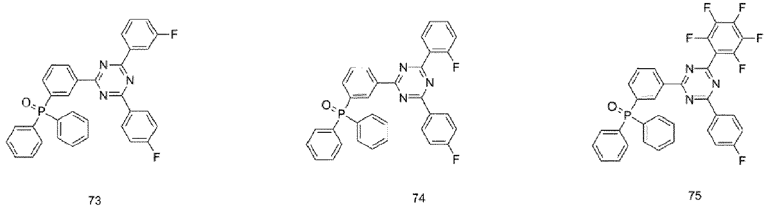

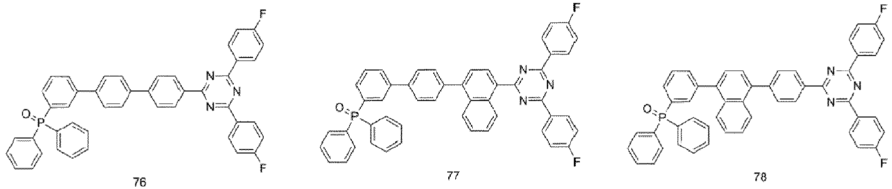

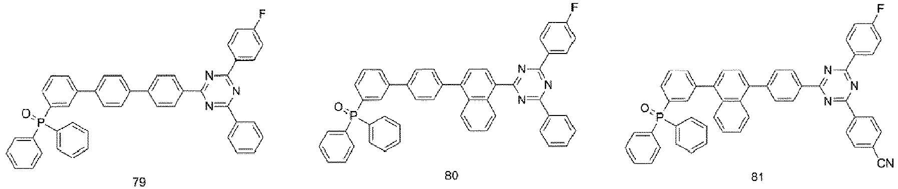

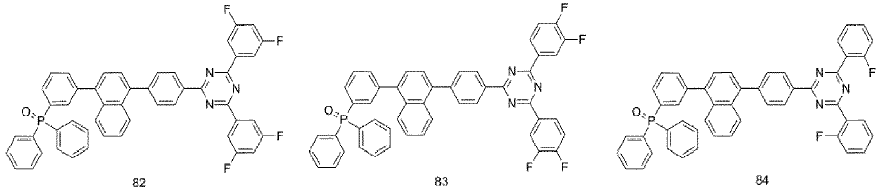

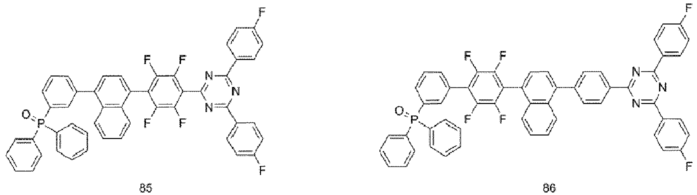

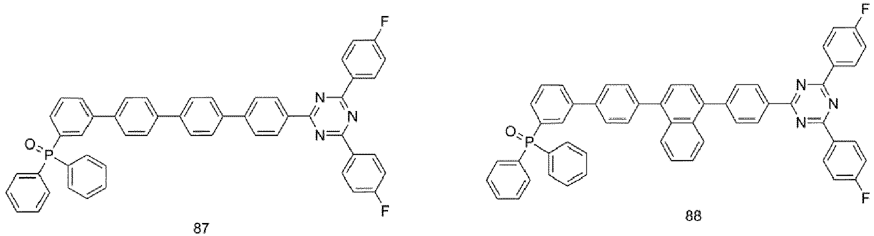

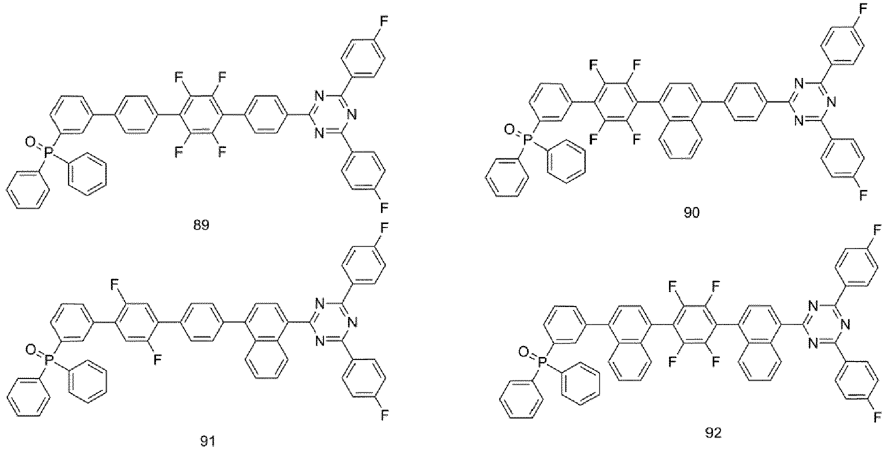

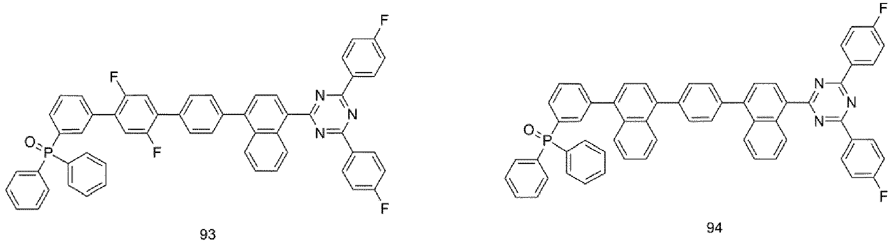

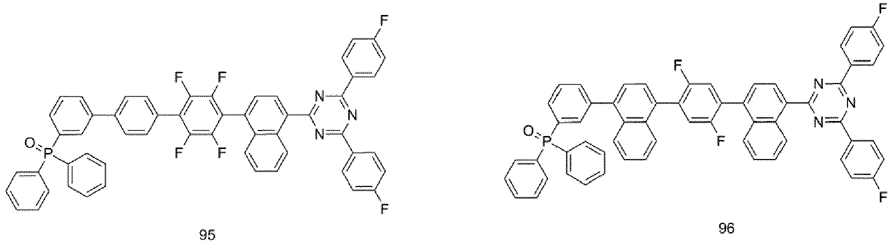

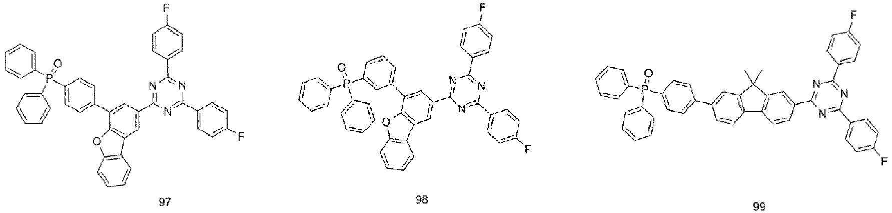

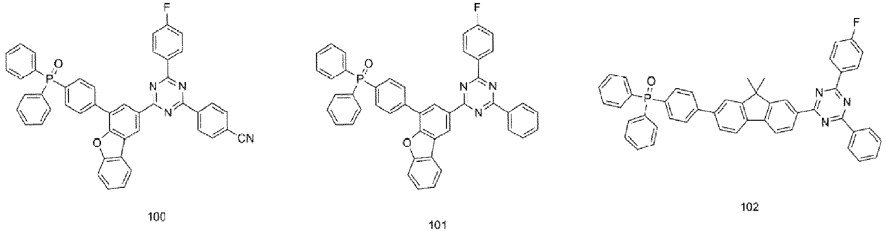

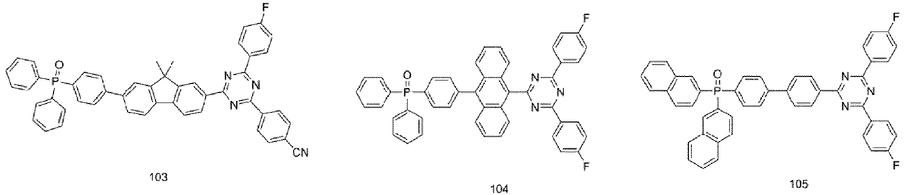

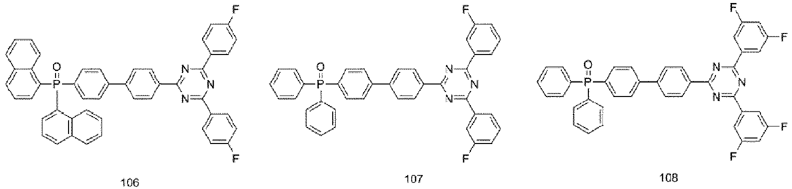

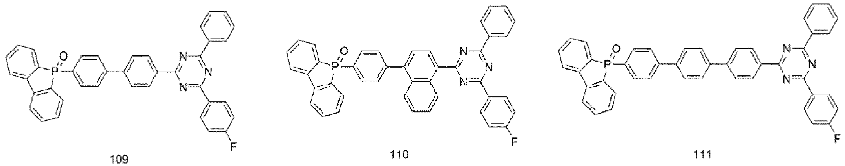

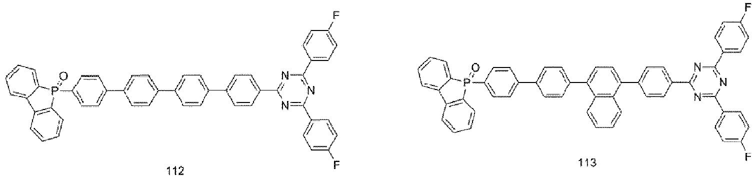

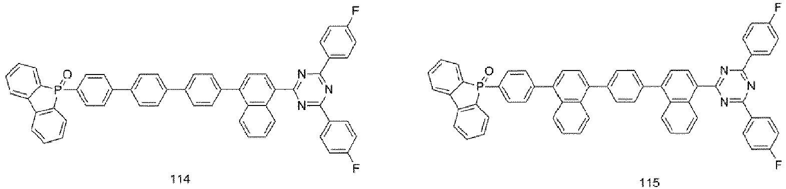

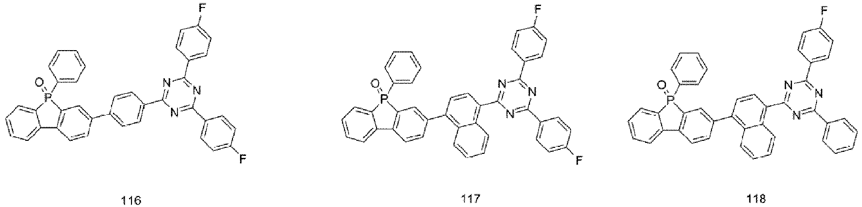

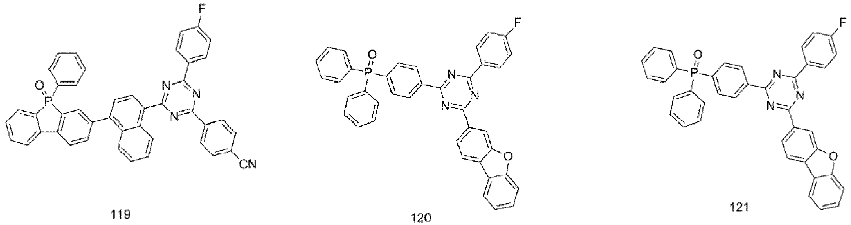

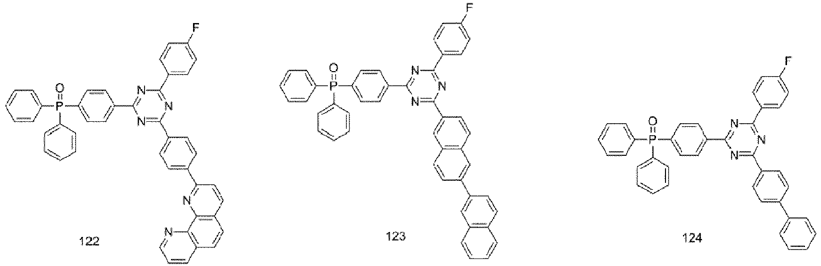

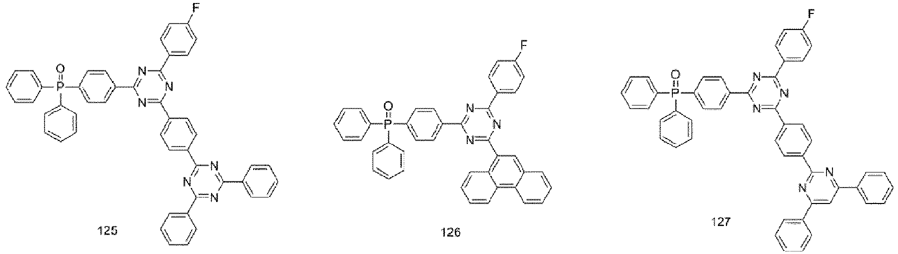

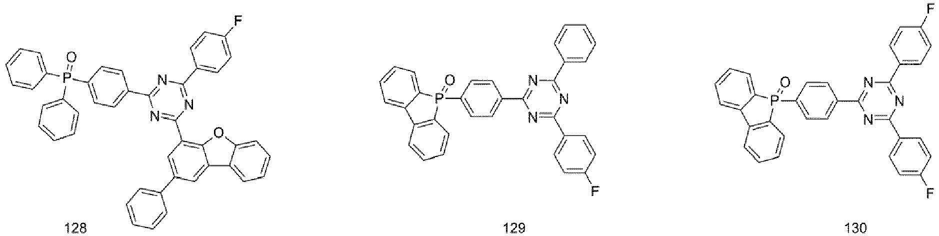

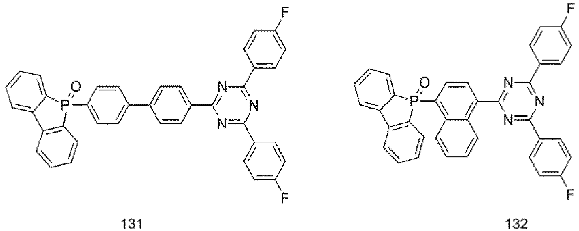

10. Dispositif électroluminescent organique comprenant :
une première électrode ;
une deuxième électrode faisant face à la première électrode ; et
une couche organique entre la première électrode et la seconde électrode ; la couche organique comprenant une couche émissive et au moins un composé hétérocyclique selon l'une quelconque des revendications 1 à 9 ; de préférence dans lequel la couche émissive comprend le composé hétérocyclique.

11. Dispositif électroluminescent organique selon la revendication 10, dans lequel :
la première électrode est une anode,
la seconde électrode est une cathode,
la couche organique comprend en outre une zone de transport de trous entre la première électrode et la couche émissive, et une zone de transport d'électrons entre la couche émissive et la seconde électrode,
la zone de transport de trous comprend une couche d'injection de trous, une couche de transport de trous, une couche auxiliaire émissive, une couche de blocage d'électrons, ou une combinaison de celles-ci, et
la zone de transport d'électrons comprend une couche tampon, une couche de blocage de trous, une couche de contrôle d'électrons, une couche de transport d'électrons, une couche d'injection d'électrons, ou une combinaison de celles-ci.

12. Dispositif électroluminescent organique selon la revendication 11, dans lequel
(i) la zone de transport d'électrons comprend le composé hétérocyclique, et/ou
(ii) la zone de transport d'électrons comprend la couche de transport d'électrons, et la couche de transport d'électrons comprend le composé hétérocyclique, et/ou
(iii) la zone de transport de trous comprend un dopant de type p comportant un niveau d'énergie d'orbitale moléculaire inoccupée la plus basse (LUMO) de -3,5 eV ou moins, de préférence
dans lequel
le dopant de type p comprend un composé contenant un groupe cyano.

13. Dispositif électroluminescent organique selon la revendication 10, dans lequel :
la couche émissive est une première couche émissive pour émettre une première lumière de couleur,
le dispositif électroluminescent organique comprend en outre i) au moins une deuxième couche émissive pour émettre une deuxième lumière de couleur ou ii) au moins une deuxième couche émissive pour émettre une deuxième lumière de couleur et au moins une troisième couche émissive pour émettre une troisième lumière de couleur, entre la première électrode et la deuxième électrode,
une longueur d'onde d'émission maximale de la première lumière de couleur, une longueur d'onde d'émission maximale de la deuxième lumière de couleur, et une longueur d'onde d'émission maximale de la troisième lumière de couleur sont identiques ou différentes entre elles, et
la première lumière de couleur et la deuxième lumière de couleur sont émises sous la forme de lumière mixte, ou la première lumière de couleur, la deuxième lumière de couleur et la troisième lumière de couleur sont émises sous la forme de lumière mixte.
